# EUROPEAN PATENT SPECIFICATION

(11) **EP 3 048 654 B1**
(45) Date of publication and mention of the grant of the patent: **09.11.2022**
(21) Application number: 16152129.9
(22) Date of filing: 20.01.2016
(51) Int. Cl.: H01L 51/54, C07C 13/00, C07C 15/00

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 20.01.2015 KR 20150009341; 09.12.2015 KR 20150175356
(43) Date of publication of application: 27.07.2016
(73) Proprietor: Samsung Display Co., Ltd., Gyeonggi-do (KR)
(72) Inventor: LEE, Jungsub, Gyeonggi-do (KR); KIM, Seulong, Gyeonggi-do (KR); ITO, Naoyuki, Gyeonggi-do (KR); KIM, Younsun, Gyeonggi-do (KR); SHIN, Dongwoo, Gyeonggi-do (KR)
(74) Representative: Marks & Clerk LLP

(56) References cited:
- EP-A1- 2 141 158
- EP-A2- 2 332 931
- WO-A1-2014/061963
- WO-A1-2014/141725
- WO-A2-2010/114243
- WO-A2-2010/114266
- CN-A- 103 187 531

## Description

### BACKGROUND

### 1. Field

One or more embodiments relate to an organic light-emitting device.

### 2. Description of the Related Art

Organic light-emitting devices are self-emission devices that have wide viewing angles, high contrast ratios, short response times, and excellent brightness, driving voltage, and response speed characteristics, and produce full-color images.

The organic light-emitting device may include a first electrode on a substrate, and a hole transport region, an emission layer, an electron transport region, and a second electrode, which are sequentially disposed on the first electrode. Holes provided from the first electrode may move toward the emission layer through the hole transport region, and electrons provided from the second electrode may move toward the emission layer through the electron transport region. Carriers, such as holes and electrons, recombine in the emission layer to produce excitons. These excitons change from an excited state to a ground state, thereby generating light. WO 2014/141725 A1 relates to anthracene derivatives and organic electroluminescence elements using the same.
WO 2010/114266 A2 relates to organic electroluminescent compounds and organic electroluminescence devices comprising the same.
CN 103 187 531 A relates to an organic light-emitting device and a double-polarity organic compound.
EP 2 141 158 A1 relates to a phenyl-substituted 1,3,5-triazine compound and a process for producing the compound.
WO 2014/061963 A1 relates to an organic electroluminescence compound and an organic electroluminescence device containing the same.

### SUMMARY

One or more embodiments include an organic light-emitting device.

Additional aspects will be set forth in part in the description which follows and, in part, will be apparent from the description, or may be learned by practice of the presented embodiments.

According to one or more embodiments, an organic light-emitting device includes a first electrode, a second electrode, and an organic layer between the first electrode and the second electrode,

wherein the organic layer includes a first compound represented by Formula 1 and a second compound represented by Formula 2:

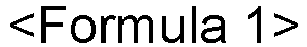

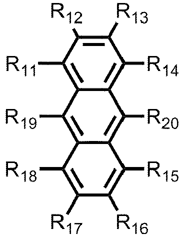

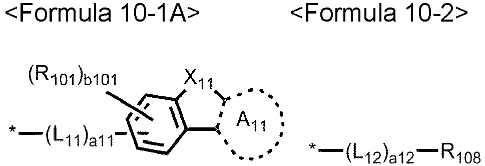

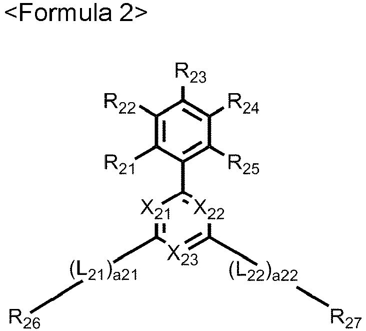

<Formula 11-1> *-(L₂₃)ₐ₂₃-R₁₁₁.

In Formulae 1, 2, 10-1A, 10-2 and 11-1,
R₁₁ to R₂₀ are each independently selected from Rₓ, R_{y}, hydrogen, deuterium, -F, -CI, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), - B(Q₁)(Q₂), -C(=O)(Q₁), -S(=O)₂(Q₁), and -P(=O)(Q₁)(Q₂), and at least one of R₁₁ to R₂₀ is Rₓ and at least one of R₁₁ to R₂₀ is R_{y},
Rₓ is represented by Formula 10-1A,
R_{y} is represented by Formula 10-2,
L₁₁ and L₁₂ are each independently selected from a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
a11 and a12 are each independently selected from 0, 1, 2, and 3,
A₁₁ is a group represented by Formula 10C, 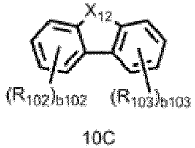
X₁₁ is selected from an oxygen atom, a sulfur atom, and C(R₁₀₄)(R₁₀₅),
X₁₂ is selected from an oxygen atom, a sulfur atom, and C(R₁₀₆)(R₁₀₇),
wherein X₁₁ and X₁₂ both are oxygen atoms; or X₁₁ and X₁₂ both are sulfur atoms; or X₁₁ is C(R₁₀₄)(R₁₀₅), and X₁₂ is C(R₁₀₆)(R₁₀₇);
R₁₀₁ to R₁₀₇ are each independently selected from hydrogen, deuterium, -F, - CI, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), - B(Q₁)(Q₂), -C(=O)(Q₁), -S(=O)₂(Q₁), and -P(=O)(Q₁)(Q₂),
b101 to b103 are each independently selected from 1, 2, 3, 4, 5, and 6,
R₁₀₈ is selected from a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group,
* indicates a binding site to a neighboring atom,
X₂₁ is C(Y₂₁) or a nitrogen atom (N), X₂₂ is C(Y₂₂) or N, X₂₃ is C(Y₂₃) or N, and at least one of X₂₁ to X₂₃ is N,
R₂₁ to R₂₅ are each independently selected from R_{z}, hydrogen, deuterium, -F, -CI, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), - S(=O)₂(Q₁), and -P(=O)(Q₁)(Q₂), and at least one of R₂₁ to R₂₅ is R_{z},
R_{z} is a group represented by Formula 11-1,
L₂₁ to L₂₃ are each independently selected from a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
a21 to a23 are each independently selected from 0 and 1,
R₂₆, R₂₇, and R₁₁₁ are each independently selected from a phenyl group, a biphenyl group, a terphenyl group, a naphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, and a dibenzothiophenyl group; and
a phenyl group, a biphenyl group, a terphenyl group, a naphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, and a dibenzothiophenyl group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a phenyl group substituted with a C₁-C₂₀ alkyl group, a biphenyl group, a terphenyl group, a naphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, and a dibenzothiophenyl group,
Y₂₁ to Y₂₃ are each independently selected from hydrogen, deuterium, -F, -CI, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂), and
at least one substituent of the substituted C₆-C₆₀ arylene group, substituted C₁-C₆₀ heteroarylene group, substituted divalent non-aromatic condensed polycyclic group, substituted divalent non-aromatic condensed heteropolycyclic group, substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₁-C₆₀ heteroaryl group, substituted monovalent non-aromatic condensed polycyclic group, and substituted monovalent non-aromatic condensed heteropolycyclic group is selected from:
deuterium, -F, -CI, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -CI, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, - F, -CI, -Br, -I, a hydroxyl group, a cyano group, a nitro group, an amidino group, a hydrazino group, a hydrazono group, a C₁-C₆₀ alkyl group, a C₂-C₆₀ alkenyl group, a C2-C60 alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₁ to Q₃, Q₁₁ to Q₁₃, Q₂₁ to Q₂₃, and Q₃₁ to Q₃₃ are each independently selected from hydrogen, deuterium, -F, -CI, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

At least some of the above and other features of the invention are set out in the claims.

### BRIEF DESCRIPTION OF THE DRAWINGS

These and/or other aspects will become apparent and more readily appreciated from the following description of the embodiments, taken in conjunction with the accompanying drawings in which:
FIG. 1 schematically illustrates a structure of an organic light-emitting device according to an embodiment;
FIG. 2 schematically illustrates a structure of an organic light-emitting device according to another embodiment;
FIG. 3 schematically illustrates a structure of an organic light-emitting device according to another embodiment; and
FIG. 4 schematically illustrates a structure of an organic light-emitting device according to another embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments will be described in detail with reference to the attached drawings. When descriptions are made in connection with the drawings, identical or corresponding elements are denoted by like reference numerals, and redundant explanation thereof will be omitted.

As used herein, the singular forms "a," "an" and "the" are intended to include the plural forms as well, unless the context clearly indicates otherwise.

It will be further understood that the terms "comprises" and/or "comprising" used herein specify the presence of stated features or components, but do not preclude the presence or addition of one or more other features or components.

It will be understood that when a layer, region, or component is referred to as being "formed on," another layer, region, or component, it can be directly or indirectly formed on the other layer, region, or component. That is, for example, intervening layers, regions, or components may be present.

Sizes of elements in the drawings may be exaggerated for convenience of explanation. In other words, since sizes and thicknesses of components in the drawings are arbitrarily illustrated for convenience of explanation, the following embodiments are not limited thereto.

The expression "an (organic layer) includes a first compound" includes a case in which "an (organic layer) includes a first compound represented by Formula 1 and a case in which an (organic layer) includes two or more different first compounds represented by Formula 1.

The term "organic layer" used herein refers to a single and/or a plurality of layers between a first electrode and a second electrode in an organic light-emitting device. A material included in the "organic layer" is not limited to an organic material.

According to one or more embodiments, an organic light-emitting device includes a first electrode, a second electrode, and an organic layer between the first electrode and the second electrode,
wherein the organic layer includes a first compound represented by Formula 1 and a second compound represented by Formula 2:

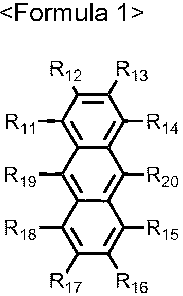

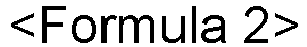

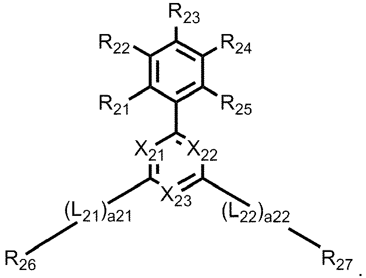

In Formula 1, R₁₁ to R₂₀ are each independently selected from Rₓ, R_{y}, hydrogen, deuterium, -F, -CI, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), -S(=O)₂(Q₁), and - P(=O)(Q₁)(Q₂), and at least one of R₁₁ to R₂₀ is Rₓ and at least one of R₁₁ to R₂₀ is R_{y},
wherein Q₁ to Q₃ may each independently be selected from a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.
Rₓ and R_{y} are the same as described later.

For example, R₁₉ and R₂₀ in Formula 1 may each independently be selected from Rₓ and R_{y}, but embodiments are not limited thereto.

As another example, in Formula 1, R₁₉ may be R_{y}, and R₂₀ may be Rₓ, but embodiments are not limited thereto.

For example, R₁₁ to R₁₈ in Formula 1 may each independently be selected from hydrogen, deuterium, -F, -CI, -Br, -I, a cyano group, a C₁-C₆₀ alkyl group, a C₆-C₆₀ aryl group, a C₁-C₆₀ heteroaryl group, and -Si(Q₁)(Q₂)(Q₃),
wherein Q₁ to Q₃ may each independently be selected from a C₁-C₆₀ alkyl group, a C₆-C₆₀ aryl group, a biphenyl group, and a terphenyl group, but embodiments are not limited thereto.

For example, R₁₁ to R₁₈ in Formula 1 may each independently be selected from hydrogen, deuterium, -F, -CI, -Br, -I, a cyano group, a C₁-C₁₀ alkyl group, a C₆-C₃₀ aryl group, a C₁-C₃₀ heteroaryl group, and -Si(Q₁)(Q₂)(Q₃),
wherein Q₁ to Q₃ may each independently be selected from a C₁-C₁₀ alkyl group, a C₆-C₃₀ aryl group, a biphenyl group, and a terphenyl group, but embodiments are not limited thereto.

As another example, R₁₁ to R₁₈ in Formula 1 may each independently be selected from hydrogen, deuterium, -F, -CI, -Br, -I, a cyano group, a methyl group, an ethyl group, an n-propyl group, an iso-propyl group, an n-butyl group, a sec-butyl group, an iso-butyl group, a tert-butyl group, a phenyl group, a biphenyl group, a terphenyl group, a naphthyl group, a pyridinyl group, and -Si(Q₁)(Q₂)(Q₃),
wherein Q₁ to Q₃ may each independently be selected from a methyl group, an ethyl group, an n-propyl group, an iso-propyl group, and a phenyl group, but embodiments are not limited thereto.

As another example, R₁₁ to R₁₈ in in Formula 1 may each independently be selected from hydrogen, deuterium, -F, -CI, -Br, -I, a cyano group, a methyl group, an ethyl group, an n-propyl group, an iso-propyl group, an n-butyl group, a sec-butyl group, an iso-butyl group, a tert-butyl group, a phenyl group, and -Si(CH₃)₃, but embodiments are not limited thereto.

As another example, in Formula 1, R₁₉ may be R_{y}, R₂₀ may be Rₓ, and R₁₁ to R₁₈ may each independently be selected from hydrogen, deuterium, -F, -CI, -Br, -I, a cyano group, a methyl group, an ethyl group, an n-propyl group, an iso-propyl group, an n-butyl group, a sec-butyl group, an iso-butyl group, a tert-butyl group, a phenyl group, and -Si(CH₃)₃, but embodiments are not limited thereto.

Rₓ in Formula 1 is a group represented by Formula 10-1A:

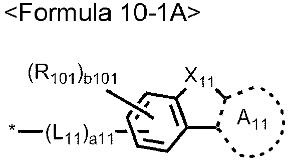

In Formula 10-1A, L₁₁, a11, A₁₁, R₁₀₁, b101, and X₁₁ are the same as described later, and
* indicates a binding site to a neighboring atom.
R_{y} in Formula 1 is represented by Formula 10-2:

   <Formula 10-2> *-(L₁₂)ₐ₁₂-R₁₀₈.

In Formula 10-2, L₁₂, a12, and R₁₀₈ are the same as described later, and
* indicates a binding site to a neighboring atom.
L₁₁ and L₁₂ in Formulae 10-1A, and 10-2 are each independently selected from a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group.

For example, L₁₁ and L₁₂ in Formulae 10-1A, and 10-2 may each independently be selected from a substituted or unsubstituted C₆-C₃₀ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group, but embodiments are not limited thereto.

For example, L₁₁ and L₁₂ in Formulae 10-1A, and 10-2 may each independently be selected from: a phenylene group, a naphthylene group, a fluorenylene group, a phenanthrenylene group, an anthracenylene group, a triphenylenylene group, a pyrenylene group, a chrysenylene group, a pyrrolylene group, a thiophenylene group, a furanylene group, an imidazolylene group, a pyridinylene group, a pyrazinylene group, a pyrimidinylene group, a pyridazinylene group, an indolylene group, a quinolinylene group, an isoquinolinylene group, a benzoquinolinylene group, a phenanthridinylene group, an acridinylene group, a phenanthrolinylene group, a benzofuranylene group, a benzothiophenylene group, a triazolylene group, a tetrazolylene group, a triazinylene group, a dibenzofuranylene group, and a dibenzothiophenylene group; and
a phenylene group, a naphthylene group, a fluorenylene group, a phenanthrenylene group, an anthracenylene group, a triphenylenylene group, a pyrenylene group, a chrysenylene group, a pyrrolylene group, a thiophenylene group, a furanylene group, an imidazolylene group, a pyridinylene group, a pyrazinylene group, a pyrimidinylene group, a pyridazinylene group, an indolylene group, a quinolinylene group, an isoquinolinylene group, a benzoquinolinylene group, a phenanthridinylene group, an acridinylene group, a phenanthrolinylene group, a benzofuranylene group, a benzothiophenylene group, a triazolylene group, a tetrazolylene group, a triazinylene group, a dibenzofuranylene group and a dibenzothiophenylene group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-fluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a carbazolyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group, but embodiments are not limited thereto.

As another example, L₁₁ and L₁₂ in Formulae 10-1A, and 10-2 may each independently be selected from:
a phenylene group, a naphthylene group, a fluorenylene group, a dibenzofuranylene group, and a dibenzothiophenylene group; and
a phenylene group, a naphthylene group, a fluorenylene group, a dibenzofuranylene group, and a dibenzothiophenylene group, each substituted with at least one selected from deuterium, -F, -CI, -Br, -I, a cyano group, a nitro group, a C₁-C₂₀ alkyl group, a phenyl group, and a naphthyl group, but embodiments are not limited thereto.

As another example, L₁₁ and L₁₂ in Formulae 10-1A, and 10-2 may each independently be selected from groups represented by Formulae 3-1 to 3-25, but embodiments are not limited thereto:

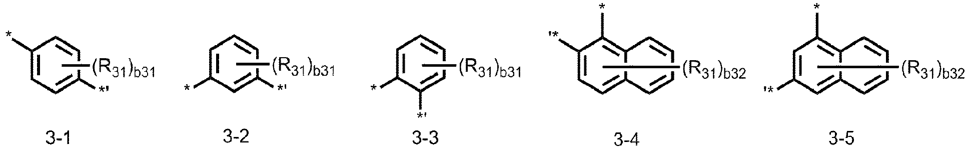

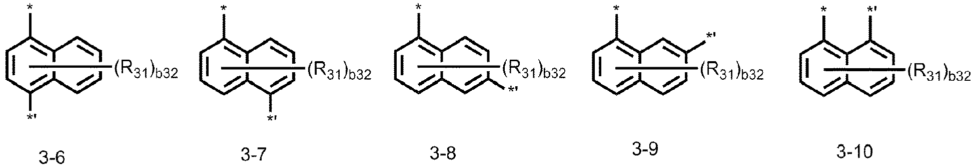

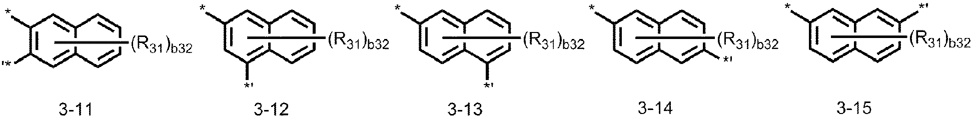

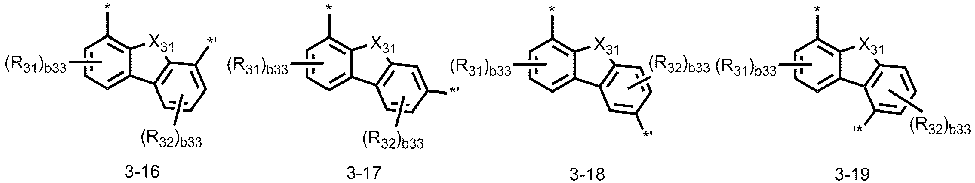

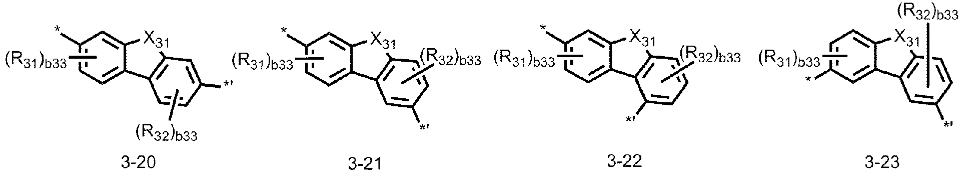

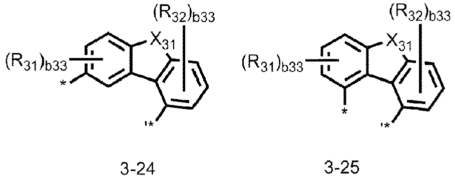

In Formulae 3-1 to 3-25,
X₃₁ may be selected from O, S, and C(R₃₃)(R₃₄),
R₃₁ to R₃₄ may each independently be selected from hydrogen, deuterium, -F, -CI, -Br, -I, a cyano group, a nitro group, a methyl group, an ethyl group, an n-propyl group, an iso-propyl group, an n-butyl group, an iso-butyl group, a sec-butyl group, a tert-butyl group, a phenyl group, and a naphthyl group,
b31 may be selected from 1, 2, 3, and 4,
b32 may be selected from 1, 2, 3, 4, 5, and 6,
b33 may be selected from 1, 2, and 3, and
* and *' each indicate a binding site to a neighboring atom.

For example, R₃₁ and R₃₂ may be hydrogen in Formulae 3-1 to 3-25, but embodiments are not limited thereto.

For example, R₃₃ and R₃₄ are both methyl, but embodiments are not limited thereto.

As another example, L₁₁ and L₁₂ in Formulae 10-1A, and 10-2 may each independently be selected from groups represented by Formulae 4-1 to 4-41, but embodiments are not limited thereto: 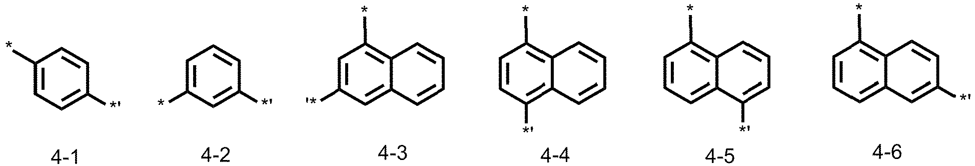 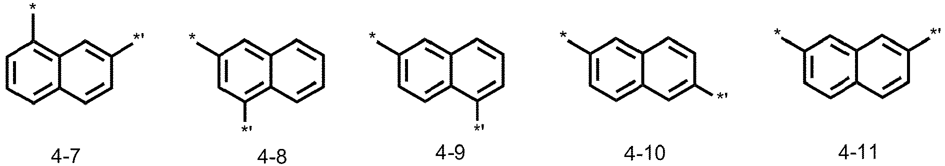 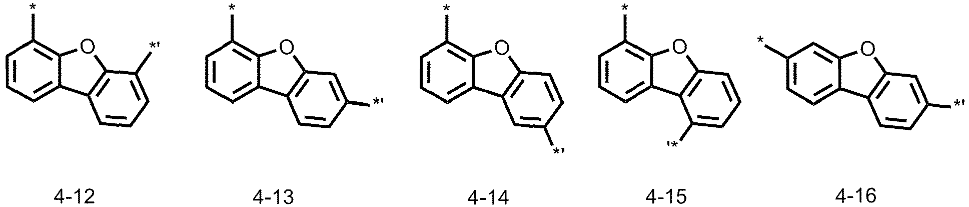 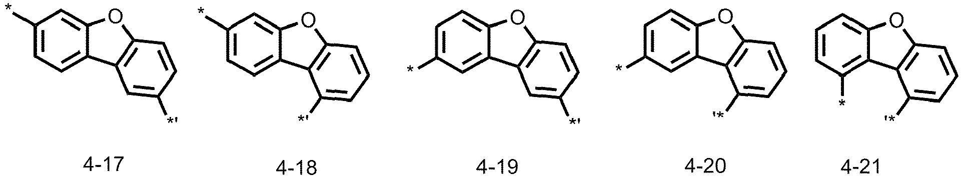 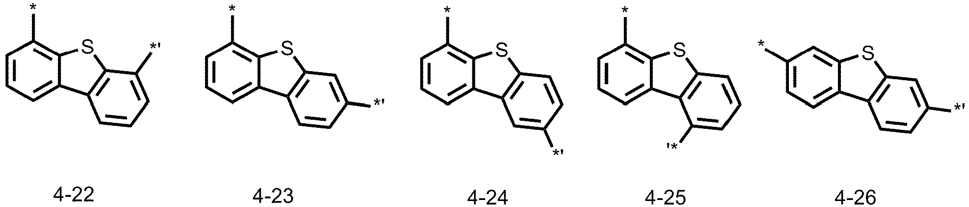 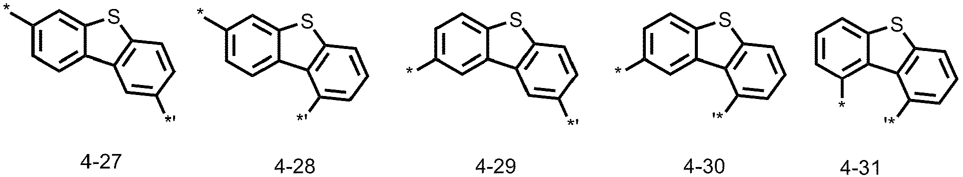 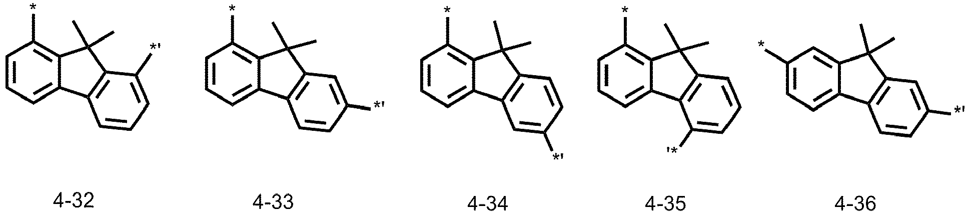 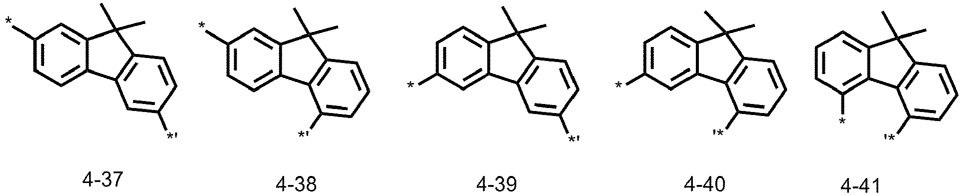
* and *' in Formulae 4-1 to 4-41 each indicate a binding site to a neighboring atom.
a11 in Formula 10-1A indicates the number of L₁₁(s) and is selected from 0, 1, 2, and 3. When a11 is 0, (L₁₁)ₐ₁₁ refers to a single bond. When a11 is 2 or more, two or more L₁₁(s) may be identical to or different from each other. For example, a11 in Formula 10-1A may be selected from 0 and 1, but embodiments are not limited thereto.
a12 in Formula 10-2 indicates the number of L₁₂(s) and is selected from 0, 1, 2, and 3. When a12 is 0, (L₁₂)ₐ₁₂ refers to a single bond. When a12 is 2 or more, two or more L₁₂(s) may be identical to or different from each other. For example, a12 in Formula 10-1A may be selected from 0 and 1, but embodiments are not limited thereto.

A₁₁ in Formula 10-1A is a group represented by Formula 10C:

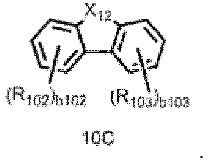

Two carbon atoms in Formula 10C are two carbon atoms in Formula 10-1A.

X₁₂, R₁₀₂, R₁₀₃, b102, and b103 in Formula 10C are the same as described later.

For example, A₁₁ in Formula 10-1A may be a group represented by one of Formulae 10C-1, 10C-2, and 10C-3, but embodiments are not limited thereto:

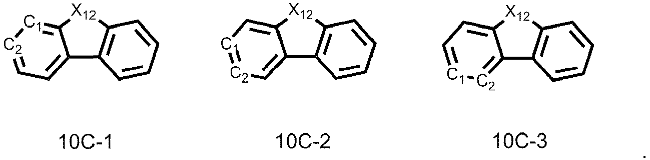

In Formulae 10C-1, 10C-2, and 10C-3,
X₁₂ is the same as described later, and
C₁ and C₂ are each independently a carbon atom in Formula 10-1A.

In Formula 10-1A, X₁₁ is selected from an oxygen atom, a sulfur atom, and C(R₁₀₄)(R₁₀₅),
X₁₂ is selected from O, S, and C(R₁₀₆)(R₁₀₇), and
R₁₀₄ to R₁₀₇ are the same as described later.
X₁₁ and X₁₂ in Formula 10-1A are both O; or
X₁₁ and X₁₂ in Formula 10-1A are both S; or
in Formula 10-1A, X₁₁ is C(R₁₀₄)(R₁₀₅), and X₁₂ is C(R₁₀₆)(R₁₀₇).

R₁₀₁ to R₁₀₇ in Formula 10-1A are independently selected from hydrogen, deuterium, -F, -CI, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, Si(Q₁)(Q₂)(Q₃), -N(Q₁)(Q₂), - B(Q₁)(Q₂), -C(=O)(Q₁), -S(=O)₂(Q₁), and -P(=O)(Q₁)(Q₂),
wherein Q₁ to Q₃ may each independently be selected from a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

For example, R₁₀₁ to R₁₀₃ in Formula 10-1A may be hydrogen, but embodiments are not limited thereto.

For example, R₁₀₄ to R₁₀₇ in Formula 10-1A may each independently be selected from hydrogen, a C₁-C₆₀ alkyl group, and a C₆-C₆₀ aryl group, but embodiments are not limited thereto.

For example, R₁₀₄ to R₁₀₇ in Formula 10-1A may each independently be selected from hydrogen, a C₁-C₁₀ alkyl group, and a C₆-C₃₀ aryl group, but embodiments are not limited thereto.

As another example, R₁₀₄ to R₁₀₇ in Formula 10-1A may each independently be selected from hydrogen, a methyl group, an ethyl group, and a phenyl group, but embodiments are not limited thereto.

b101 in Formula 10-1A indicates the number of R₁₀₁(s), and b101 is selected from 1, 2, 3, 4, 5, and 6. When b101 is 2 or more, two or more R₁₀₁(s) may be identical to or different from each other.

b102 in Formula 10C indicates the number of R₁₀₂(s), and b102 is selected from 1, 2, 3, 4, 5, and 6. When b102 is 2 or more, two or more R₁₀₂(s) may be identical to or different from each other.

b103 in Formula 10C indicates the number of R₁₀₃(s), and b103 is selected from 1, 2, 3, 4, 5, and 6 (e.g. 1, 2, 3 and 4). When b103 is 2 or more, two or more R₁₀₃(s) may be identical to or different from each other.

For example, Rₓ in Formula 1 may be selected from groups represented by Formulae 10-21 to 10-26, but embodiments are not limited thereto:

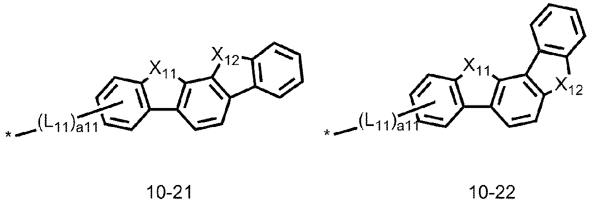

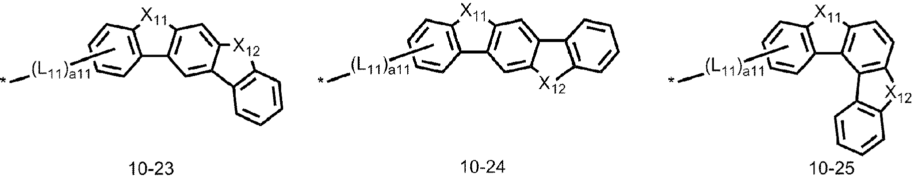

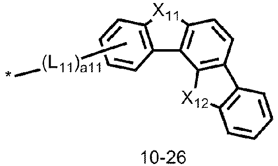

In Formulae 10-21 to 10-26,
L₁₁, a11, X₁₁, and X₁₂ are the same as described above, and
* indicates a binding site to a neighboring atom.
R₁₀₈ in Formula 10-2 is selected from a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group.

For example, R₁₀₈ in Formula 10-2 may be selected from a substituted or unsubstituted C₆-C₁₈ aryl group, a substituted or unsubstituted C₁₀-C₁₅ heteroaryl group, a substituted or unsubstituted monovalent non-aromatic condensed polycyclic group, and a substituted or unsubstituted monovalent non-aromatic condensed heteropolycyclic group, but embodiments are not limited thereto.

For example, R₁₀₈ in Formula 10-2 may be selected from: a phenyl group, a biphenyl group, a terphenyl group, a naphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a carbazolyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group; and
a phenyl group, a biphenyl group, a terphenyl group, a naphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a carbazolyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a carbazolyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group, but embodiments are not limited thereto.

As another example, R₁₀₈ in Formula 10-2 may be selected from: a phenyl group, a biphenyl group, a terphenyl group, a naphthyl group, a fluorenyl group, a phenanthrenyl group, an anthracenyl group, a dibenzofuranyl group, and a dibenzothiophenyl group; and
a phenyl group, a biphenyl group, a terphenyl group, a naphthyl group, a fluorenyl group, an anthracenyl group, a dibenzofuranyl group, and a dibenzothiophenyl group, each substituted with at least one selected from a methyl group, an ethyl group, an n-propyl group, an iso-propyl group, an n-butyl group, a sec-butyl group, an iso-butyl group, a tert-butyl group, a phenyl group, and a naphthyl group, but embodiments are not limited thereto.

As another example, R₁₀₈ in Formula 10-2 may be selected from groups represented by Formulae 5-1 to 5-30, but embodiments are not limited thereto:

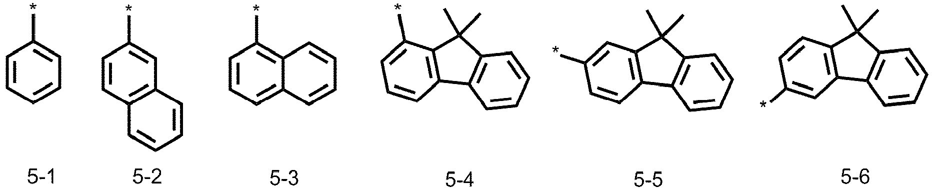

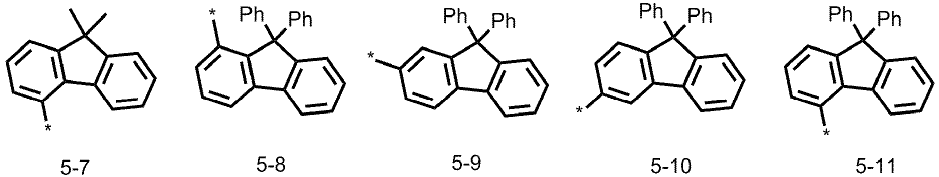

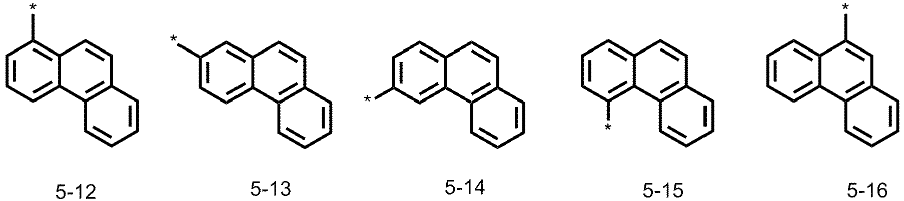

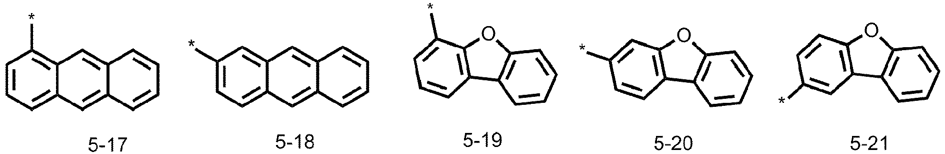

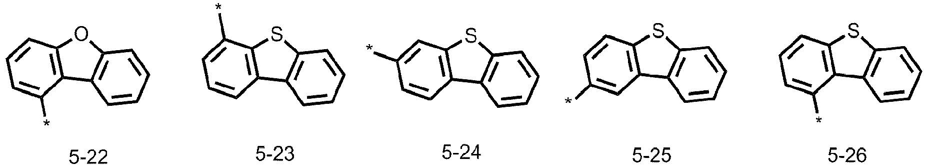

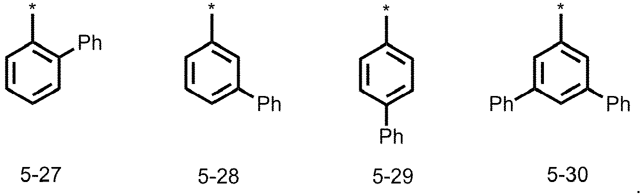

In Formulae 5-1 to 5-30,
Ph may be a phenyl group, and
* indicates a binding site to a neighboring atom.

In Formula 2, X₂₁ may be C(Y₂₁) or a nitrogen atom (N), X₂₂ may be C(Y₂₂) or N, X₂₃ may be C(Y₂₃) or N, and at least one of X₂₁ to X₂₃ may be N, and
Y₂₁ to Y₂₃ are the same as described later.

For example, in Formula 2, X₂₁ may be N, X₂₂ may be C(Y₂₂), and X₂₃ may be C(Y₂₃),
X₂₁ may be C(Y₂₁), X₂₂ may be N, and X₂₃ may be C(Y₂₃),
X₂₁ may be C(Y₂₁), X₂₂ may be C(Y₂₂), and X₂₃ may be N,
X₂₁ may be N, X₂₂ may be N, and X₂₃ may be C(Y₂₃),
X₂₁ may be N, X₂₂ may be C(Y₂₂), and X₂₃ may be N,
X₂₁ may be C(Y₂₁), X₂₂ may be N, and X₂₃ may be N, or
X₂₁ may be N, X₂₂ may be N, and X₂₃ may be N, but embodiments are not limited thereto.

In Formula 2, R₂₁ to R₂₅ are each independently selected from R_{z}, hydrogen, deuterium, -F, -CI, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), - S(=O)₂(Q₁), and -P(=O)(Q₁)(Q₂), and at least one of R₂₁ to R₂₅ is R_{z},
R_{z} is the same as described later, and
wherein Q₁ to Q₃ may each independently be selected from a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

For example, in Formula 2, R₂₁ to R₂₅ may each independently be selected from R_{z}, hydrogen, deuterium, -F, -CI, -Br, -I, a hydroxyl group, a cyano group, a nitro group, an amidino group, a hydrazino group, a hydrazono group, a substituted or unsubstituted C₁-C₁₀ alkyl group, a substituted or unsubstituted C₁-C₁₀ alkoxy group, a substituted or unsubstituted C₃-C₁₀ cycloalkyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), - C(=O)(Q₁), -S(=O)₂(Q₁), and -P(=O)(Q₁)(Q₂), and at least one of R₂₁ to R₂₅ may be R_{z},
R_{z} is the same as described later, and
wherein Q₁ to Q₃ may each independently be selected from a C₁-C₁₀ alkyl group, a C₆-C₃₀ aryl group, a C₁-C₂₀ heteroaryl group, a monovalent non-aromatic condensed polycyclic group, a monovalent non-aromatic condensed heteropolycyclic group, a biphenyl group, and a terphenyl group, but embodiments are not limited thereto.

For example, a substituent selected from R₂₁ to R₂₅ in Formula 2 may be R_{z}, but is not limited thereto.

In some embodiments, two substituents selected from R₂₁ to R₂₅ in Formula 2 may be R_{z}, but are not limited thereto.

As another example, R₂₃ in Formula 2 may be R_{z}, but embodiments are not limited thereto.

As another example, in Formula 2, R₂₂ and R₂₄ may each be R_{z}, and R₂₂ and R₂₄ may be identical to or different from each other, but embodiments are not limited thereto.

For example, R₂₁ to R₂₅ in Formula 2 may each independently be selected from R_{z}, hydrogen, and a C₁-C₆₀ alkyl group (e.g. a C₁-C₁₀ alkyl group), but embodiments are not limited thereto.

As another example, R₂₁ to R₂₅ in Formula 2 may each independently be selected from R_{z} and hydrogen, but embodiments are not limited thereto.

L₂₁ to L₂₃ in Formulae 2 and 11-1 are each independently selected from a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group.

For example, L₂₁ to L₂₃ in Formulae 2 and 11-1 may each independently be selected from a substituted or unsubstituted C₆-C₁₈ arylene group, a substituted or unsubstituted C₁-C₁₃ heteroarylene group, a substituted or unsubstituted divalent non-aromatic condensed polycyclic group, and a substituted or unsubstituted divalent non-aromatic condensed heteropolycyclic group, but embodiments are not limited thereto.

For example, L₂₁ to L₂₃ in Formulae 2 and 11-1 may each independently be selected from: a phenylene group, a naphthylene group, a phenanthrenylene group, an anthracenylene group, a triphenylenylene group, a pyrenylene group, a chrysenylene group, a pyrrolylene group, a thiophenylene group, a furanylene group, an imidazolylene group, a pyridinylene group, a pyrazinylene group, a pyrimidinylene group, a pyridazinylene group, an indolylene group, a quinolinylene group, an isoquinolinylene group, a benzoquinolinylene group, a phenanthridinylene group, an acridinylene group, a phenanthrolinylene group, a benzofuranylene group, a benzothiophenylene group, a triazolylene group, a tetrazolylene group, a triazinylene group, a dibenzofuranylene group, and a dibenzothiophenylene group; and
a phenylene group, a naphthylene group, a phenanthrenylene group, an anthracenylene group, a triphenylenylene group, a pyrenylene group, a chrysenylene group, a pyrrolylene group, a thiophenylene group, a furanylene group, an imidazolylene group, a pyridinylene group, a pyrazinylene group, a pyrimidinylene group, a pyridazinylene group, an indolylene group, a quinolinylene group, an isoquinolinylene group, a benzoquinolinylene group, a phenanthridinylene group, an acridinylene group, a phenanthrolinylene group, a benzofuranylene group, a benzothiophenylene group, a triazolylene group, a tetrazolylene group, a triazinylene group, a dibenzofuranylene group, and a dibenzothiophenylene group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a carbazolyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group, but embodiments are not limited thereto.

As another example, L₂₁ to L₂₃ in Formulae 2 and 11-1 may each independently be selected from: a phenylene group, a naphthylene group, a pyridinylene group, a pyrazinylene group, a pyrimidinylene group, a quinolinylene group, an isoquinolinylene group, and a triazinylene group; and
a phenylene group, a naphthylene group, a pyridinylene group, a pyrazinylene group, a pyrimidinylene group, a quinolinylene group, an isoquinolinylene group, and a triazinylene group, each substituted with at least one selected from deuterium, -F, -CI, -Br, -I, a cyano group, a nitro group, a C₁-C₂₀ alkyl group, a C₁-C₂₀ alkoxy group, a phenyl group, and a naphthyl group, but embodiments are not limited thereto.

As another example, L₂₁ to L₂₃ in Formulae 2 and 11-1 may each independently be selected from groups represented by Formulae 6-1 to 6-54, but embodiments are not limited thereto:

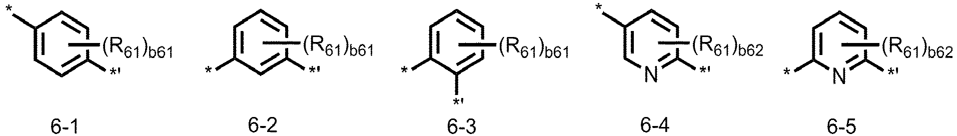

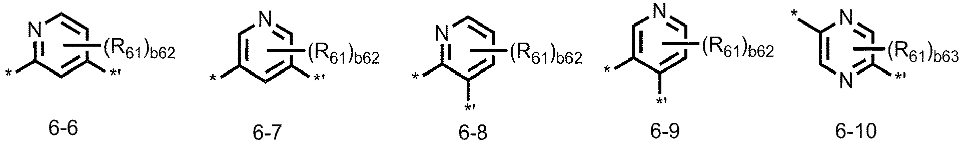

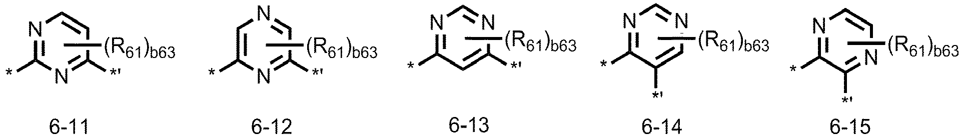

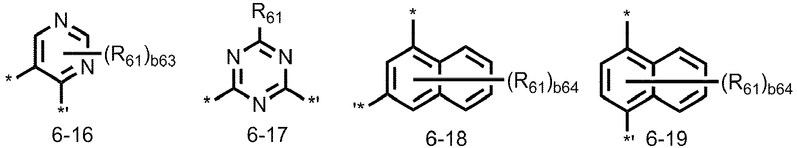

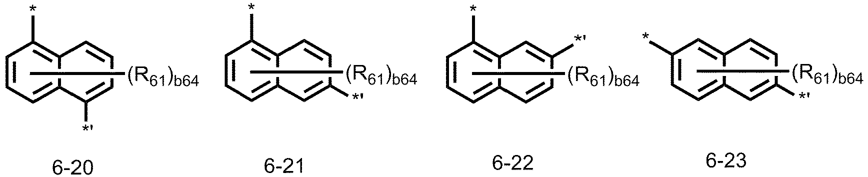

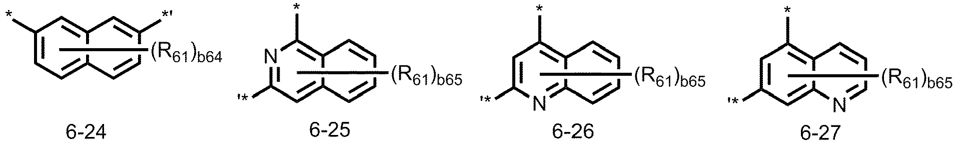

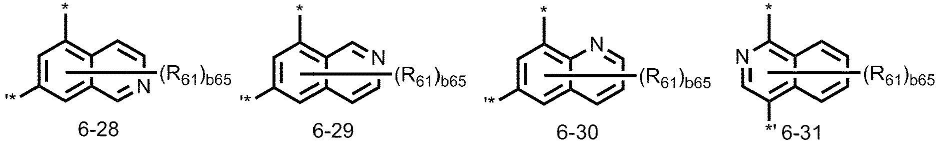

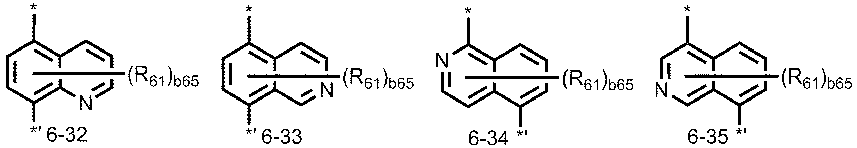

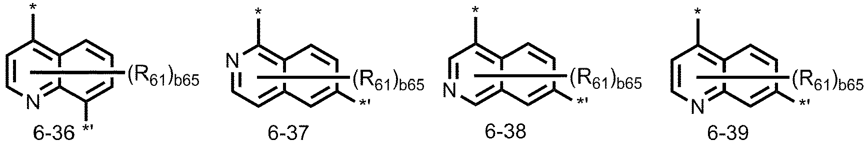

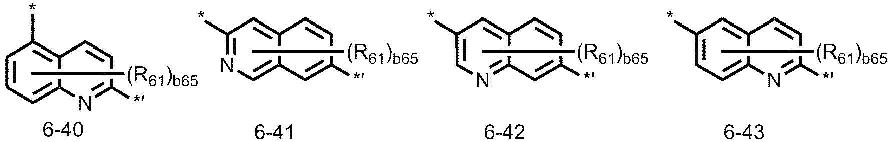

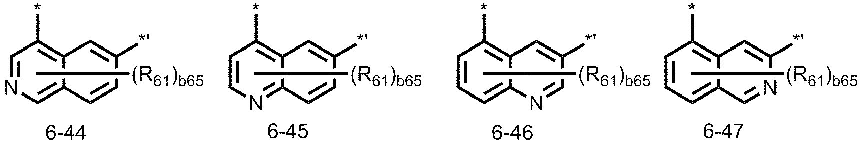

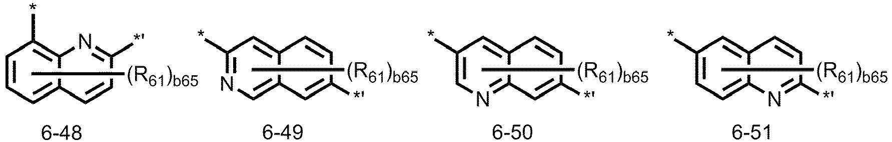

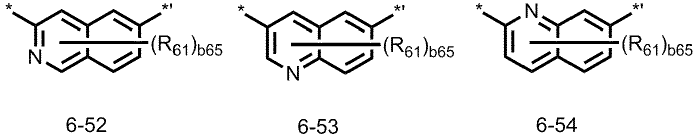

In Formulae 6-1 to 6-54,
R₆₁ may be selected from hydrogen, deuterium, -F, -CI, -Br, -I, a cyano group, a nitro group, a methyl group, an ethyl group, an n-propyl group, an iso-propyl group, an n-butyl group, an iso-butyl group, a sec-butyl group, a tert-butyl group, a methoxy group, an ethoxy group, a phenyl group, and a naphthyl group,
b61 may be selected from 1, 2, 3, and 4,
b62 may be selected from 1, 2, and 3,
b63 may be selected from 1 and 2,
b64 may be selected from 1, 2, 3, 4, 5, and 6,
b65 may be selected from 1, 2, 3, 4, and 5, and
* and *' each indicate a binding site to a neighboring atom.

As another example, in Formulae 2 and 11-1, L₂₁ to L₂₃ may each independently be selected from groups represented by Formulae 6-1 to 6-54, and R₆₁ may be selected from hydrogen and a methyl group, but embodiments are not limited thereto.

a21 in Formula 2 refers to the number of L₂₁(s), and a21 is selected from 0 and 1. When a21 is 0, (L₂₁)ₐ₂₁ refers to a single bond.

a22 in Formula 2 refers to the number of L₂₂(s), and a22 is selected from 0 and 1. When a22 is 0, (L₂₂)ₐ₂₂ refers to a single bond.

a23 in Formula 2-1 refers to the number of L₂₃(s), and a23 is selected from 0 and 1. When a23 is 0, (L₂₃)ₐ₂₃ refers to a single bond.

R₂₆, R₂₇, and R₁₁₁ in Formulae 2 and 11-1 are each independently selected from: a phenyl group, a biphenyl group, a terphenyl group, a naphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, and a dibenzothiophenyl group,; and
a phenyl group, a biphenyl group, a terphenyl group, a naphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, and a dibenzothiophenyl group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a phenyl group substituted with a C₁-C₂₀ alkyl group, a biphenyl group, a terphenyl group, a naphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, and a dibenzothiophenyl group.

As another example, R₂₆, R₂₇, and R₁₁₁ in Formulae 2 and 11-1 may each independently be selected from: a phenyl group, a biphenyl group, a terphenyl group, a naphthyl group, a fluorenyl group, a benzofluorenyl group, a dibenzofluorenyl group, a phenanthrenyl group, an anthracenyl group, a pyrenyl group, a tetraphenyl group, a chrysenyl group, a pyridinyl group, a pyrazinyl group, a pyrimidinyl group, a quinolinyl group, an isoquinolinyl group, and a benzoquinolinyl group; and
a phenyl group, a biphenyl group, a terphenyl group, a naphthyl group, a fluorenyl group, a benzofluorenyl group, a dibenzofluorenyl group, a phenanthrenyl group, an anthracenyl group, a pyrenyl group, a tetraphenyl group, a chrysenyl group, a pyridinyl group, a pyrazinyl group, a pyrimidinyl group, a quinolinyl group, an isoquinolinyl group, and a benzoquinolinyl group, each substituted with at least one selected from a methyl group, an ethyl group, an n-propyl group, an iso-propyl group, an n-butyl group, a sec-butyl group, an iso-butyl group, a tert-butyl group, a methoxy group, an ethoxy group, a phenyl group, a phenyl group substituted with a methyl group, a biphenyl group, a terphenyl group, and a naphthyl group, but embodiments are not limited thereto.

As another example, R₂₆, R₂₇, and R₁₁₁ in Formulae 2 and 11-1 may each independently be selected from groups represented by Formulae 8-1 to 8-36, but embodiments are not limited thereto:

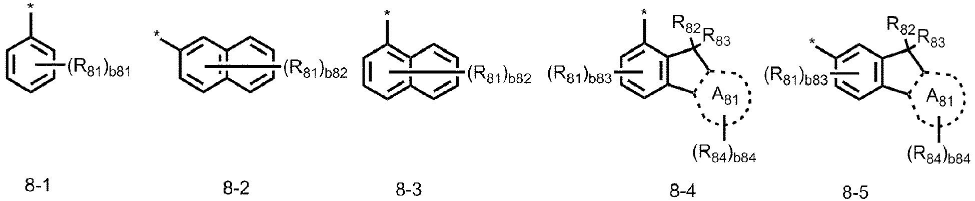

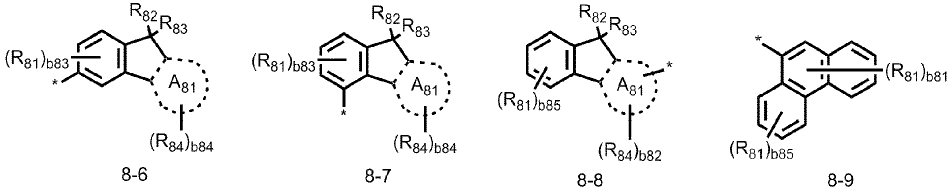

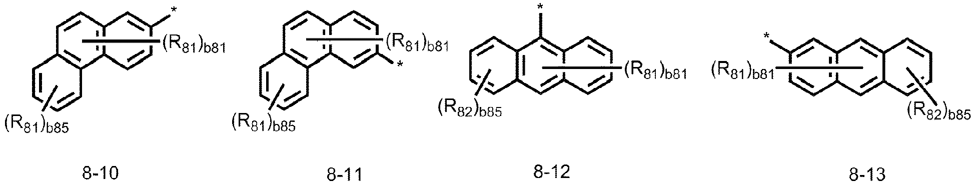

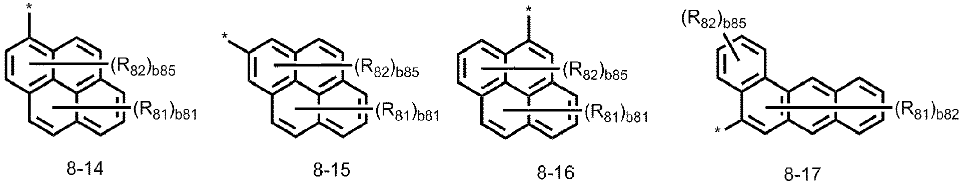

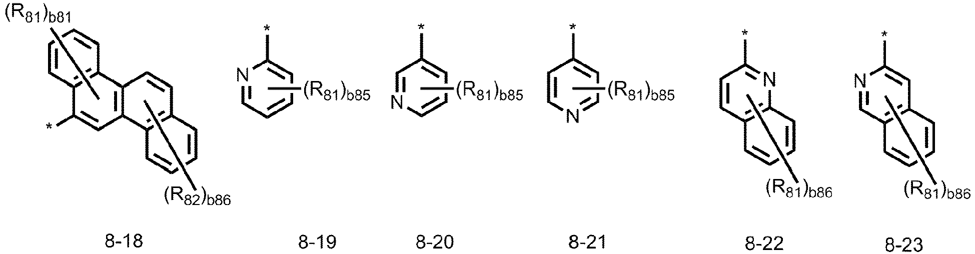

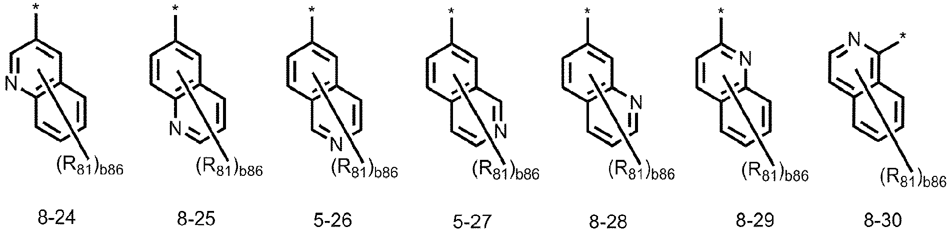

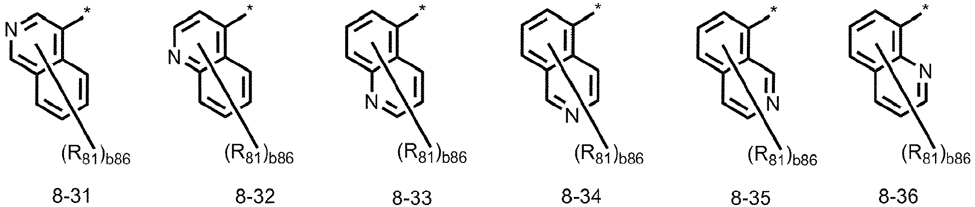

In Formulae 8-1 to 8-36,
A₈₁ may be selected from a benzene group, a naphthalene group, and a phenanthrene group,
R₈₁ to R₈₄ may each independently be selected from hydrogen, a methyl group, an ethyl group, an n-propyl group, an iso-propyl group, an n-butyl group, a sec-butyl group, an iso-butyl group, a tert-butyl group, a methoxy group, an ethoxy group, a phenyl group, a phenyl group substituted with a methyl group, a biphenyl group, a terphenyl group, and a naphthyl group,
b81 may be selected from 1, 2, 3, 4, and 5,
b82 may be selected from 1, 2, 3, 4, 5, 6, and 7,
b83 may be selected from 1, 2, and 3,
b84 may be selected from 1, 2, 3, 4, 5, 6, 7, and 8,
b85 may be selected from 1, 2, 3, and 4,
b86 may be selected from 1, 2, 3, 4, 5, and 6, and
* indicates a binding site to a neighboring atom.

As another example, at least one of R₂₆, R₂₇, and R₁₁₁ in Formulae 2 and 11-1 may be selected from groups represented by Formulae 8-19 to 8-36, but embodiments are not limited thereto.

Y₂₁ to Y₂₃ in Formula 2 are each independently selected from hydrogen, deuterium, -F, -CI, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), - S(=O)₂(Q₁), and -P(=O)(Q₁)(Q₂), and
wherein Q₁ to Q₃ may each independently be selected from a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

For example, Y₂₁ to Y₂₃ in Formula 2 may each independently be selected from hydrogen and a C₁-C₆₀ alkyl group (e.g. a C₁-C₁₀ alkyl group), but embodiments are not limited thereto.

As another example, Y₂₁ to Y₂₃ in Formula 2 may be hydrogen, but embodiments are not limited thereto.

For example, the first compound may be represented by Formula 1-1, but embodiments are not limited thereto:

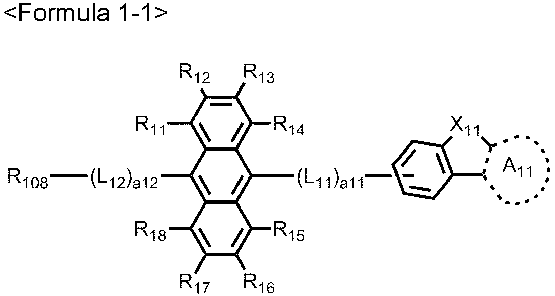

R₁₁ to R₁₄, R₁₅ to R₁₈, L₁₁, L₁₂, a11, a12, A₁₁, X₁₁, and R₁₀₈ in Formula 1-1 are the same as described in Formula 1.

As another example, the first compound may be represented by one of Formulae 1-21 to 1-26, but embodiments are not limited thereto:

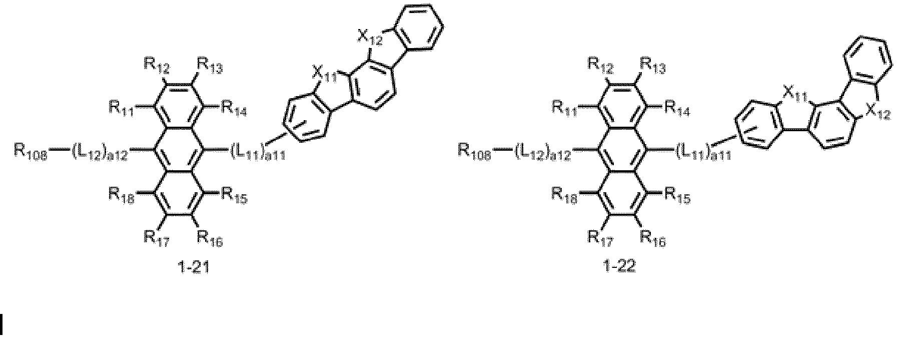

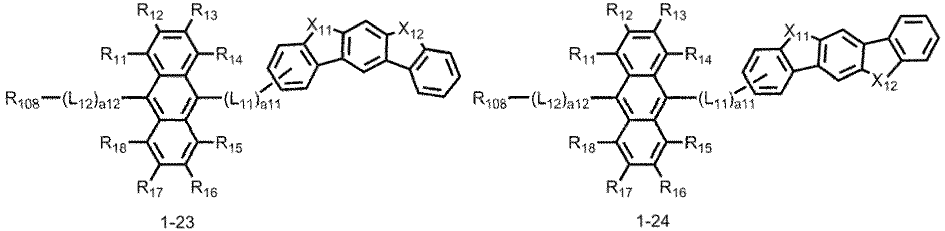

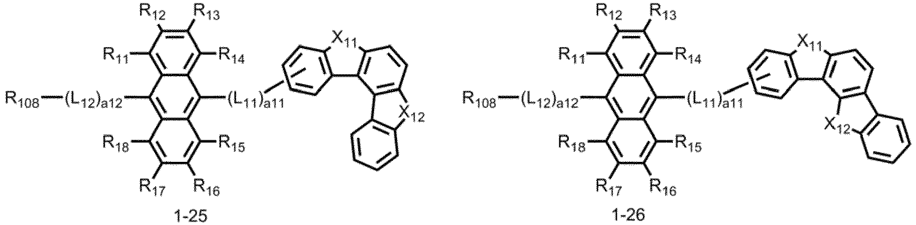

R₁₁ to R₁₄, R₁₅ to R₁₈, L₁₁, L₁₂, a11, a12, X₁₁, X₁₂, and R₁₀₈ in Formulae 1-21 to 1-26 are the same as described in Formula 1.

For example, the second compound may be represented by one of Formulae 2-1 and 2-2, but embodiments are not limited thereto:

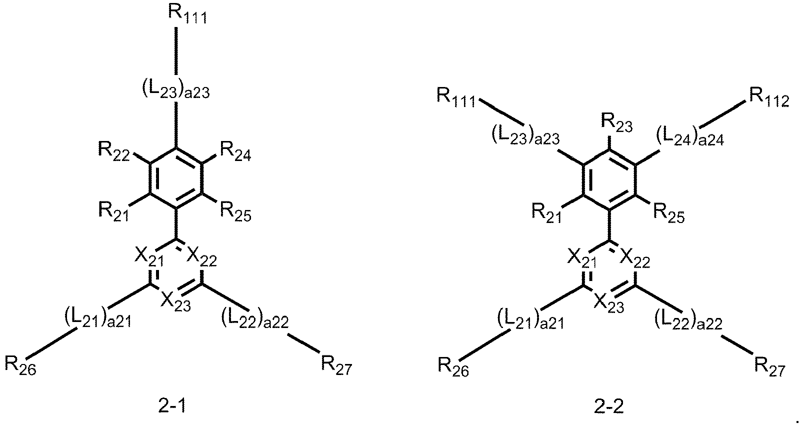

In Formulae 2-1 and 2-2,
X₂₁ to X₂₃, L₂₁ to L₂₃, a21 to a23, R₂₁, R₂₂, R₂₃, R₂₄ to R₂₇, and R₁₁₁ are the same as described in Formula 2,
L₂₄ is the same as described in connection with L₂₃ in Formula 2,
a24 is the same as described in connection with a23 in Formula 2, and
R₁₁₂ is the same as described in connection with R₁₁₁ in Formula 2, and
as another example, the second compound may be represented by one of Formulae 2-11 to 2-20, but embodiments are not limited thereto:

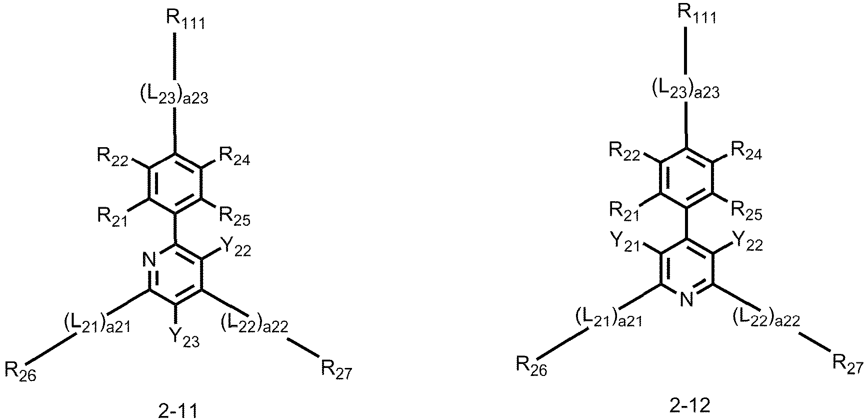

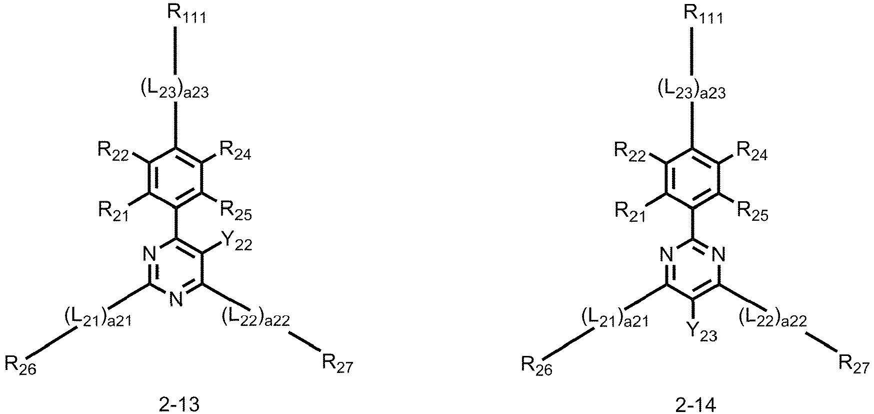

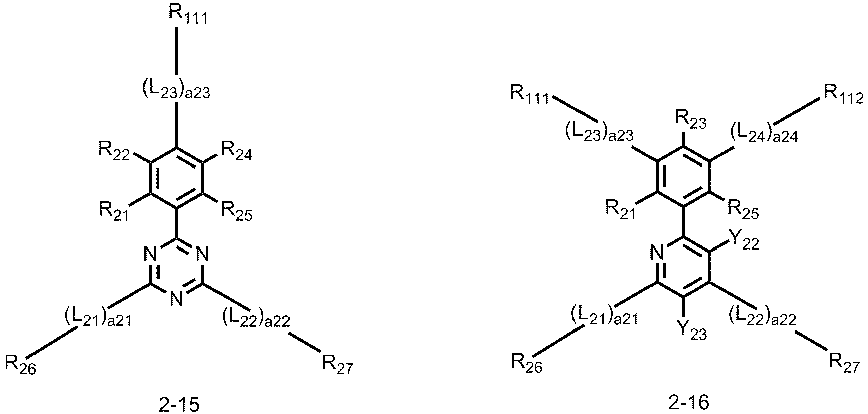

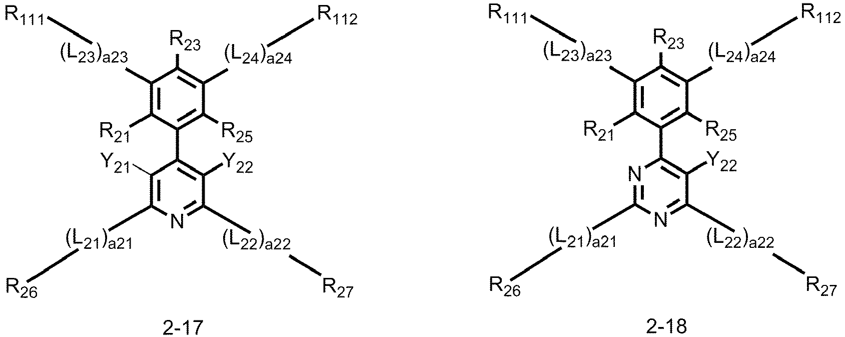

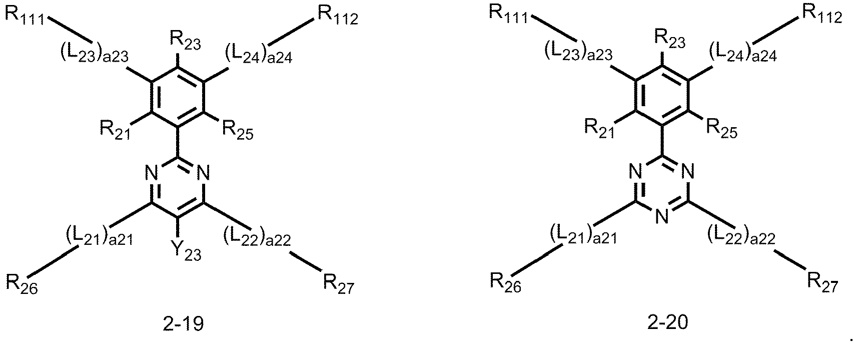

In Formulae 2-11 to 2-20,
Y₂₁ to Y₂₃, L₂₁ to L₂₃, a21 to a23, R₂₁, R₂₂, R₂₃, R₂₄ to R₂₇, and R₁₁₁ are the same as described above,
L₂₄ is the same as described in connection with L₂₃ in Formula 2,
a24 is the same as described in connection with a23 in Formula 2, and
R₁₁₂ is the same as described in connection with R₁₁₁ in Formula 2, and
for example, the first compound may be selected from compounds illustrated below, but embodiments are not limited thereto:

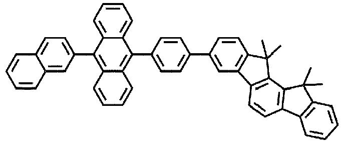

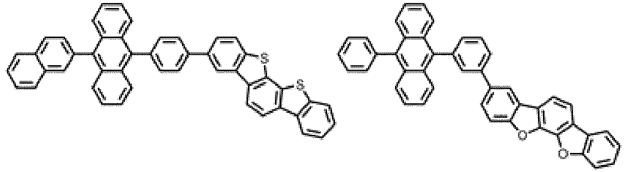

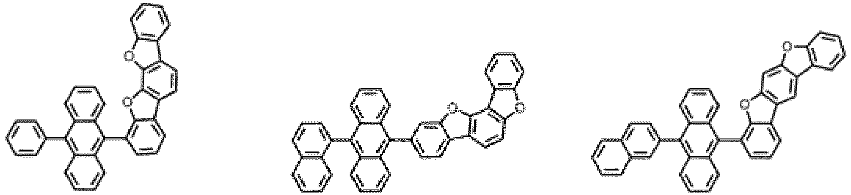

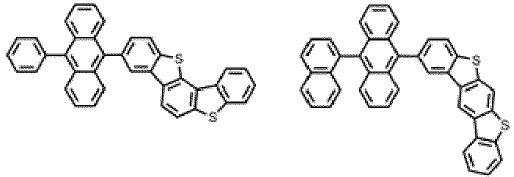

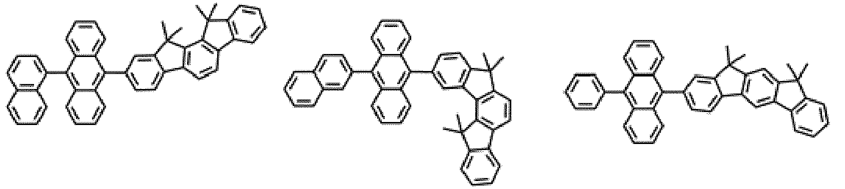

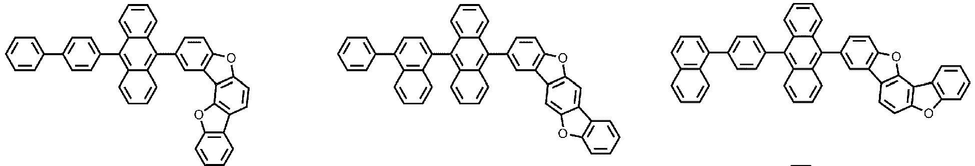

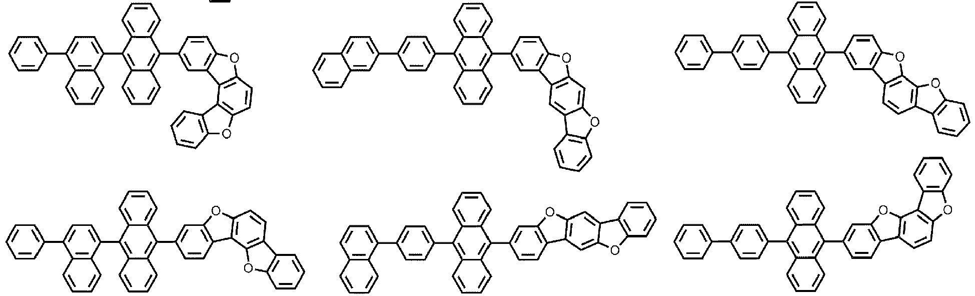

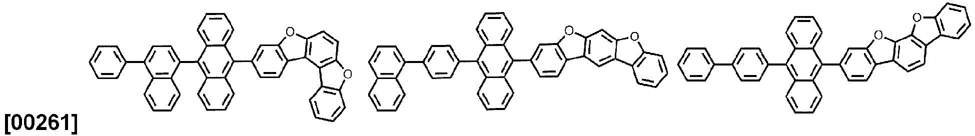

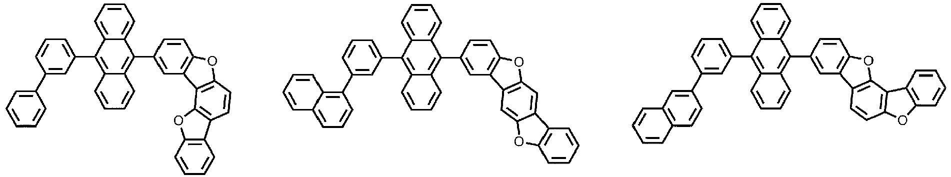

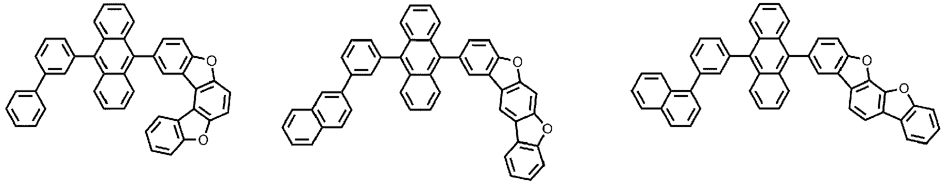

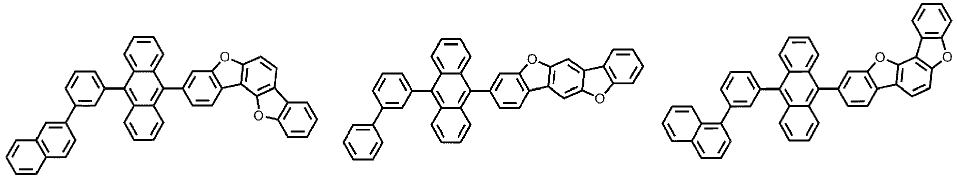

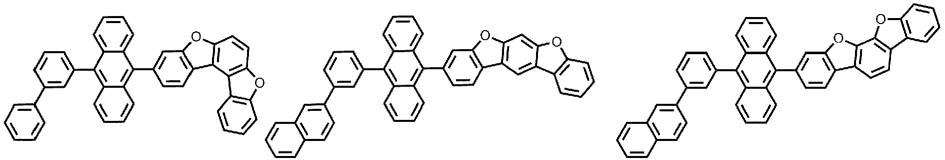

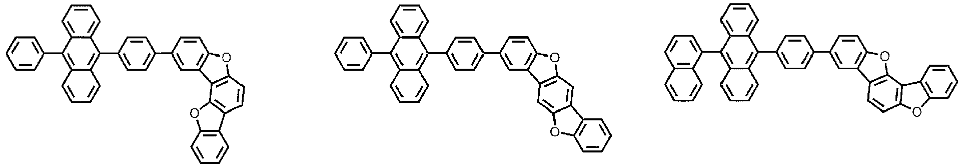

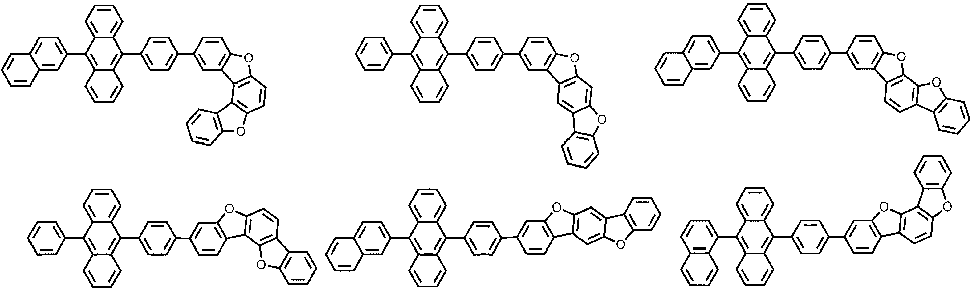

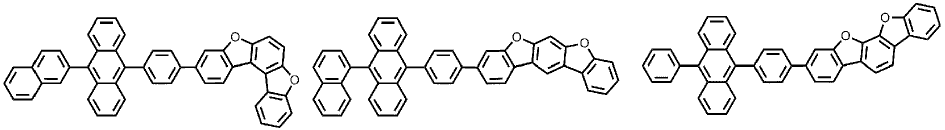

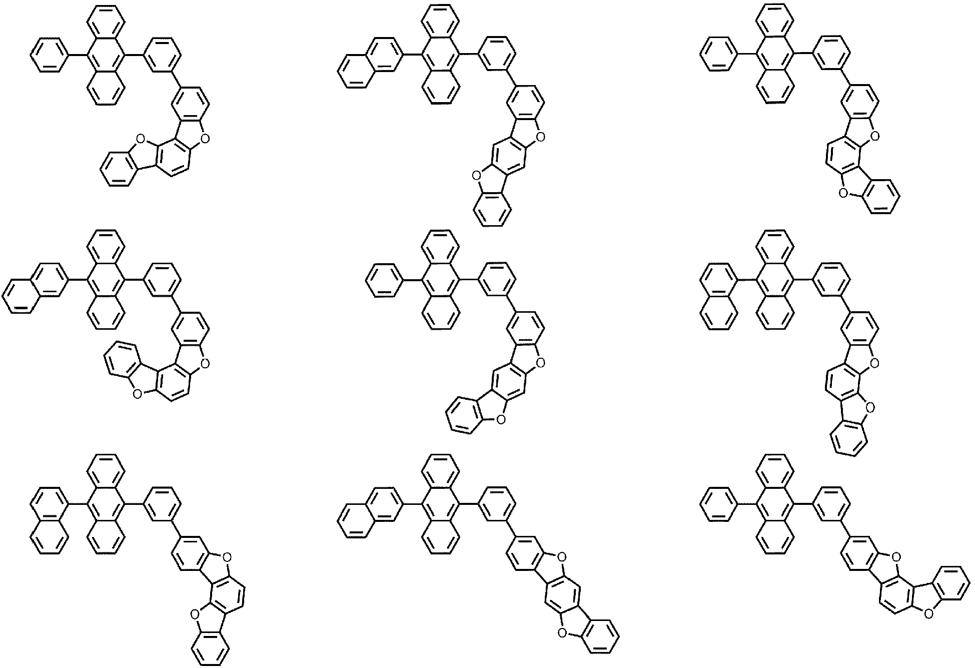

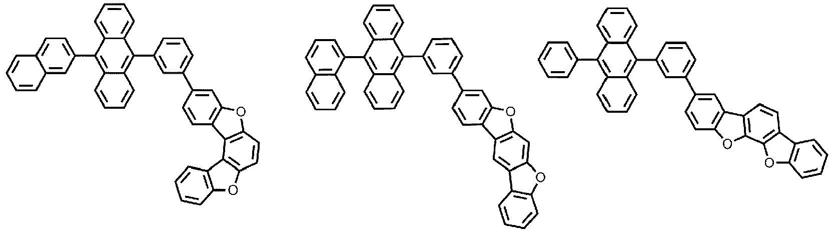

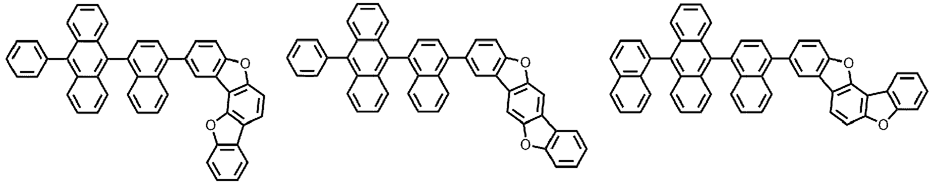

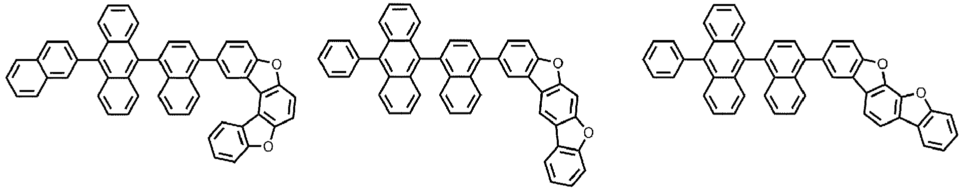

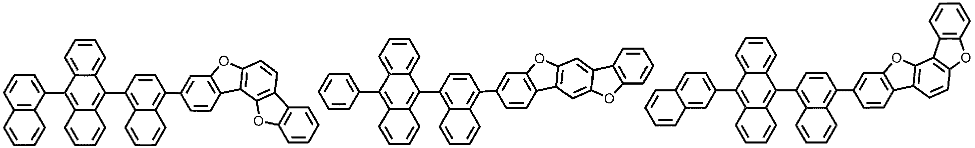

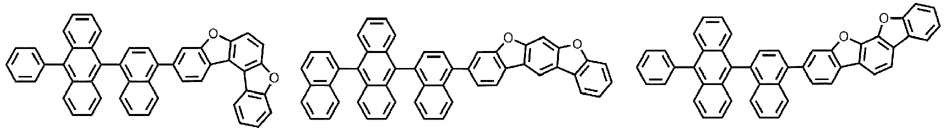

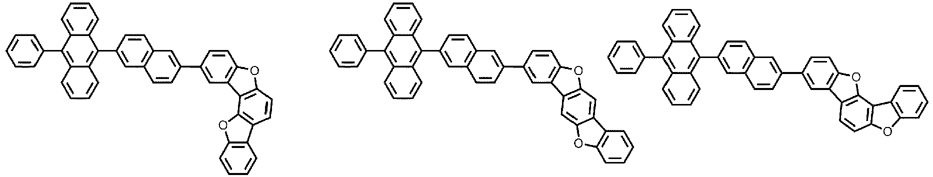

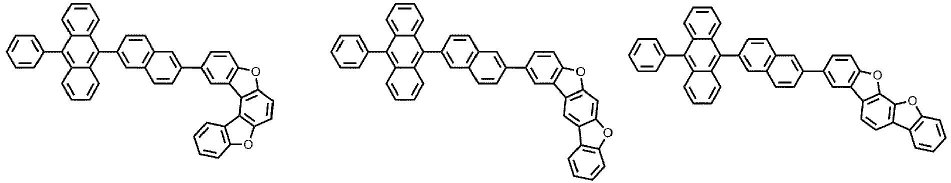

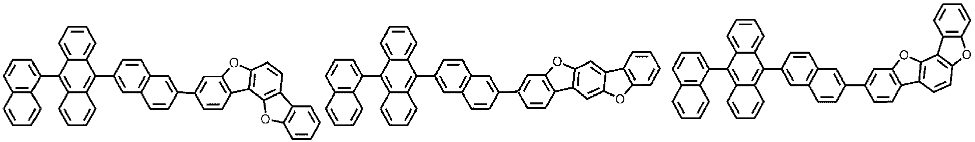

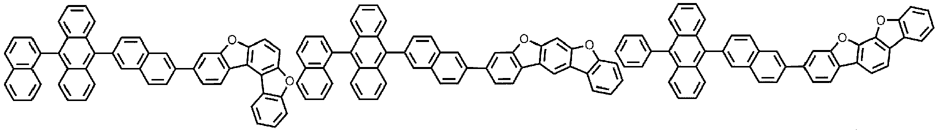

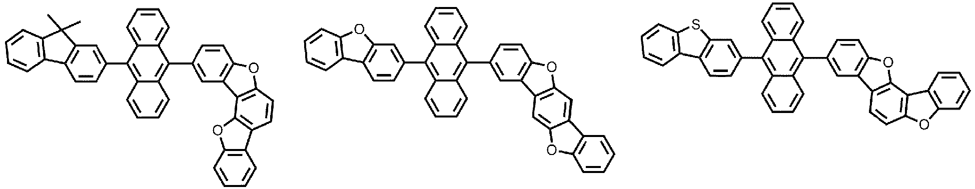

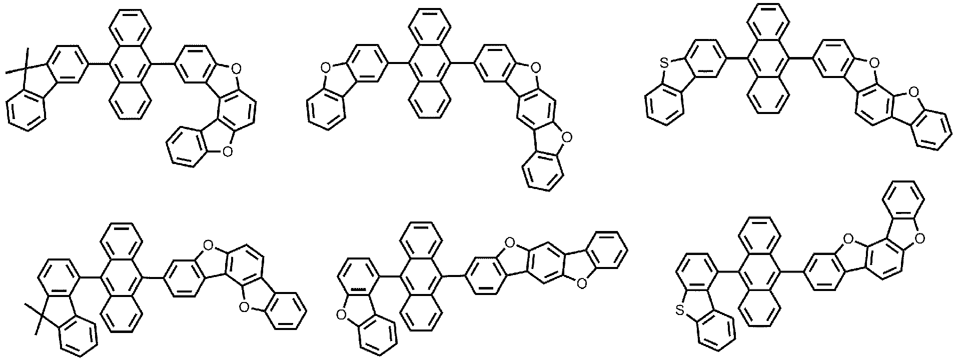

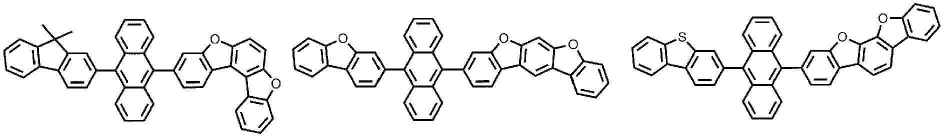

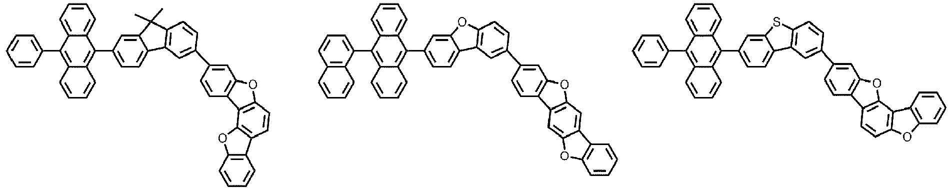

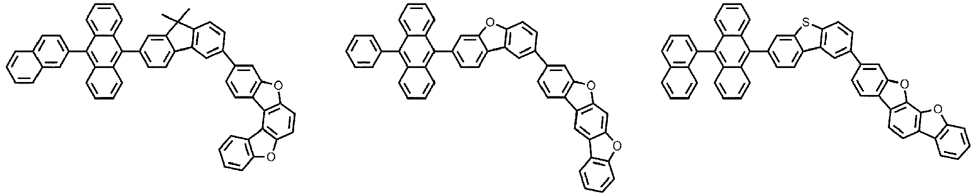

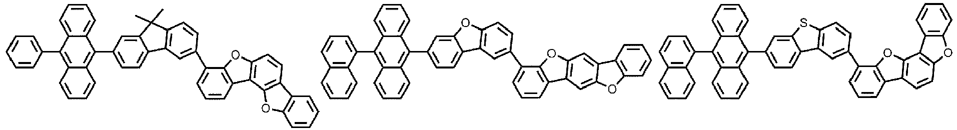

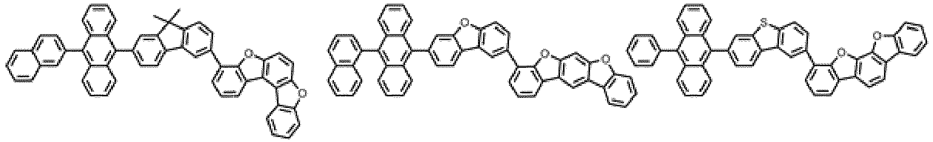

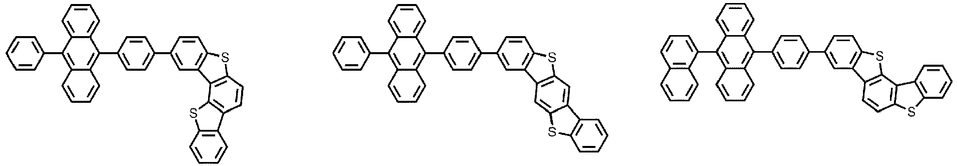

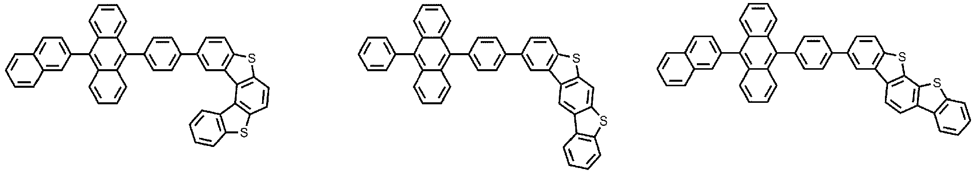

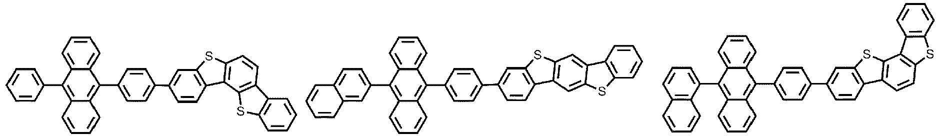

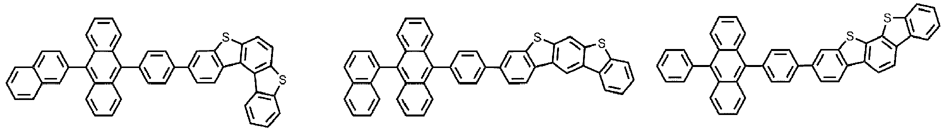

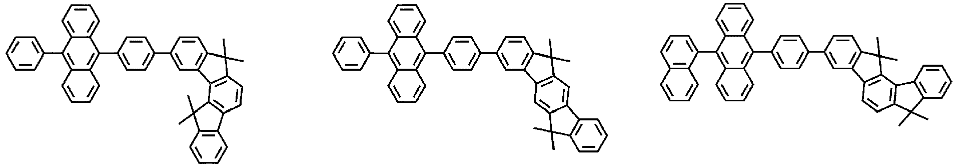

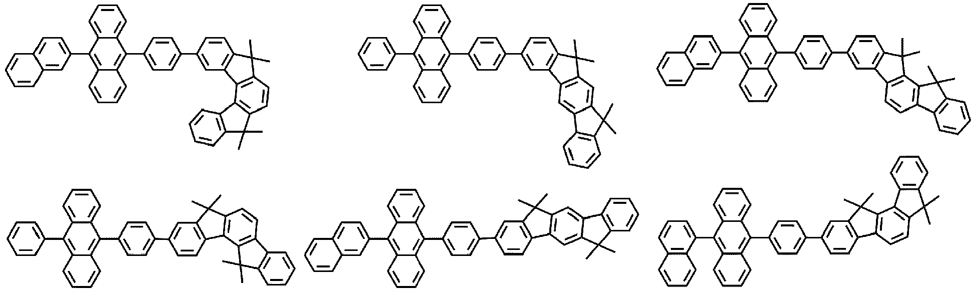

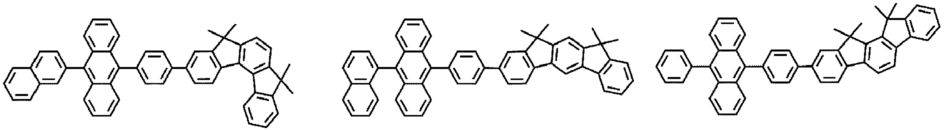

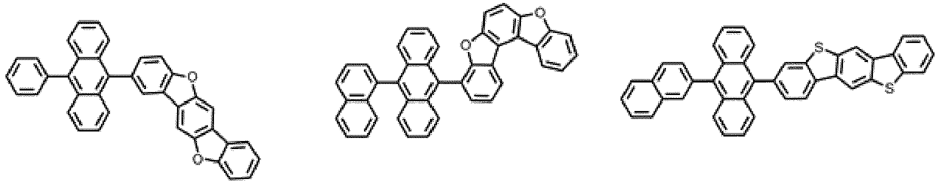

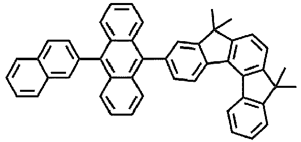

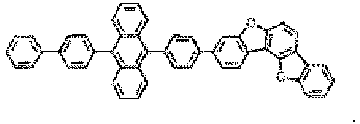

In some embodiments, the first compound may be selected from Compounds H6 to H8, but embodiments are not limited thereto:

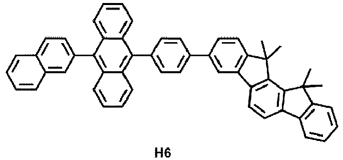

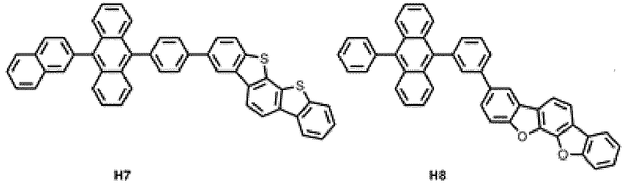

For example, the second compound may be selected from compounds illustrated below, but embodiments are not limited thereto:

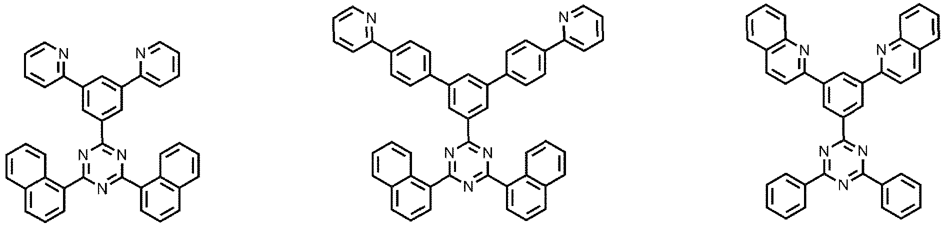

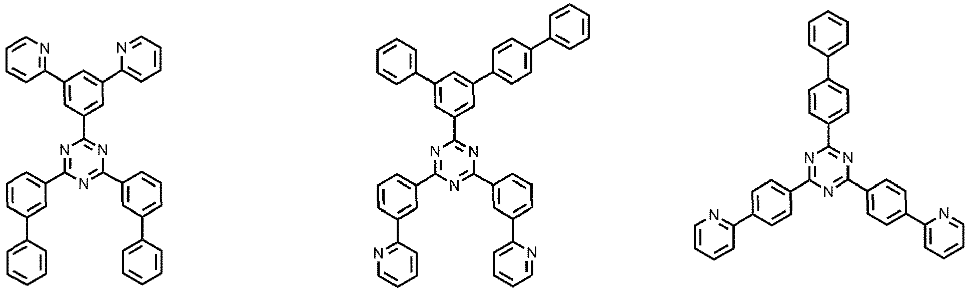

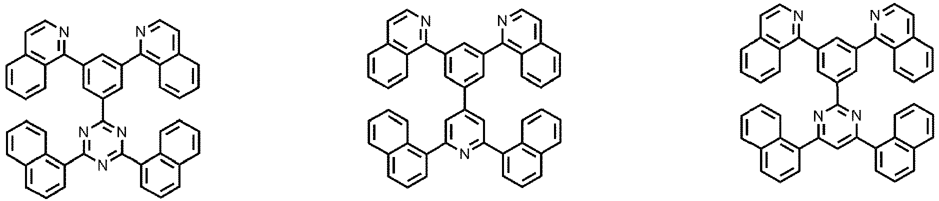

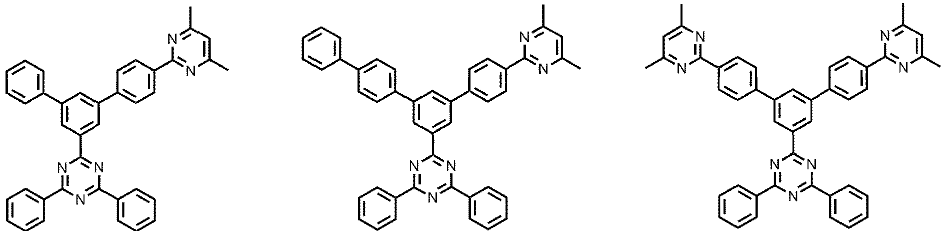

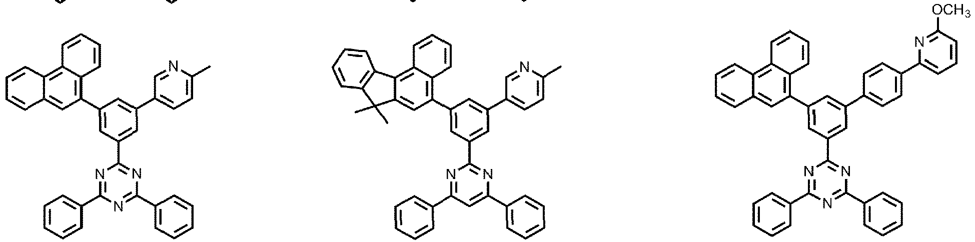

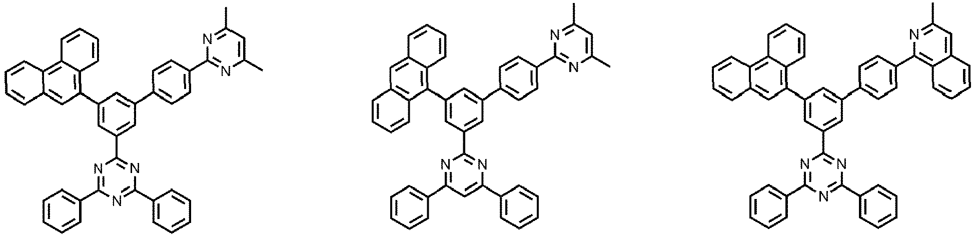

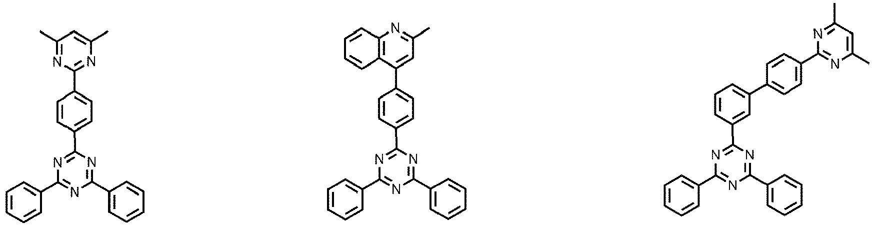

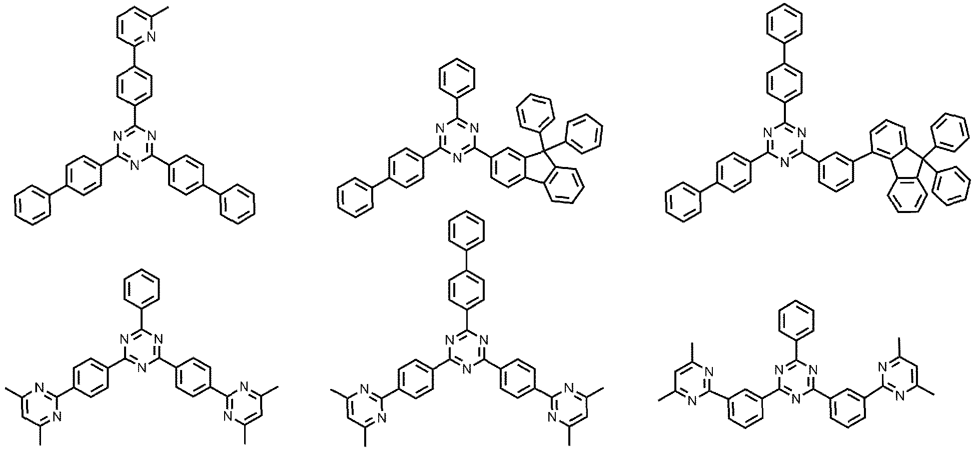

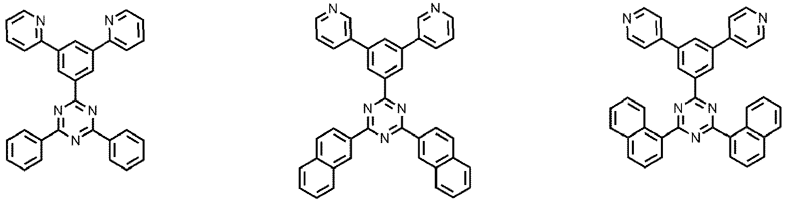

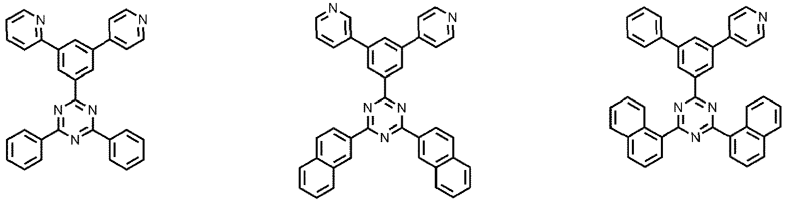

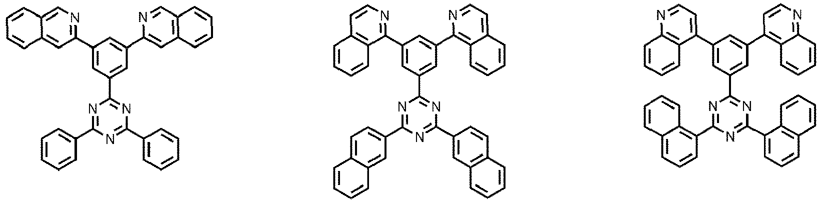

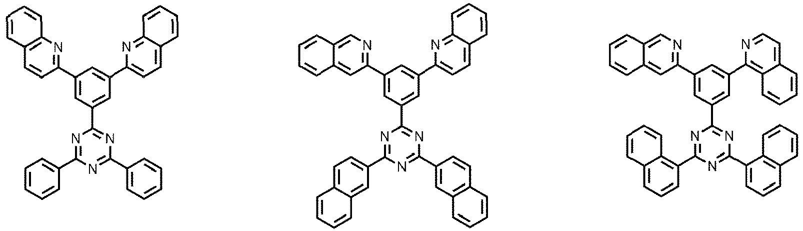

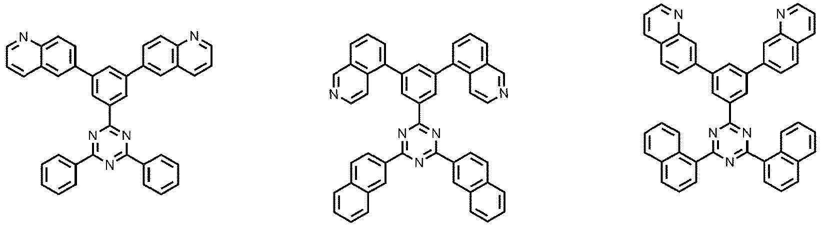

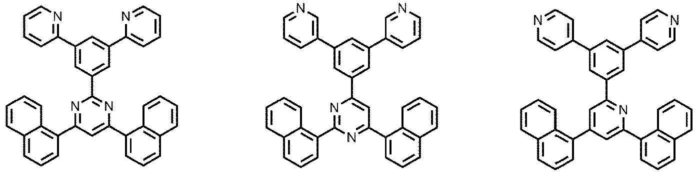

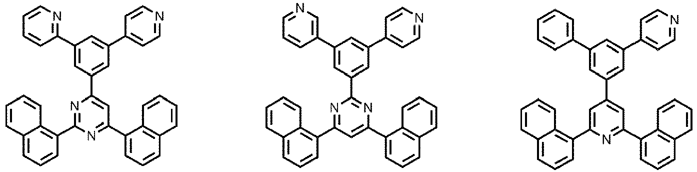

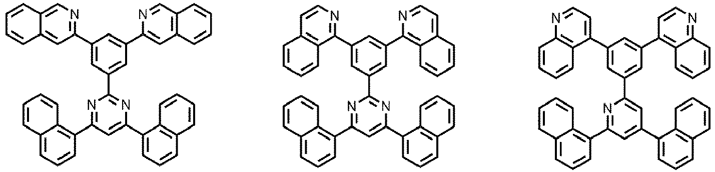

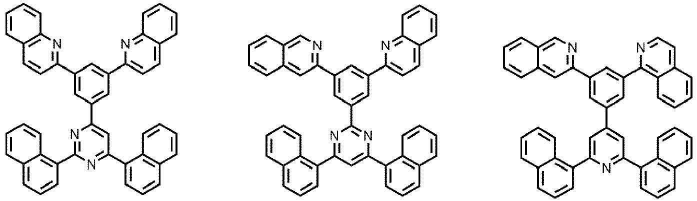

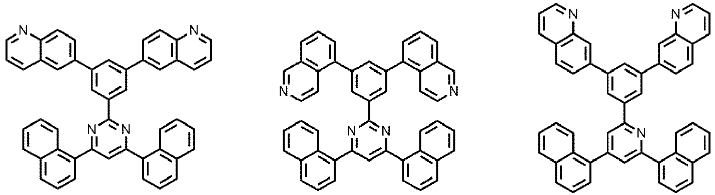

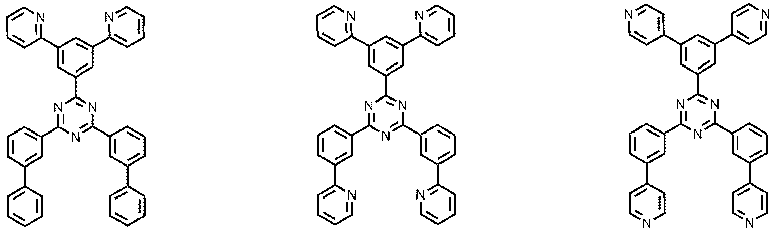

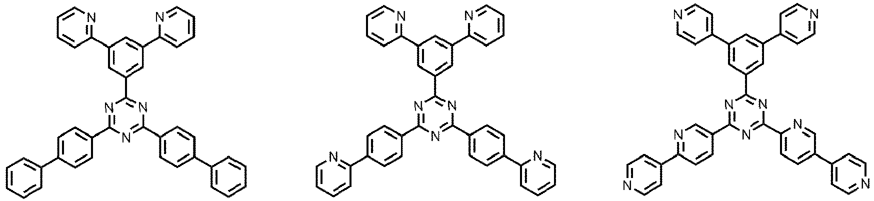

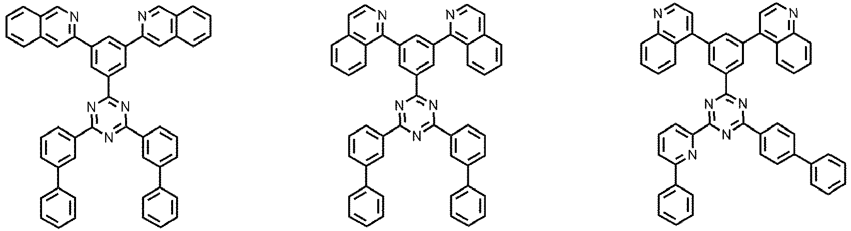

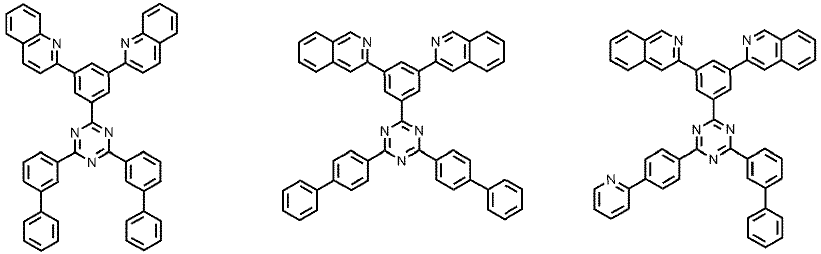

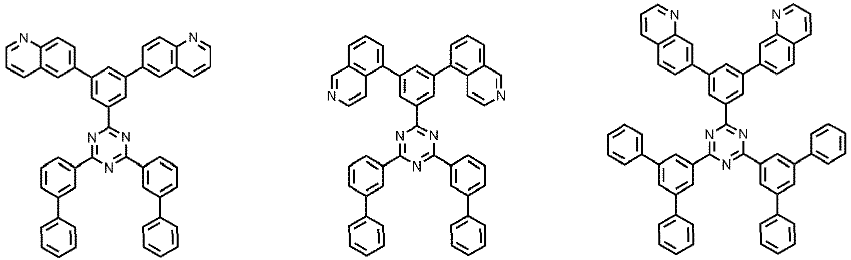

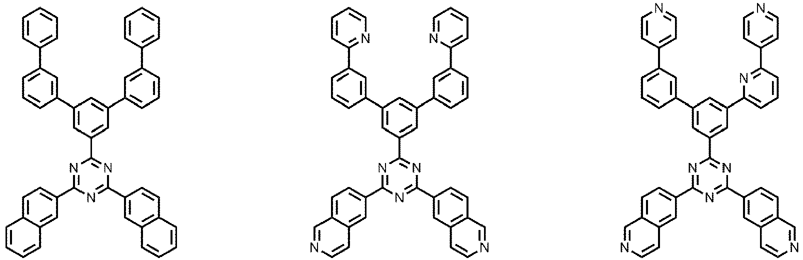

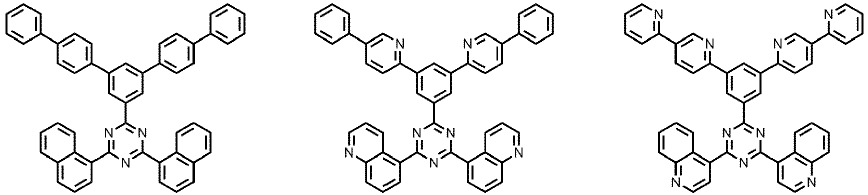

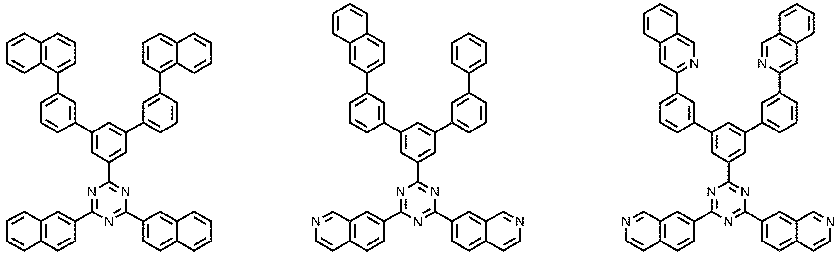

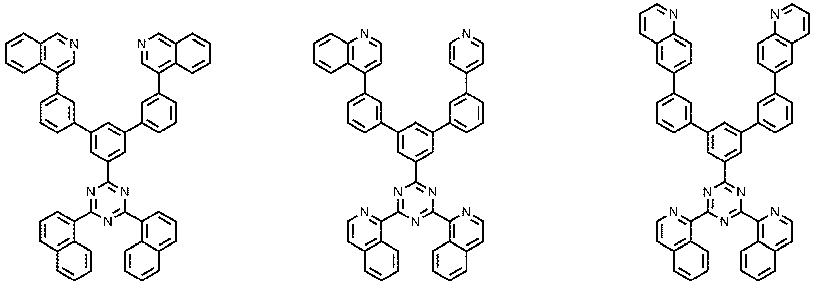

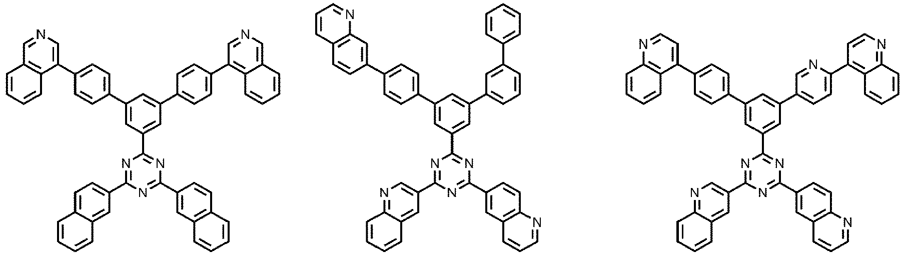

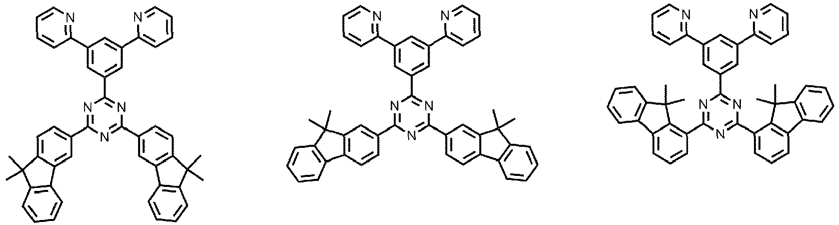

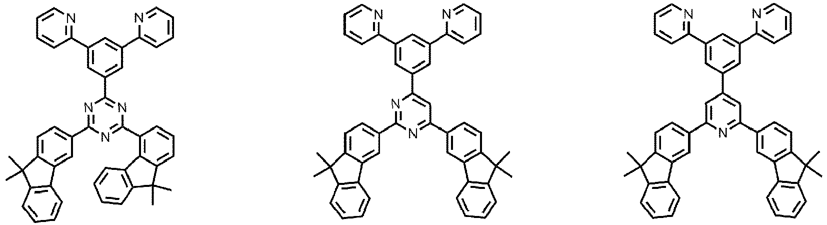

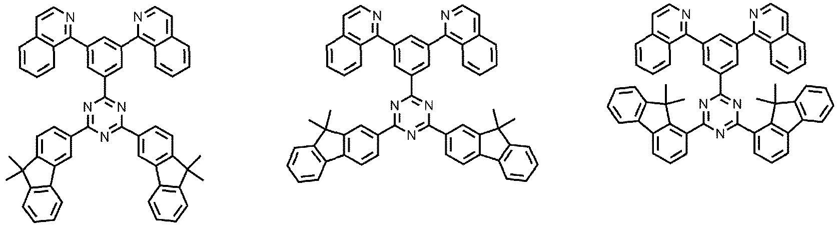

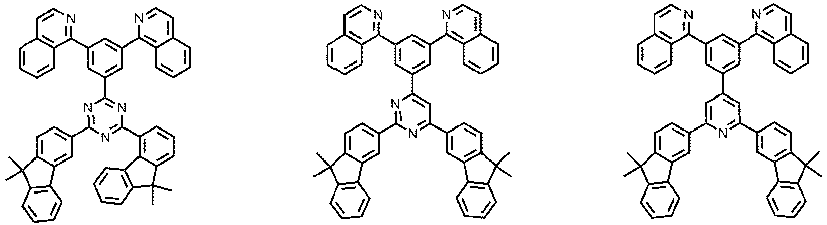

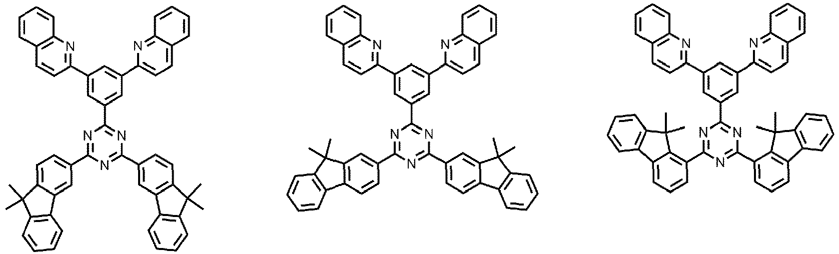

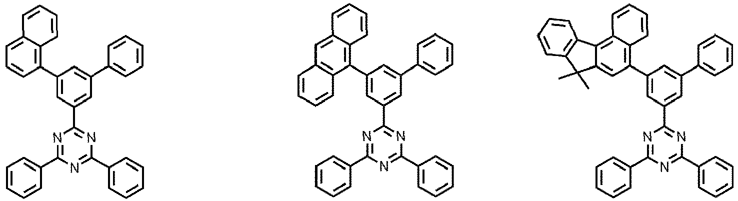

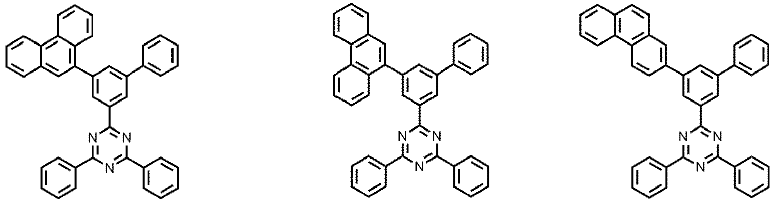

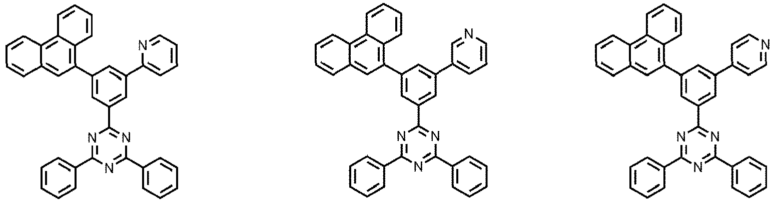

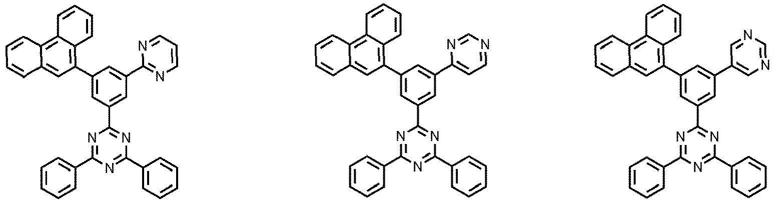

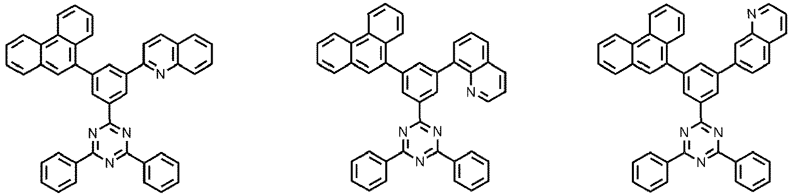

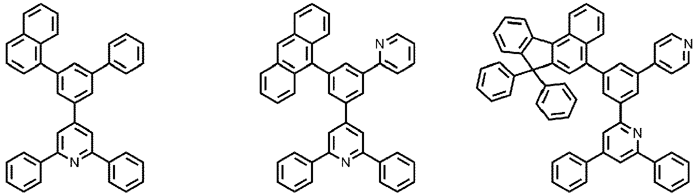

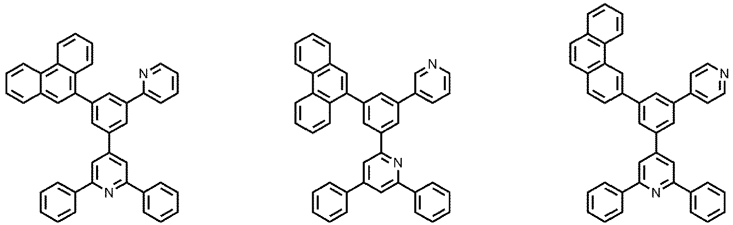

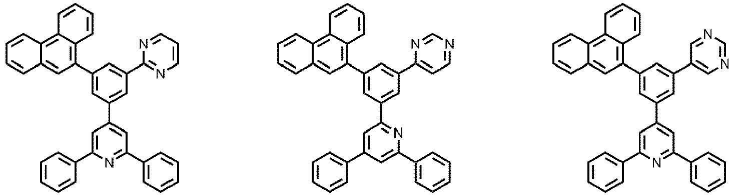

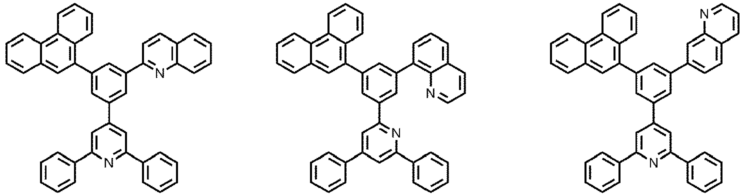

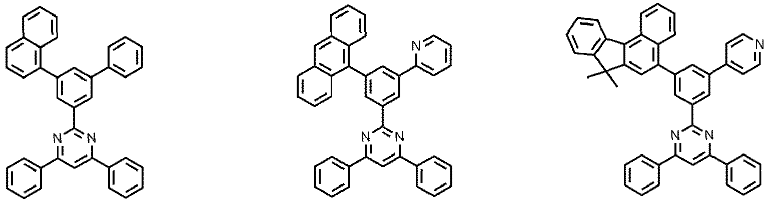

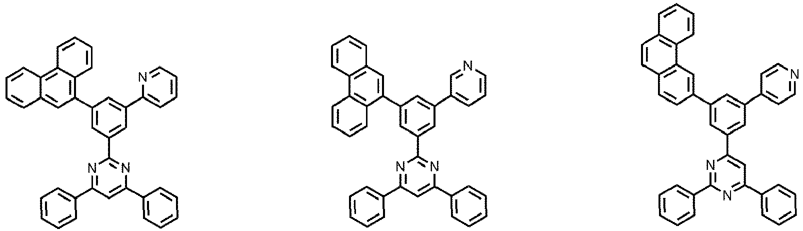

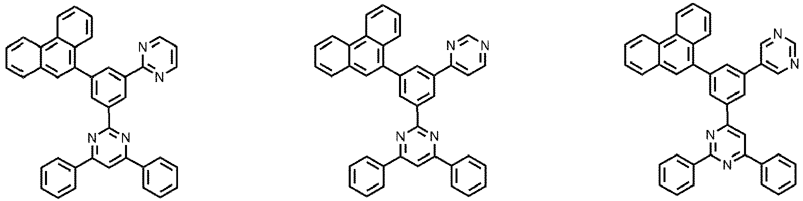

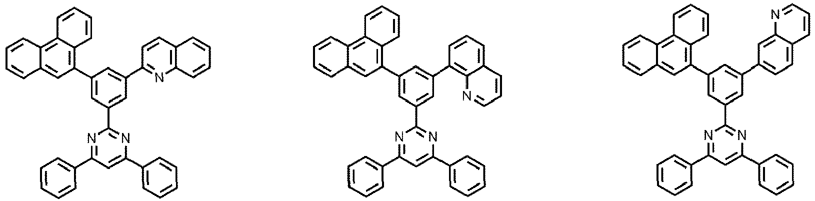

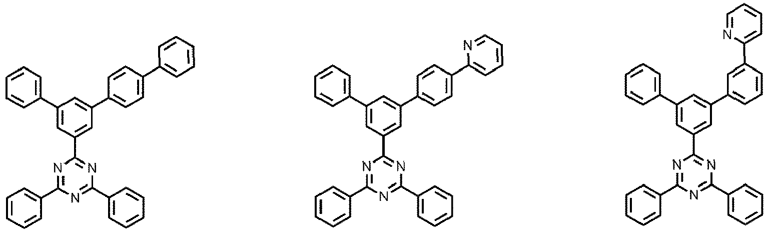

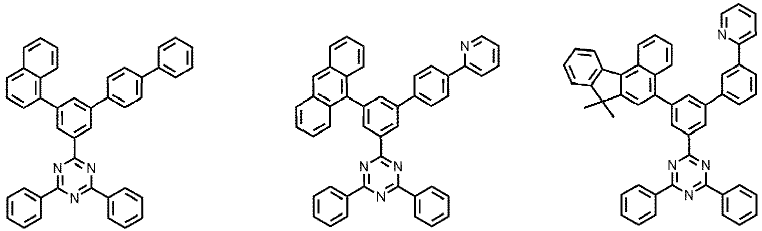

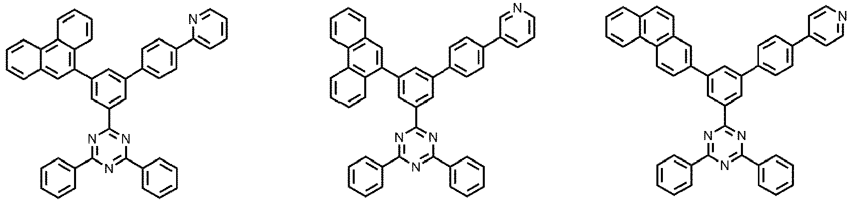

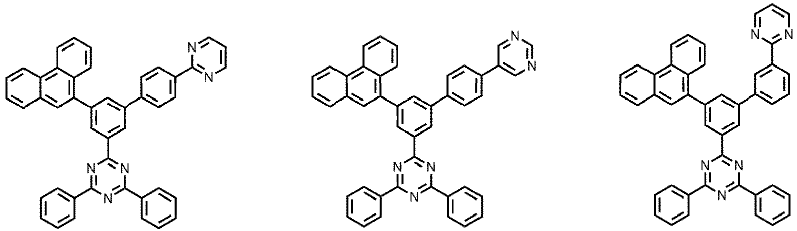

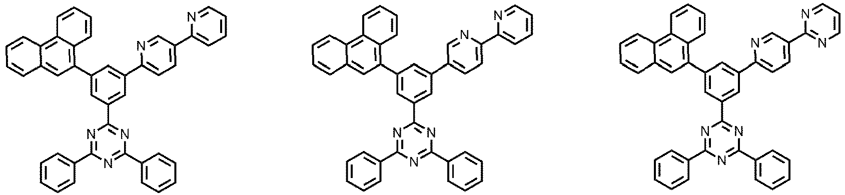

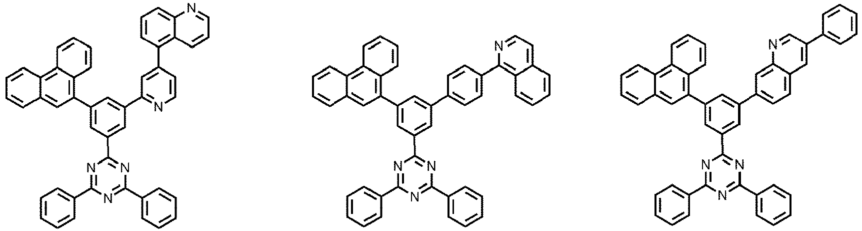

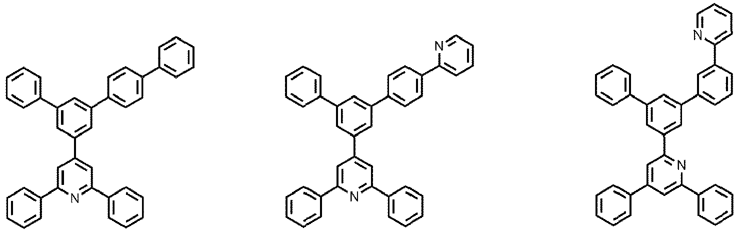

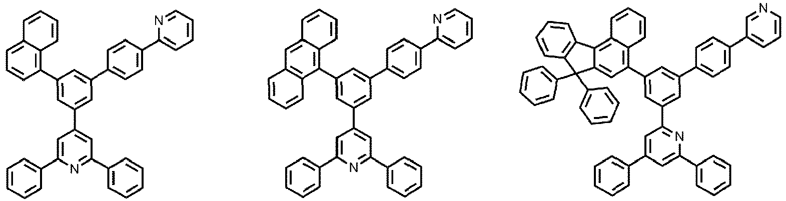

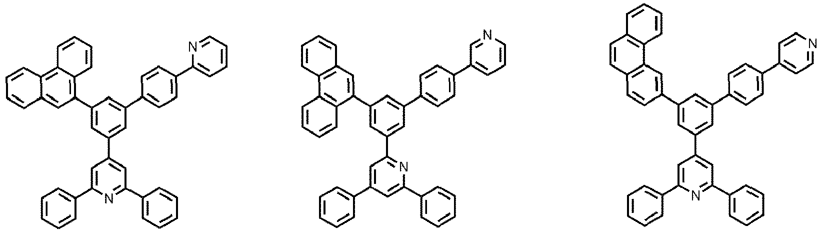

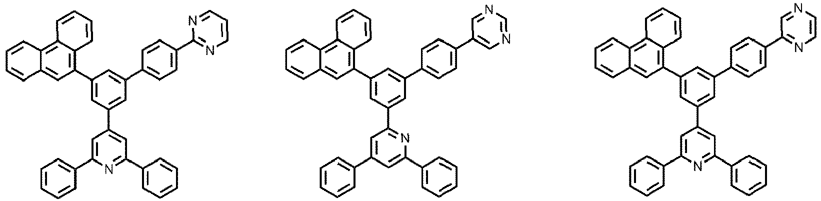

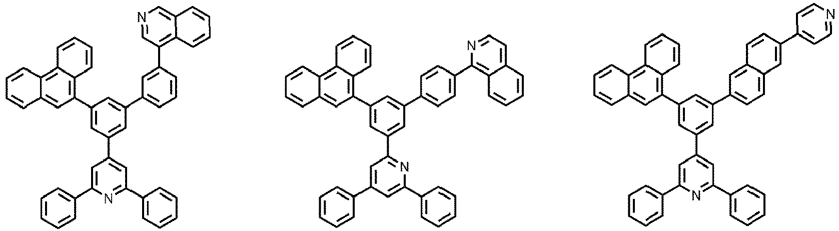

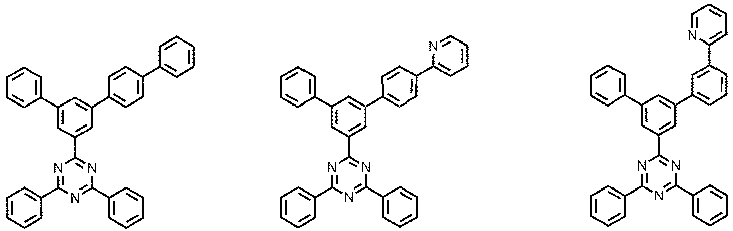

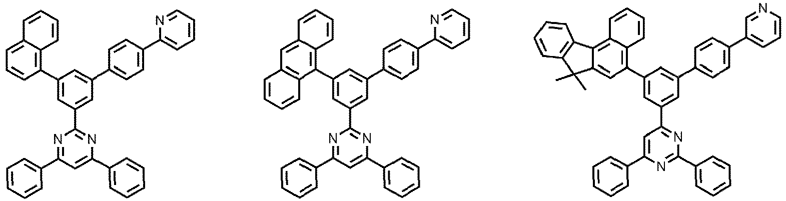

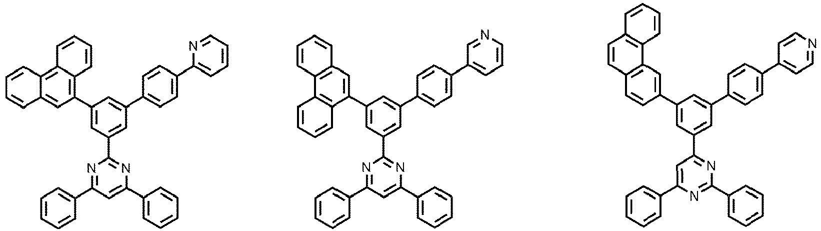

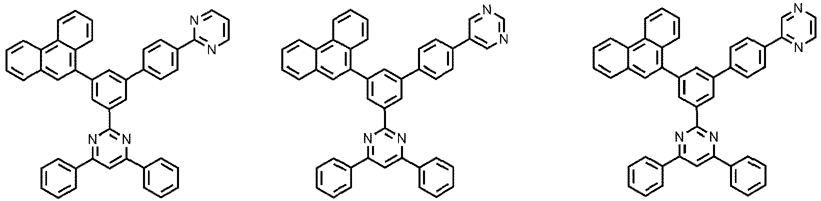

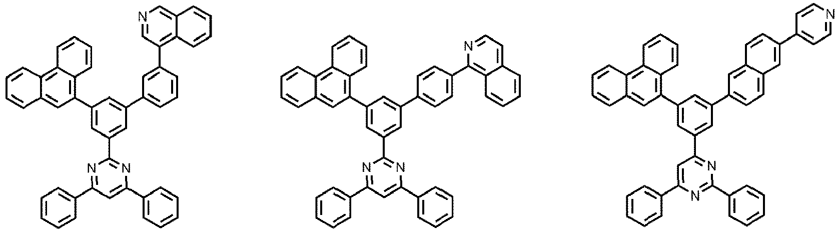

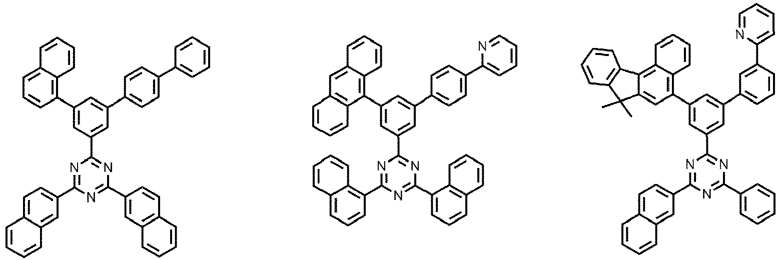

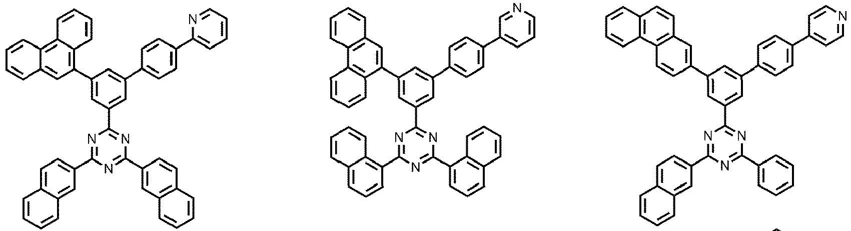

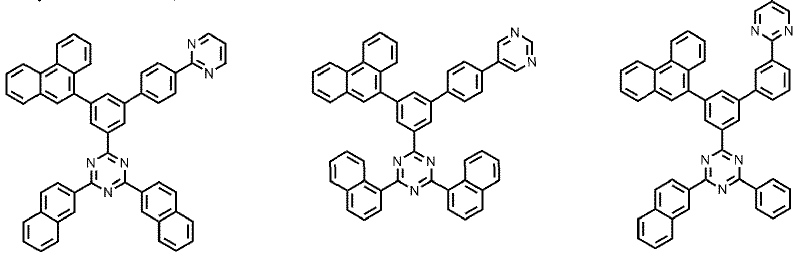

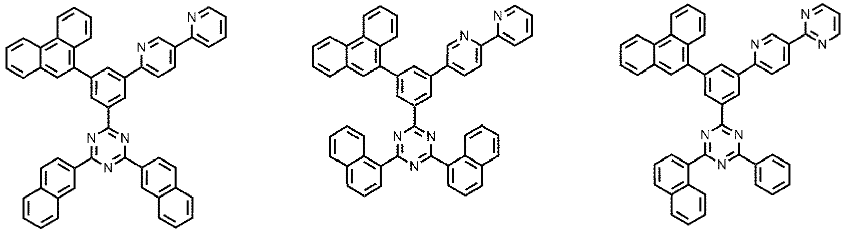

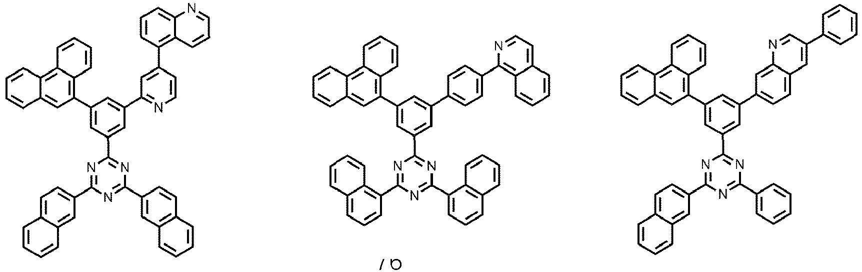

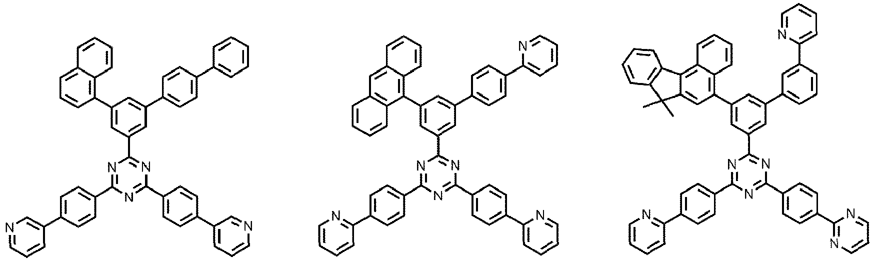

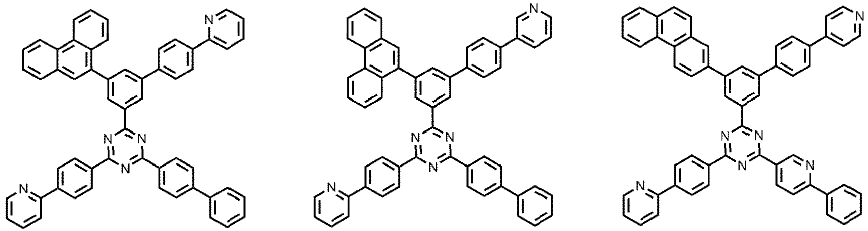

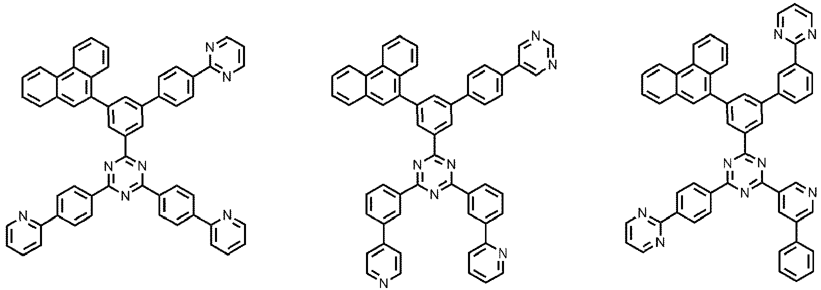

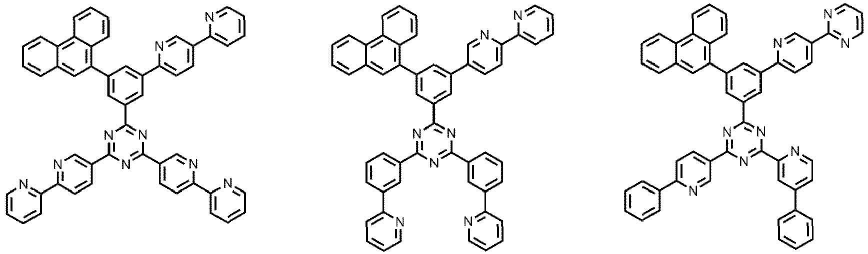

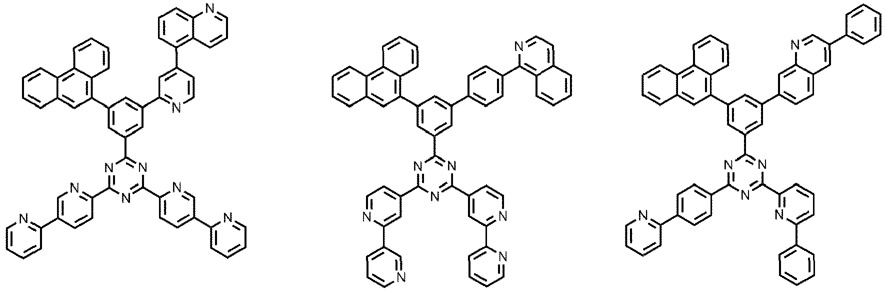

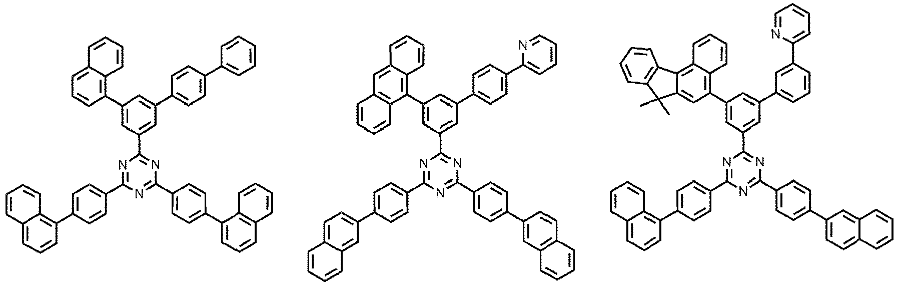

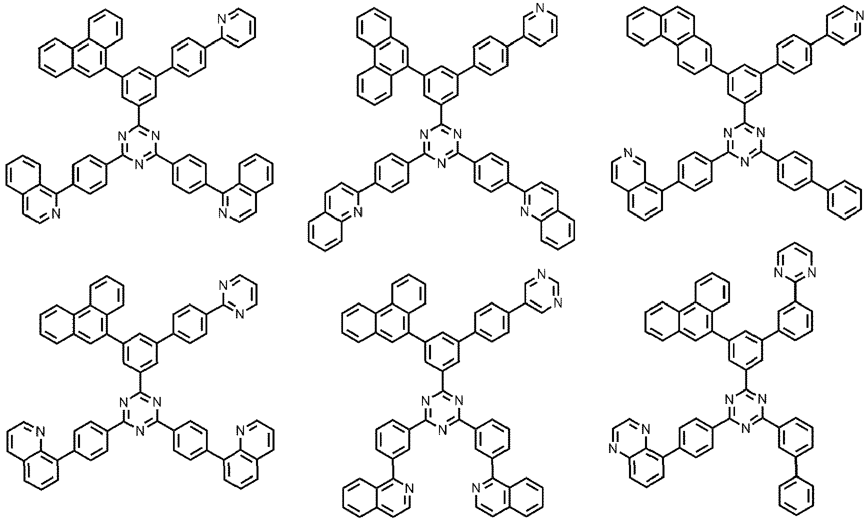

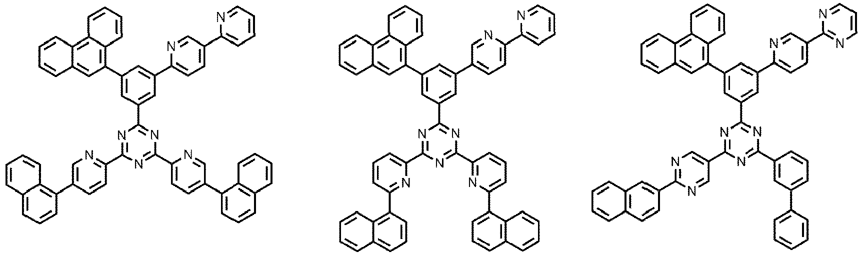

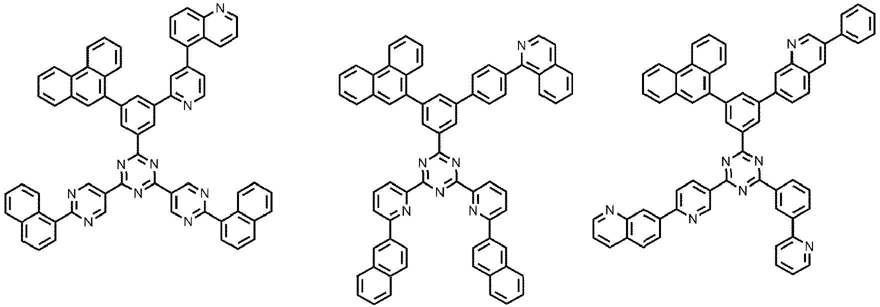

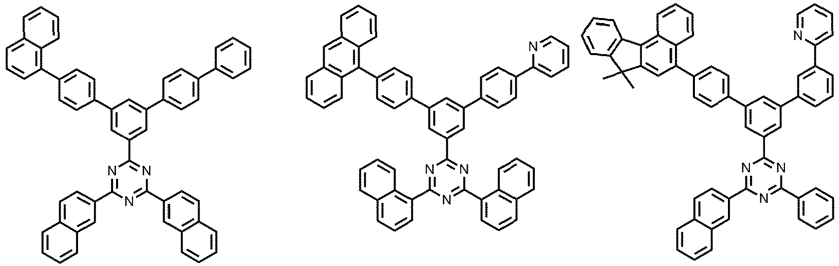

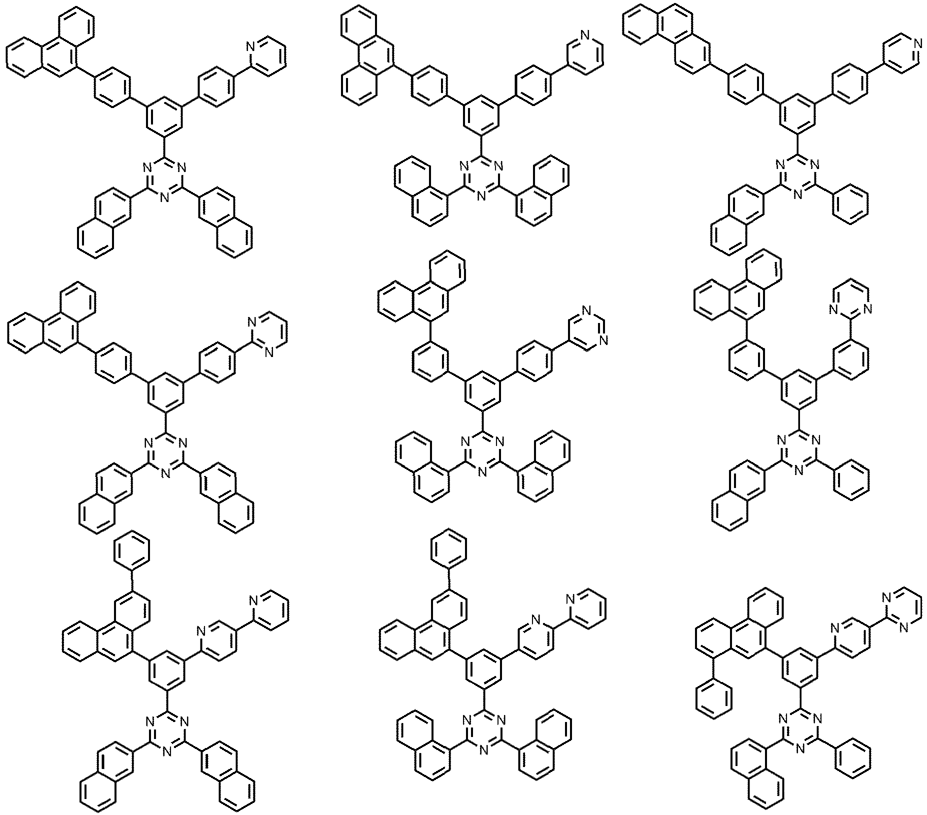

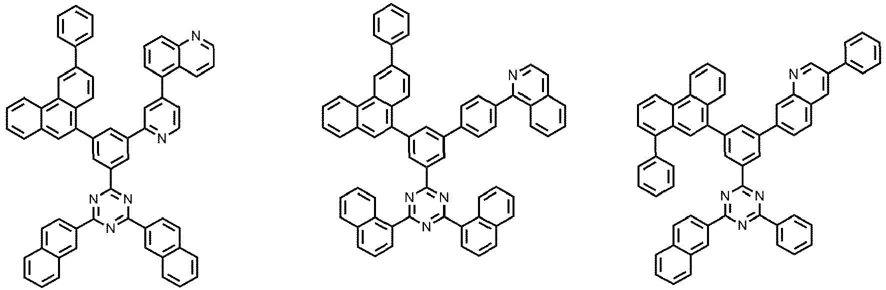

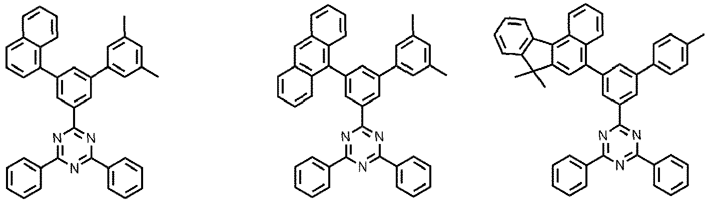

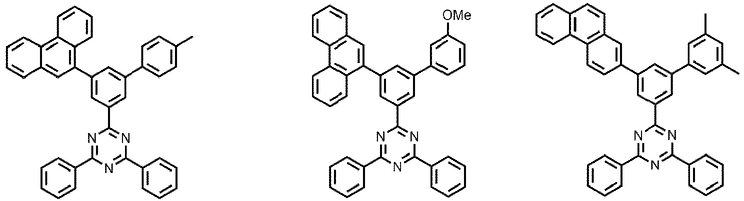

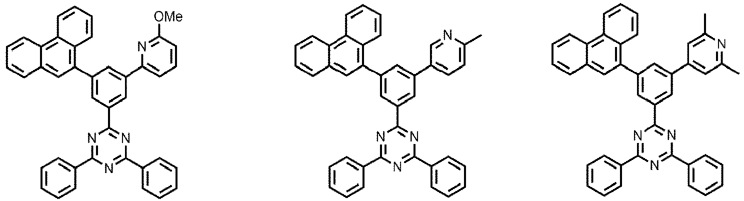

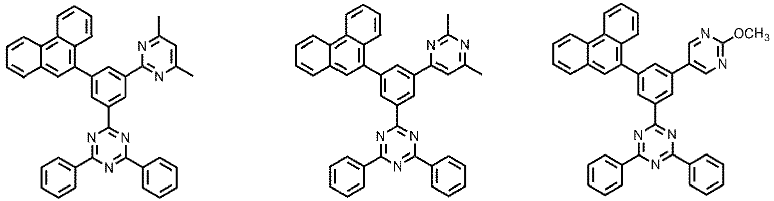

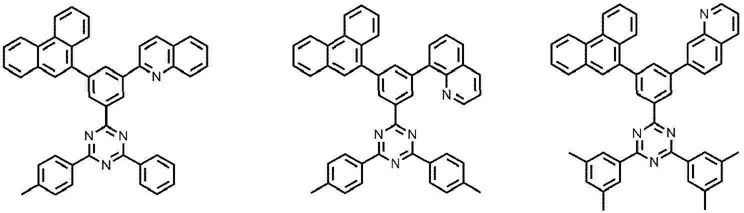

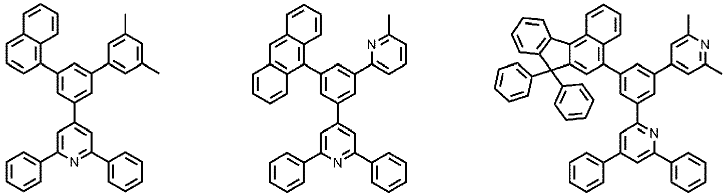

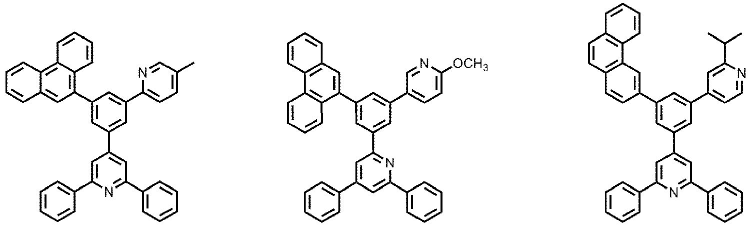

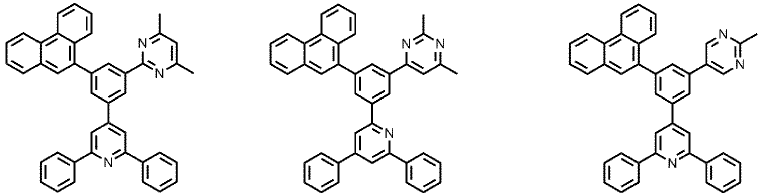

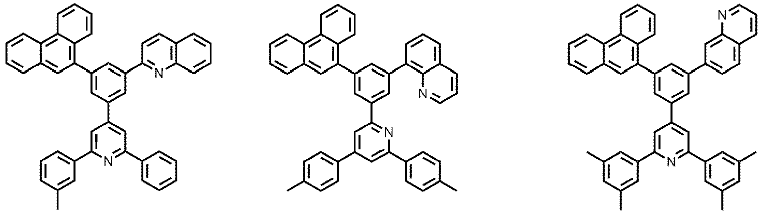

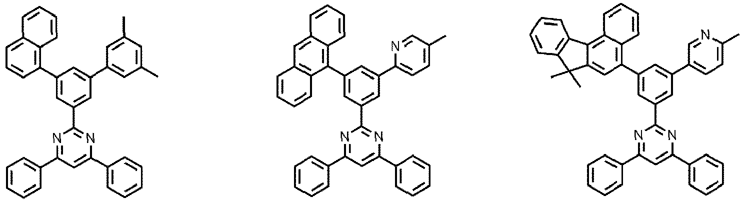

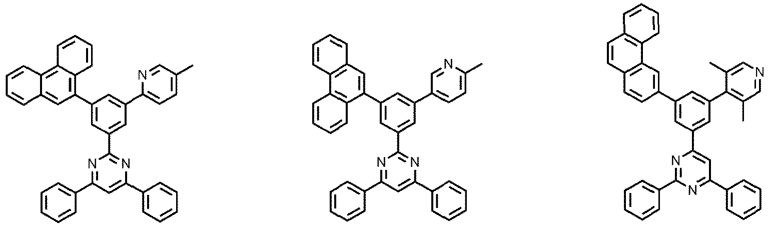

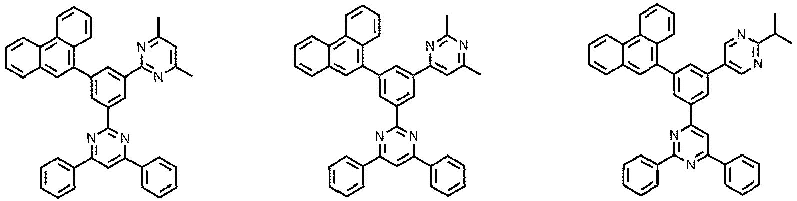

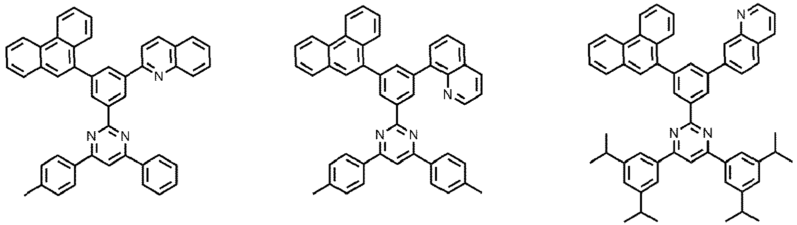

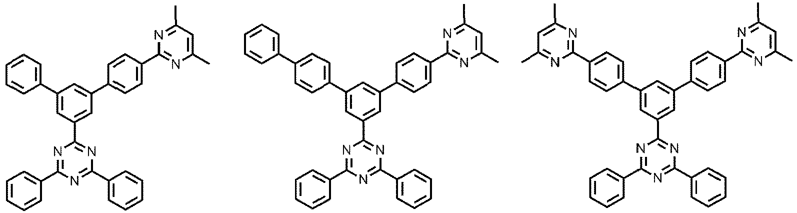

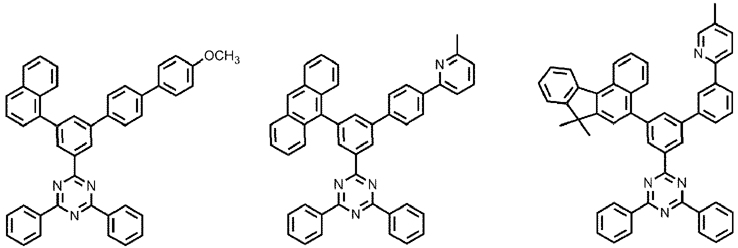

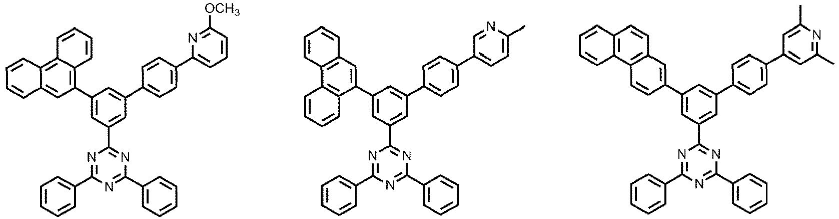

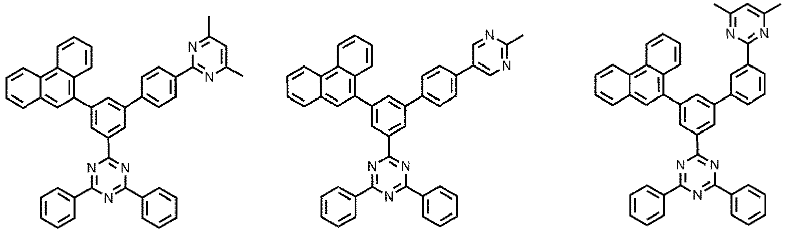

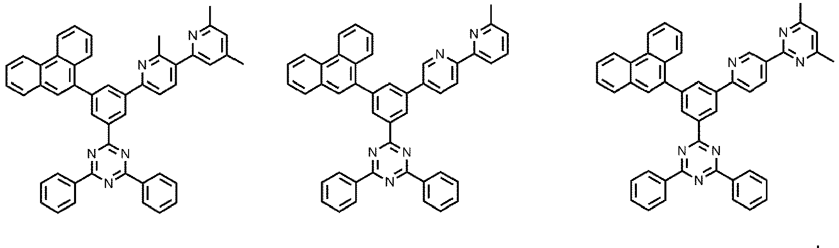

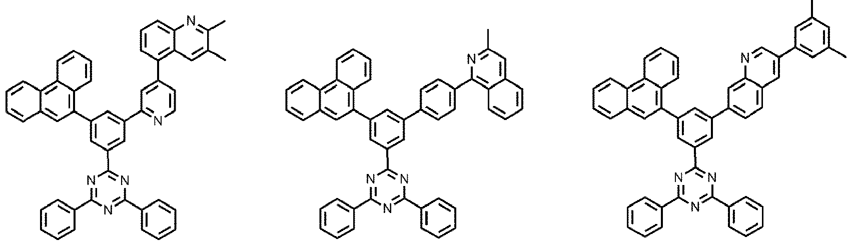

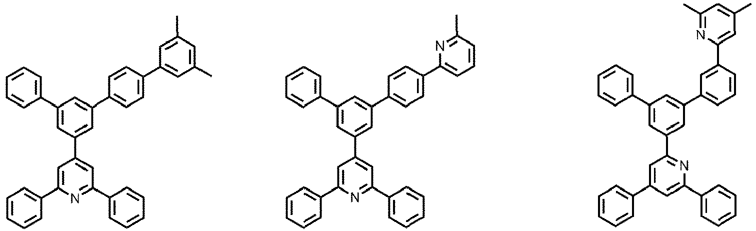

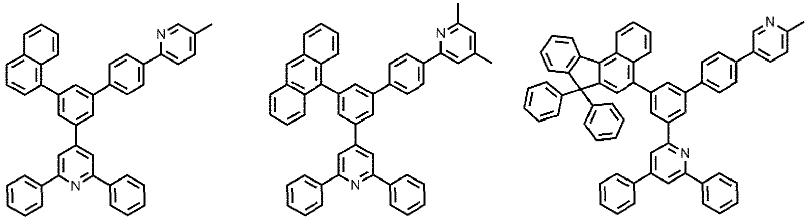

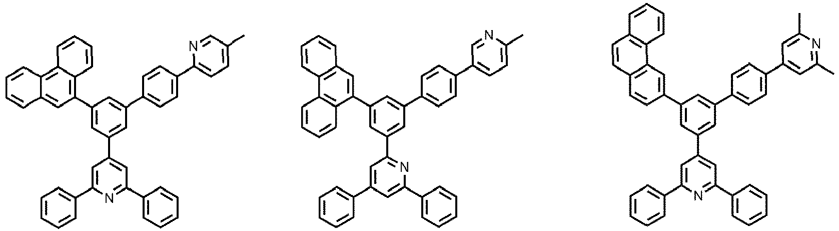

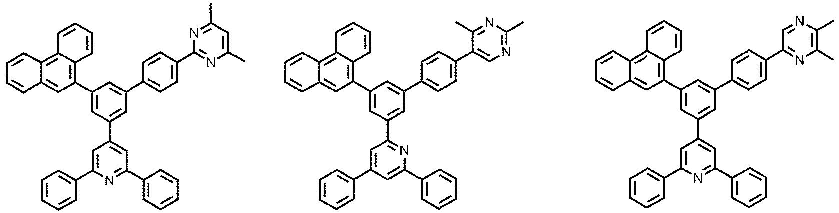

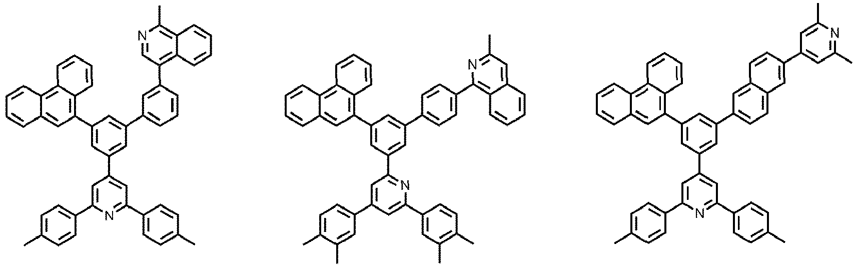

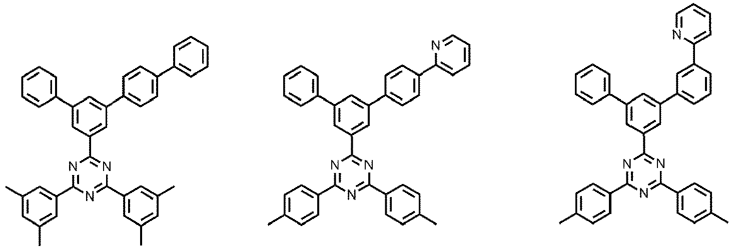

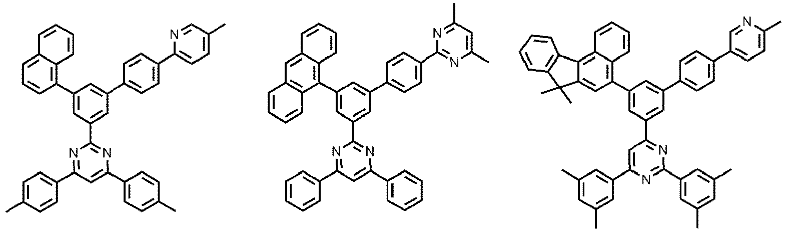

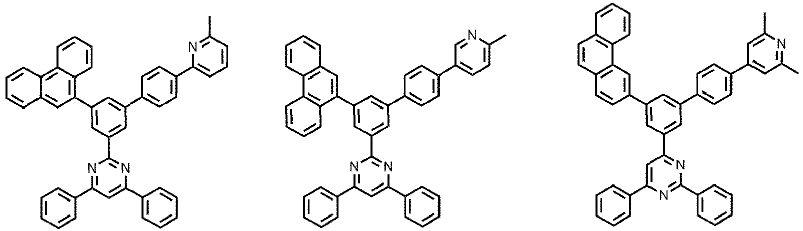

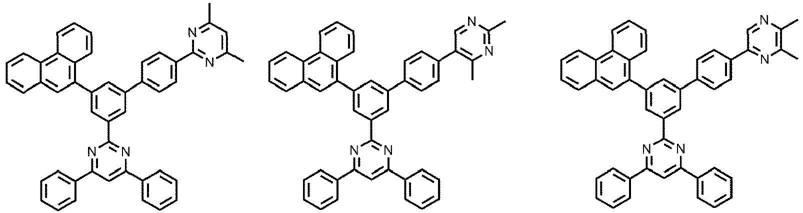

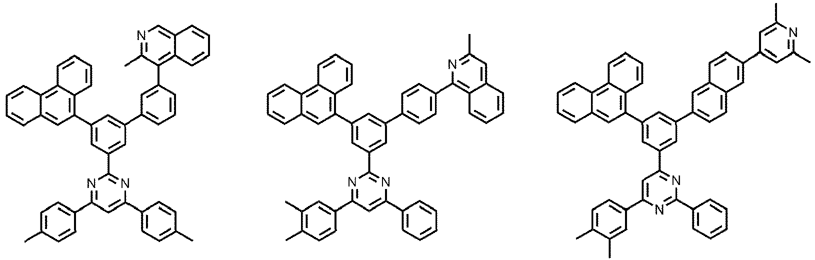

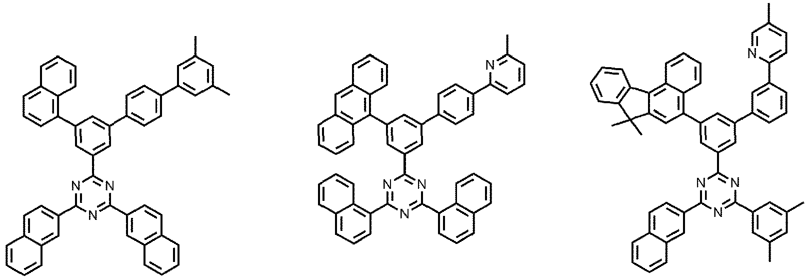

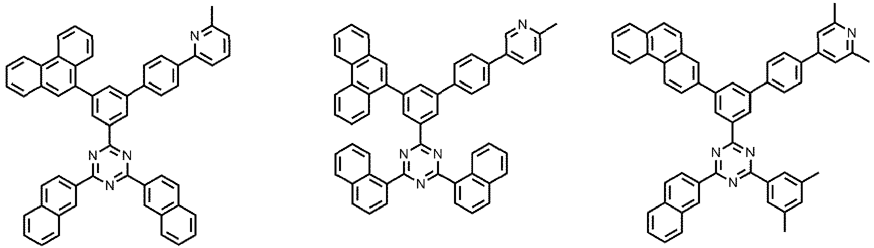

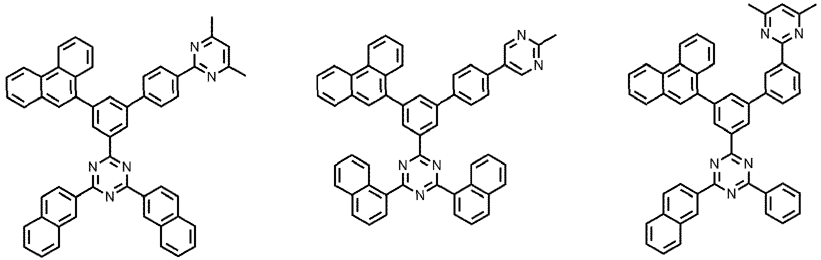

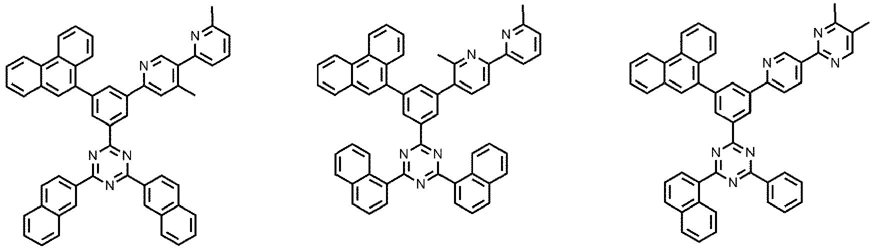

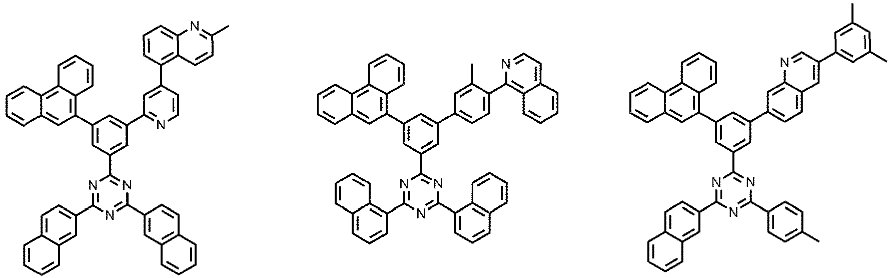

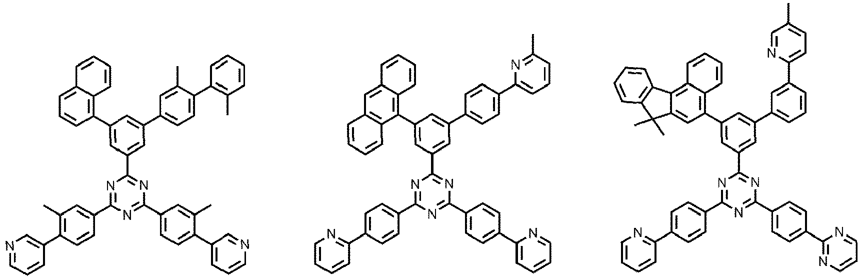

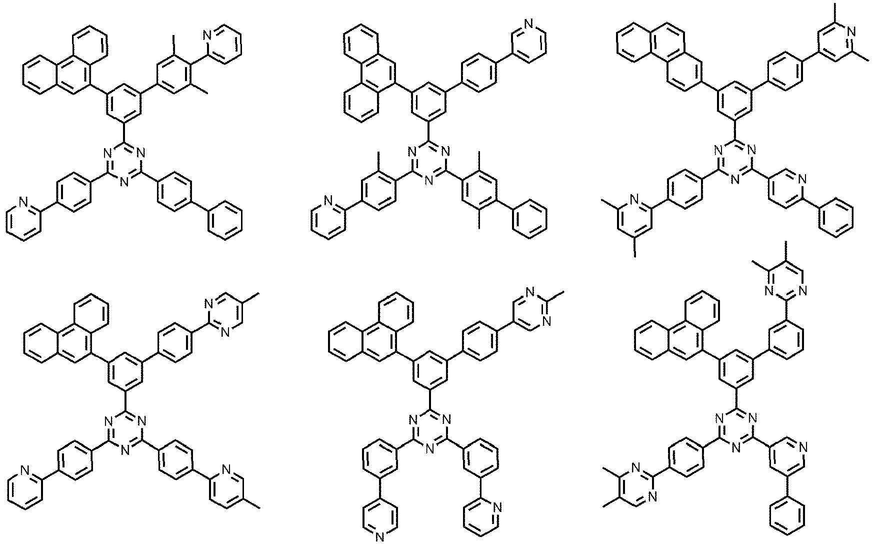

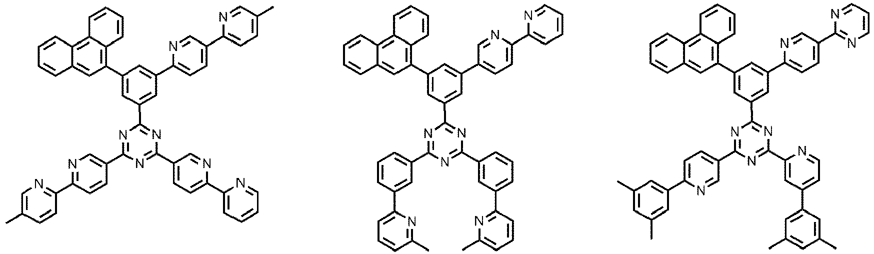

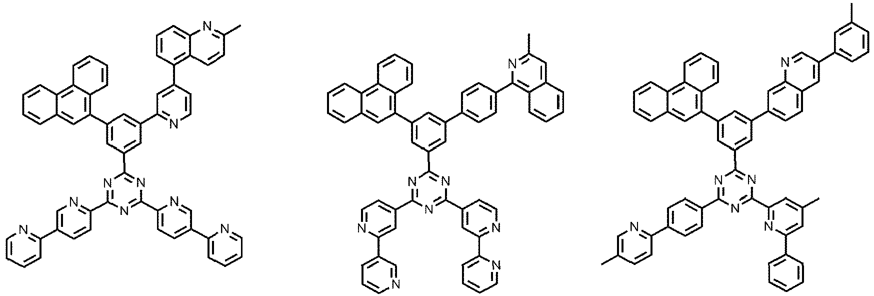

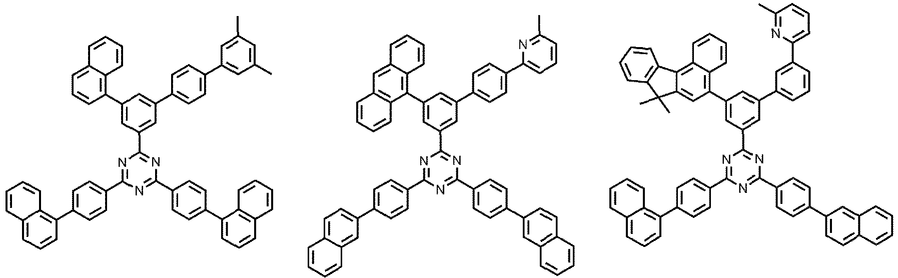

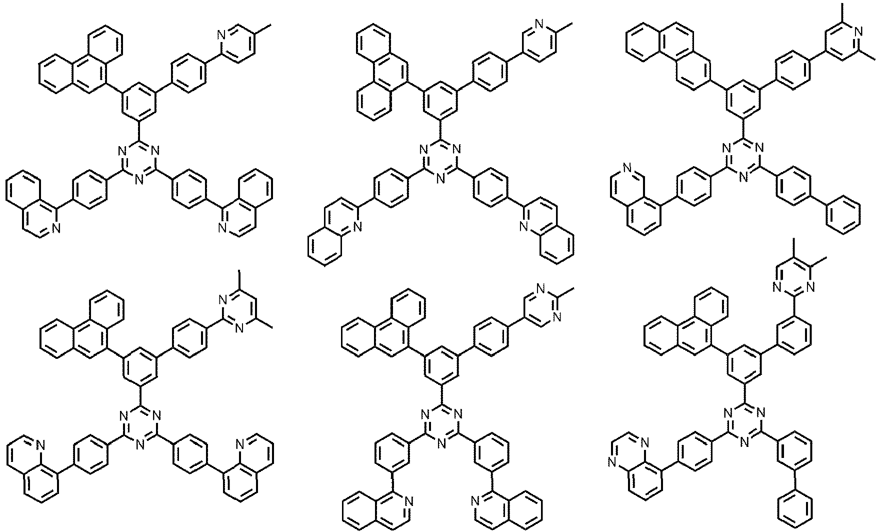

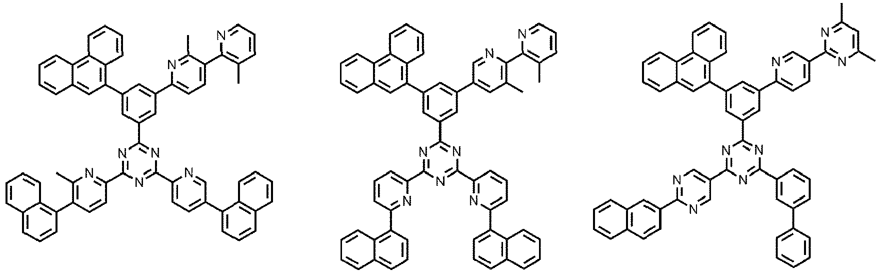

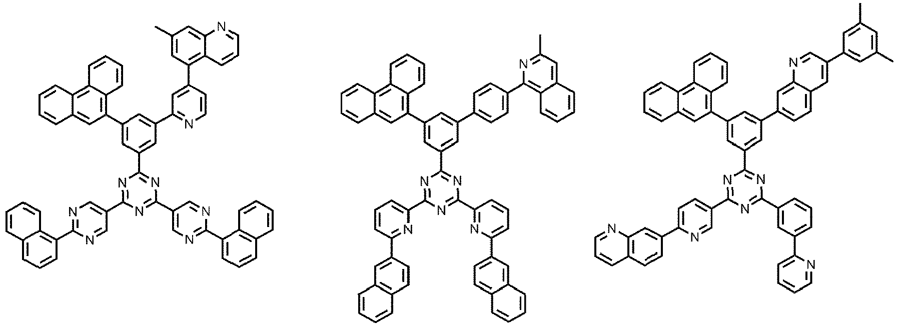

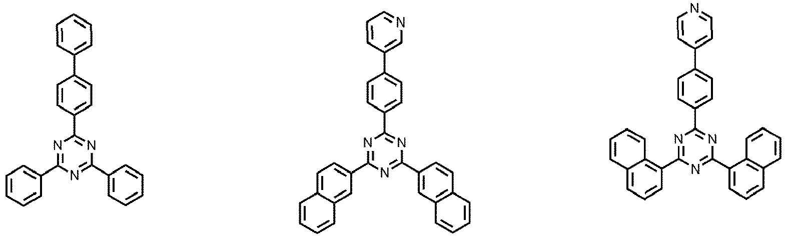

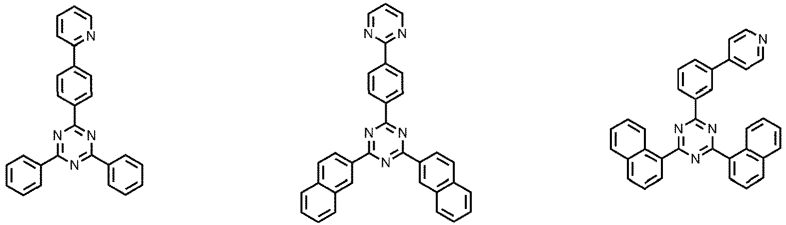

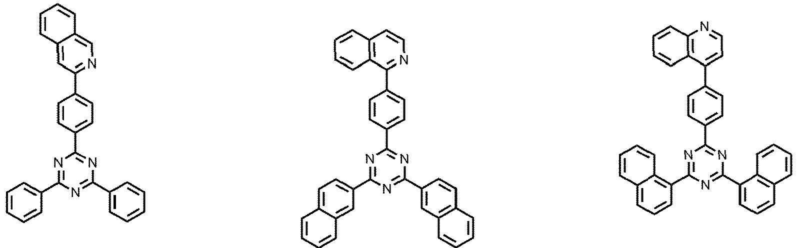

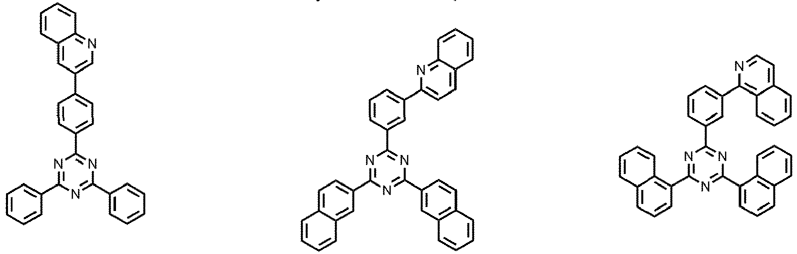

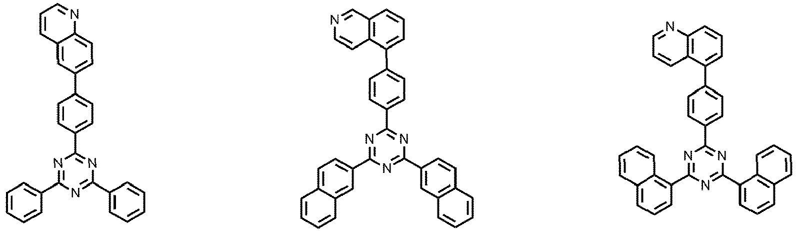

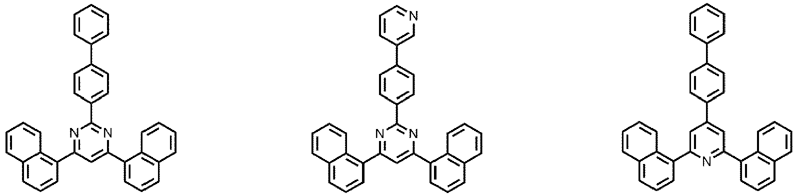

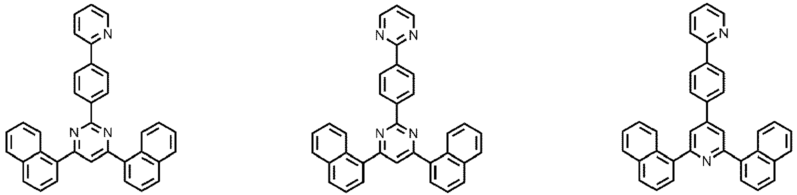

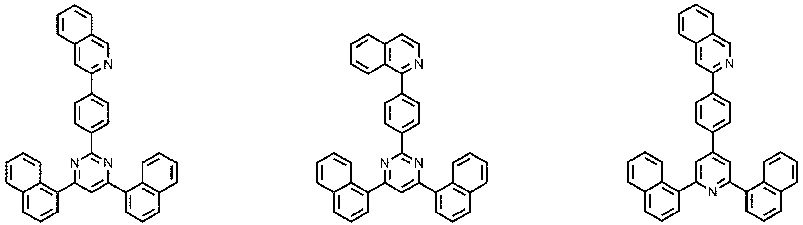

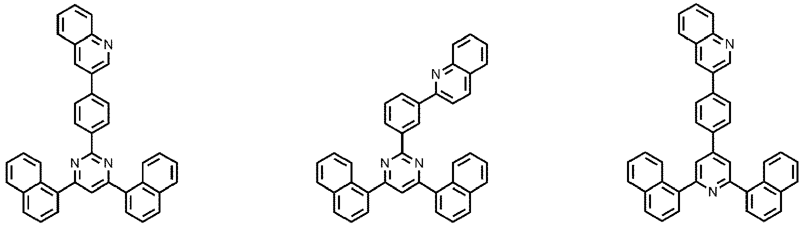

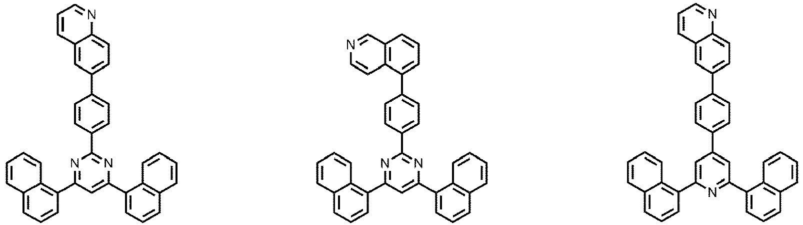

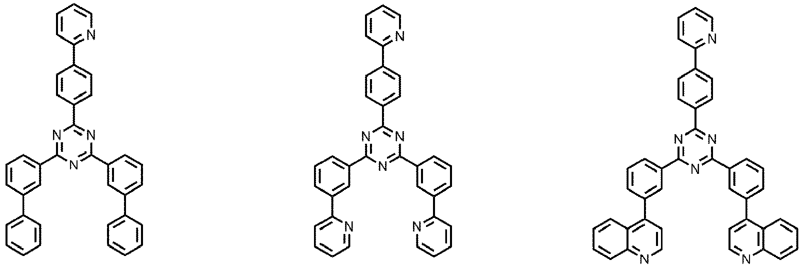

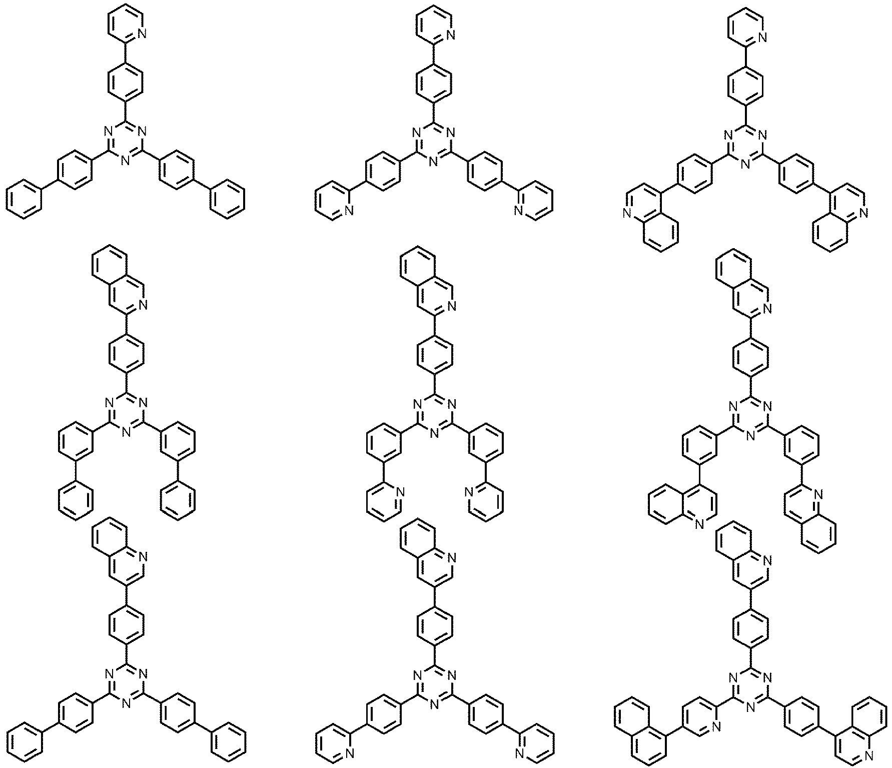

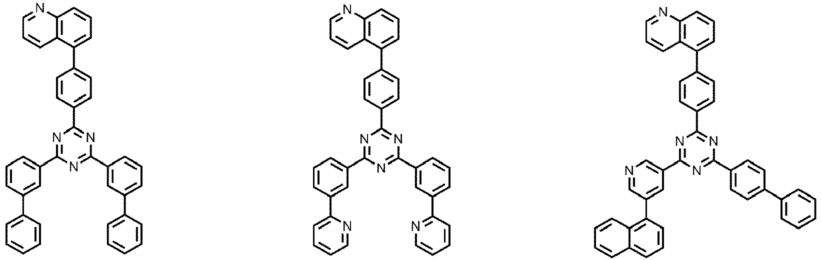

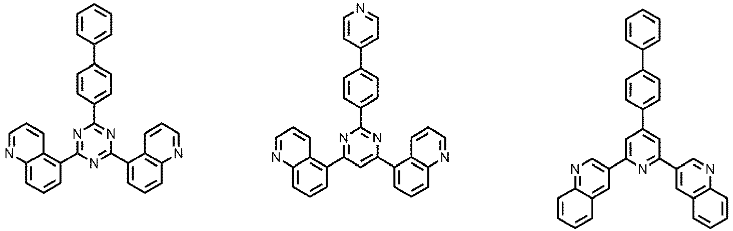

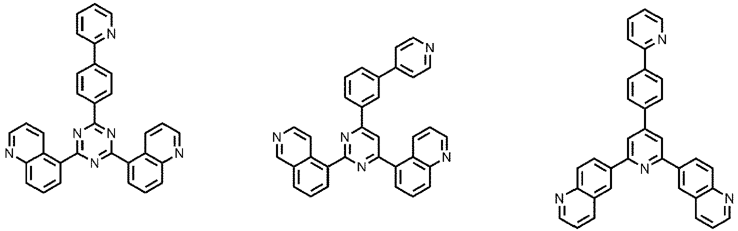

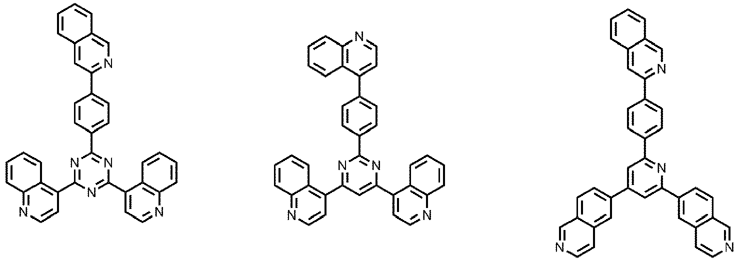

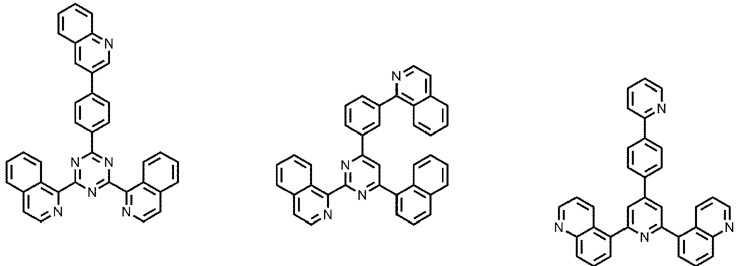

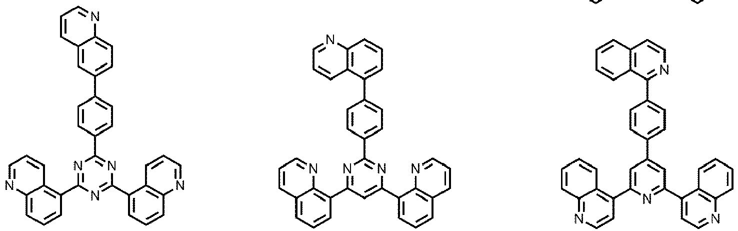

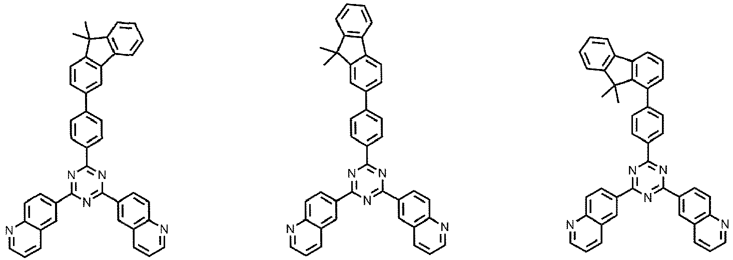

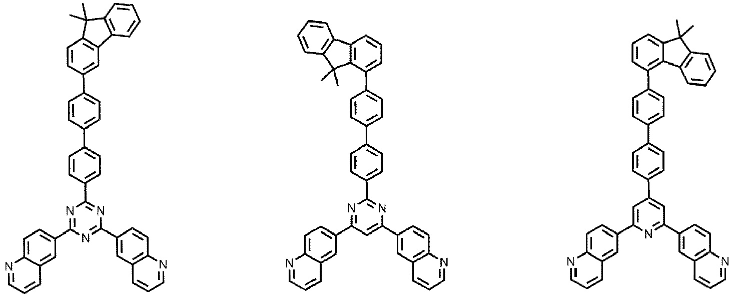

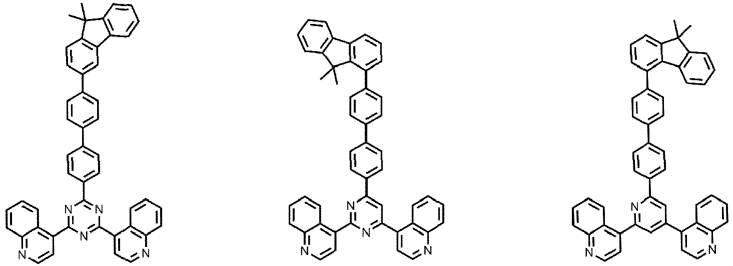

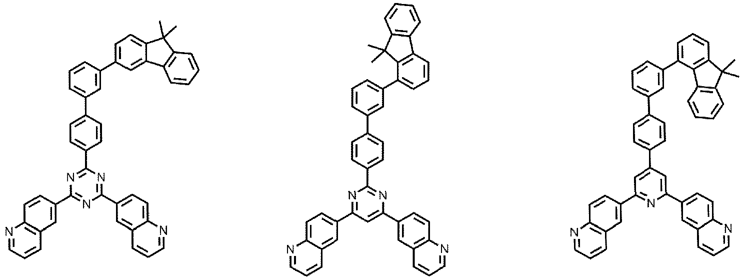

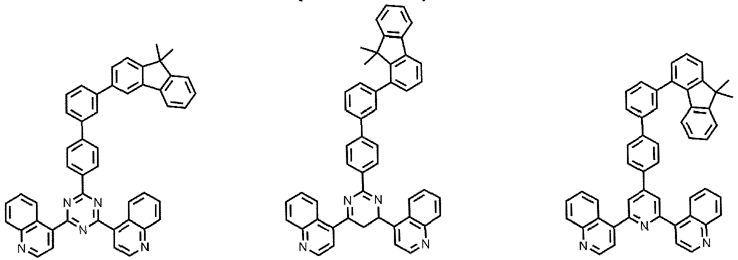

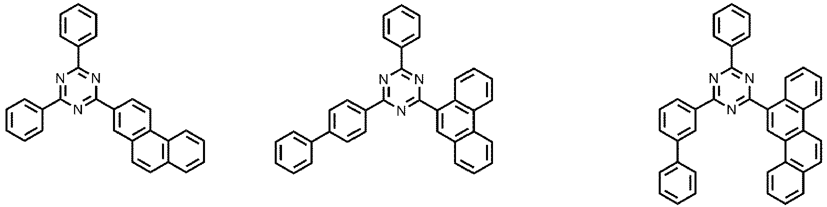

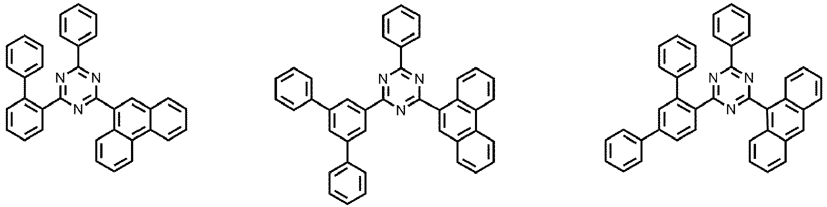

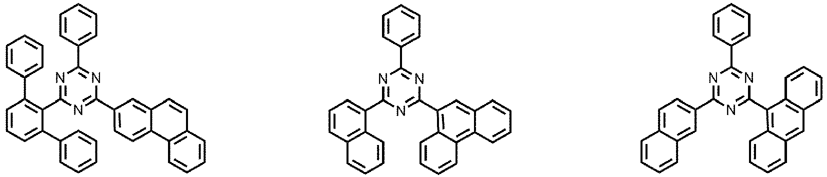

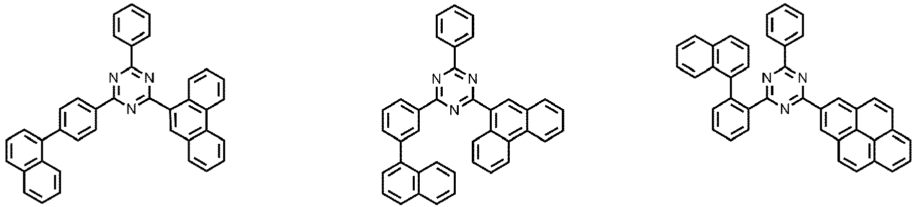

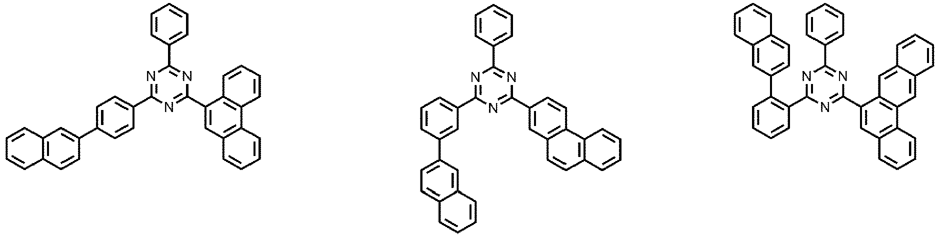

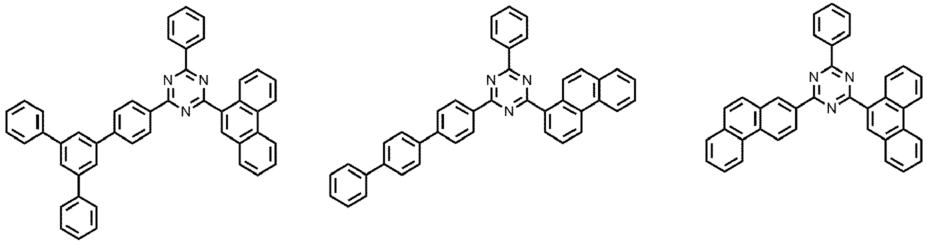

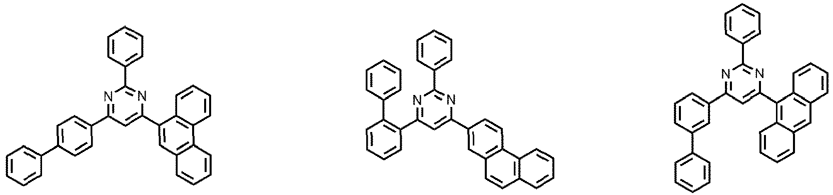

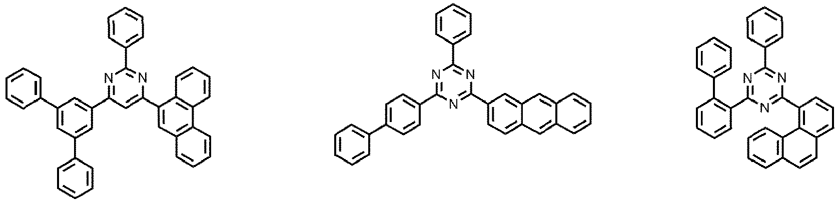

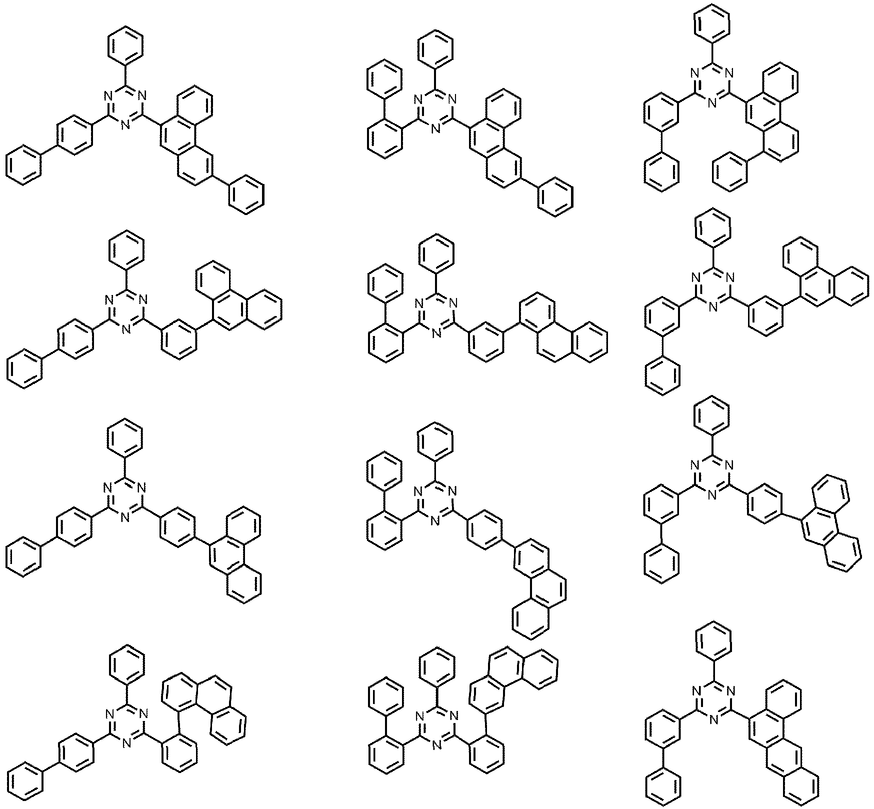

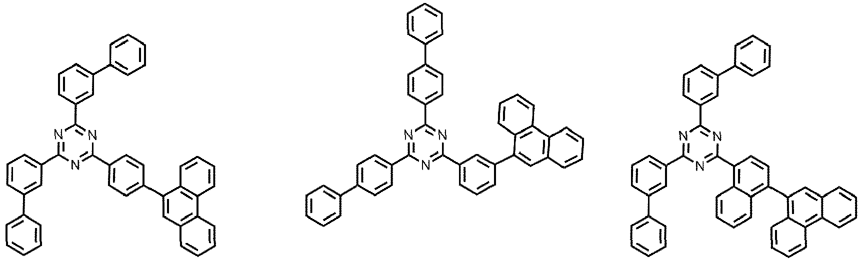

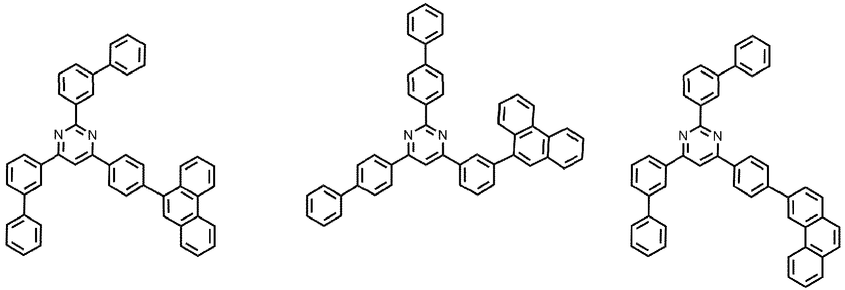

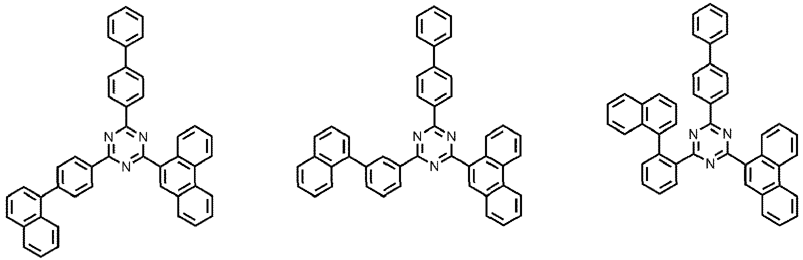

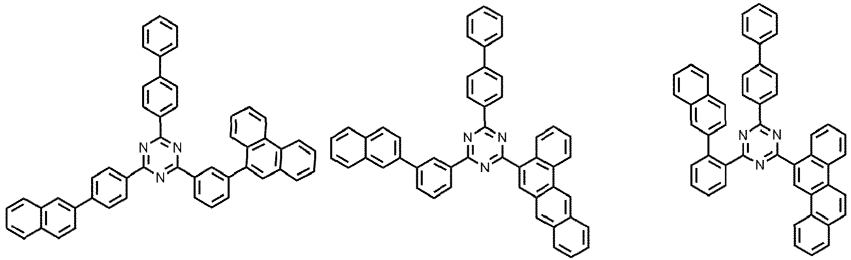

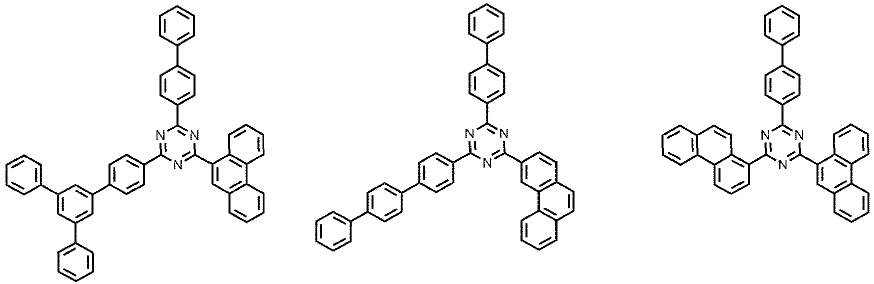

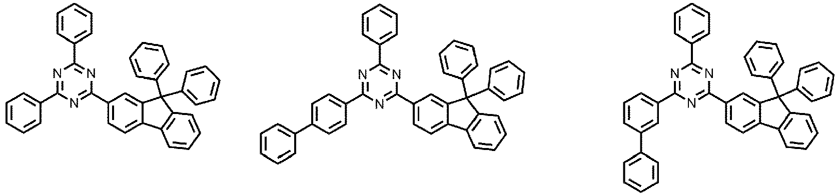

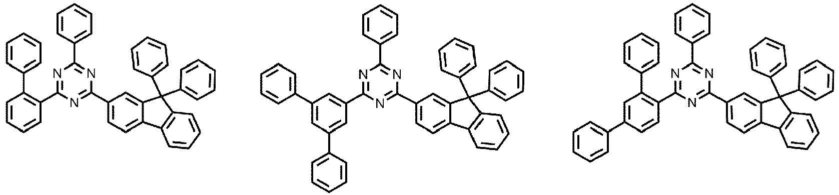

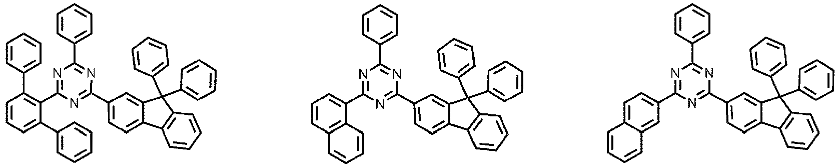

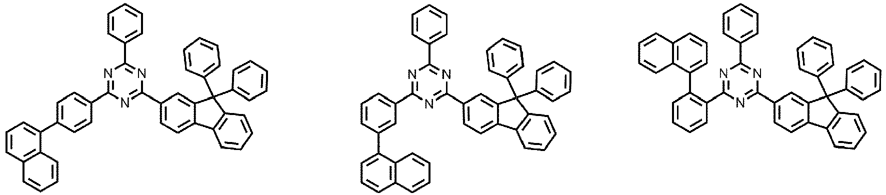

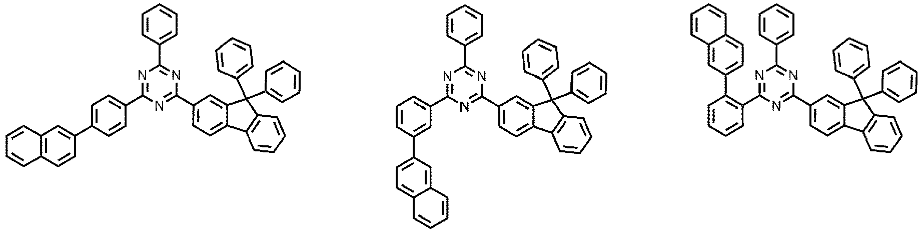

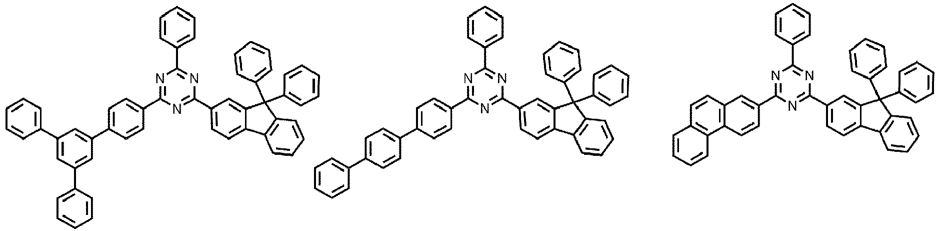

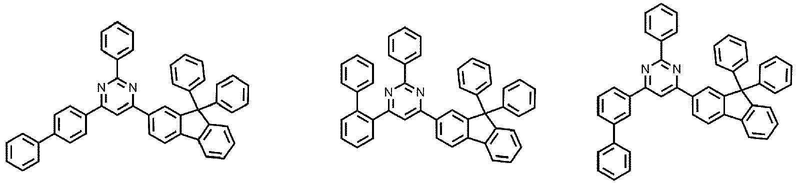

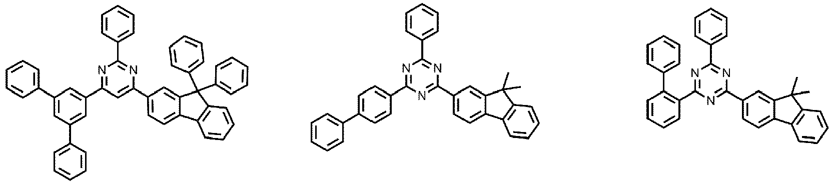

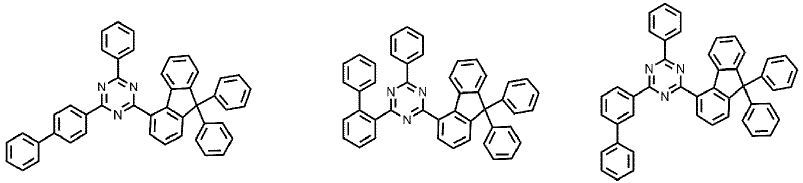

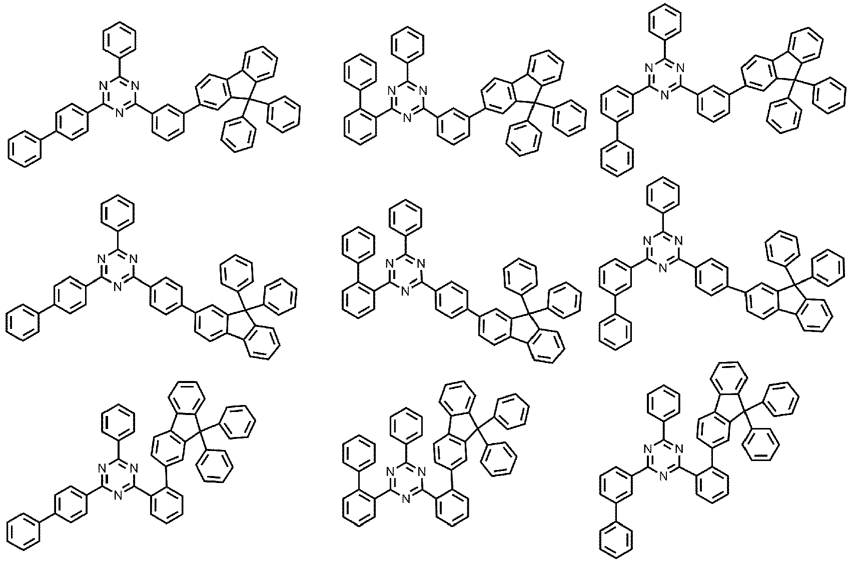

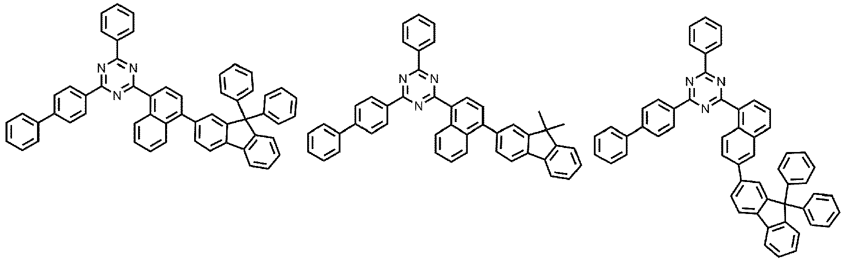

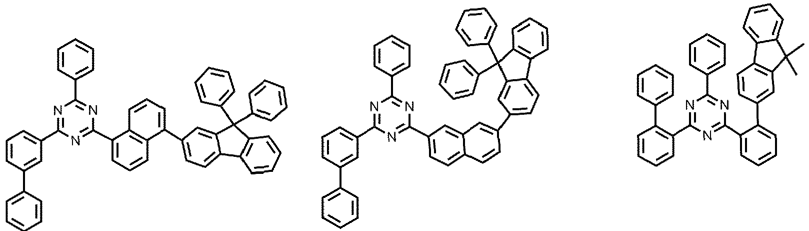

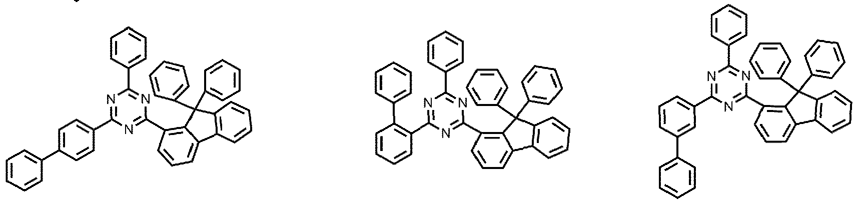

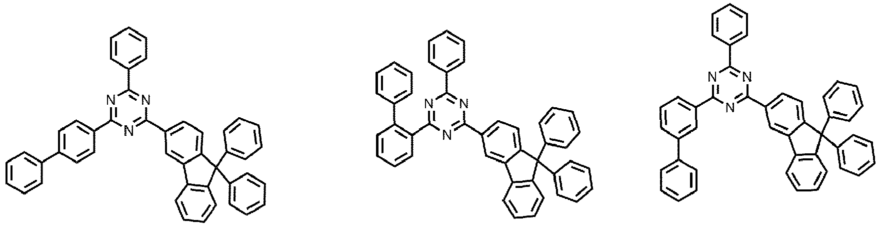

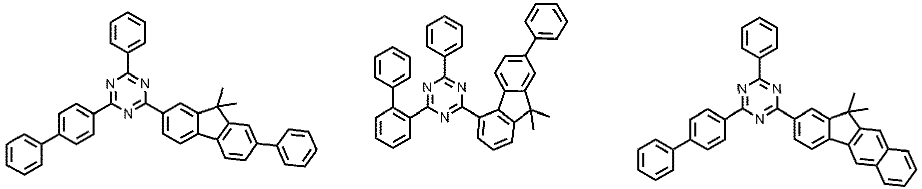

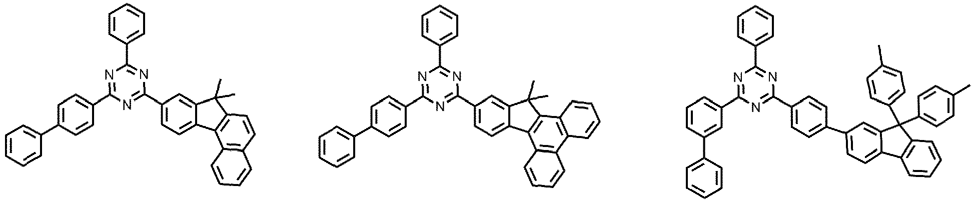

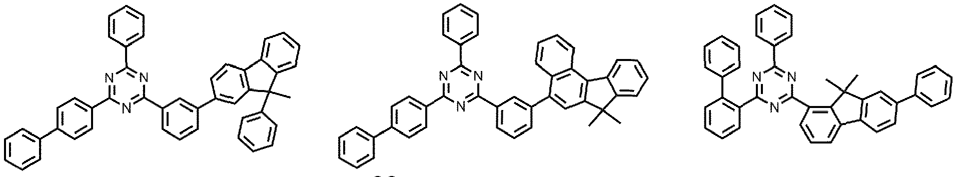

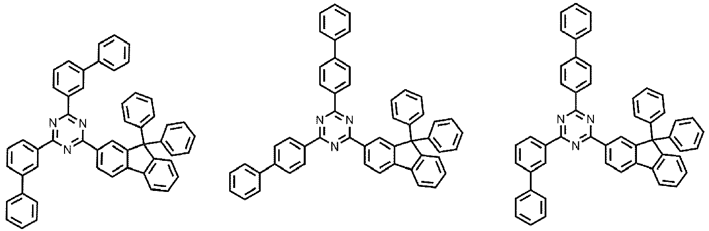

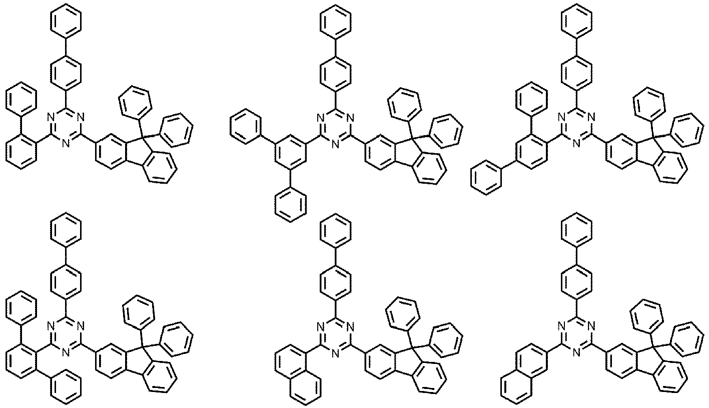

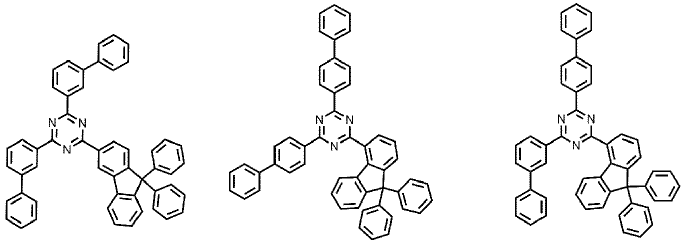

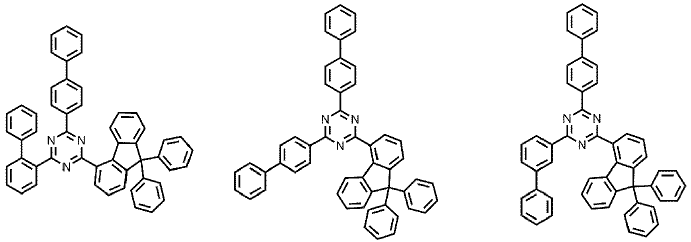

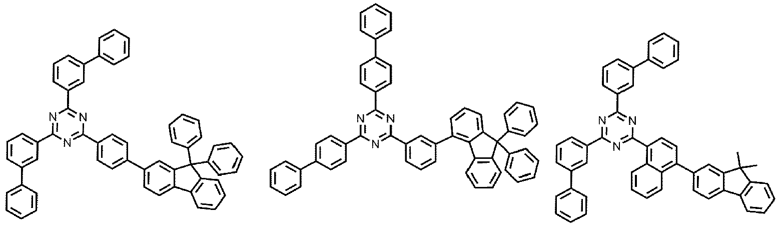

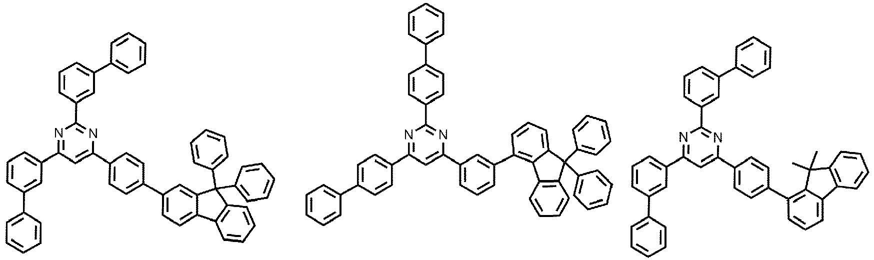

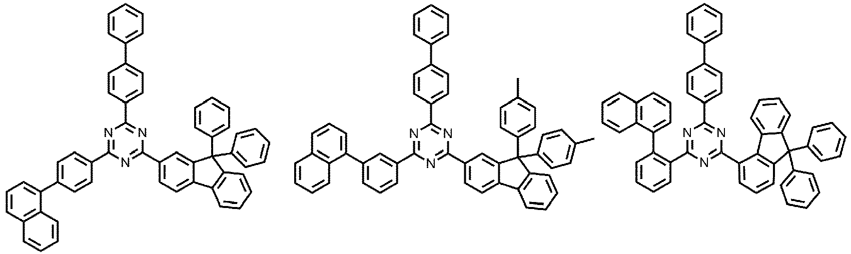

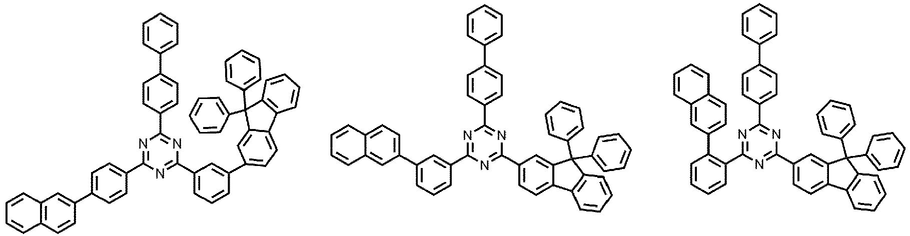

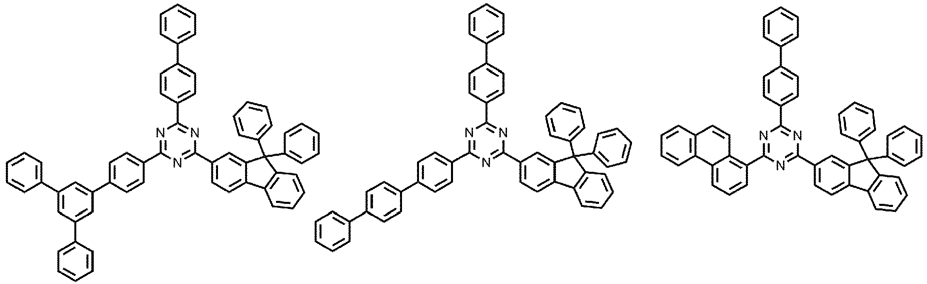

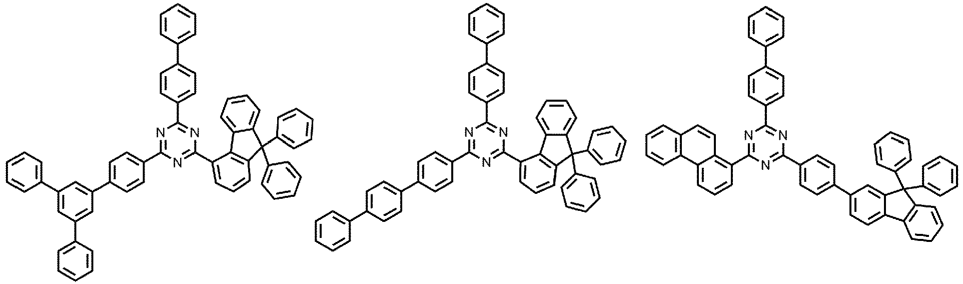

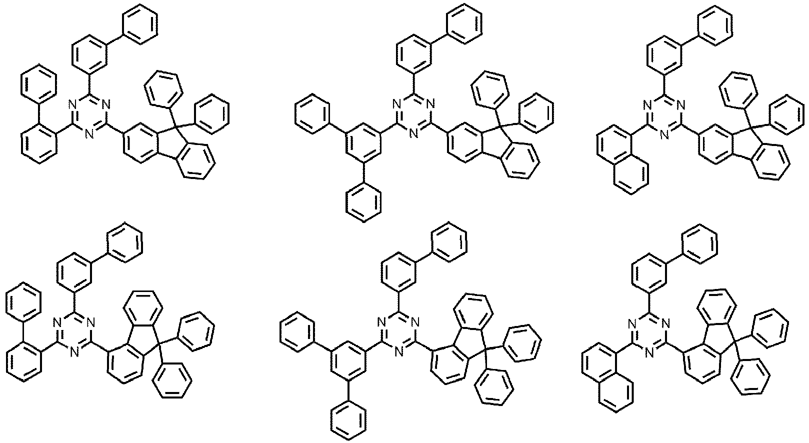

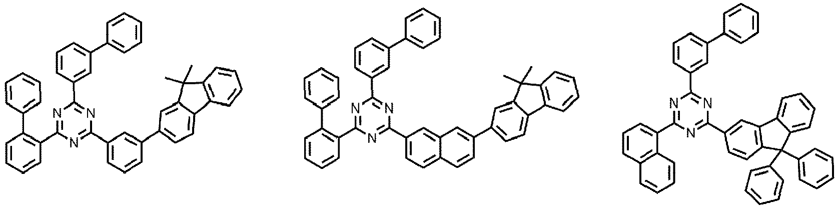

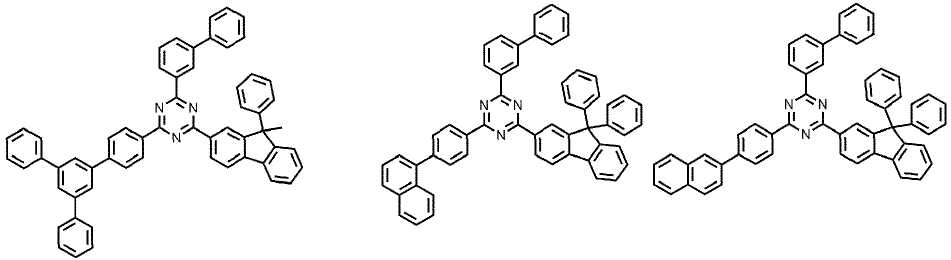

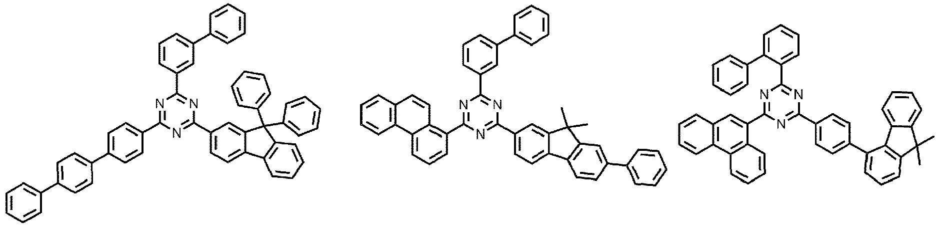

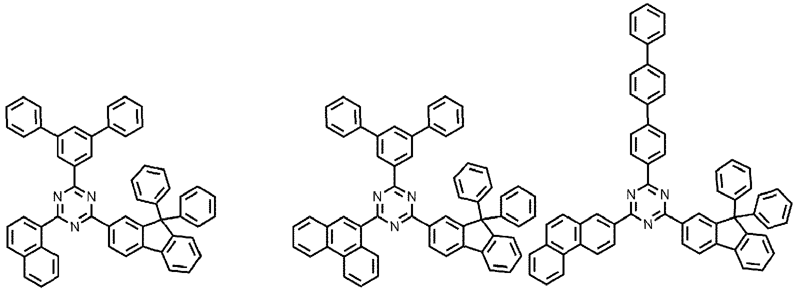

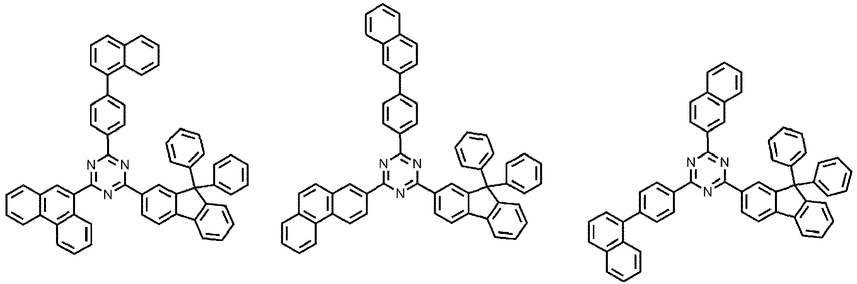

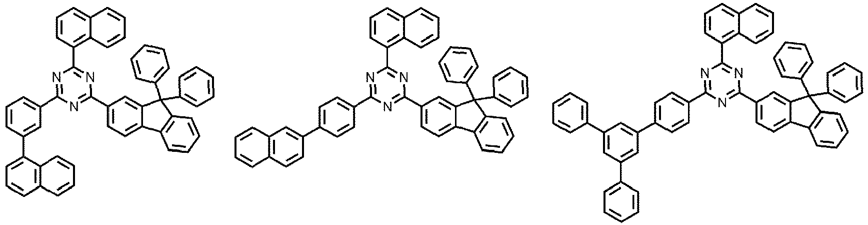

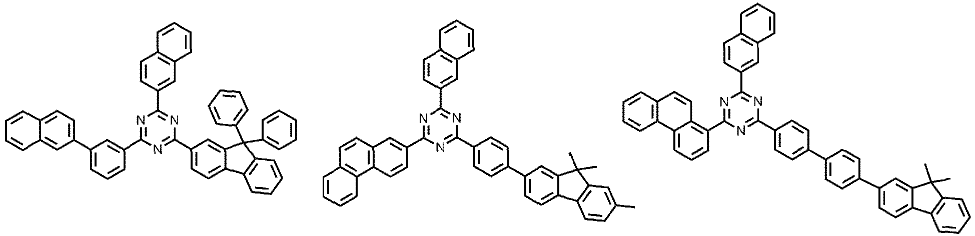

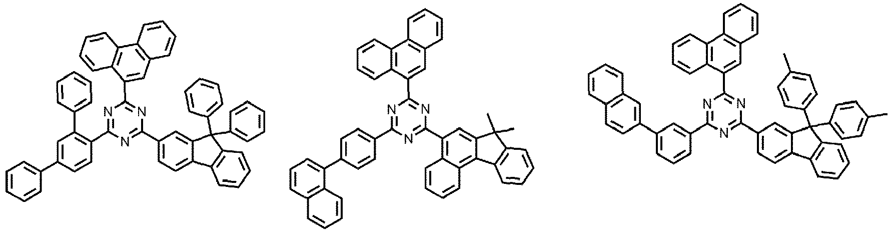

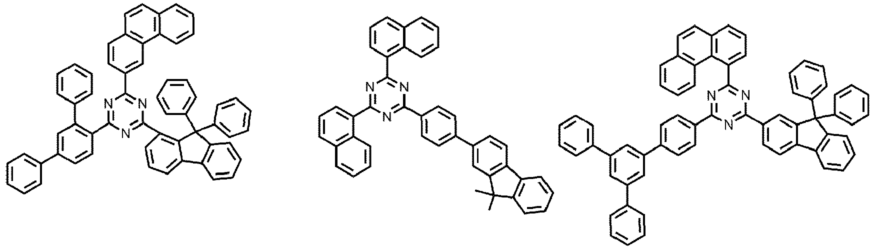

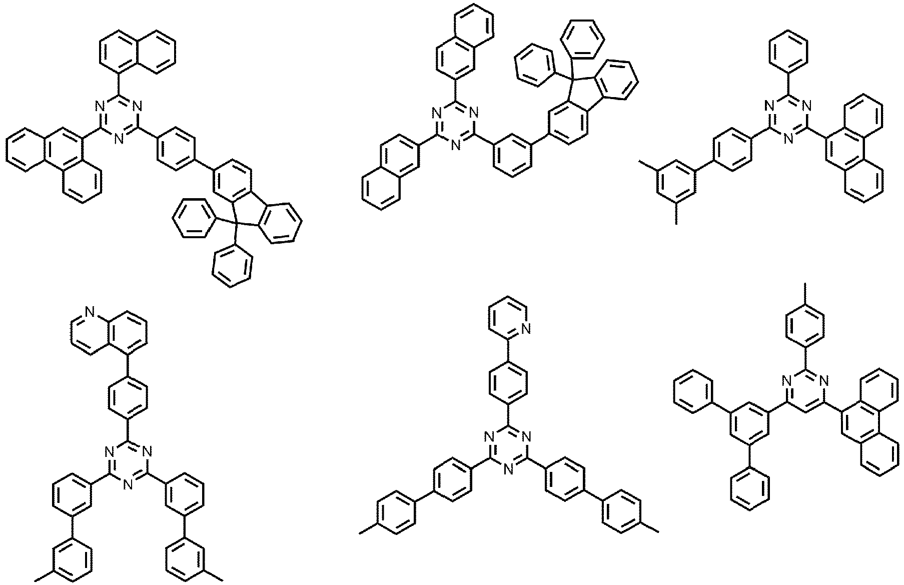

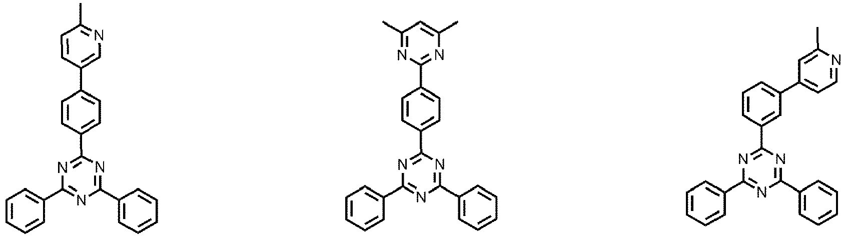

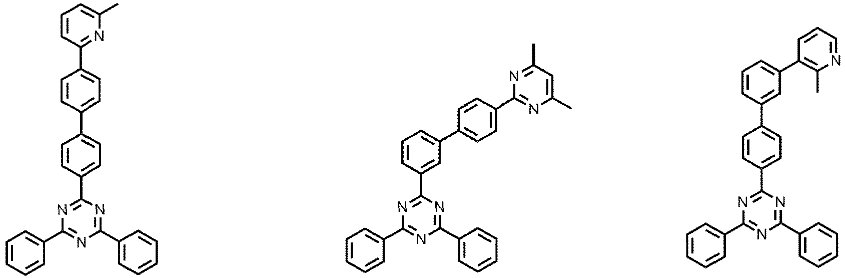

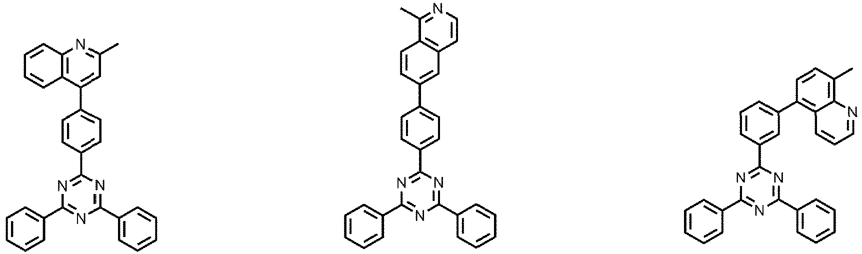

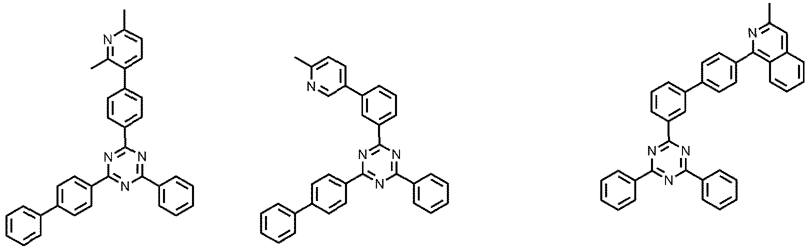

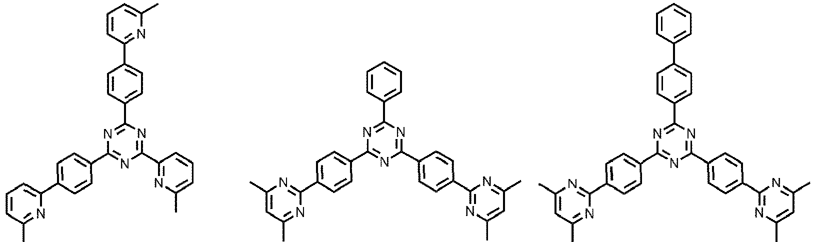

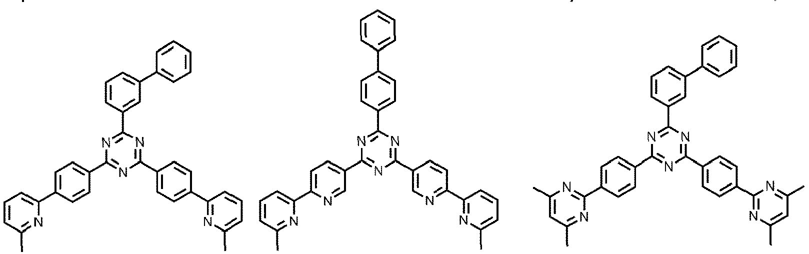

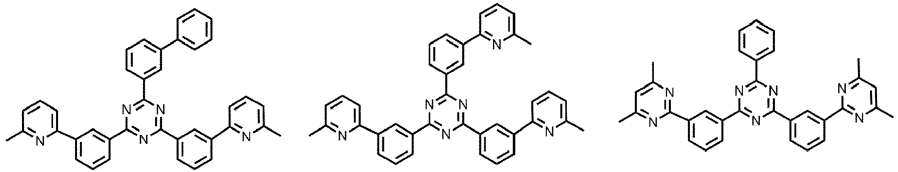

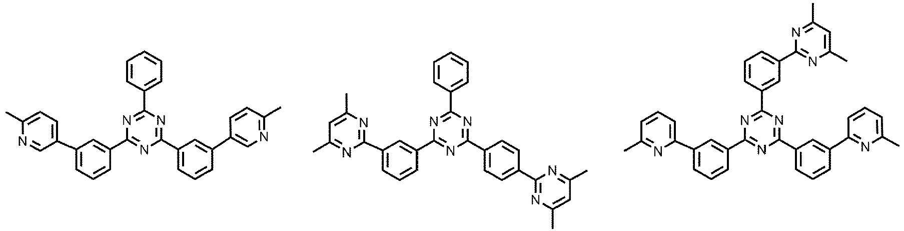

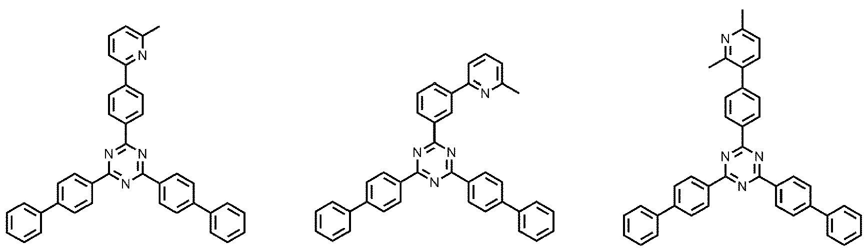

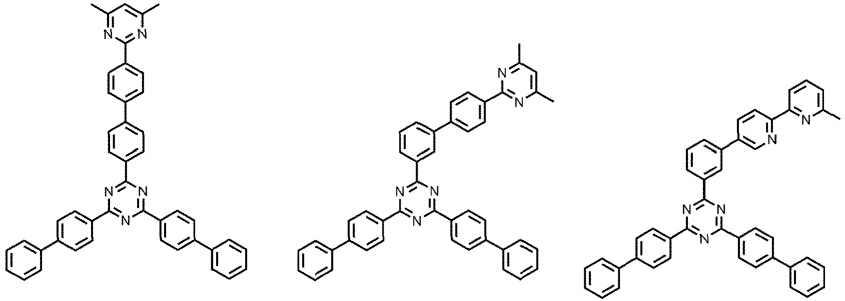

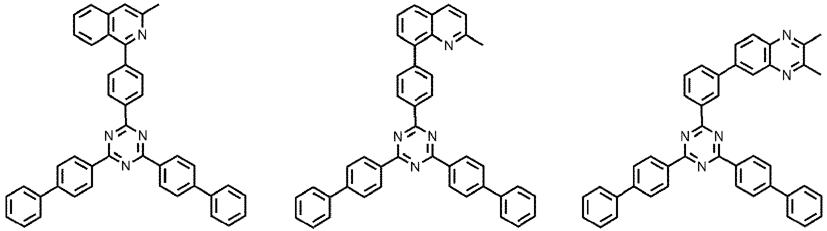

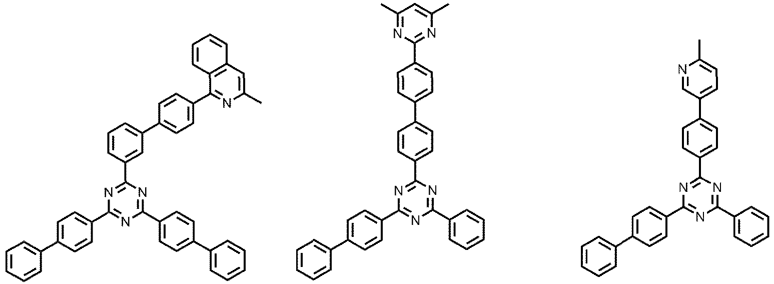

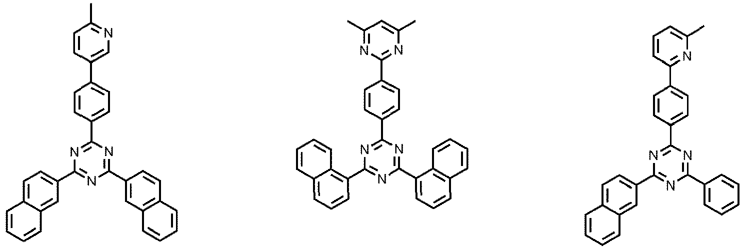

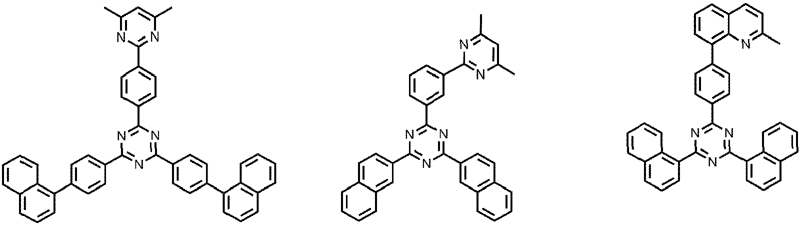

As another example, the second compound may be selected from Compounds E1 to E27, but embodiments are not limited thereto:

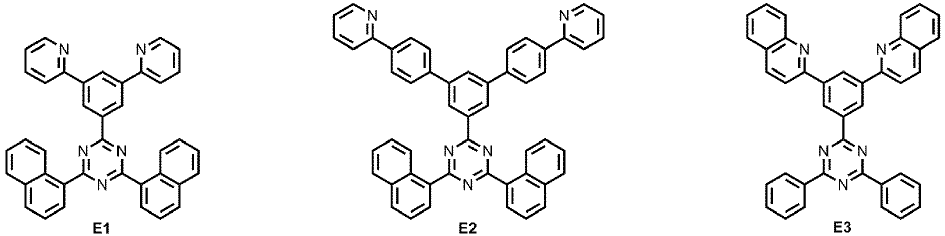

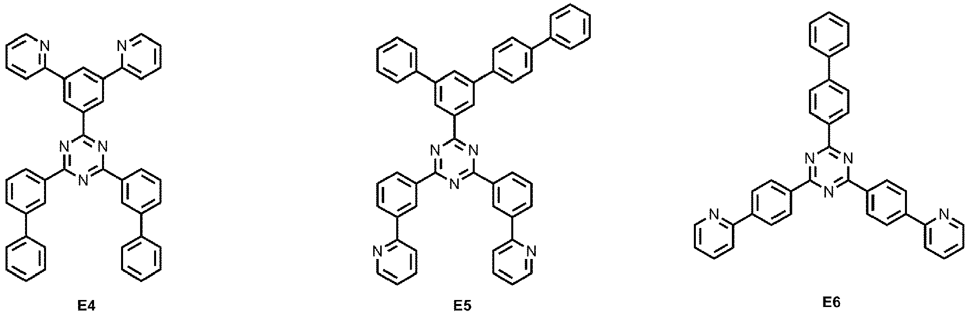

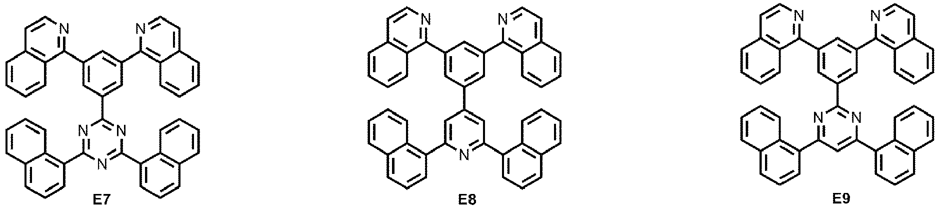

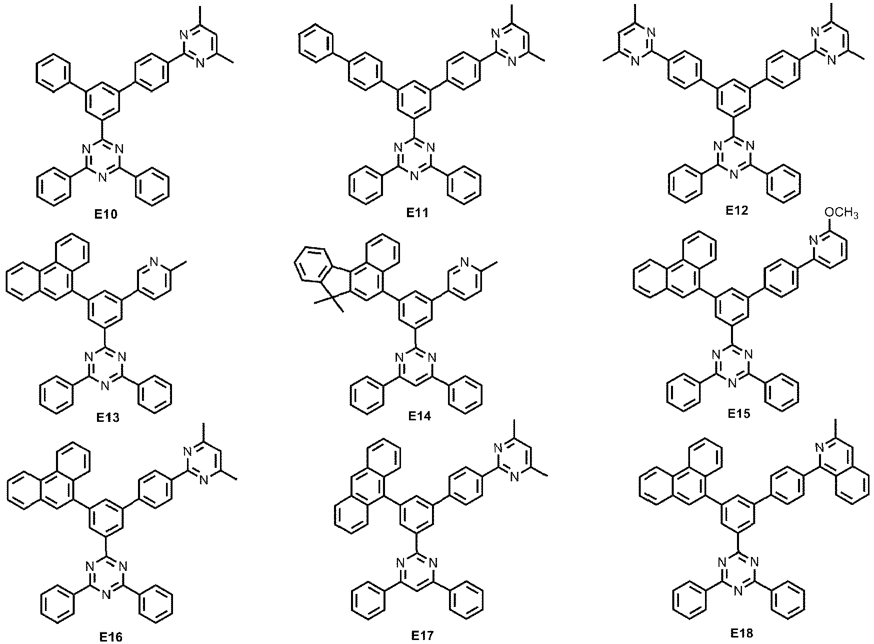

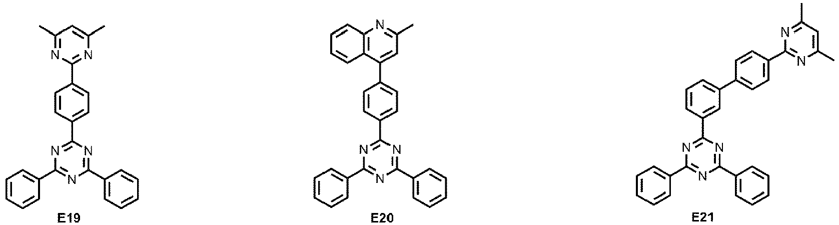

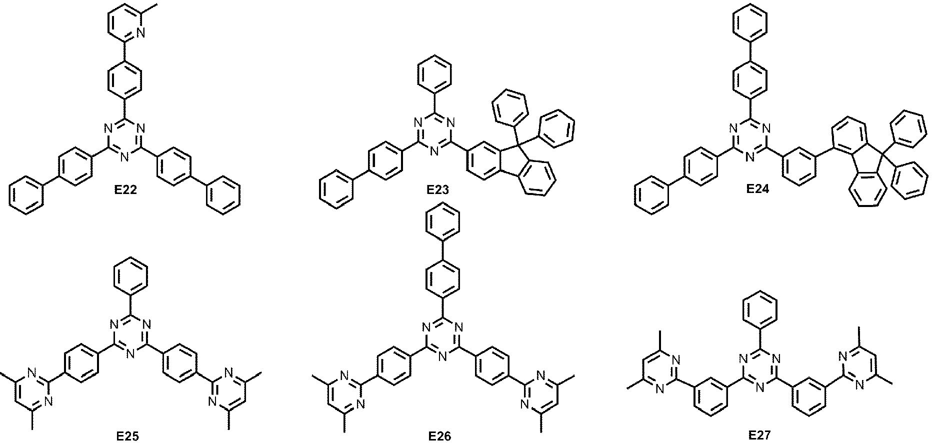

In general, an anthracene-based compound having a symmetric structure has high crystallinity, and thus, known to have poor film-forming properties. However, the first compound represented by Formula 1 has an asymmetric structure, and thus, its film-forming properties are improved. Regarding the first compound represented by Formula 1, a substituent that is more bulky than a phenyl group is located in a 10^{th} carbon of an anthracene, resulting in less association with a dopant. Accordingly, efficiency and lifespan of a manufactured organic light-emitting device may be improved.

The second compound represented by Formula 2 may have relatively high electron transport capability and T1 energy level. Accordingly, the second compound represented by Formula 2 may effectively move carriers in an emission layer, and may trap excitons in the emission layer. Thus, an organic light-emitting device including the second compound may be improved in terms of efficiency and lifespan.

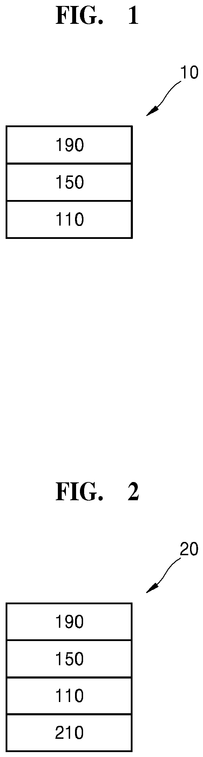

### [Description of FIG. 1]

FIG. 1 is a schematic view of an organic light-emitting device 10 according to an embodiment. The organic light-emitting device 10 includes a first electrode 110, an organic layer 150, and a second electrode 190.

Hereinafter, the structure of the organic light-emitting device 10 according to an embodiment and a method of manufacturing the organic light-emitting device 10 will be described in connection with FIG. 1.

### [First electrode 110]

In FIG. 1, a substrate may be additionally disposed under the first electrode 110 or above the second electrode 190. The substrate may be a glass substrate having excellent mechanical strength, thermal stability, transparency, surface smoothness, ease of handling, and water-resistance, or a plastic substrate.

The first electrode 110 may be formed by depositing or sputtering a material for forming the first electrode 110 on the substrate. When the first electrode 110 is an anode, the material for a first electrode may be selected from materials with a high work function to facilitate hole injection.

The first electrode 110 may be a reflective electrode, a semi-transmissive electrode, or a transmissive electrode. When the first electrode 110 is a transmissible electrode, a material for forming a first electrode may be selected from indium tin oxide (ITO), indium zinc oxide (IZO), tin oxide (SnO₂), zinc oxide (ZnO), and any combinations thereof, but is not limited thereto. In some embodiments, when the first electrode 110 is a semi-transmissible electrode or a reflectable electrode, a material for forming a first electrode may be selected from magnesium (Mg), silver (Ag), aluminum (Al), aluminum-lithium (Al-Li), calcium (Ca), magnesium-indium (Mg-In), magnesium-silver (Mg-Ag), and any combinations thereof, but is not limited thereto.

The first electrode 110 may have a single-layer structure, or a multi-layer structure including two or more layers. For example, the first electrode 110 may have a three-layered structure of ITO/Ag/ITO, but the structure of the first electrode 110 is not limited thereto.

### [Organic layer 150]

The organic layer 150 is disposed on the first electrode 110. The organic layer 150 may include an emission layer.

The organic layer 150 may further include a hole transport region between the first electrode 110 and the emission layer, and an electron transport region between the emission layer and the second electrode 190.

### [Hole transport region in organic layer 150]

The hole transport region may have i) a single-layered structure including a single layer including a single material, ii) a single-layered structure including a single layer including a plurality of different materials, or iii) a multi-layered structure having a plurality of layers including a plurality of different materials.

The hole transport region may include at least one layer selected from a hole injection layer (HIL), a hole transport layer (HTL), an emission auxiliary layer, and an electron blocking layer (EBL).

For example, the hole transport region may have a single-layer structure including a single layer including a plurality of different materials, or a multi-layer structure having a structure of hole injection layer/hole transport layer, hole injection layer/hole transport layer/emission auxiliary layer, hole injection layer/emission auxiliary layer, hole transport layer/emission auxiliary layer or hole injection layer/hole transport layer/electron blocking layer, which are sequentially stacked from the first electrode 110 in this stated order, but the structure of the hole transport region is not limited thereto.

The hole transport region may include at least one selected from m-MTDATA, TDATA, 2-TNATA, NPB(NPD), β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), polyaniline/poly(4-styrenesulfonate) (PANI/PSS), a compound represented by Formula 201, and a compound represented by Formula 202:

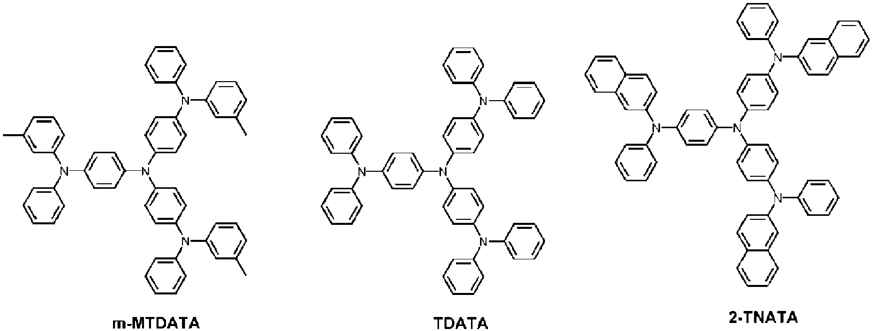

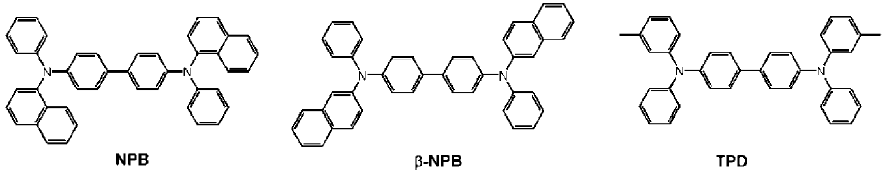

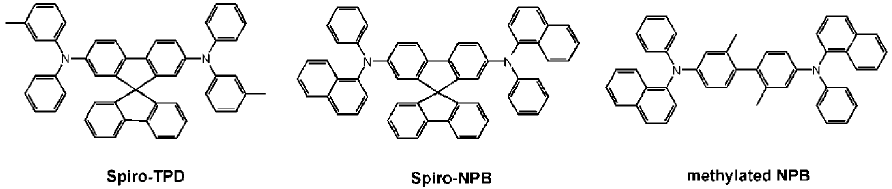

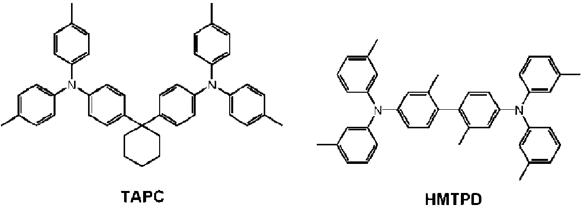

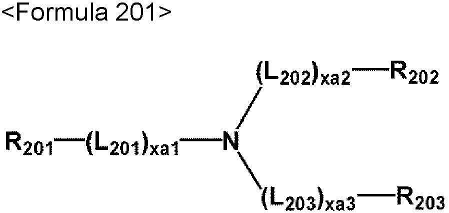

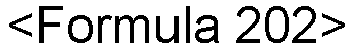

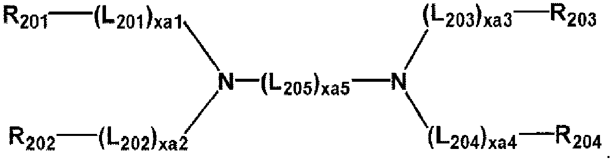

In Formulae 201 and 202,
L₂₀₁ to L₂₀₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
L₂₀₅ may be selected from *-O-*', *-S-*', *-N(Q₂₀₁)-*', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xa1 to xa4 may be each independently an integer of 0 to 3,
xa5 may be an integer of 1 to 10, and
R₂₀₁ to R₂₀₄ and Q₂₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group.

For example, in Formula 202, R₂₀₁ and R₂₀₂ may be optionally linked to each other via a single bond, a dimethyl-methylene group, or a diphenyl-methylene group, and R₂₀₃ and R₂₀₄ may be optionally linked to each other via a single bond, a dimethyl-methylene group, or a diphenyl-methylene group.

For example, R₂₀₁ to R₂₀₄ and Q₂₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₂ aryl group, a substituted or unsubstituted C₆-C₃₂ aryloxy group, a substituted or unsubstituted C₆-C₃₂ arylthio group, a substituted or unsubstituted C₁-C₂₀ heteroaryl group, a substituted or unsubstituted monovalent non-aromatic condensed polycyclic group, and a substituted or unsubstituted monovalent non-aromatic condensed heteropolycyclic group, but embodiments are not limited thereto.

For example, L₂₀₁ to L₂₀₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₃₂ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group, but embodiments are not limited thereto.

L₂₀₅ may be selected from *-O-*', *-S-*', *-N(Q₂₀₁)-*', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₃₂ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group, but embodiments are not limited thereto.

According to an embodiment, L₂₀₁ to L₂₀₅ in Formulae 201 and 202 may each independently be selected from:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(C₃₁)(Q₃₂)(Q₃₃), and -N(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

According to another embodiment, xa1 to xa4 may be each independently 0, 1, or 2.

According to some embodiments, xa5 may be 1, 2, 3, or 4.

According to some embodiments, R₂₀₁ to R₂₀₄ and Q₂₀₁ may each independently be selected from: a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -CI, - Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ are the same as described herein.

According to some embodiments, at least one of R₂₀₁ to R₂₀₃ in Formula 201 may each independently be selected from:
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group, but embodiments are not limited thereto.

According to some embodiments, in Formula 202, i) R₂₀₁ and R₂₀₂ may be linked to each other via a single bond and/or ii) R₂₀₃ and R₂₀₄ may be linked to each other via a single bond.

According to some embodiments, at least one of R₂₀₁ to R₂₀₄ in Formula 202 may be selected from
a carbazolyl group; and
a carbazolyl group substituted with at least one selected from deuterium, -F, - CI, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group, but embodiments are not limited thereto.

The compound represented by Formula 201 may be represented by Formula 201A:

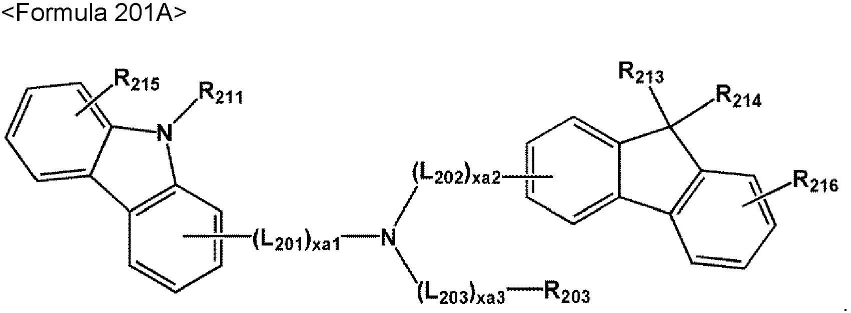

For example, the compound represented by Formula 201 may be represented by Formula 201A(1), but embodiments are not limited thereto:

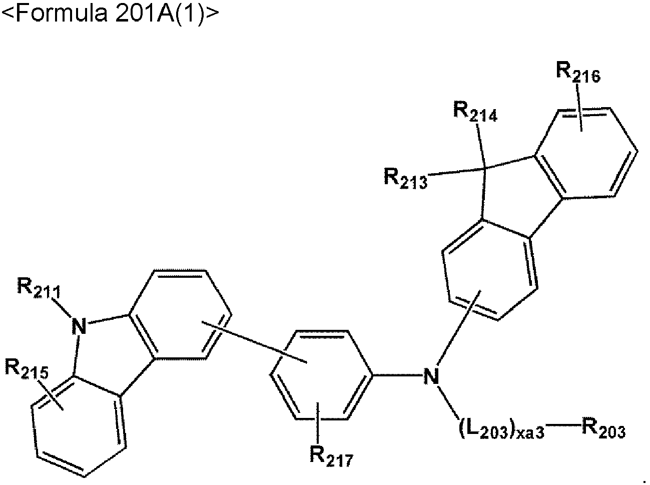

As another example, the compound represented by Formula 201 may be represented by Formula 201A-1, but embodiments are not limited thereto:

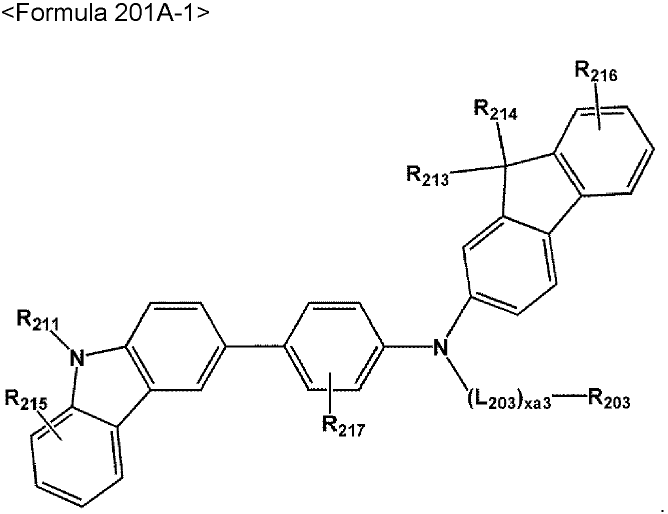

The compound represented by Formula 202 may be represented by Formula 202A:

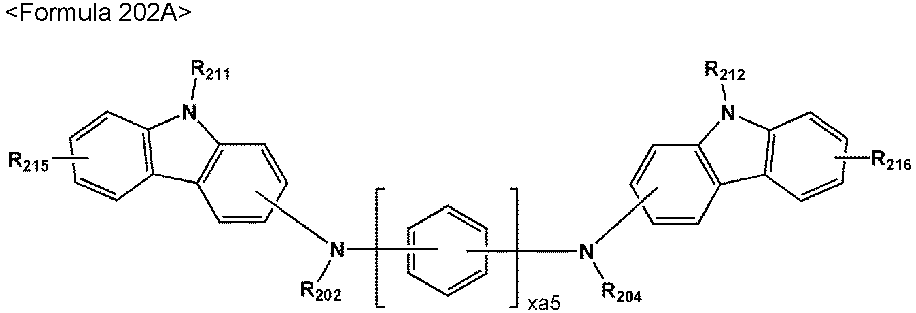

According to some embodiments, the compound represented by Formula 202 may be represented by Formula 202A-1:

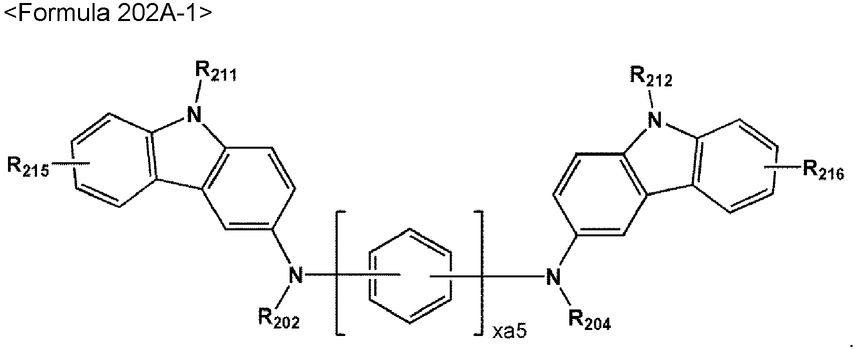

In Formulae 201A, 201A(1), 201A-1, 202A and 202A-1,
L₂₀₁ to L₂₀₃, xa1 to xa3, xa5, and R₂₀₂ to R₂₀₄ are the same as described herein,
R₂₁₁ and R₂₁₂ are the same as described herein in connection with R₂₀₃, and
R₂₁₃ to R₂₁₇ may each independently be selected from hydrogen, deuterium, - F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may include at least one compound selected from Compounds HT1 to HT39, but embodiments are not limited thereto:

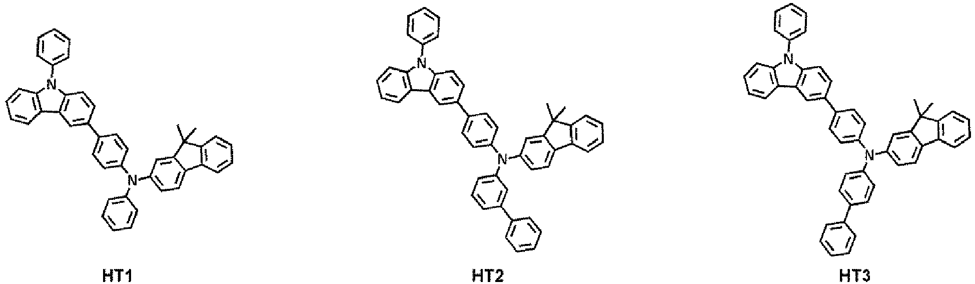

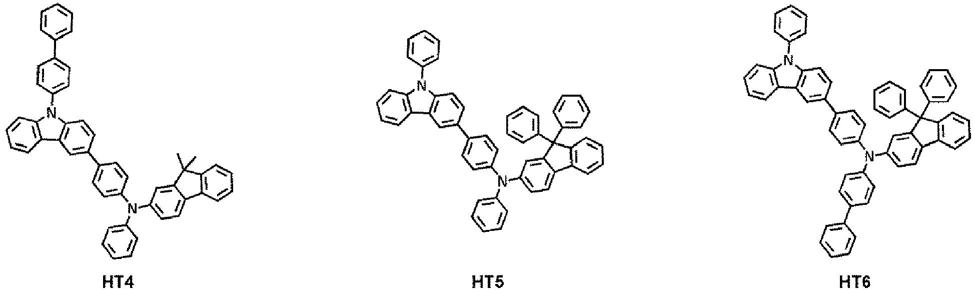

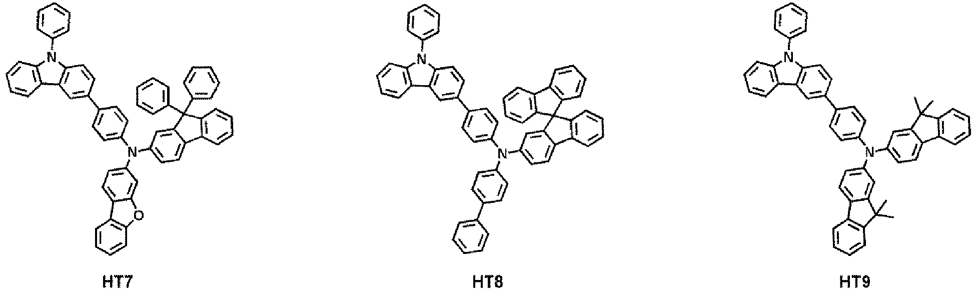

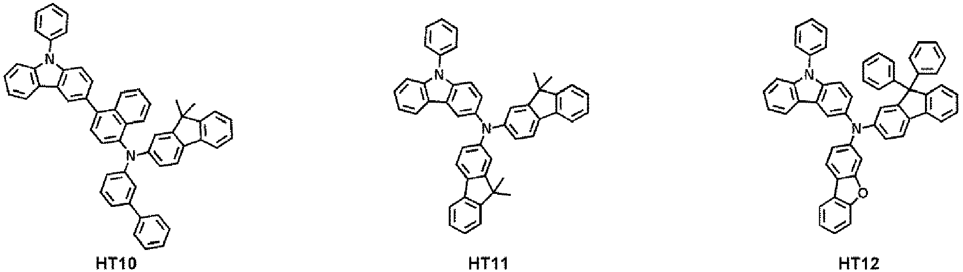

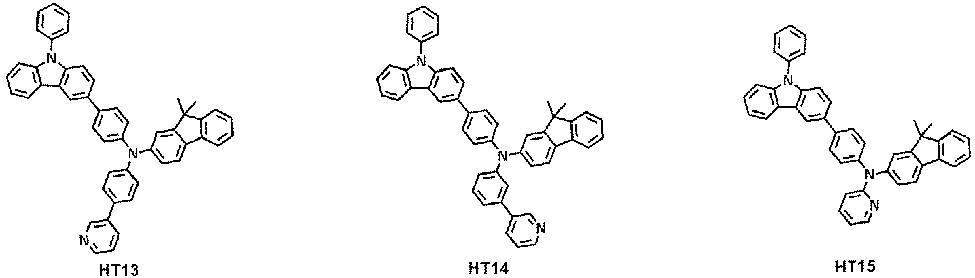

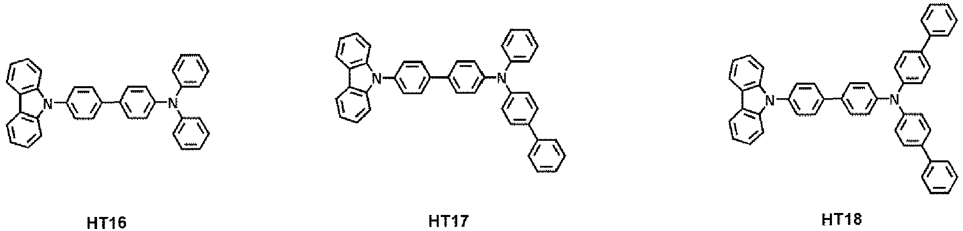

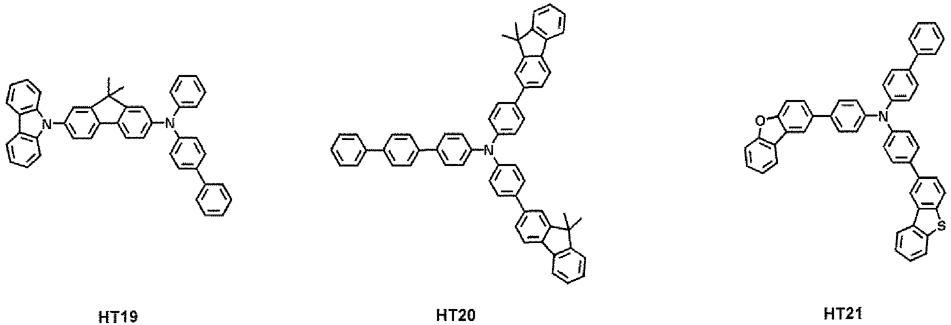

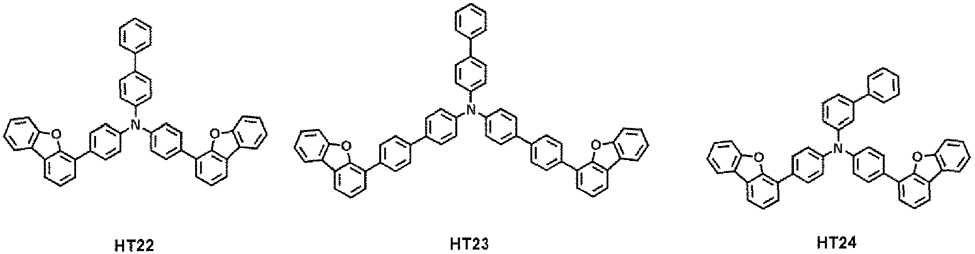

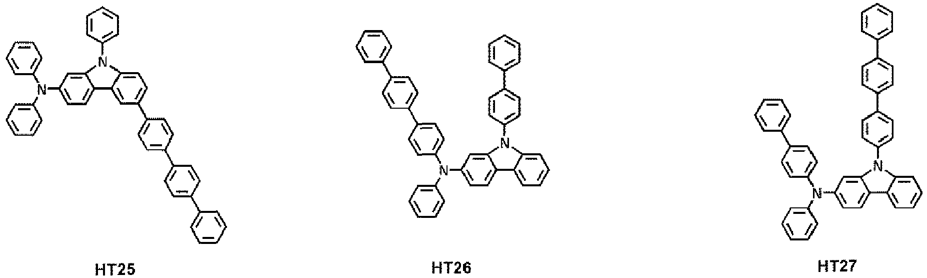

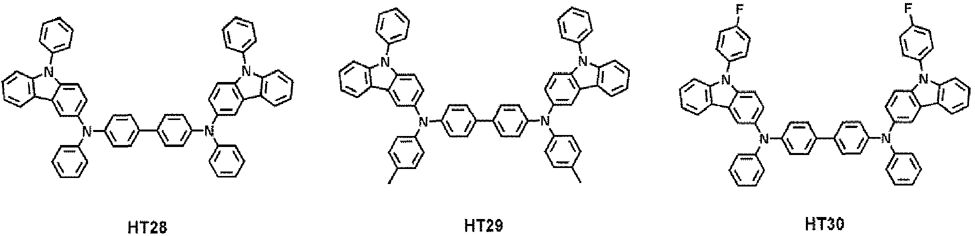

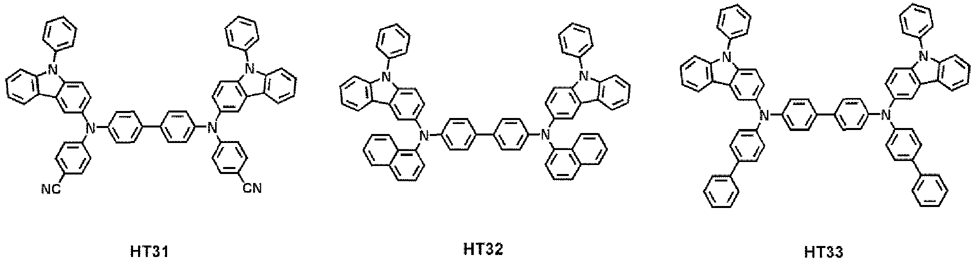

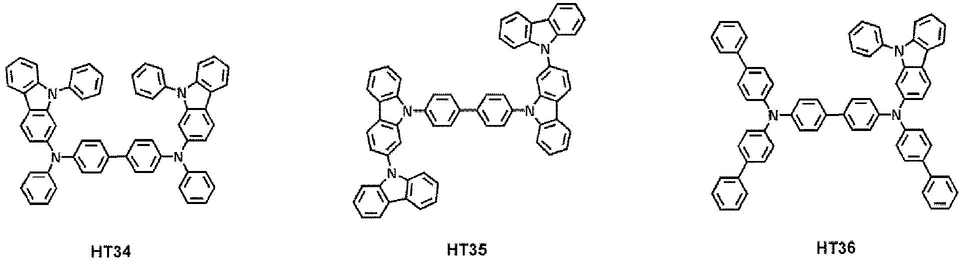

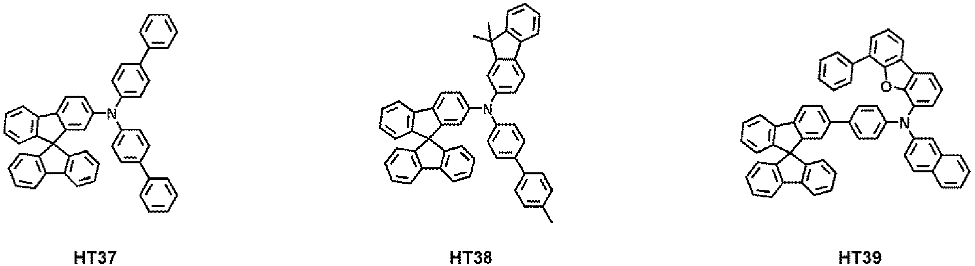

A thickness of the hole transport region may be in a range of about 100 A to about 10,000 A, for example, about 100 A to about 7000 A, about 100 A to about 5000 A, about 100 A to about 3000 A, about 100 A to about 1000 A. When the hole transport region includes at least one of a hole injection layer and a hole transport layer, a thickness of the hole injection layer may be in a range of about 100 A to about 9,000 A, for example, about 100 A to about 7,000 A, about 100 A to about 5,000 A, about 100 A to about 3,000 A or about 100 Å to about 1,000 Å, and a thickness of the hole transport layer may be in a range of about 50 A to about 2,000 A, for example about 100 A to about 1,500 A. When the thicknesses of the hole transport region, the hole injection layer and the hole transport layer are within these ranges, satisfactory hole transporting characteristics may be obtained without a substantial increase in driving voltage.

The emission auxiliary layer may increase light-emission efficiency by compensating for an optical resonance distance according to the wavelength of light emitted by an emission layer, and the electron blocking layer may block the flow of electrons from an electron transport region. The emission auxiliary layer and the electron blocking layer may include those materials as described above.

### [p-dopant]

The hole transport region may further include, in addition to these materials, a charge-generation material for the improvement of conductive properties. The charge-generation material may be homogeneously or inhomogeneously dispersed in the hole transport region.

The charge-generation material may be, for example, a p-dopant.

In an embodiment, a lowest unoccupied molecular orbital (LUMO) of the p-dopant may be -3.5 eV or less.

The p-dopant may include at least one selected from a quinone derivative, a metal oxide, and a cyano group-containing compound, but embodiments are not limited thereto.

For example, the p-dopant may include at least one selected from
a quinone derivative, such as tetracyanoquinodimethane (TCNQ) or 2,3,5,6-Tetrafluoro-7,7,8,8-tetracyanoquinodimethane (F4-TCNQ );
metal oxide, such as tungsten oxide or molybdenum oxide;
1,4,5,8,9,11-hexaazatriphenylene-hexacarbonitrile (HAT-CN); and
Compound represented by Formula 221, but is not limited thereto:

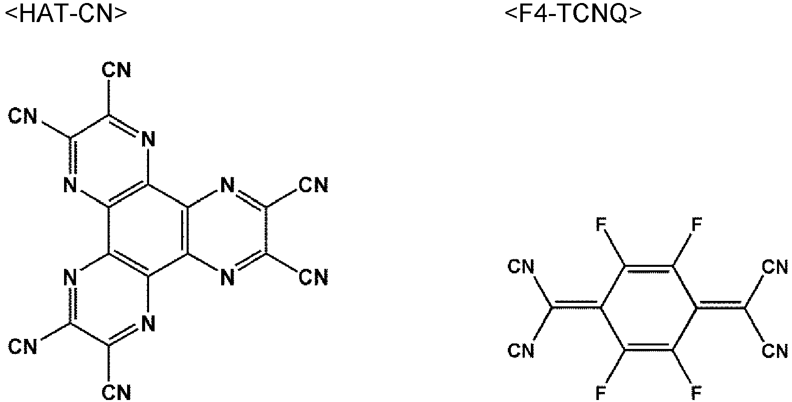

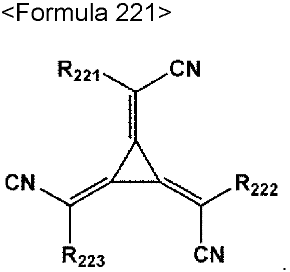

In Formula 221,
R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e*.*g*. C₆-C₃₂) aryl group, a substituted or unsubstituted C₁-C₆₀ (*e*.*g*. C1-C₂₀) heteroaryl group, a substituted or unsubstituted monovalent non-aromatic condensed polycyclic group, and a substituted or unsubstituted monovalent non-aromatic condensed heteropolycyclic group, and at least one of R₂₂₁ to R₂₂₃ has at least one substituent selected from a cyano group, -F, -CI, -Br, -I, a C₁-C₂₀ alkyl group substituted with -F, a C₁-C₂₀ alkyl group substituted with -CI, a C₁-C₂₀ alkyl group substituted with -Br, and a C₁-C₂₀ alkyl group substituted with -I.

### [Emission layer in organic layer 150]

When the organic light-emitting device 10 is a full color organic light-emitting device, the emission layer may be patterned into a red emission layer, a green emission layer, or a blue emission layer, according to a sub pixel. In some embodiments, the emission layer may have a stacked structure of two or more layers selected from a red emission layer, a green emission layer, and a blue emission layer, in which the two or more layers contact each other or are separated from each other. In some embodiments, the emission layer may include two or more materials selected from a red-light emission material, a green-light emission material, and a blue-light emission material, in which the two or more materials are mixed with each other in a single layer to emit white light.

The emission layer may include a host and a dopant. The dopant may be at least one selected from a phosphorescent dopant and a fluorescent dopant.

An amount of the dopant in the emission layer may be, in general, in a range of about 0.01 to about 15 parts by weight based on 100 parts by weight of the host, but is not limited thereto.

A thickness of the emission layer may be in a range of about 100 A to about 1,000 A, for example, about 100 A to about 800 A, about 150 A to about 800 A, about 150 A to about 700 A, about 150 A to about 650 A or about 200 Å to about 600 Å. When the thickness of the emission layer is within this range, excellent light-emission characteristics may be obtained without a substantial increase in driving voltage.

### [Host in emission layer]

The host may include the first compound represented by Formula 1.

In some embodiments, the host may further include, in addition to the first compound represented by Formula 1, a compound represented by Formula 301 below:

<Formula 301> [Ar₃₀₁]_{xb11}-[(L₃₀₁)_{xb1}-R₃₀₁]_{xb21}

In Formula 301,
Ar₃₀₁ may be a substituted or unsubstituted C₅-C₆₀ carbocyclic group or a substituted or unsubstituted C₁-C₆₀ heterocyclic group,
xb11 may be 1, 2, or 3,
L₃₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xb1 may be an integer of 0 to 5,
R₃₀₁ may be selected from deuterium, -F, -CI, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), - S(=O)₂(Q₃₀₁), and -P(=O)(Q₃₀₁)(Q₃₀₂), and
xb21 may be an integer of 1 to 5,
wherein Q₃₀₁ to Q₃₀₃ may each independently be selected from a C₁-C₁₀ alkyl group, a C₁-C₁₀ alkoxy group, a phenyl group, a biphenyl group, a terphenyl group, and a naphthyl group, but embodiments are not limited thereto.

For example, Ar₃₀₁ may be a substituted or unsubstituted C₆-C₃₂ carbocyclic group or a substituted or unsubstituted C₁-C₁₂ heterocyclic group, but embodiments are not limited thereto.

According to an embodiment, Ar₃₀₁ in Formula 301 may be selected from:
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group; and
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group, but embodiments are not limited thereto.

When xb11 in Formula 301 is 2 or more, two or more Ar₃₀₁(s) may be linked to each other via a single bond.

According to another embodiment, the compound represented by Formula 301 may be represented by Formula 301-1 or 301-2:

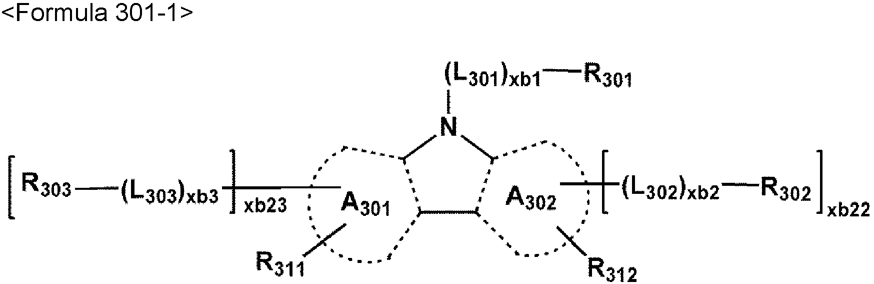

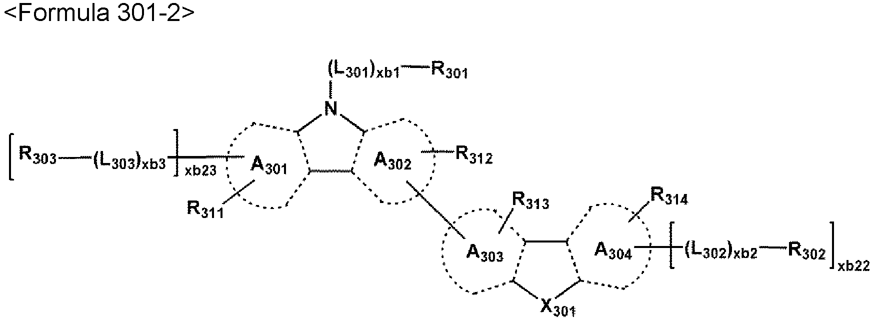

In Formulae 301-1 and 301-2,
A₃₀₁ to A₃₀₄ may each independently be selected from a benzene, a naphthalene, a phenanthrene, a fluoranthene, a triphenylene, a pyrene, a chrysene, a pyridine, a pyrimidine, an indene, a fluorene, a spiro-bifluorene, a benzofluorene, a dibenzofluorene, an indole, a carbazole, a benzocarbazole, a dibenzocarbazole, a furan, a benzofuran, a dibenzofuran, a naphtofuran, a benzonaphtofuran, a dinaphtofuran, a thiophene, a benzothiophene, a dibenzothiophene, a naphthothiophene, a benzonaphthothiophene, and a dinaphthothiophene,
X301 may be O, S, or N-[(L₃₀₄)_{xb4}-R₃₀₄],
R₃₁₁ to R₃₁₄ may each independently be selected from hydrogen, deuterium, - F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
xb22 and xb23 may be each independently 0, 1, or 2,
L₃₀₁, xb1, R₃₀₁, and Q₃₁ to Q₃₃ are the same as described herein,
L₃₀₂ to L₃₀₄ are each independently the same as described herein in connection with L₃₀₁,
xb2 to xb4 are each independently the same as described herein in connection with xb1, and
R₃₀₂ to R₃₀₄ are each independently the same as described herein in connection with R₃₀₁.

For example, L₃₀₁ to L₃₀₄ in Formulae 301, 301-1, and 301-2 may each independently be selected from: a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₃₀ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group, but embodiments are not limited thereto.

For example, L₃₀₁ to L₃₀₄ in Formulae 301, 301-1, and 301-2 may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), - N(Q₃₁)(Q₃₂), -B(Q₃₁)(Q₃₂), -C(=O)(Q₃₁), -S(=O)₂(Q₃₁), and -P(=O)(Q₃₁)(Q₃₂),
wherein Q₃₁ to Q₃₃ are the same as described herein.

As another example, R₃₀₁ to R₃₀₄ in Formulae 301, 301-1, and 301-2 may each independently be selected from: deuterium, -F, -CI, -Br, -I, a hydroxyl group, a cyano group, a nitro group, an amidino group, a hydrazino group, a hydrazono group, a substituted or unsubstituted C₁-C₆₀ (*e*.*g*. C₁-C₁₀) alkyl group, a substituted or unsubstituted C₂-C₆₀ (*e*.*g*. C₂-C₁₀) alkenyl group, a substituted or unsubstituted C₂-C₆₀ (*e*.*g*. C₂-C₁₀) alkynyl group, a substituted or unsubstituted C₁-C₆₀ (*e*.*g*. C₁-C₁₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, a substituted or unsubstituted monovalent non-aromatic condensed heteropolycyclic group, -Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), and -P(=O)(Q₃₀₁)(Q₃₀₂), but embodiments are not limited thereto.

As another example, R₃₀₁ to R₃₀₄ in Formulae 301, 301-1, and 301-2 may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), and -P(=O)(Q₃₁)(Q₃₂),
wherein Q₃₁ to Q₃₃ are the same as described herein.

In some embodiments, the host may include an alkaline earth metal complex. For example, the host may include a complex selected from a Be complex (for example, Compound H55), a Mg complex, and a Zn complex. For example, the host may be selected from a Be complex (for example, Compound H55), a Mg complex, and a Zn complex.

The host may include at least one selected from 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), and Compounds H1a to H55a, but is not limited thereto:

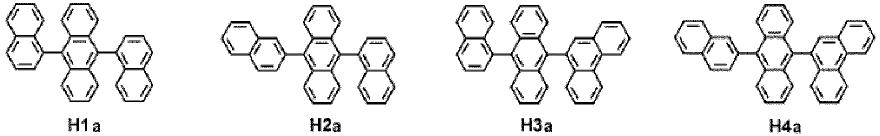

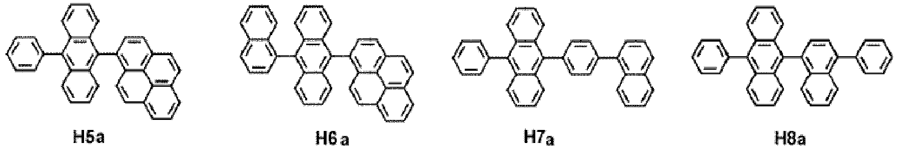

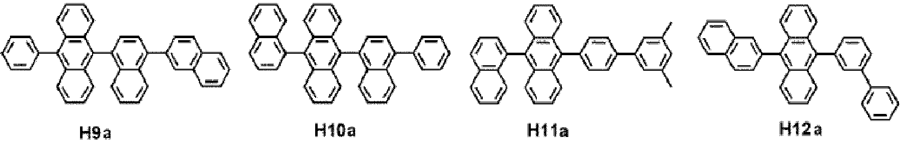

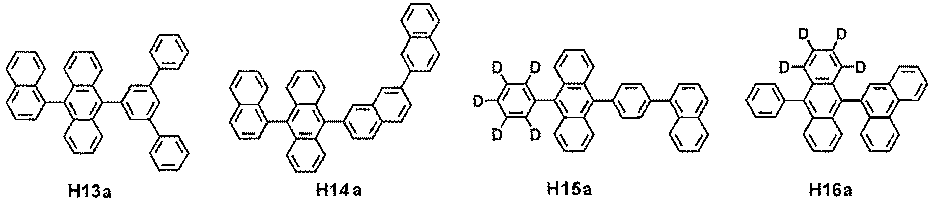

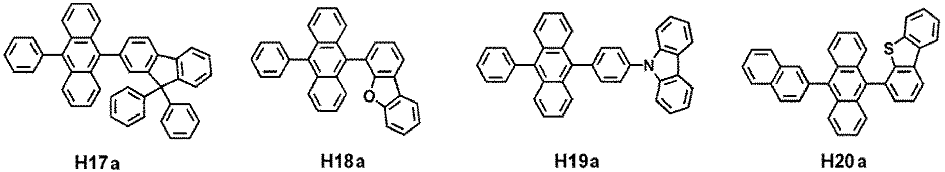

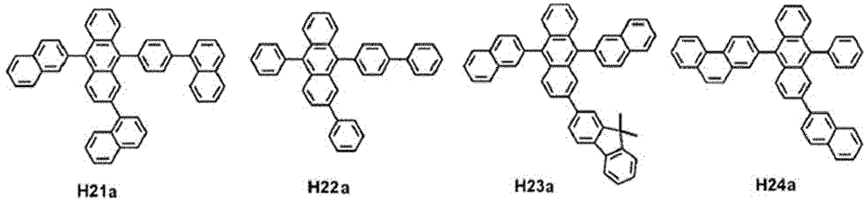

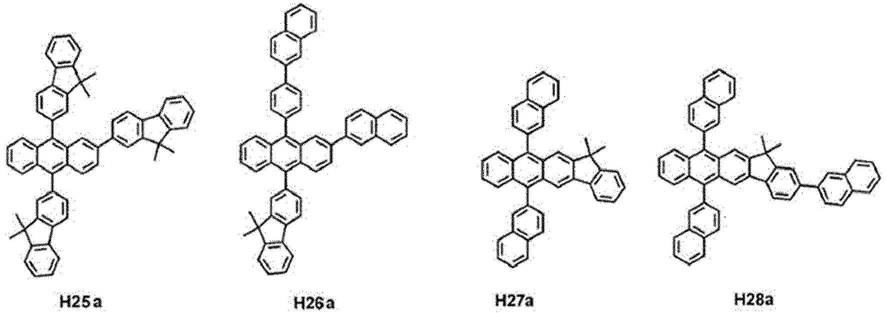

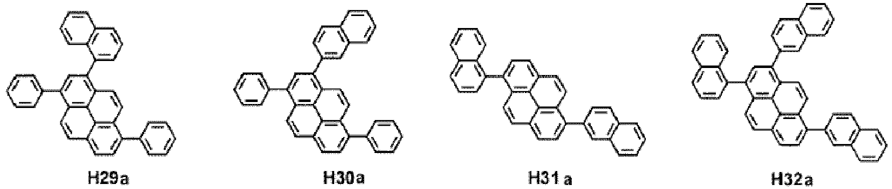

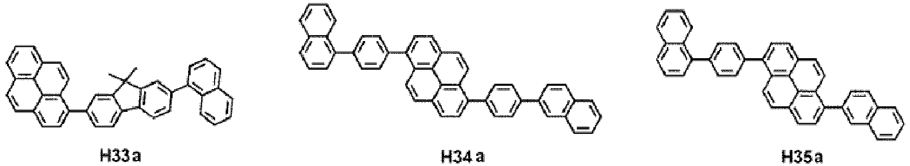

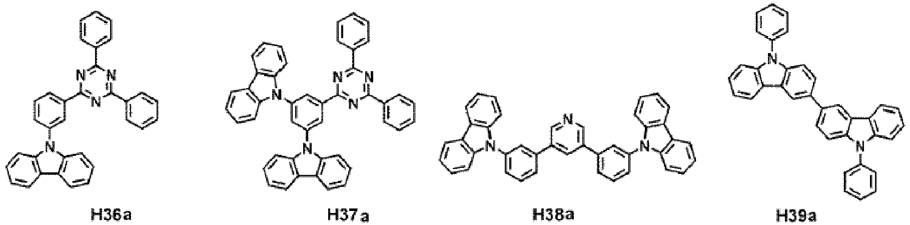

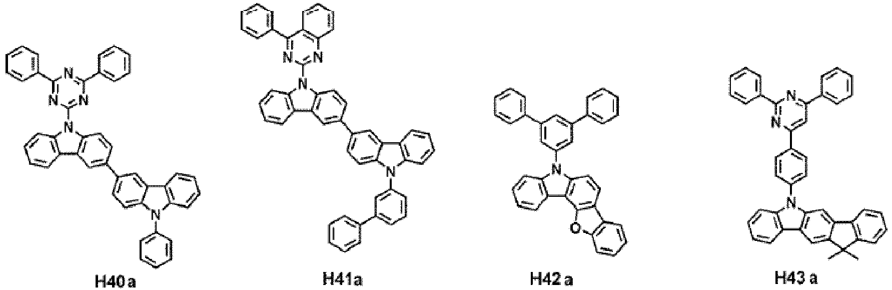

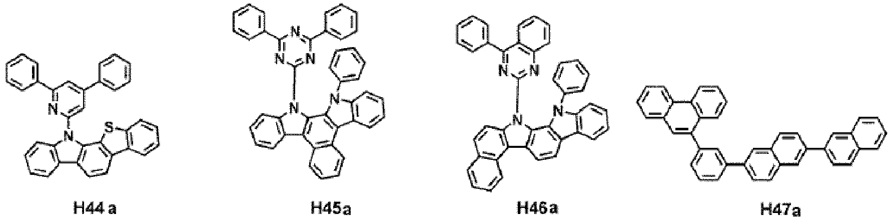

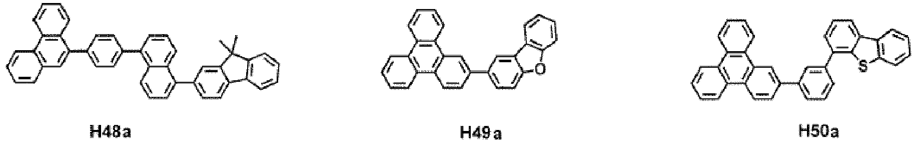

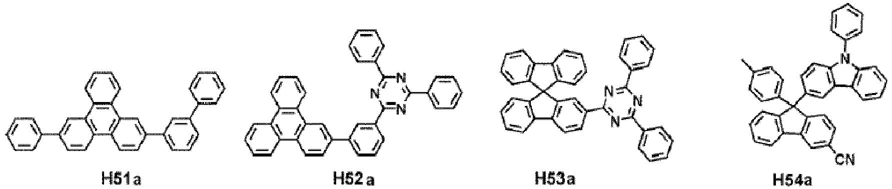

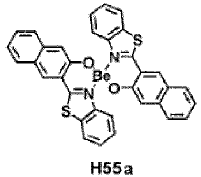

### [Fluorescent dopant in emission layer]

The fluorescent dopant may include an arylamine compound or styrylamine compound.

The fluorescent dopant may include a compound represented by Formula 501 below.

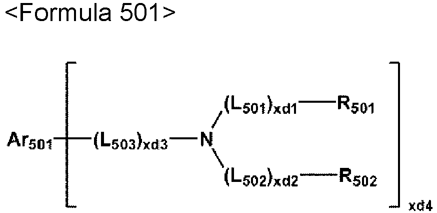

In Formula 501,
Ar₅₀₁ may be a substituted or unsubstituted C₅-C₆₀ carbocyclic group or a substituted or unsubstituted C₁-C₆₀ heterocyclic group,
L₅₀₁ to L₅₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xd1 to xd3 may be each independently an integer of 0 to 3,
R₅₀₁ and R₅₀₂ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, and
xd4 may be an integer of 1 to 6.

For example, Ar₅₀₁ may be a substituted or unsubstituted C₅-C₃₀ carbocyclic group or a substituted or unsubstituted C₁-C₂₀ heterocyclic group, but embodiments are not limited thereto.

According to an embodiment, Ar₅₀₁ in Formula 501 may be selected from:
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group; and
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

For example, L₅₀₁ to L₅₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₃₀ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group, but embodiments are not limited thereto.

According to another embodiment, L₅₀₁ to L₅₀₃ in Formula 501 may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

For example, R₅₀₁ and R₅₀₂ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, and a substituted or unsubstituted monovalent non-aromatic condensed heteropolycyclic group, but embodiments are not limited thereto.

According to some embodiments, R₅₀₁ and R₅₀₂ in Formula 501 may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and -Si(Q₃₁)(Q₃₂)(Q₃₃),
wherein Q₃₁ to Q₃₃ may be selected from a C₁-C₁₀ alkyl group, a C₁-C₁₀ alkoxy group, a phenyl group, a biphenyl group, a terphenyl group, and a naphthyl group.

According to some embodiments, xd4 in Formula 501 may be 2, but embodiments are not limited thereto.

For example, the fluorescent dopant may be selected from Compounds FD1 to FD22:

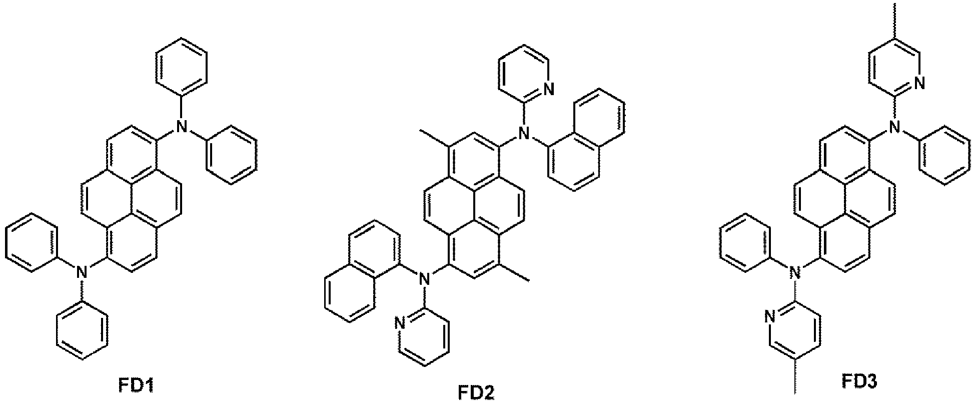

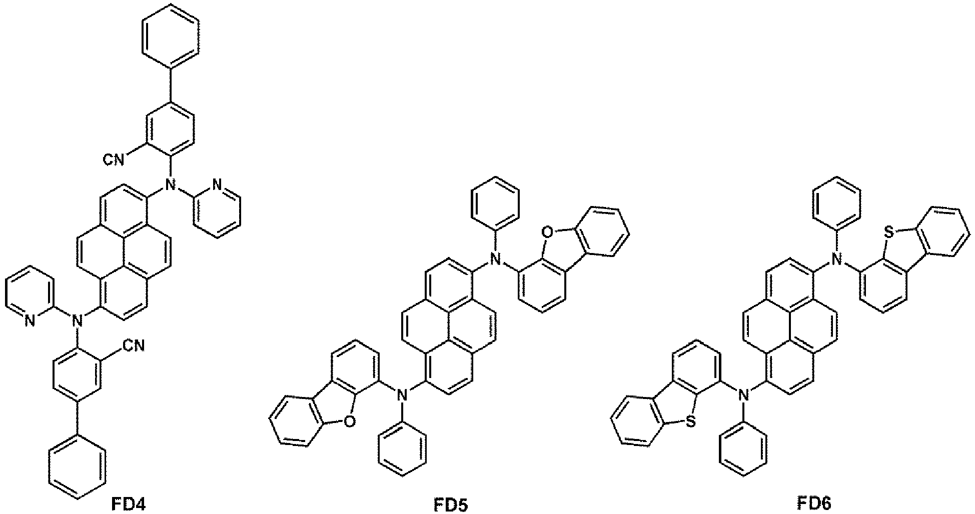

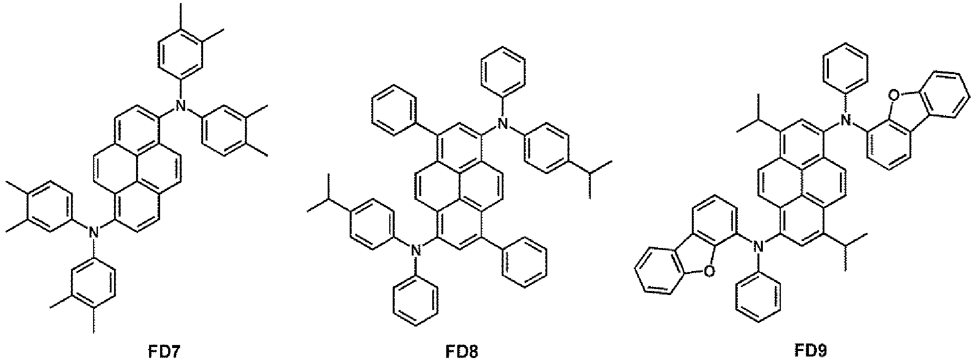

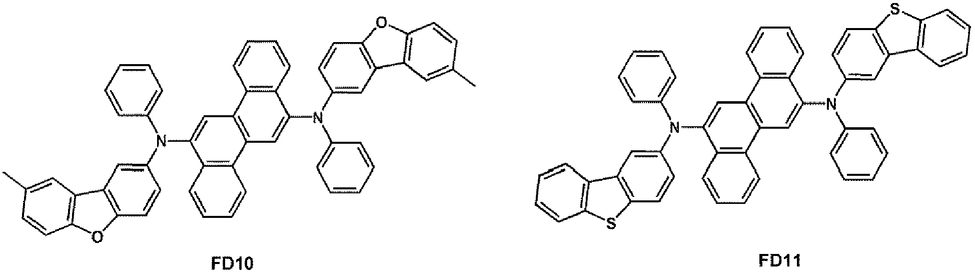

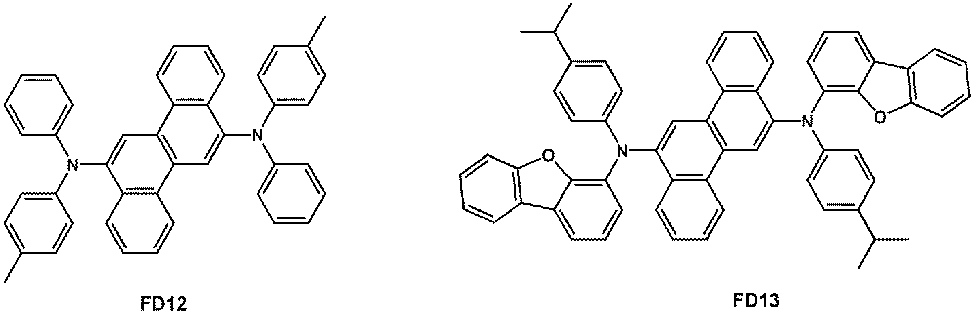

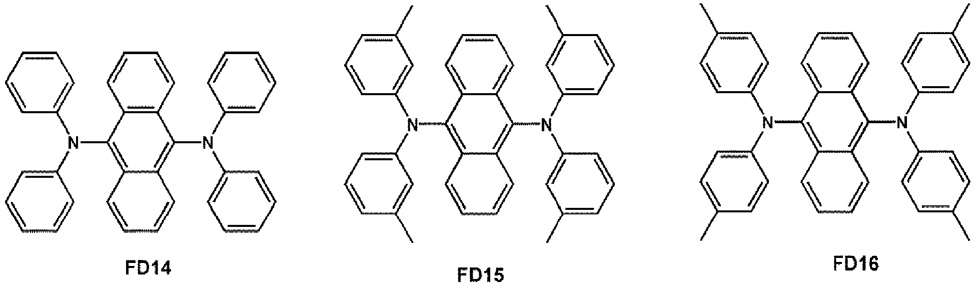

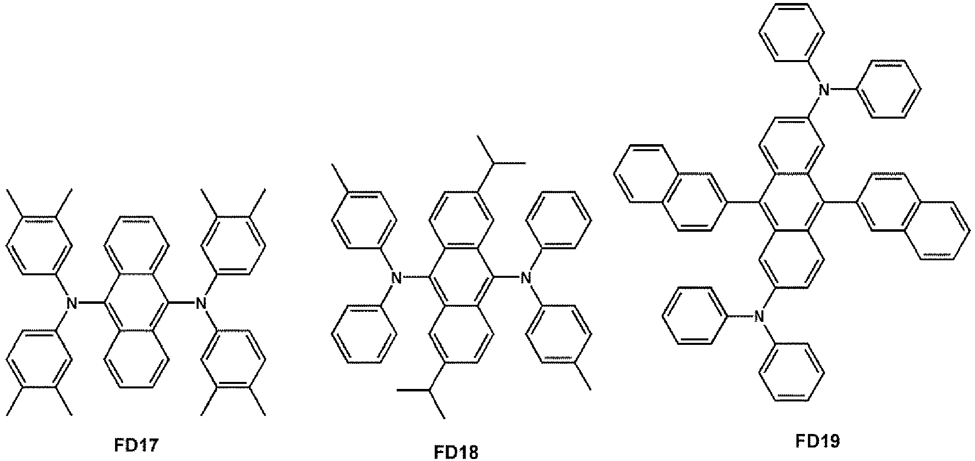

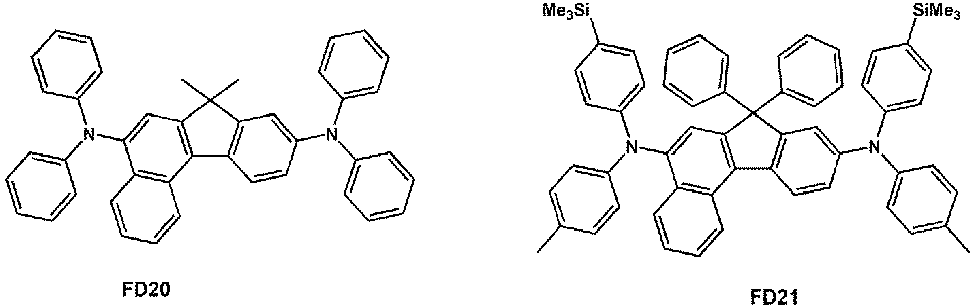

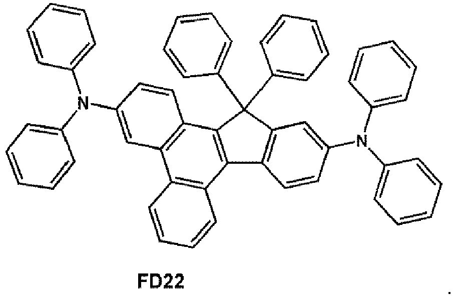

Alternatively, the fluorescent dopant may be selected from compounds illustrated below, but embodiments are not limited thereto.

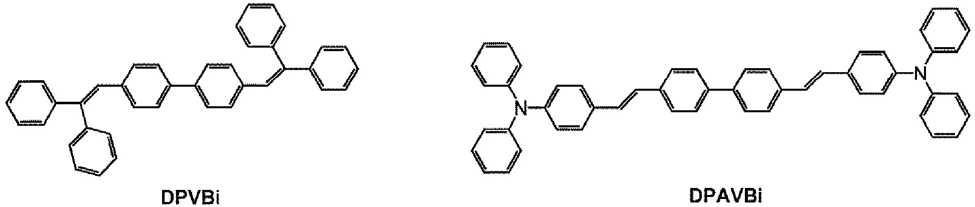

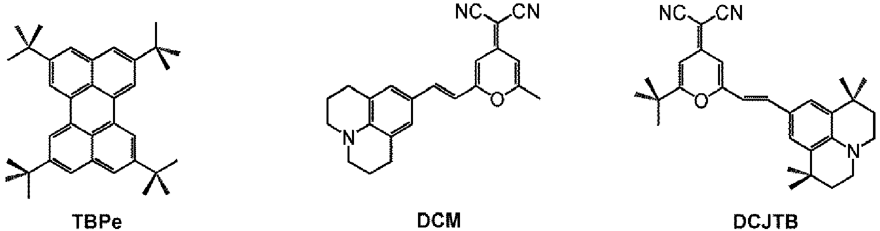

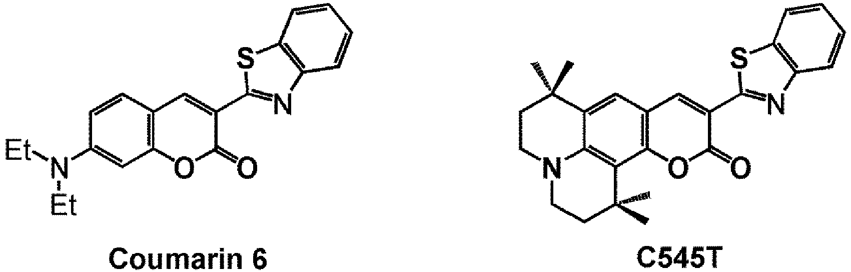

### [Electron transport region in organic layer 150]

The electron transport region may have i) a single-layered structure including a single layer including a single material, ii) a single-layered structure including a single layer including a plurality of different materials, or iii) a multi-layered structure having a plurality of layers including a plurality of different materials.

The electron transport region may include at least one selected from a buffer layer, a hole blocking layer, an electron control layer, an electron transport layer (ETL), and an electron injection layer, but is not limited thereto.

For example, the electron transport region may have a structure of electron transport layer/electron injection layer, a structure of hole blocking layer/electron transport layer/electron injection layer, a structure of electron control layer/electron transport layer/electron injection layer, or a structure of buffer layer/electron transport layer/electron injection layer, wherein in each of these structures, constituting layers are sequentially stacked in this stated order from an emission layer. However, the structure of the electron transport layer is not limited thereto.

The electron transport region (for example, a buffer layer, a hole blocking layer, an electron control layer, or an electron transport layer in the electron transport region) may include a metal-free compound containing at least one π electron-depleted nitrogen-containing ring.

The "π electron-depleted nitrogen-containing ring" indicates a C₁-C₆₀ heterocyclic group (e.g. a C₁-C₃₀ heterocyclic group) having at least one *-N=*' moiety as a ring-forming moiety.

For example, the "π electron-depleted nitrogen-containing ring" may be i) a 5-membered to 7-membered hetero monocyclic group having at least one *-N=*' moiety, ii) a heteropolycyclic group in which two or more 5-membered to 7-membered hetero monocyclic groups each having at least one *-N=*' moiety are condensed with each other, or iii) a heteropolycyclic group in which at least one of 5-membered to 7-membered hetero monocyclic groups, each having at least one *-N=*' moiety, is condensed with at least one C₅-C₆₀ carbocyclic group.

Examples of the π electron-depleted nitrogen-containing ring are an imidazole, a pyrazole, a thiazole, an isothiazole, an oxazole, an isoxazole, a pyridine, a pyrazine, a pyrimidine, a pyridazine, an indazole, a purine, a quinoline, an isoquinoline, a benzoquinoline, a phthalazine, a naphthyridine, a quinoxaline, a quinazoline, a cinnoline, a phenanthridine, an acridine, a phenanthroline, a phenazine, a benzoimidazole, an isobenzothiazole, a benzoxazole, an isobenzoxazole, a triazole, a tetrazole, an oxadiazole, a triazine, thiadiazol, an imidazopyridine, an imidazopyrimidine, and an azacarbazole, but are not limited thereto.

For example, the electron transport region (for example, a buffer layer, a hole blocking layer, an electron control layer, or an electron transport layer in the electron transport region) may include a second compound represented by Formula 2.

In an embodiment, the electron transport region may include a first layer, and the first layer may include a second compound represented by Formula 2, but embodiments are not limited thereto. In this regard, the first layer may be an electron transport layer.

In an embodiment, the electron transport region may include a first layer and a second layer, and the first layer is disposed between the emission layer and the second layer, and the first layer may include a second compound represented by Formula 2, but embodiments are not limited thereto. In this regard, the first layer may be a buffer layer, and the second layer may be an electron transport layer.

The electron transport region may further include, in addition to the second compound represented by Formula 2, a compound represented by Formula 601.

<Formula 601> [Ar₆₀₁]ₓₑ₁₁-[(L₆₀₁)ₓₑ₁-R₆₀₁]ₓₑ₂₁

In Formula 601,
Ar₆₀₁ may be a substituted or unsubstituted C₅-C₆₀ carbocyclic group or a substituted or unsubstituted C₁-C₆₀ heterocyclic group,
xe11 may be 1, 2, or 3,
L₆₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xe1 may be an integer of 0 to 5,
R₆₀₁ may be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₆₀₁)(Q₆₀₂)(Q₆₀₃), -C(=O)(Q₆₀₁), -S(=O)₂(Q₆₀₁), and -P(=O)(Q₆₀₁)(Q₆₀₂),
wherein Q₆₀₁ to Q₆₀₃ may be each independently a C₁-C₁₀ alkyl group, a C₁-C₁₀ alkoxy group, a phenyl group, a biphenyl group, a terphenyl group, or a naphthyl group, and
xe21 may be an integer of 1 to 5.

According to an embodiment, at least one of Ar₆₀₁(s) in the number of xe11 and R₆₀₁(s) in the number of xe21 may include a π electron-depleted nitrogen-containing ring.

For example, Ar₆₀₁ may be a substituted or unsubstituted C₅-C₃₀ carbocyclic group or a substituted or unsubstituted C₁-C₂₀ heterocyclic group, but embodiments are not limited thereto.

According to an embodiment, ring Ar₆₀₁ in Formula 601 may be selected from:
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzoimidazole group, an isobenzothiazole group, a benzoxazole group, an isobenzoxazole group, a triazole group, a tetrazole group, an oxadiazole group, a triazine group, a thiadiazol group, an imidazopyridine group, an imidazopyrimidine group, and an azacarbazole group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzoimidazole group, an isobenzothiazole group, a benzoxazole group, an isobenzoxazole group, a triazole group, a tetrazole group, an oxadiazole group, a triazine group, a thiadiazol group, an imidazopyridine group, an imidazopyrimidine group, and an azacarbazole group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -S(=O)₂(Q₃₁), and -P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

When xe11 in Formula 601 is 2 or more, two or more Ar₆₀₁(s) may be linked to each other via a single bond.

According to another embodiment, Ar₆₀₁ in Formula 601 may be an anthracene group.

According to some embodiments, the compound represented by Formula 601 may be represented by Formula 601-1:

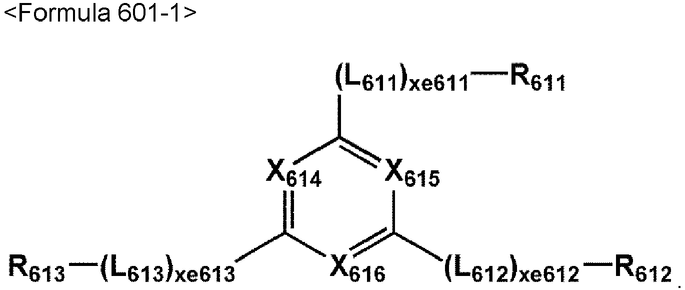

In Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may be N,
L₆₁₁ to L₆₁₃ are each independently the same as described above in connection with L₆₀₁,
xe611 to xe613 are each independently the same as described above in connection with xe1,
R₆₁₁ to R₆₁₃ are each independently the same as described above in connection with R₆₀₁, and
R₆₁₄ to R₆₁₆ may each independently be selected from hydrogen, deuterium, - F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

For example, L₆₀₁ and L₆₁₁ to L₆₁₃ in Formulae 601 and 601-1 may each independently be selected from: a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₃₀ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group, but embodiments are not limited thereto.

According to an embodiment, L₆₀₁ and L₆₁₁ to L₆₁₃ in Formulae 601 and 601-1 may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, but embodiments are not limited thereto.

According to another embodiment, xe1 and xe611 to xe613 in Formulae 601 and 601-1 may be each independently 0, 1, or 2.

For example, R₆₀₁ and R₆₁₁ to R₆₁₃ in Formulae 601 and 601-1 may each independently be selected from: a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, a substituted or unsubstituted monovalent non-aromatic condensed heteropolycyclic group, -Si(Q₆₀₁)(Q₆₀₂)(Q₆₀₃), -C(=O)(Q₆₀₁), -S(=O)₂(Q₆₀₁), and -P(=O)(Q₆₀₁)(Q₆₀₂)

According to some embodiments, R₆₀₁ and R₆₁₁ to R₆₁₃ in Formulae 601 and 601-1 may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
-S(=O)₂(Q₆₀₁) and -P(=O)(Q₆₀₁)(Q₆₀₂),
wherein Q₆₀₁ and Q₆₀₂ are the same as described herein.

The electron transport region may include at least one compound selected from Compounds ET1 to ET36, but embodiments are not limited thereto:

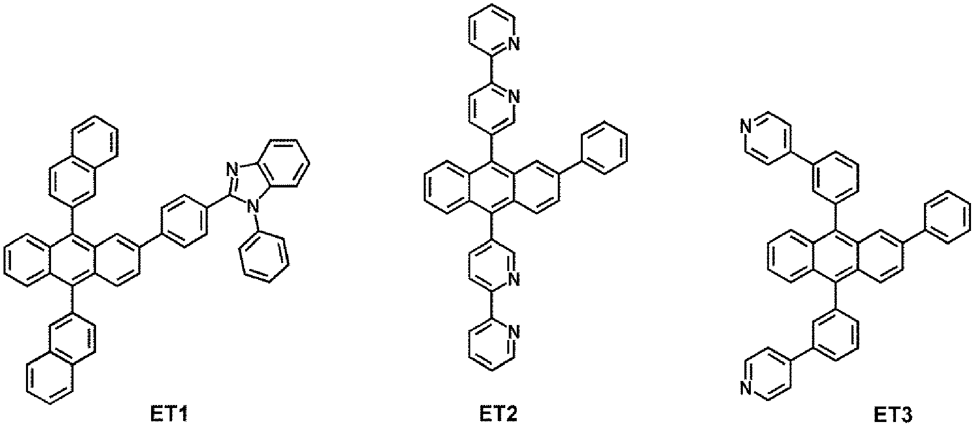

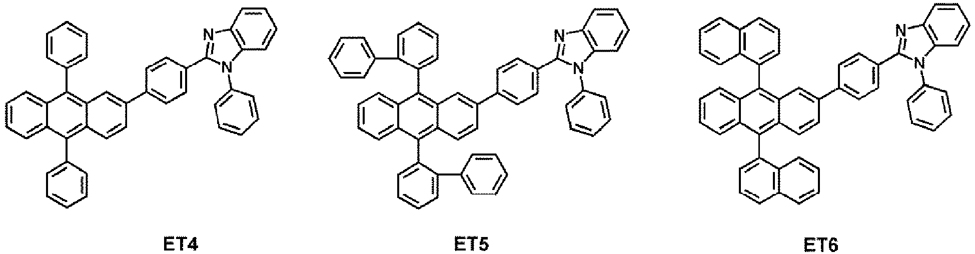

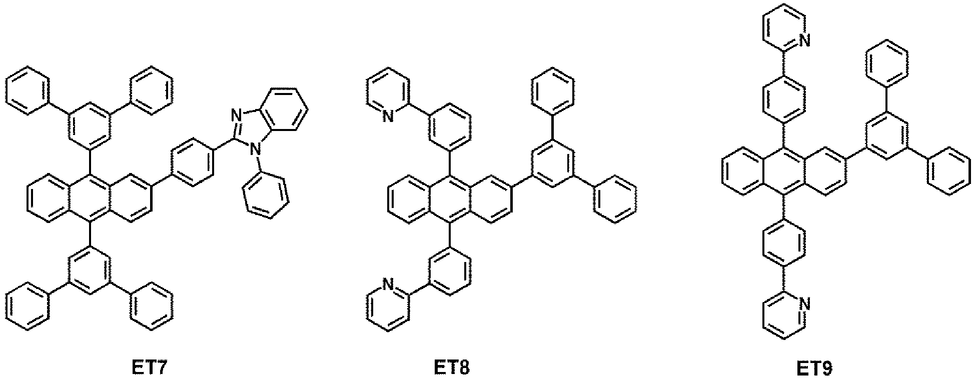

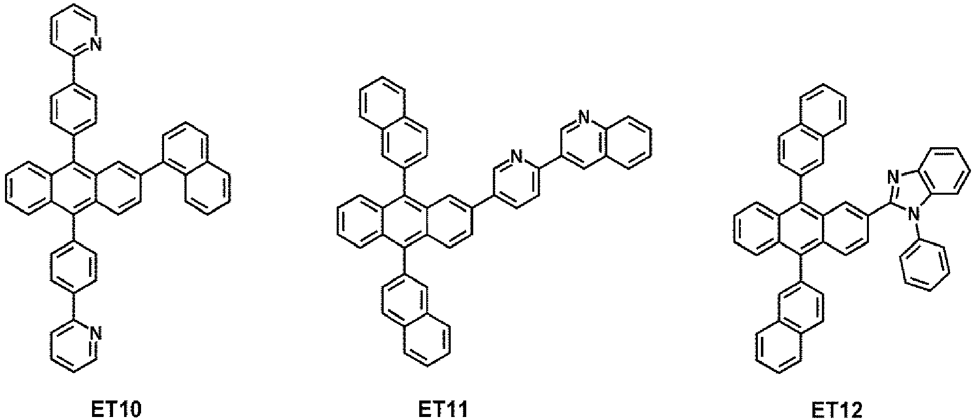

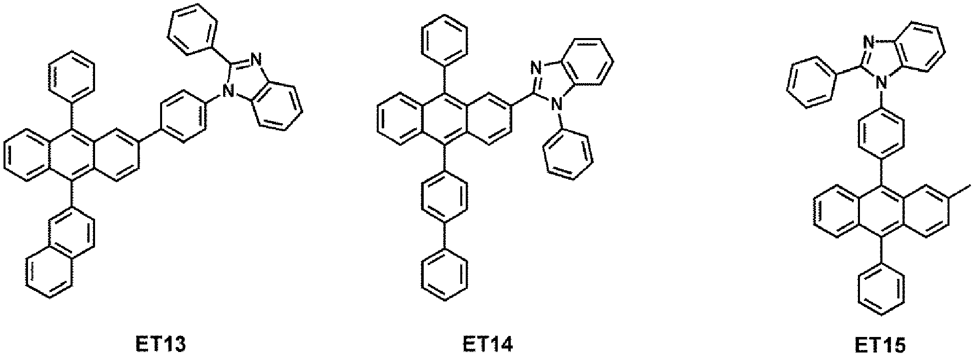

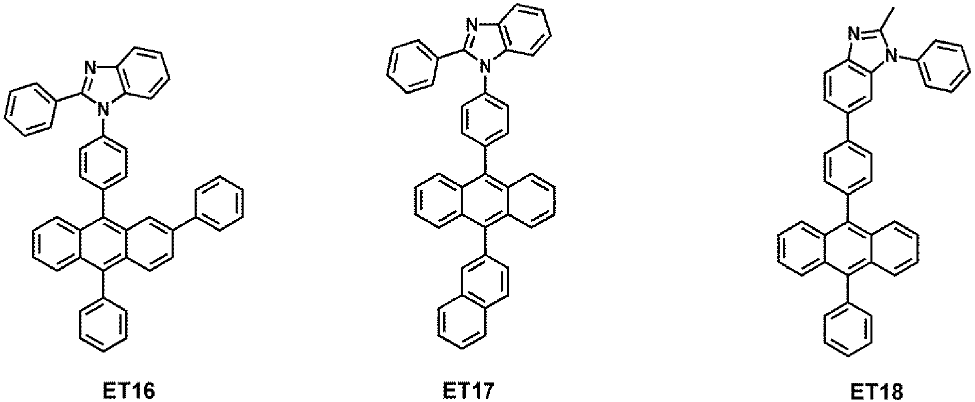

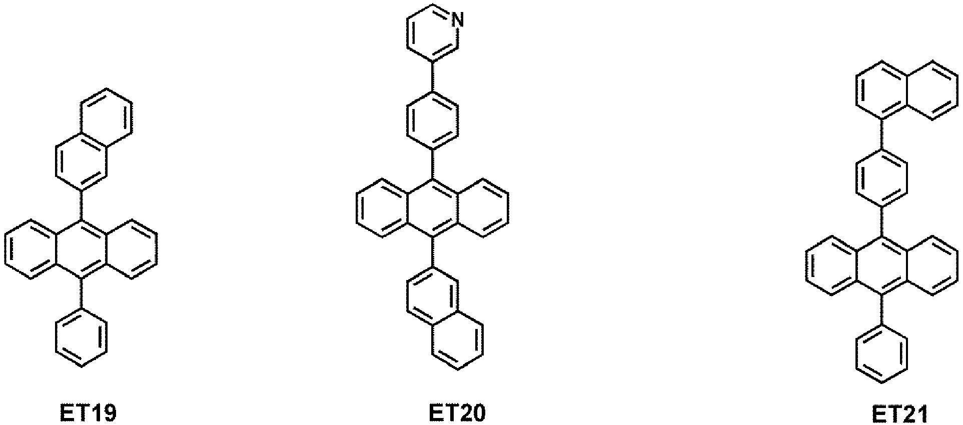

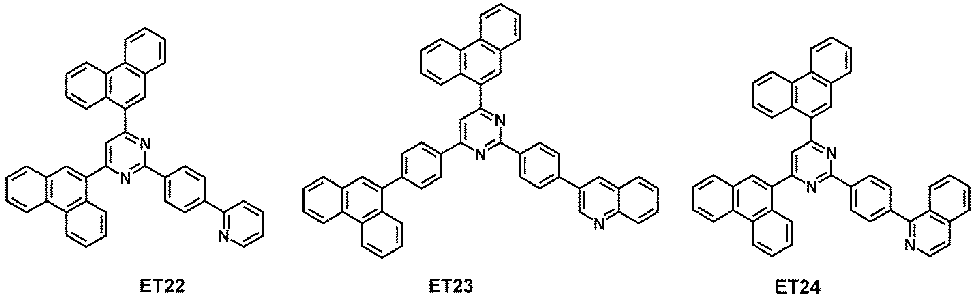

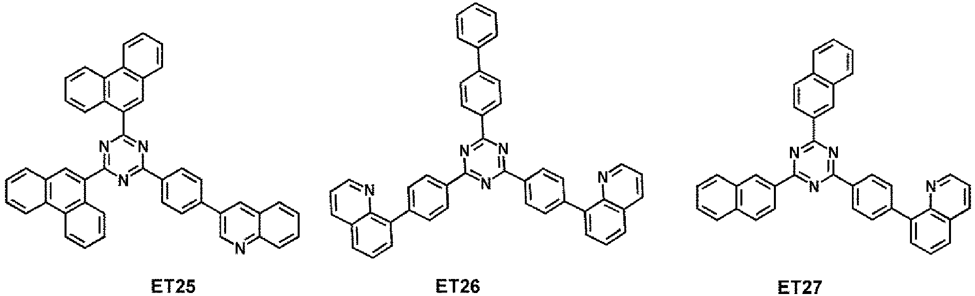

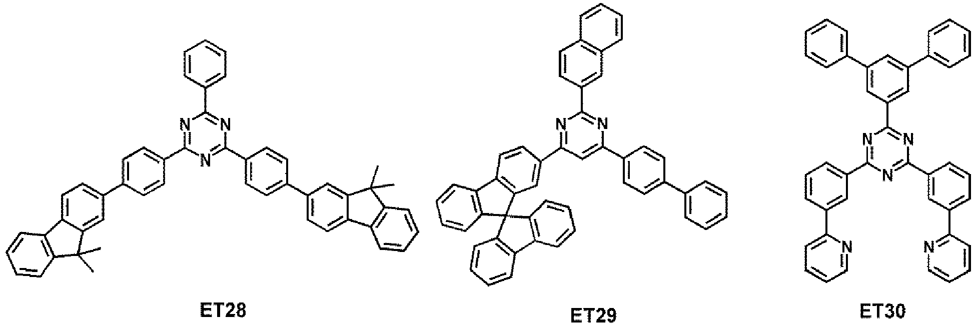

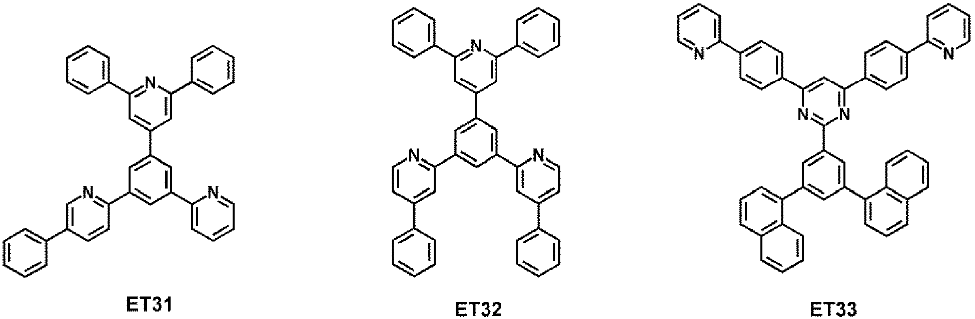

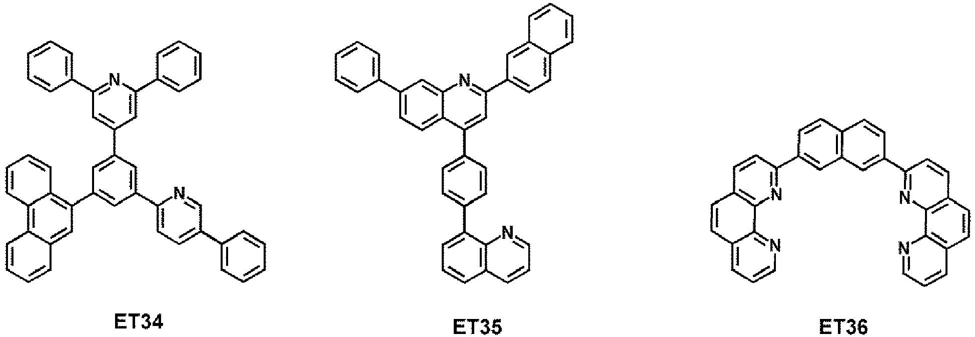

In some embodiments, the electron transport region may include at least one compound selected from 2,9-dimethyl-4,7-diphenyl-1,10-phenanthroline (BCP), 4,7-diphenyl-1,10-phenanthroline (Bphen), Alq₃, Balq, 3-(biphenyl-4-yl)-5-(4-tert-butylphenyl)-4-phenyl-4H-1,2,4-triazole (TAZ), and NTAZ.

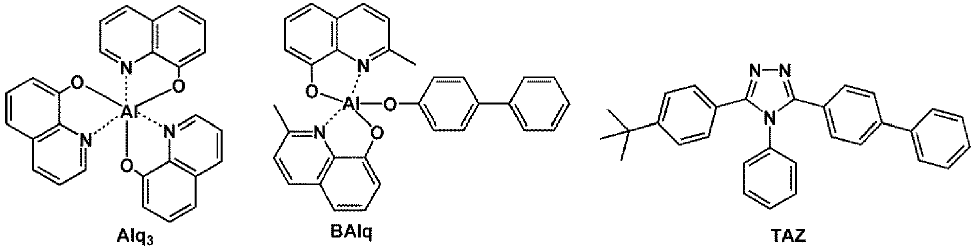

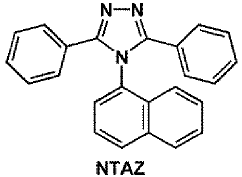

A thickness of the buffer layer, the hole blocking layer, or the electron control layer may be in a range of about 20 A to about 1,000 A, for example, about 20 A to about 700 A, about 20 A to about 500 A, about 20 A to about 400, about 30 A to about 400 A or A, or about 30 A to about 300 A. When the thicknesses of the buffer layer, the hole blocking layer, and the electron control layer are within these ranges, the electron blocking layer may have excellent electron blocking characteristics or electron control characteristics without a substantial increase in driving voltage.

A thickness of the electron transport layer may be in a range of about 100 A to about 1,000 A, for example, about 100 A to about 700 A, about 100 A to about 600 A. about 150 A to about 600 A or about 150 Å to about 500 Å. When the thickness of the electron transport layer is within the range described above, the electron transport layer may have satisfactory electron transport characteristics without a substantial increase in driving voltage.

The electron transport region (for example, the electron transport layer in the electron transport region) may further include, in addition to the materials described above, a metal-containing material.

The metal-containing material may include at least one selected from an alkali metal complex and an alkali earth-metal complex. The alkali metal complex may include a metal ion selected from an Li ion, a Na ion, a K ion, a Rb ion, and a Cs ion, and the alkali earth-metal complex may include a metal ion selected from a Be ion, a Mg ion, a Ca ion, a Sr ion, and a Ba ion. A ligand coordinated with the metal ion of the alkali metal complex or the alkali earth-metal complex may each independently selected from a hydroxy quinoline, a hydroxy isoquinoline, a hydroxy benzoquinoline, a hydroxy acridine, a hydroxy phenanthridine, a hydroxy phenyl oxazole, a hydroxy phenylthiazole, a hydroxy diphenyloxadiazole, a hydroxy diphenylthiadiazole, a hydroxy phenylpyridine, a hydroxy phenylbenzoimidazole, a hydroxy phenylbenzothiazole, a bipyridine, a phenanthroline, and a cyclopentadiene, but is not limited thereto.

For example, the metal-containing material may include a Li complex. The Li complex may include, for example, Compound ET-D1 (lithium quinolate, LiQ) or ET-D2.

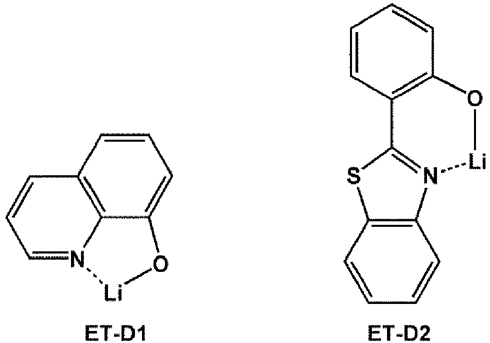

The electron transport region may include an electron injection layer that facilitates injection of electrons from the second electrode 190. The electron injection layer may directly contact the second electrode 190.

The electron injection layer may have i) a single-layered structure including a single layer including a single material, ii) a single-layered structure including a single layer including a plurality of different materials, or iii) a multi-layered structure having a plurality of layers including a plurality of different materials.

The electron injection layer may include alkali metal, alkali earth metal, rare-earth metal, alkali metal compound, alkali earth-metal compound, rare-earth metal compound, alkali metal complex, alkali earth-metal complex, rare-earth metal complex or any combinations thereof.

The alkali metal may be selected from Li, Na, K, Rb, and Cs. In an embodiment, the alkali metal may be Li, Na, or Cs. In some embodiments, the alkali metal may be Li or Cs, but is not limited thereto.

The alkali earth metal may be selected from Mg, Ca, Sr, and Ba.

The rare-earth metal may be selected from Sc, Y, Ce, Tb, Yb, Gd, and Tb.

The alkali metal compound, the alkali earth-metal compound, and the rare-earth metal compound may be selected from oxides and halides (for example, fluorides, chlorides, bromides, or iodides) of the alkali metal, the alkali earth-metal and rare-earth metal.

The alkali metal compound may be selected from alkali metal oxides, such as Li₂O, Cs₂O, or K₂O, and alkali metal halides, such as LiF, NaF, CsF, KF, Lil, Nal, Csl, or KI. In an embodiment, the alkali metal compound may be selected from LiF, Li₂O, NaF, Lil, Nal, Csl, and KI, but is not limited thereto.

The alkali earth-metal compound may be selected from alkali earth-metal compounds, such as BaO, SrO, CaO, BaₓSr₁₋ₓO(0<x<1), or BaₓCa₁₋ₓO(0<x<1). In an embodiment, the alkali earth-metal compound may be selected from BaO, SrO, and CaO, but is not limited thereto.

The rare-earth metal compound may be selected from YbF₃, ScF₃, ScO₃, Y₂O₃, Ce₂O₃, GdF₃, and TbF₃. In an embodiment, the rare-earth metal compound may be selected from YbF₃, ScF₃, TbF₃, YbI₃, ScI₃, and TbI₃, but is not limited thereto.

The alkali metal complex, the alkali earth-metal complex, and the rare-earth metal complex may include an ion of alkali metal, alkali earth-metal, and rare-earth metal as described above, and a ligand coordinated with a metal ion of the alkali metal complex, the alkali earth-metal complex, and the rare-earth metal complex may each independently be selected from hydroxy quinoline, hydroxy isoquinoline, hydroxy benzoquinoline, hydroxy acridine, hydroxy phenanthridine, hydroxy phenyloxazole, hydroxy phenylthiazole, hydroxy diphenyloxadiazole, hydroxy diphenylthiadiazol, hydroxy phenylpyridine, hydroxy phenylbenzoimidazole, hydroxy phenylbenzothiazole, bipyridine, and a phenanthroline and cyclopentadiene, but is not limited thereto.

The electron injection layer may include only alkali metal, alkali earth metal, rare-earth metal, alkali metal compound, alkali earth-metal compound, rare-earth metal compound, alkali metal complex, alkali earth-metal complex, rare-earth metal complex or any combinations thereof, as described above. In some embodiments, the electron injection layer may further include an organic material. When the electron injection layer further includes an organic material, alkali metal, alkali earth metal, rare-earth metal, alkali metal compound, alkali earth-metal compound, rare-earth metal compound, alkali metal complex, alkali earth-metal complex, rare-earth metal complex, or any combinations thereof may be homogeneously or inhomogeneously dispersed in a matrix including the organic material.

A thickness of the electron injection layer may be in a range of about 1 Å to about 100 A, about 1 Å to about 95 A, about 2 A to about 95 A or about 3 Å to about 90 Å. When a thickness of the electron injection layer is within these ranges, satisfactory electron injection characteristics may be obtained without substantial increase in driving voltage.

### [Second electrode 190]

The second electrode 190 may be disposed on the organic layer 150 having such a structure. The second electrode 190 may be a cathode which is an electron injection electrode, and in this regard, a material for the second electrode 190 may be selected from metal, an alloy, an electrically conductive compound, and a mixture thereof, which have a relatively low work function.

The second electrode 190 may include at least one selected from lithium (Li), silver (Ag), magnesium (Mg), aluminum (Al), aluminum-lithium (Al-Li), calcium (Ca), magnesium-indium (Mg-In), magnesium-silver (Mg-Ag), ITO, and IZO, but is not limited thereto. The second electrode 190 may be a transmissive electrode, a semi-transmissive electrode, or a reflective electrode.

The second electrode 190 may have a single-layer structure, or a multi-layer structure including two or more layers.

### [Description of FIGS. 2 to 4]

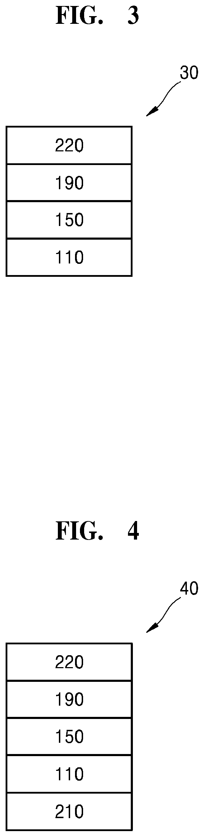

An organic light-emitting device 20 of FIG. 2 includes a first capping layer 210, a first electrode 110, an organic layer 150, and a second electrode 190 which are sequentially stacked in this stated order, an organic light-emitting device 30 of FIG. 3 includes a first electrode 110, an organic layer 150, a second electrode 190, and a second capping layer 220 which are sequentially stacked in this stated order, and an organic light-emitting device 40 of FIG. 4 includes a first capping layer 210, a first electrode 110, an organic layer 150, a second electrode 190, and a second capping layer 220.

Regarding FIGS. 2 to 4, the first electrode 110, the organic layer 150, and the second electrode 190 may be understood by referring to the description presented in connection with FIG. 1.

In the organic layer 150 of each of the organic light-emitting devices 20 and 40, light generated in an emission layer may pass through the first electrode 110, which is a semi-transmissive electrode or a transmissive electrode, and the first capping layer 210 toward the outside, and in the organic layer 150 of each of the organic light-emitting devices 30 and 40, light generated in an emission layer may pass through the second electrode 190, which is a semi-transmissive electrode or a transmissive electrode, and the second capping layer 220 toward the outside.

The first capping layer 210 and the second capping layer 220 may increase external luminescent efficiency according to the principle of constructive interference.

The first capping layer 210 and the second capping layer 220 may each independently be a capping layer including an organic material, an inorganic capping layer including an inorganic material, or a composite capping layer including an organic material and an inorganic material.

At least one selected from the first capping layer 210 and the second capping layer 220 may each independently include at least one material selected from carbocyclic compounds, heterocyclic compounds, amine-based compounds, porphine derivatives, phthalocyanine derivatives, naphthalocyanine derivatives, alkali metal complexes, and alkali earth-based complexes. The carbocyclic compound, the heterocyclic compound, and the amine-based compound may be optionally substituted with a substituent containing at least one element selected from O, N, S, Se, Si, F, CI, Br, and I. In an embodiment, at least one selected from the first capping layer 210 and the second capping layer 220 may each independently include an amine-based compound.

In an embodiment, at least one selected from the first capping layer 210 and the second capping layer 220 may each independently include the compound represented by Formula 201 or the compound represented by Formula 202.

In some embodiments, at least one selected from the first capping layer 210 and the second capping layer 220 may each independently include a compound selected from Compounds HT28 to HT33 and Compounds CP1 to CP5, but is not limited thereto.

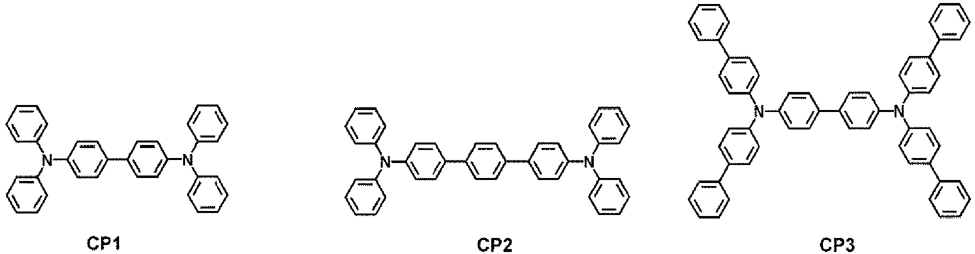

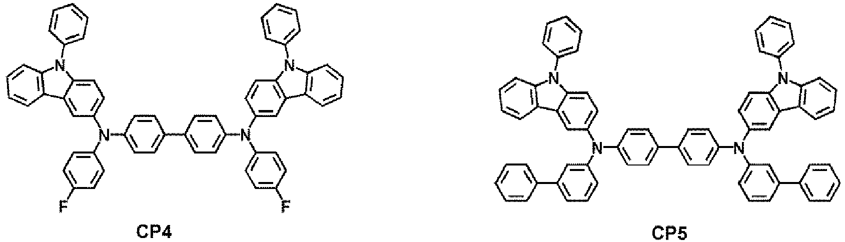

Hereinbefore, the organic light-emitting device according to an embodiment has been described in connection with FIGS. 1-4. However, embodiments are not limited thereto.

Layers constituting the hole transport region, an emission layer, and layers constituting the electron transport region may be formed in a certain region by using one or more methods selected from vacuum deposition, spin coating, casting, a Langmuir-Blodgett (LB) method, ink-jet printing, laser-printing, and laser-induced thermal imaging.

When layers constituting the hole transport region, an emission layer, and layers constituting the electron transport region are formed by vacuum deposition, for example, the vacuum deposition may be performed at a deposition temperature of about 100°C to about 500°C, at a vacuum degree of about 10⁻⁸ to about 10⁻³ torr, and at a deposition rate of about 0.01 to about 100 A/sec by taking into account a compound to be included in a to-be-formed layer, and the structure of a to-be-formed layer.

When layers constituting the hole transport region, an emission layer, and layers constituting the electron transport region are formed by spin coating, the spin coating may be performed at a coating speed of about 2000 rpm to about 5000 rpm and at a heat treatment temperature of about 80°C to 200°C by taking into account a compound to be included in a to-be-formed layer, and the structure of a to-be-formed layer.

### [General definition of substituents]

A C₁-C₆₀ alkyl group used herein refers to a linear or branched aliphatic hydrocarbon monovalent group having 1 to 60 carbon atoms, and examples thereof are a methyl group, an ethyl group, a propyl group, an isobutyl group, a sec-butyl group, a tert-butyl group, a pentyl group, an iso-amyl group, and a hexyl group. A C₁-C₆₀ alkylene group used herein refers to a divalent group having the same structure as the C₁-C₆₀ alkyl group.

A C₂-C₆₀ alkenyl group used herein refers to a hydrocarbon group having at least one carbon double bond in the middle or at the terminal of the C₂-C₆₀ alkyl group, and examples thereof are an ethenyl group, a propenyl group, and a butenyl group. A C₂-C₆₀ alkenylene group used herein refers to a divalent group having the same structure as the C₂-C₆₀ alkenyl group.

A C₂-C₆₀ alkynyl group used herein refers to a hydrocarbon group having at least one carbon triple bond in the middle or at the terminal of the C₂-C₆₀ alkyl group, and examples thereof are an ethynyl group and a propynyl group. A C₂-C₆₀ alkynylene group used herein refers to a divalent group having the same structure as the C₂-C₆₀ alkynyl group.

A C₁-C₆₀ alkoxy group used herein refers to a monovalent group represented by -OA₁₀₁ (wherein A₁₀₁ is the C₁-C₆₀ alkyl group), and examples thereof are a methoxy group, an ethoxy group, and an isopropyloxy group.

A C₃-C₁₀ cycloalkyl group used herein refers to a monovalent hydrocarbon monocyclic group having 3 to 10 carbon atoms, and examples thereof are a cyclopropyl group, a cyclobutyl group, a cyclopentyl group, a cyclohexyl group, and a cycloheptyl group. A C₃-C₁₀ cycloalkylene group used herein refers to a divalent group having the same structure as the C₃-C₁₀ cycloalkyl group.

A C₁-C₁₀ heterocycloalkyl group used herein refers to a monovalent monocyclic group having at least one heteroatom selected from N, O, Si, P, and S as a ring-forming atom and 1 to 10 carbon atoms, and examples thereof are a 1,2,3,4-oxatriazolidinyl group, a tetrahydrofuranyl group, and a tetrahydrothiophenyl group. A C₁-C₁₀ heterocycloalkylene group used herein refers to a divalent group having the same structure as the C₁-C₁₀ heterocycloalkyl group.

A C₃-C₁₀ cycloalkenyl group used herein refers to a monovalent monocyclic group that has 3 to 10 carbon atoms and at least one double bond in the ring thereof and does not have aromaticity, and examples thereof are a cyclopentenyl group, a cyclohexenyl group, and a cycloheptenyl group. A C₃-C₁₀ cycloalkenylene group used herein refers to a divalent group having the same structure as the C₃-C₁₀ cycloalkenyl group.

A C₁-C₁₀ heterocycloalkenyl group used herein refers to a monovalent monocyclic group that has at least one heteroatom selected from N, O, P, and S as a ring-forming atom, 1 to 10 carbon atoms, and at least one double bond in its ring. Examples of the C₁-C₁₀ heterocycloalkenyl group are a 4,5-dihydro-1,2,3,4-oxatriazolyl group, a 2,3-hydrofuranyl group and a 2,3-hydrothiophenyl group. A C₁-C₁₀ heterocycloalkenylene group used herein refers to a divalent group having the same structure as the C₁-C₁₀ heterocycloalkenyl group.

A C₆-C₆₀ aryl group used herein refers to a monovalent group having a carbocyclic aromatic system having 6 to 60 carbon atoms, and a C₆-C₆₀ arylene group used herein refers to a divalent group having a carbocyclic aromatic system having 6 to 60 carbon atoms. Examples of the C₆-C₆₀ aryl group are a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other. Corresponding definitions apply to other ranges given for the number of carbon atoms in an aryl/arylene group.

A C₁-C₆₀ heteroaryl group used herein refers to a monovalent group having a carbocyclic aromatic system that has at least one heteroatom selected from N, O, Si, P, and S as a ring-forming atom, and 1 to 60 carbon atoms. A C₁-C₆₀ heteroarylene group used herein refers to a divalent group having a carbocyclic aromatic system that has at least one heteroatom selected from N, O, Si, P, and S as a ring-forming atom, and 1 to 60 carbon atoms. Examples of the C₁-C₆₀ heteroaryl group are a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include two or more rings, the rings may be fused to each other. Corresponding definitions apply to other ranges given for the number of carbon atoms in a heteroaryl/heteroarylene group.

A C₆-C₆₀ aryloxy group used herein indicates -OA₁₀₂ (wherein A₁₀₂ is the C₆-C₆₀ aryl group), and a C₆-C₆₀ arylthio group indicates -SA₁₀₃ (wherein A₁₀₃ is the C₆-C₆₀ aryl group). Corresponding definitions apply to other ranges given for the number of carbon atoms in an aryloxy group and an arylthio group.

A monovalent non-aromatic condensed polycyclic group used herein refers to a monovalent group (for example, having 8 to 60 carbon atoms) that has two or more rings condensed with each other, only carbon atoms as a ring forming atom, and non-aromaticity in the entire molecular structure. A detailed example of the monovalent non-aromatic condensed polycyclic group is a fluorenyl group. A divalent non-aromatic condensed polycyclic group used herein refers to a divalent group having the same structure as the monovalent non-aromatic condensed polycyclic group.

A monovalent non-aromatic condensed heteropolycyclic group used herein refers to a monovalent group (for example, having 1 to 60 carbon atoms) that has two or more rings condensed to each other, has at least one heteroatom selected from N, O, Si, P, and S, other than carbon atoms, as a ring forming atom, and has non-aromaticity in the entire molecular structure. An example of the monovalent non-aromatic condensed heteropolycyclic group is a carbazolyl group. A divalent non-aromatic condensed heteropolycyclic group used herein refers to a divalent group having the same structure as the monovalent non-aromatic condensed heteropolycyclic group.

A C₅-C₆₀ carbocyclic group used herein refers to a monocyclic or polycyclic group having 5 to 60 carbon atoms in which a ring-forming atom is a carbon atom only. The C₅-C₆₀ carbocyclic group may be an aromatic carbocyclic group or a non-aromatic carbocyclic group. The C₅-C₆₀ carbocyclic group may be a ring, such as a benzene, a monovalent group, such as a phenyl group, or a divalent group, such as a phenylene group. In some embodiments, depending on the number of substituents connected to the C₅-C₆₀ carbocyclic group, the C₅-C₆₀ carbocyclic group may be a trivalent group or a quadrivalent group. Corresponding definitions apply to other ranges given for the number of carbon atoms in a carbocyclic group.

A C₁-C₆₀ heterocyclic group used herein refers to a group having the same structure as the C₅-C₆₀ carbocyclic group, except that as a ring-forming atom, at least one heteroatom selected from N, O, Si, P, and S is used in addition to carbon (the number of carbon atoms may be in a range of 1 to 60). Corresponding definitions apply to other ranges given for the number of carbon atoms in a heterocyclic group.

At least one of substituents of the substituted C₅-C₆₀ carbocyclic group, substituted C₁-C₆₀ heterocyclic group, substituted C₃-C₁₀ cycloalkylene group, substituted C₁-C₁₀ heterocycloalkylene group, substituted C₃-C₁₀ cycloalkenylene group, substituted C₁-C₁₀ heterocycloalkenylene group, substituted C₆-C₆₀ arylene group, substituted C₁-C₆₀ heteroarylene group, substituted divalent non-aromatic condensed polycyclic group, substituted divalent non-aromatic condensed heteropolycyclic group, substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₁-C₆₀ heteroaryl group, substituted monovalent non-aromatic condensed polycyclic group, and substituted monovalent non-aromatic condensed heteropolycyclic group may be selected from:
deuterium (-D), -F, -CI, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, - CI, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, - F, -CI, -Br, -I, a hydroxyl group, a cyano group, a nitro group, an amidino group, a hydrazino group, a hydrazono group, a C₁-C₆₀ alkyl group, a C₂-C₆₀ alkenyl group, a C2-C60 alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q32),
wherein Q₁₁ to Q₁₃, Q₂₁ to Q₂₃, and Q₃₁ to Q₃₃ may each independently be selected from hydrogen, deuterium, -F, -CI, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

The term "Ph" used herein refers to a phenyl group, the term "Me" used herein refers to a methyl group, the term "Et" used herein refers to an ethyl group, the term "ter-Bu" or "Bu^{t}" used herein refers to a tert-butyl group, and the term "OMe" used herein refers to a methoxy group.

The term "biphenyl group" used herein refers to a "phenyl group substituted with a phenyl group". The "biphenyl group" belongs to a "substituted phenyl group" having "C₆-C₆₀ aryl group" as a substituent.

The term "terphenyl group" used herein refers to a "phenyl group substituted with a biphenyl group". The "terphenyl group" belongs to a "substituted phenyl group" having "C₆-C₆₀ aryl group substituted with a C₆-C₆₀ aryl group" as a substituent.

Unless otherwise defined, * and *' used herein each refer to a binding site to a neighboring atom in a corresponding formula.

Hereinafter, a compound according to an embodiment and an organic light-emitting device according to an embodiment will be described in detail with reference to Synthesis Examples and Examples. The wording "B was used instead of A" used in describing Synthesis Examples below means that an amount of A used was identical to an amount of B used, in terms of a molar equivalent.

### [Example]

### Reference Example 1

A Corning 15 Ohms per square centimeter (Ω/cm²) (1,200 A) ITO glass substrate was cut to a size of 50 millimeters (mm) x 50 mm x 0.7 mm, sonicated in isopropyl alcohol and pure water for 5 minutes in each solvent, and cleaned by exposure to ultraviolet rays with ozone for about 30 minutes so as to use the glass substrate as an anode. Then, the glass substrate was mounted on a vacuum deposition apparatus.

On the substrate, HT28 was vacuum-deposited to form a hole injection layer having a thickness of about 500 A. Then, as a hole transport compound, HT3 was vacuum-deposited to form a hole transport layer having a thickness of about 450 A, thereby forming a hole transport region.

Subsequently, Compound H1 (as a host) and FD1 (as a dopant) were codeposited at a volume ratio of about 95:5 to form an emission layer having a thickness of about 300 A.

Afterward, on the emission layer, Compound E1 was deposited to form an electron transport layer having a thickness of about 250 A. LiF was next deposited on the electron transport layer to form an electron injection layer having a thickness of about 5 A, thereby forming an electron transport region. Aluminum (Al) was then vacuum-deposited thereon to form a cathode having a thickness of about 1,500 A, thereby completing the manufacture of an organic light-emitting device.

### Reference Examples 2 to 13 and 17, Examples 14 to 16 and Comparative Examples 1 to 5

Organic light-emitting devices were manufactured in the same manner as in Reference Example 1, except that, instead of Compound H1 and Compound E1, the compounds listed in Table 1 were used, to form an emission layer and an electron transport layer, respectively.

**[Table 1]**

| Example | Emission layer host | Electron transport layer | Example | Emission layer host | Electron transport layer |
|---|---|---|---|---|---|
| Reference Example 1 | H1 | E1 | Reference Example 12 | H4 | E7 |
| Reference Example 2 | H1 | E2 | Reference Example 13 | H5 | E7 |
| Reference Example 3 | H1 | E3 | Example 14 | H6 | E7 |
| Reference Example 4 | H1 | E4 | Example 15 | H7 | E7 |
| Reference Example 5 | H1 | E5 | Example 16 | H8 | E7 |
| Reference Example 6 | H1 | E6 | Reference Example 17 | H9 | E7 |
| Reference Example 7 | H1 | E7 | Comparative Example 1 | Compound 1 | E7 |
| Reference Example 8 | H1 | E8 | Comparative Example 2 | Compound 2 | E7 |
| Reference Example 9 | H1 | E9 | Comparative Example 3 | H1 | Compound D |
| Reference Example 10 | H2 | E7 | Comparative Example 4 | H2 | Compound D |
| Reference Example 11 | H3 | E7 | Comparative Example 5 | H3 | Alq3 |

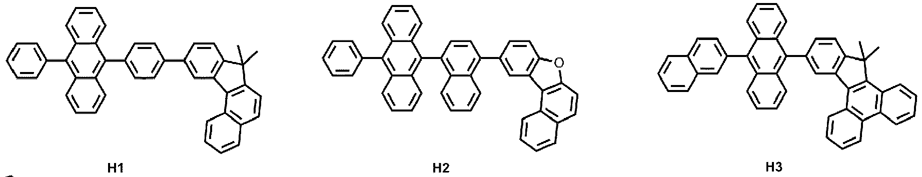

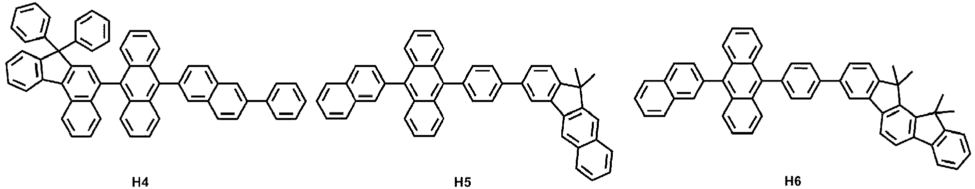

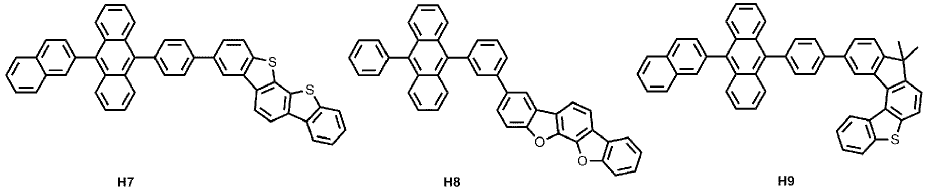

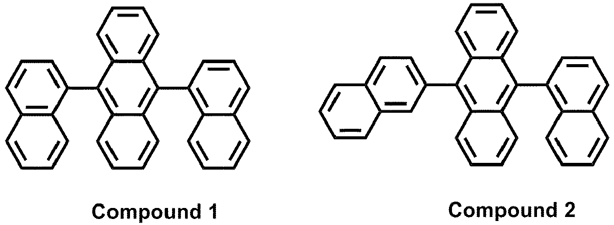

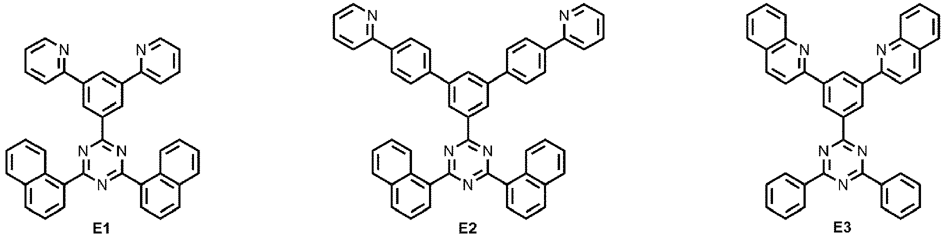

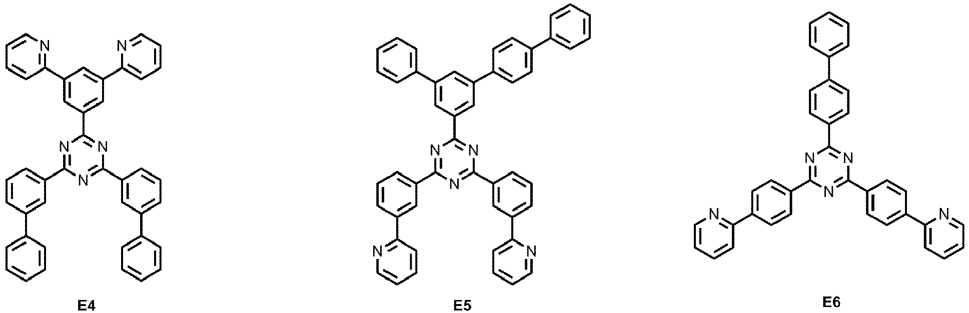

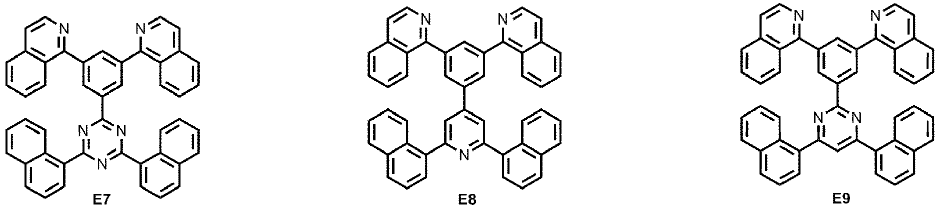

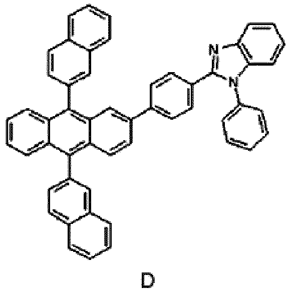

### Reference Example 18

A Corning 15 Ω/cm² (1,200 A) ITO glass substrate was cut to a size of 50 mm x 50 mm x 0.7 mm, sonicated in isopropyl alcohol and pure water for 5 minutes in each solvent, and cleaned by exposure to ultraviolet rays with ozone for about 30 minutes so as to use the glass substrate as an anode. Then, the glass substrate was mounted on a vacuum deposition apparatus.

On the substrate, HT28 was vacuum-deposited to form a hole injection layer having a thickness of about 500 Å. Then, as a hole transport compound, HT3 was vacuum-deposited to form a hole transport layer having a thickness of about 450 Å. Subsequently, Compound H1 (as a host) and FD1 (as a dopant) were codeposited at a weight ratio of about 95:5 to form an emission layer having a thickness of about 300 Å.

Afterward, on the emission layer, Compound E1 and Liq were deposited at a weight ratio of about 50:50 to form an electron transport layer having a thickness of about 250 Å. LiF was next deposited on the electron transport layer to form an electron injection layer having a thickness of about 5 Å, and then, Al was vacuum-deposited thereon to form a cathode having a thickness of about 1,500 Å, thereby completing the manufacture of an organic light-emitting device.

### Reference Examples 19 to 26 and Comparative Examples 6 to 10

Organic light-emitting devices were manufactured in the same manner as in Reference Example 18, except that, instead of Compound H1 and Compound E1, the compounds listed in Table 2 were used, to form an emission layer and an electron transport layer, respectively.

**[Table 2]**

| Example | Emission layer host | Electron transport layer | Example | Emission layer host | Electron transport layer |
|---|---|---|---|---|---|
| Reference Example 18 | H1 | E1:Liq | Reference Example 25 | H1 | E8:Liq |
| Reference Example 19 | H1 | E2:Liq | Reference Example 26 | H1 | E9:Liq |
| Reference Example 20 | H1 | E3:Liq | Comparative Example 6 | Compound 1 | E1:Liq |
| Reference Example 21 | H1 | E4:Liq | Comparative Example 7 | Compound 2 | E1:Liq |
| Reference Example 22 | H1 | E5:Liq | Comparative Example 8 | H1 | Compound D:Liq |
| Reference Example 23 | H1 | E6:Liq | Comparative Example 9 | H2 | Compound D:Liq |
| Reference Example 24 | H1 | E7:Liq | Comparative Example 10 | H3 | Alq3:Liq |

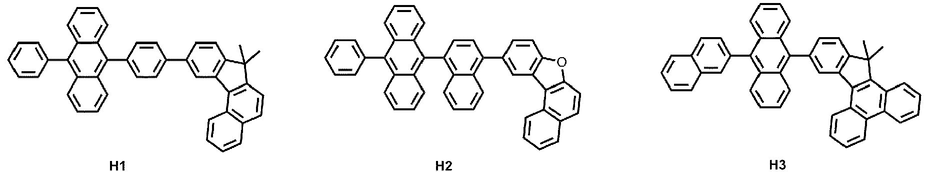

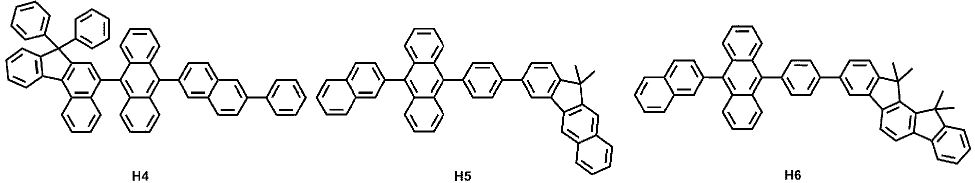

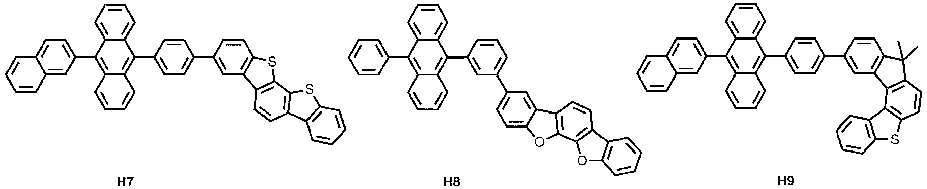

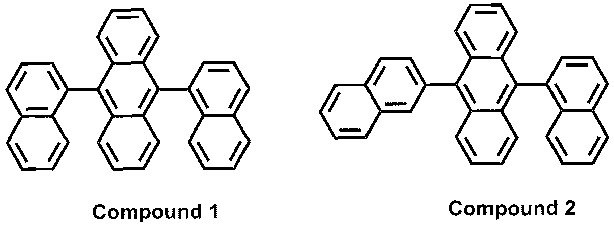

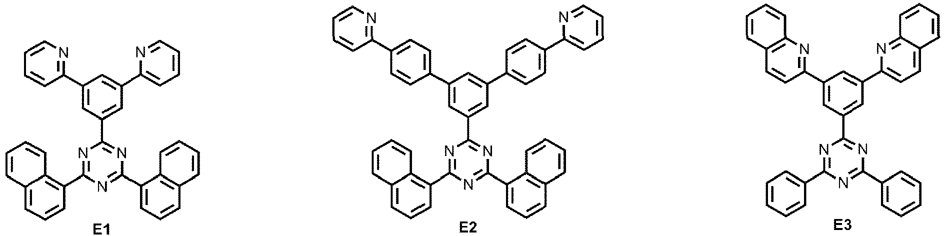

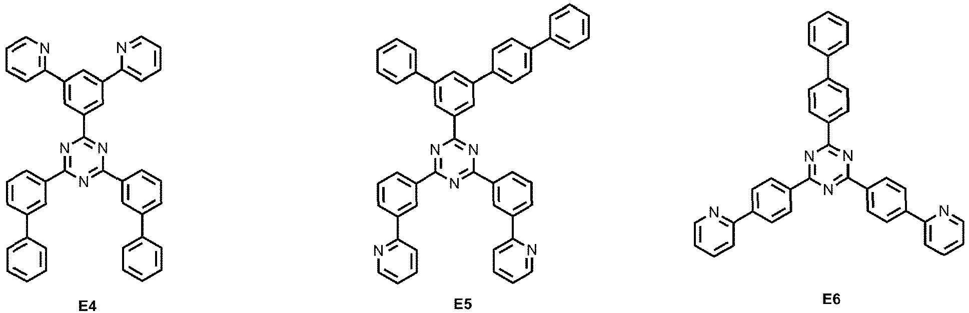

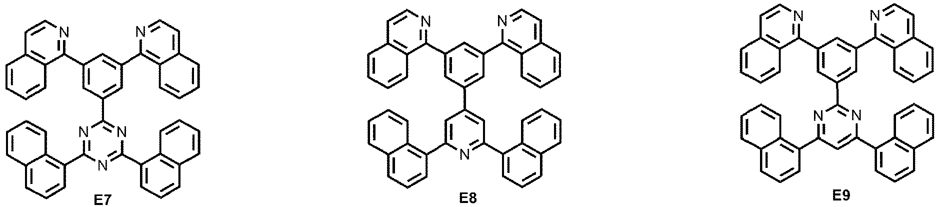

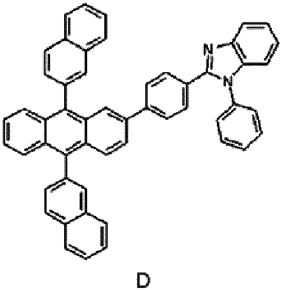

### Reference Example 27

A Corning 15 Ω/cm² (1,200 A) ITO glass substrate was cut to a size of 50 mm x 50 mm x 0.7 mm, sonicated in isopropyl alcohol and pure water for 5 minutes in each solvent, and cleaned by exposure to ultraviolet rays with ozone for about 30 minutes so as to use the glass substrate as an anode. Then, the glass substrate was mounted on a vacuum deposition apparatus.

On the substrate, HT28 was vacuum-deposited to form a hole injection layer having a thickness of about 500 Å. Then, as a hole transport compound, HT3 was vacuum-deposited to form a hole transport layer having a thickness of about 450 Å, thereby forming a hole transport region.

Subsequently, Compound H1 (as a host) and FD1 (as a dopant) were codeposited at a volume ratio of about 95:5 to form an emission layer having a thickness of about 300 Å.

Afterward, on the emission layer, Compound E1 was deposited to form a buffer layer having a thickness of about 100 Å. On the buffer layer, BPhen and Liq were deposited at a weight ratio of about 50:50 to form an electron transport layer having a thickness of about 150 Å. LiF was next deposited on the electron transport layer to form an electron injection layer having a thickness of about 5 Å, thereby forming an electron transport region. Al was then vacuum-deposited thereon to form a cathode having a thickness of about 1,500 Å, thereby completing the manufacture of an organic light-emitting device.

### Reference Examples 28 to 35 and Comparative Examples 11 to 15

Organic light-emitting devices were manufactured in the same manner as in Reference Example 27, except that, instead of Compound H1 and Compound E1, the compounds listed in Table 3 were used, to form an emission layer and a buffer transport layer, respectively.

**[Table 3]**

| Example | Emission layer host | Buffer layer | Electron transport layer | Example | Emission layer host | Buffer layer | Electron transport layer |
|---|---|---|---|---|---|---|---|
| Reference Example 27 | H1 | E1 | BPhen:Liq | Reference Example 34 | H1 | E8 | BPhen:Liq |
| Reference Example 28 | H1 | E2 | BPhen:Liq | Reference Example 35 | H1 | E9 | BPhen:Liq |
| Reference Example 29 | H1 | E3 | BPhen:Liq | Comparative Example 11 | Compound 1 | E1 | BPhen:Liq |
| Reference Example 30 | H1 | E4 | BPhen:Liq | Comparative Example 12 | Compound 2 | E1 | BPhen:Liq |
| Reference Example 31 | H1 | E5 | BPhen:Liq | Comparative Example 13 | H1 | Compound D | BPhen:Liq |
| Reference Example 32 | H1 | E6 | BPhen:Liq | Comparative Example 14 | H2 | Compound D | BPhen:Liq |
| Reference Example 33 | H1 | E7 | BPhen:Liq | Comparative Example 15 | H3 | Alq3 | BPhen:Liq |

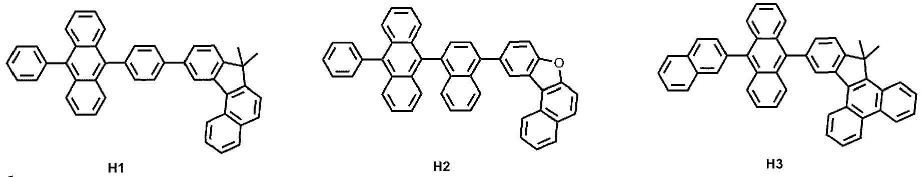

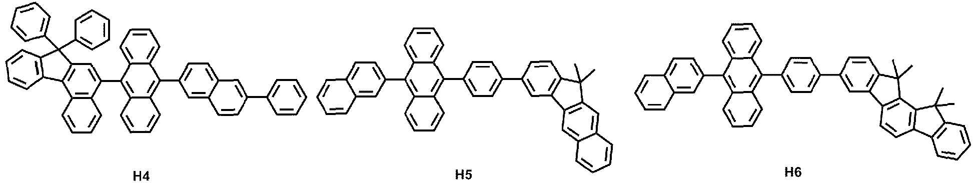

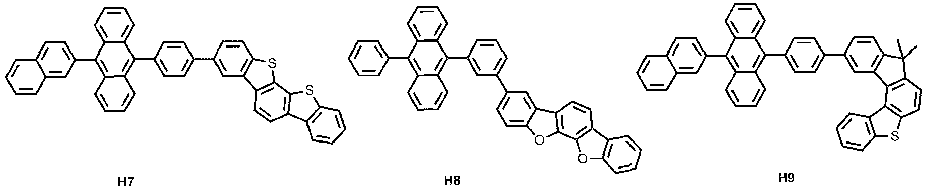

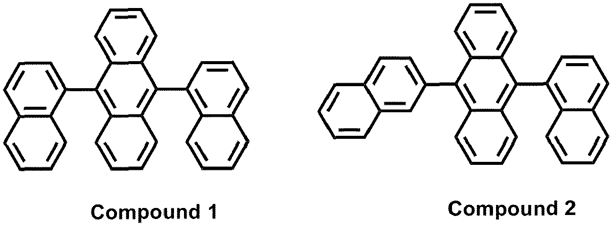

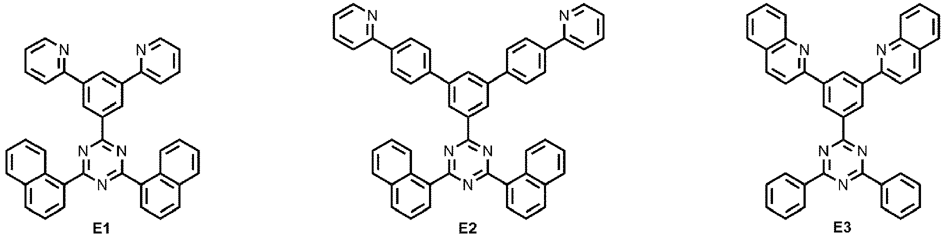

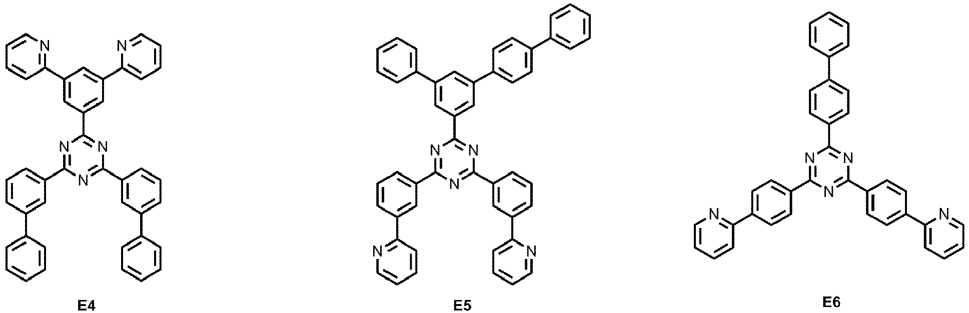

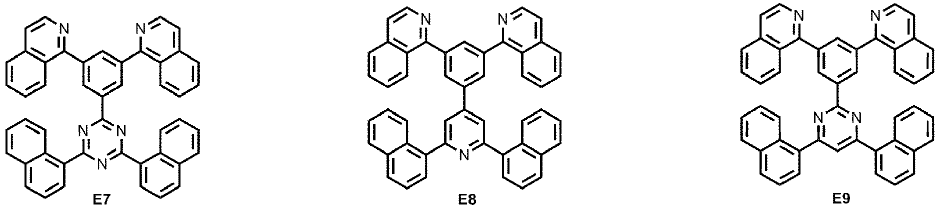

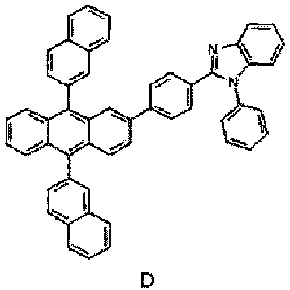

### Evaluation Example 1

Efficiency (at a current density of about 10 mA/cm²) and T₉₀ lifespan (at a current density of about 50 mA/cm²) of the organic light-emitting devices manufactured in Reference Examples 1 to 13 and 17 to 35, Examples 14 to 16 and Comparative Examples 1 and 15 were evaluated using a Keithley 2400 current voltmeter and a Minolta Cs-1000A luminance meter. T₉₀ indicates time for the initial luminance of the organic light-emitting device to reduce by 90%. The evaluation results are shown in Tables 4 to 6.

**[Table 4]**

| Example | Emission layer host | Electron transport layer | Efficiency (cd/A) | T₉₀ (hour) |
|---|---|---|---|---|
| Reference Example 1 | H1 | E1 | 5.2 | 130 |
| Reference Example 2 | H1 | E2 | 5.4 | 110 |
| Reference Example 3 | H1 | E3 | 5.4 | 110 |
| Reference Example 4 | H1 | E4 | 5.4 | 110 |
| Reference Example 5 | H1 | E5 | 5.4 | 120 |
| Reference Example 6 | H1 | E6 | 5.3 | 120 |
| Reference Example 7 | H1 | E7 | 5.5 | 130 |
| Reference Example 8 | H1 | E8 | 5.4 | 120 |
| Reference Example 9 | H1 | E9 | 5.5 | 120 |
| Reference Example 10 | H2 | E7 | 5.4 | 120 |
| Reference Example 11 | H3 | E7 | 5.3 | 120 |
| Reference Example 12 | H4 | E7 | 5.3 | 130 |
| Reference Example 13 | H5 | E7 | 5.5 | 120 |
| Example 14 | H6 | E7 | 5.3 | 120 |
| Example 15 | H7 | E7 | 5.4 | 130 |
| Example 16 | H8 | E7 | 5.3 | 140 |
| Reference Example 17 | H9 | E7 | 5.3 | 120 |
| Comparative Example 1 | Compound 1 | E7 | 4.9 | 70 |
| Comparative Example 2 | Compound 2 | E7 | 4.7 | 80 |
| Comparative Example 3 | H1 | Compound D | 5.0 | 90 |
| Comparative Example 4 | H2 | Compound D | 4.9 | 100 |
| Comparative Example 5 | H3 | Alq3 | 4.8 | 70 |

**[Table 5]**

| Example | Emission layer host | Electron transport layer | Efficiency (cd/A) | T₉₀ (hour) |
|---|---|---|---|---|
| Reference Example 18 | H1 | E1:Liq | 5.2 | 140 |
| Reference Example 19 | H1 | E2:Liq | 5.3 | 120 |
| Reference Example 20 | H1 | E3:Liq | 5.4 | 130 |
| Reference Example 21 | H1 | E4:Liq | 5.2 | 120 |
| Reference Example 22 | H1 | E5:Liq | 5.3 | 150 |
| Reference Example 23 | H1 | E6:Liq | 5.2 | 130 |
| Reference Example 24 | H1 | E7:Liq | 5.3 | 140 |
| Reference Example 25 | H1 | E8:Liq | 5.3 | 130 |
| Reference Example 26 | H1 | E9:Liq | 5.4 | 130 |
| Comparative Example 6 | Compound 1 | E1:Liq | 4.8 | 70 |
| Comparative Example 7 | Compound 2 | E1:Liq | 4.6 | 80 |
| Comparative Example 8 | H1 | Compound D:Liq | 4.9 | 100 |
| Comparative Example 9 | H2 | Compound D:Liq | 4.8 | 110 |
| Comparative Example 10 | H3 | Alq3: Liq | 4.6 | 80 |

**[Table 6]**

| Example | emission layer host | Buffer layer | Electron transport layer | Efficiency (cd/A) | T₉₀ (hour) |
|---|---|---|---|---|---|
| Reference Example 27 | H1 | E1 | BPhen:Liq | 5.2 | 130 |
| Reference Example 28 | H1 | E2 | BPhen:Liq | 5.3 | 120 |
| Reference Example 29 | H1 | E3 | BPhen:Liq | 5.3 | 130 |
| Reference Example 30 | H1 | E4 | BPhen:Liq | 5.4 | 120 |
| Reference Example 31 | H1 | E5 | BPhen:Liq | 5.4 | 140 |
| Reference Example 32 | H1 | E6 | BPhen:Liq | 5.3 | 120 |
| Reference Example 33 | H1 | E7 | BPhen:Liq | 5.4 | 140 |
| Reference Example 34 | H1 | E8 | BPhen:Liq | 5.3 | 130 |
| Reference Example 35 | H1 | E9 | BPhen:Liq | 5.4 | 130 |
| Comparative Example 11 | Compound 1 | E1 | BPhen:Liq | 4.7 | 60 |
| Comparative Example 12 | Compound 2 | E1 | BPhen:Liq | 4.6 | 70 |
| Comparative Example 13 | H1 | Compound D | BPhen:Liq | 4.9 | 90 |
| Comparative Example 14 | H2 | Compound D | BPhen:Liq | 4.8 | 90 |
| Comparative Example 15 | H3 | Alq | BPhen:Liq | 4.9 | 60 |

Referring to Tables 4 to 6, it was found that the organic light-emitting devices manufactured in Reference Examples 1 to 13 and 17 to 35 and Examples 14 to 16 had improved efficiency and lifespan, as compared with the organic light-emitting devices manufactured in Comparative Examples 1 to 15.

### Reference Example 1-1

A Corning 15 Ω/cm² (1,200 A) ITO glass substrate was cut to a size of 50 mm x 50 mm x 0.7 mm, sonicated in isopropyl alcohol and pure water for 5 minutes in each solvent, and cleaned by exposure to ultraviolet rays with ozone for about 30 minutes so as to use the glass substrate as an anode. Then, the glass substrate was mounted on a vacuum deposition apparatus.

On the substrate, HT28 was vacuum-deposited to form a hole injection layer having a thickness of about 500 Å. Then, as a hole transport compound, HT3 was vacuum-deposited to form a hole transport layer having a thickness of about 450 Å, thereby forming a hole transport region.

Subsequently, Compound H2 (as a host) and FD1 (as a dopant) were codeposited at a volume ratio of about 95:5 to form an emission layer having a thickness of about 300 Å.

Afterward, on the emission layer, Compound E10 was deposited to form an electron transport layer having a thickness of about 250 Å. LiF was next deposited on the electron transport layer to form an electron injection layer having a thickness of about 5 Å, thereby forming an electron transport region. Al was then vacuum-deposited thereon to form a cathode having a thickness of about 1,500 Å, thereby completing the manufacture of an organic light-emitting device.

### Reference Examples 1-2 to 1-13, 1-17, 2-1 to 2-13, 2-17, Examples 1-14 to 1-16 and 2-14 to 2-16 and Comparative Examples 1-1 to 1-4 and 2-1 and 2-2

Organic light-emitting devices were manufactured in the same manner as in Reference Example 1-1, except that, instead of Compound H2 and Compound E10, the compounds listed in Table 7 were used, to form an emission layer and an electron transport layer, respectively.

**[Table 7]**

| Example | Emission layer host | Electron transport layer | Example | Emission layer host | Electron transport layer |
|---|---|---|---|---|---|
| Reference Example 1-1 | H2 | E10 | Reference Example 1-12 | H4 | E16 |
| Reference Example 1-2 | H2 | E11 | Reference Example 1-13 | H5 | E16 |
| Reference Example 1-3 | H2 | E12 | Example 1-14 | H6 | E16 |
| Reference Example 1-4 | H2 | E13 | Example 1-15 | H7 | E16 |
| Reference Example 1-5 | H2 | E14 | Example 1-16 | H8 | E16 |
| Reference Example 1-6 | H2 | E15 | Reference Example 1-17 | H9 | E16 |
| Reference Example 1-7 | H2 | E16 | Comparative Example 1-1 | Compound 1 | E16 |
| Reference Example 1-8 | H2 | E17 | Comparative Example 1-2 | Compound 2 | E16 |
| Reference Example 1-9 | H2 | E18 | Comparative Example 1-3 | H1 | Compound D |
| Reference Example 1-10 | H1 | E16 | Comparative Example 1-4 | H2 | Compound D |
| Reference Example 1-11 | H3 | E16 | | | |
| Reference Example 2-1 | H2 | E19 | Reference Example 2-12 | H4 | E23 |
| Reference Example 2-2 | H2 | E21 | Reference Example 2-13 | H5 | E23 |
| Reference Example 2-3 | H2 | E22 | Example 2-14 | H6 | E23 |
| Reference Example 2-4 | H2 | E23 | Example 2-15 | H7 | E23 |
| Reference Example 2-5 | H2 | E24 | Example 2-16 | H8 | E23 |
| Reference Example 2-6 | H2 | E25 | Reference Example 2-17 | H9 | E23 |
| Reference Example 2-7 | H2 | E26 | Comparative Example 2-1 | Compound 1 | E23 |
| Reference Example 2-8 | H2 | E27 | Comparative Example 2-2 | Compound 2 | E23 |
| Reference Example 2-9 | H2 | E28 | | | |
| Reference Example 2-10 | H1 | E23 | | | |
| Reference Example 2-11 | H3 | E23 | | | |

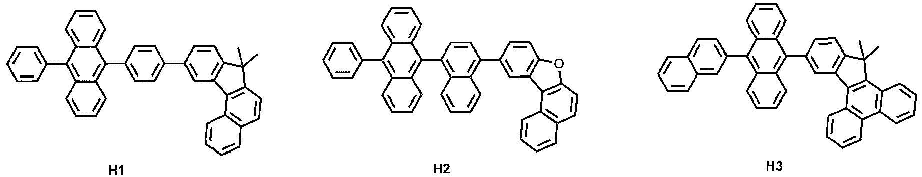

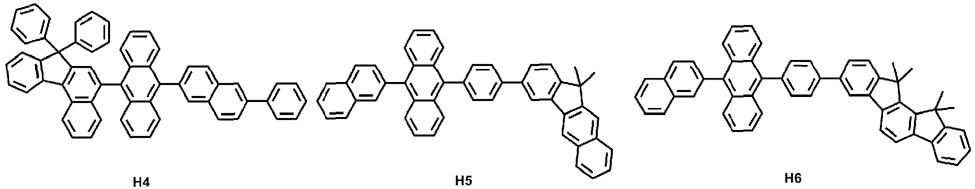

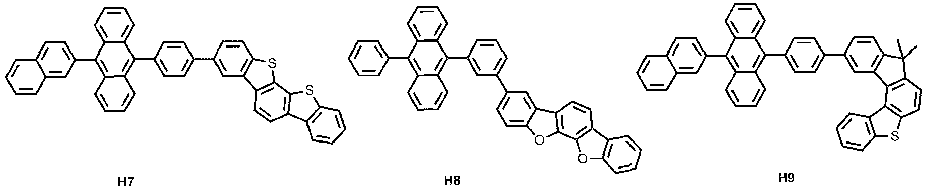

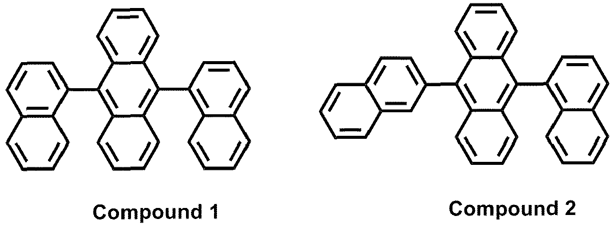

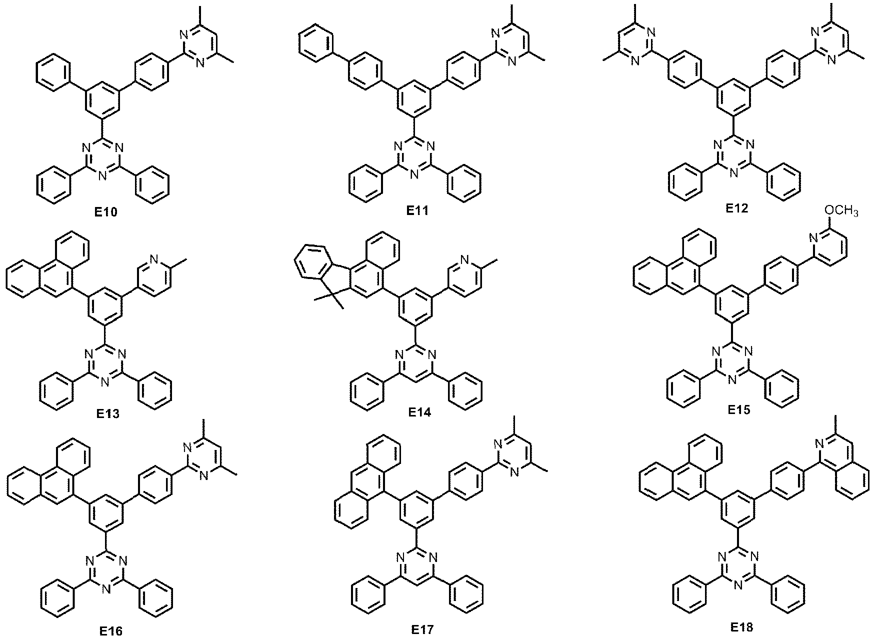

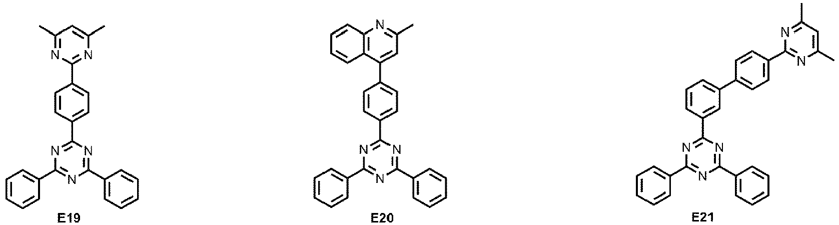

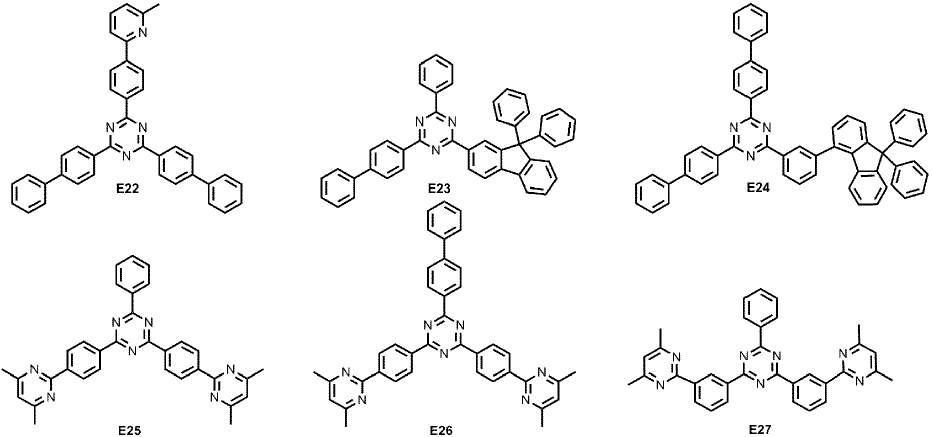

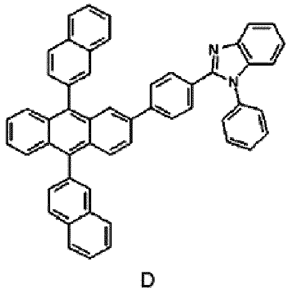

### Reference Example 3-1

A Corning 15 Ω/cm² (1,200 A) ITO glass substrate was cut to a size of 50 mm x 50 mm x 0.7 mm, sonicated in isopropyl alcohol and pure water for 5 minutes in each solvent, and cleaned by exposure to ultraviolet rays with ozone for about 30 minutes so as to use the glass substrate as an anode. Then, the glass substrate was mounted on a vacuum deposition apparatus.

On the substrate, HT28 was vacuum-deposited to form a hole injection layer having a thickness of about 500 Å. Then, as a hole transport compound, HT3 was vacuum-deposited to form a hole transport layer having a thickness of about 450 Å. Subsequently, Compound H2 (as a host) and FD1 (as a dopant) were codeposited at a weight ratio of about 95:5 to form an emission layer having a thickness of about 300 Å.

Afterward, on the emission layer, Compound E10 and Liq were deposited at a weight ratio of about 50:50 to form an electron transport layer having a thickness of about 250 Å. LiF was next deposited on the electron transport layer to form an electron injection layer having a thickness of about 5 Å, and then, Al was vacuum-deposited thereon to form a cathode having a thickness of about 1,500 Å, thereby completing the manufacture of an organic light-emitting device.

### Reference Examples 3-2 to 3-9 and 4-1 to 4-9 and Comparative Examples 3-1 to 3-4 and 4-1 and 4-2

Organic light-emitting devices were manufactured in the same manner as in Reference Example 3-1, except that, instead of Compound H2 and Compound E10, the compounds listed in Table 8 were used, to form an emission layer and an electron transport layer, respectively.

**[Table 8]**

| Example | Emission layer host | Electron transport layer | Example | Emission layer host | Electron transport layer |
|---|---|---|---|---|---|
| Reference Example 3-1 | H2 | E10:Liq | Reference Example 3-8 | H2 | E17:Liq |
| Reference Example 3-2 | H2 | E11:Liq | Reference Example 3-9 | H2 | E18:Liq |
| Reference Example 3-3 | H2 | E12:Liq | Comparative Example 3-1 | Compound 1 | E16:Liq |
| Reference Example 3-4 | H2 | E13:Liq | Comparative Example 3-2 | Compound 2 | E16:Liq |
| Reference Example 3-5 | H2 | E14:Liq | Comparative Example 3-3 | H1 | Compound D:Liq |
| Reference Example 3-6 | H2 | E15:Liq | Comparative Example 3-4 | H2 | Compound D:Liq |
| Reference Example 3-7 | H2 | E16:Liq | | | |
| Reference Example 4-1 | H2 | E19:Liq | Reference Example 4-8 | H2 | E27:Liq |
| Reference Example 4-2 | H2 | E21:Liq | Reference Example 4-9 | H2 | E28:Liq |
| Reference Example 4-3 | H2 | E22:Liq | Comparative Example 4-1 | Compound 1 | E23:Liq |
| Reference Example 4-4 | H2 | E23:Liq | Comparative Example 4-2 | Compound 2 | E23:Liq |
| Reference Example 4-5 | H2 | E24:Liq | | | |
| Reference Example 4-6 | H2 | E25:Liq | | | |
| Reference Example 4-7 | H2 | E26:Liq | | | |

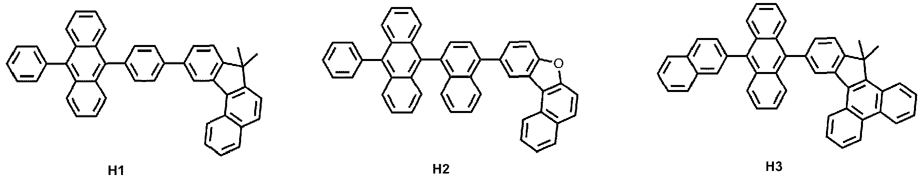

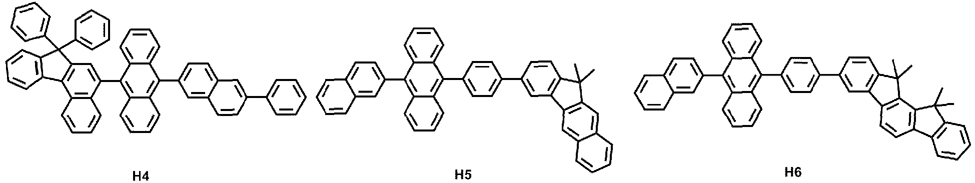

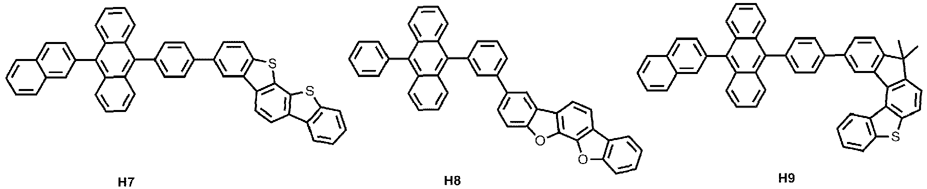

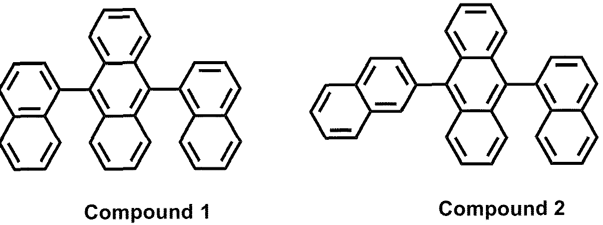

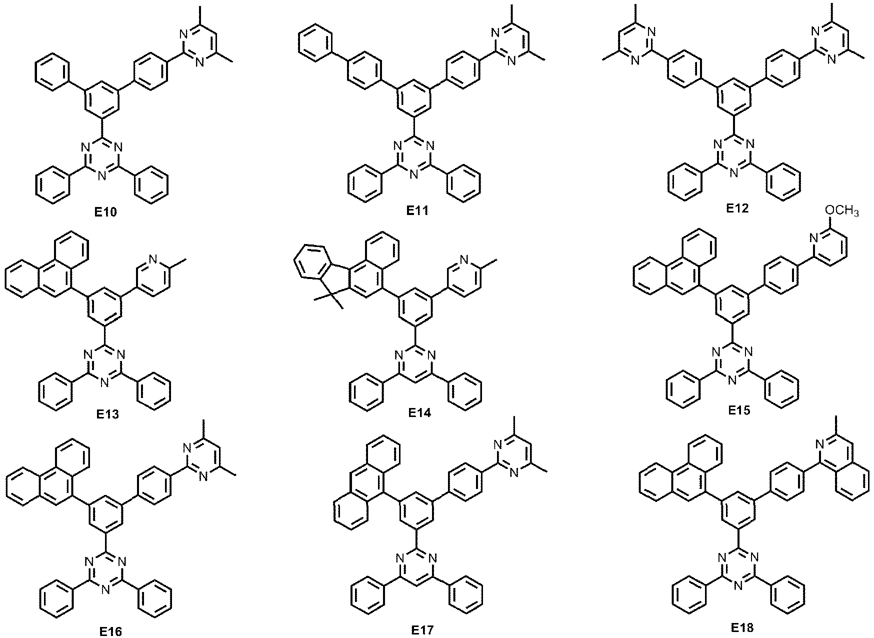

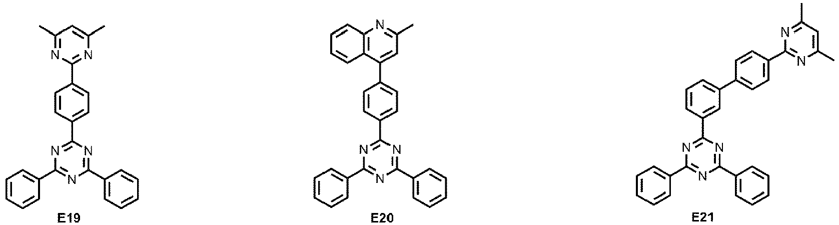

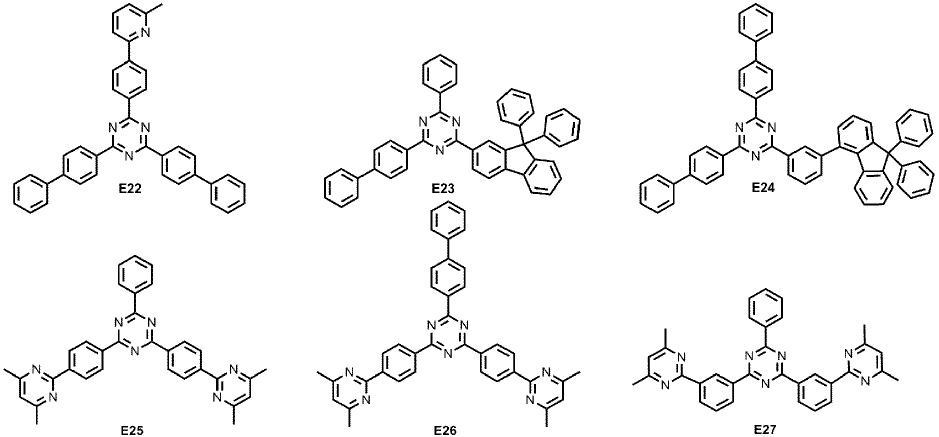

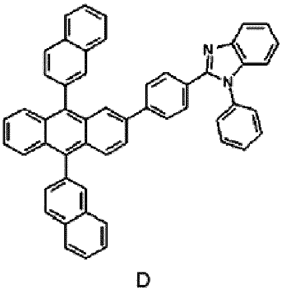

### Evaluation Example 2

Efficiency (at a current density of about 10 mA/cm²) and T90 lifespan (at a current density of about 50 mA/cm²) of the organic light-emitting devices manufactured in Reference Examples 1-1 to 1-13 and 1-17, Examples 1-14 to 1-16, Reference Examples 2-1 to 2-13 and 2-17, Examples 2-14 to 2-16, Reference Examples 3-1 to 3-9, Reference Examples 4-1 to 4-9, Comparative Examples 1-1 to 1-4, Comparative Examples 2-1 and 2-2, Comparative Examples 3-1 to 3-4, and Comparative Example 4-1 and 4-2 were evaluated using a Keithley 2400 current voltmeter and a Minolta Cs-1000A luminance meter. T₉₀ indicates time for the initial luminance of the organic light-emitting device to reduce by 90%. The evaluation results are shown in Tables 9 to 12.

**[Table 9]**

| Example | Emission layer host | Electron transport layer | Efficiency (cd/A) | T₉₀ (hour) |
|---|---|---|---|---|
| Reference Example 1-1 | H2 | E10 | 5.4 | 110 |
| Reference Example 1-2 | H2 | E11 | 5.4 | 120 |
| Reference Example 1-3 | H2 | E12 | 5.3 | 130 |
| Reference Example 1-4 | H2 | E13 | 5.4 | 120 |
| Reference Example 1-5 | H2 | E14 | 5.3 | 120 |
| Reference Example 1-6 | H2 | E15 | 5.5 | 110 |
| Reference Example 1-7 | H2 | E16 | 5.4 | 130 |
| Reference Example 1-8 | H2 | E17 | 5.2 | 120 |
| Reference Example 1-9 | H2 | E18 | 5.3 | 120 |
| Reference Example 1-10 | H1 | E16 | 5.4 | 120 |
| Reference Example 1-11 | H3 | E16 | 5.4 | 110 |
| Reference Example 1-12 | H4 | E16 | 5.4 | 120 |
| Reference Example 1-13 | H5 | E16 | 5.4 | 130 |
| Example 1-14 | H6 | E16 | 5.3 | 110 |
| Example 1-15 | H7 | E16 | 5.4 | 130 |
| Example 1-16 | H8 | E16 | 5.3 | 140 |
| Reference Example 1-17 | H9 | E16 | 5.3 | 120 |
| Comparative Example 1-1 | Compound 1 | E16 | 4.9 | 80 |
| Comparative Example 1-2 | Compound 2 | E16 | 4.8 | 70 |
| Comparative Example 1-3 | H1 | Compound D | 5.0 | 90 |
| Comparative Example 1-4 | H2 | Compound D | 4.9 | 100 |

**[Table 10]**

| Example | Emission layer host | Electron transport layer | Efficiency (cd/A) | T₉₀ (hour) |
|---|---|---|---|---|
| Reference Example 2-1 | H2 | E19 | 5.3 | 120 |
| Reference Example 2-2 | H2 | E21 | 5.2 | 110 |
| Reference Example 2-3 | H2 | E22 | 5.3 | 120 |
| Reference Example 2-4 | H2 | E23 | 5.2 | 130 |
| Reference Example 2-5 | H2 | E24 | 5.3 | 140 |
| Reference Example 2-6 | H2 | E25 | 5.4 | 130 |
| Reference Example 2-7 | H2 | E26 | 5.3 | 120 |
| Reference Example 2-8 | H2 | E27 | 5.2 | 130 |
| Reference Example 2-9 | H2 | E28 | 5.3 | 130 |
| Reference Example 2-10 | H1 | E23 | 5.4 | 110 |
| Reference Example 2-11 | H3 | E23 | 5.3 | 120 |
| Reference Example 2-12 | H4 | E23 | 5.4 | 120 |
| Reference Example 2-13 | H5 | E23 | 5.3 | 130 |
| Example 2-14 | H6 | E23 | 5.3 | 110 |
| Example 2-15 | H7 | E23 | 5.3 | 130 |
| Example 2-16 | H8 | E23 | 5.3 | 130 |
| Reference Example 2-17 | H9 | E23 | 5.3 | 120 |
| Comparative Example 2-1 | Compound 1 | E23 | 4.7 | 80 |
| Comparative Example 2-2 | Compound 2 | E23 | 4.6 | 70 |

**[Table 11]**

| Example | Emission layer host | Electron transport layer | Efficiency (cd/A) | T₉₀ (hour) |
|---|---|---|---|---|
| Reference Example 3-1 | H2 | E10:Liq | 5.3 | 120 |
| Reference Example 3-2 | H2 | E11:Liq | 5.2 | 130 |
| Reference Example 3-3 | H2 | E12:Liq | 5.2 | 130 |
| Reference Example 3-4 | H2 | E13:Liq | 5.3 | 130 |
| Reference Example 3-5 | H2 | E14:Liq | 5.2 | 120 |
| Reference Example 3-6 | H2 | E15:Liq | 5.4 | 120 |
| Reference Example 3-7 | H2 | E16:Liq | 5.2 | 140 |
| Reference Example 3-8 | H2 | E17:Liq | 5.2 | 130 |
| Reference Example 3-9 | H2 | E18:Liq | 5.2 | 130 |
| Comparative Example 3-1 | Compound 1 | E16:Liq | 4.8 | 90 |
| Comparative Example 3-2 | Compound 2 | E16:Liq | 4.6 | 80 |
| Comparative Example 3-3 | H1 | Compound D:Liq | 4.9 | 100 |
| Comparative Example 3-4 | H2 | Compound D:Liq | 4.8 | 110 |

**[Table 12]**

| Example | Emission layer host | Electron transport layer | Efficiency (cd/A) | T₉₀ (hour) |
|---|---|---|---|---|
| Reference Example 4-1 | H2 | E19:Liq | 5.2 | 130 |
| Reference Example 4-2 | H2 | E21:Liq | 5.2 | 120 |
| Reference Example 4-3 | H2 | E22:Liq | 5.2 | 130 |
| Reference Example 4-4 | H2 | E23:Liq | 5.0 | 140 |
| Reference Example 4-5 | H2 | E24:Liq | 5.2 | 140 |
| Reference Example 4-6 | H2 | E25:Liq | 5.3 | 140 |
| Reference Example 4-7 | H2 | E26:Liq | 5.2 | 130 |
| Reference Example 4-8 | H2 | E27:Liq | 5.1 | 140 |
| Reference Example 4-9 | H2 | E28:Liq | 5.1 | 130 |
| Comparative Example 4-1 | Compound 1 | E23:Liq | 4.6 | 90 |
| Comparative Example 4-2 | Compound 2 | E23:Liq | 4.6 | 80 |

Referring to Tables 9 to 12, it was found that the organic light-emitting devices manufactured in Reference Examples 1-1 to 1-13 and 1-17, Examples 1-14 to 1-16, Reference Examples 2-1 to 2-13 and 2-17, Examples 2-14 to 2-16, Reference Examples 3-1 to 3-9, and Reference Examples 4-1 to 4-9 organic light-emitting device had improved efficiency and lifespan, as compared with the organic light-emitting devices manufactured in Comparative Examples 1-1 to 1-4, Comparative Examples 2-1 and 2-2, Comparative Examples 3-1 to 3-4, and Comparative Examples 4-1 and 4-2.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope as defined by the following claims.

## Claims

1. An organic light-emitting device comprising:
a first electrode;
a second electrode; and
an organic layer between the first electrode and the second electrode,
wherein the organic layer comprises a first compound represented by Formula 1 and a second compound represented by Formula 2: 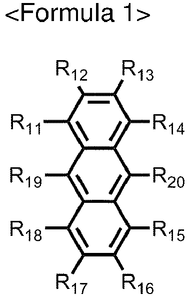 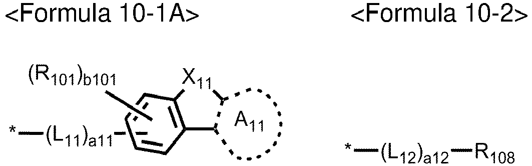 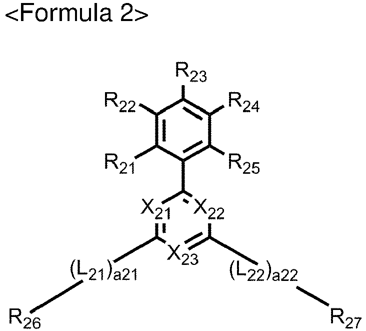 <Formula 11-1> *-(L₂₃)ₐ₂₃-R₁₁₁
wherein, in Formulae 1, 2, 10-1A, 10-2 and 11-1,
R₁₁ to R₂₀ are each independently selected from Rₓ, R_{y}, hydrogen, deuterium, -F, -CI, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), - B(Q₁)(Q₂), -C(=O)(Q₁), -S(=O)₂(Q₁), and -P(=O)(Q₁)(Q₂), and at least one of R₁₁ to R₂₀ is Rₓ and at least one of R₁₁ to R₂₀ is R_{y},
Rₓ is represented by Formula 10-1A,
R_{y} is represented by Formula 10-2,
L₁₁ and L₁₂ are each independently selected from a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
a11 and a12 are each independently selected from 0, 1, 2, and 3,
A₁₁ is a group represented by Formula 10C, 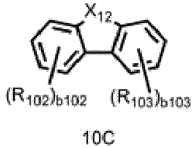
X₁₁ is selected from an oxygen atom, a sulfur atom, and C(R₁₀₄)(R₁₀₅),
X12 is selected from an oxygen atom, a sulfur atom, and C(R₁₀₆)(R₁₀₇),
wherein X₁₁ and X12 both are oxygen atoms; or X₁₁ and X12 both are sulfur atoms; or X₁₁ is C(R₁₀₄)(R₁₀₅), and X12 is C(R₁₀₆)(R₁₀₇);
R101 to R₁₀₇ are each independently selected from hydrogen, deuterium, -F, - Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), - B(Q₁)(Q₂), -C(=O)(Q₁), -S(=O)₂(Q₁), and -P(=O)(Q₁)(Q₂),
b101 to b103 are each independently selected from 1, 2, 3, 4, 5, and 6,
R₁₀₈ is selected from a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group,
* indicates a binding site to a neighboring atom,
X21 is C(Y₂₁) or a nitrogen atom (N), X22 is C(Y22) or N, X23 is C(Y23) or N, and at least one of X21 to X23 is N,
R₂₁ to R₂₅ are each independently selected from R_{z}, hydrogen, deuterium, -F, -CI, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), - S(=O)₂(Q₁), and -P(=O)(Q₁)(Q₂), and at least one of R₂₁ to R₂₅ is R_{z},
R_{z} is a group represented by Formula 11-1,
L₂₁ to L₂₃ are each independently selected from a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
a21 to a23 are each independently selected from 0 and 1,
R₂₆, R₂₇, and R₁₁₁ are each independently selected from a phenyl group, a biphenyl group, a terphenyl group, a naphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, and a dibenzothiophenyl group; and
a phenyl group, a biphenyl group, a terphenyl group, a naphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, and a dibenzothiophenyl group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a phenyl group substituted with a C₁-C₂₀ alkyl group, a biphenyl group, a terphenyl group, a naphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, and a dibenzothiophenyl group,
Y₂₁ to Y₂₃ are each independently selected from hydrogen, deuterium, -F, -CI, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂),
at least one substituent of the substituted C₆-C₆₀ arylene group, substituted C₁-C₆₀ heteroarylene group, substituted divalent non-aromatic condensed polycyclic group, substituted divalent non-aromatic condensed heteropolycyclic group, substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₁-C₆₀ heteroaryl group, substituted monovalent non-aromatic condensed polycyclic group, and substituted monovalent non-aromatic condensed heteropolycyclic group is selected from:
deuterium, -F, -CI, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, - Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, - F, -CI, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
wherein Q₁ to Q₃, Q₁₁ to Q₁₃, Q₂₁ to Q₂₃, and Q₃₁ to Q₃₃ are each independently selected from hydrogen, deuterium, -F, -CI, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

2. An organic light-emitting device according to claim 1, wherein R₁₉ and R₂₀ are each independently selected from Rₓ and R_{y}.

3. An organic light-emitting device according to claim 1 or claim 2, wherein R₁₁ to R₁₈ are each independently selected from hydrogen, deuterium, -F, - Cl, -Br, -I, a cyano group, a C₁-C₆₀ alkyl group, a C₆-C₆₀ aryl group, a C₁-C₆₀ heteroaryl group, and -Si(Q₁)(Q₂)(Q₃),
wherein Q₁ to Q₃ are each independently selected from a C₁-C₆₀ alkyl group, a C₆-C₆₀ aryl group, a biphenyl group, and a terphenyl group.

4. An organic light-emitting device according to any one of claims 1 to 3, wherein L₁₁ and L₁₂ are each independently selected from:
a phenylene group, a naphthylene group, a fluorenylene group, a dibenzofuranylene group, and a dibenzothiophenylene group; and
a phenylene group, a naphthylene group, a fluorenylene group, a dibenzofuranylene group, and a dibenzothiophenylene group, each substituted with at least one selected from deuterium, -F, -CI, -Br, -I, a cyano group, a nitro group, a C₁-C₂₀ alkyl group, a phenyl group, and a naphthyl group.

5. An organic light-emitting device according to any one of claims 1 to 4, wherein L₁₁ and L₁₂ are each independently selected from groups represented by Formulae 3-1 to 3-25: 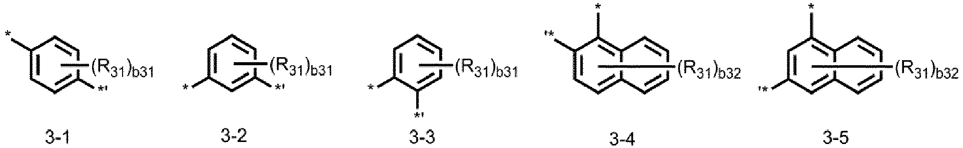 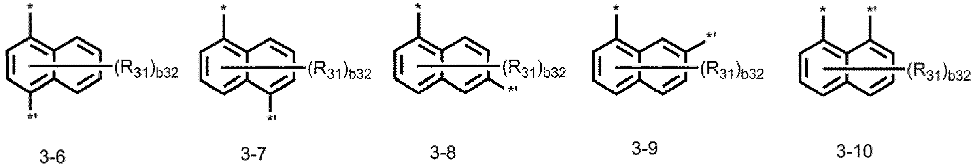 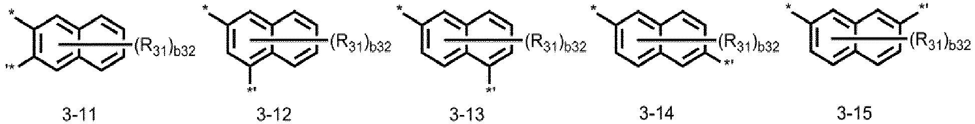 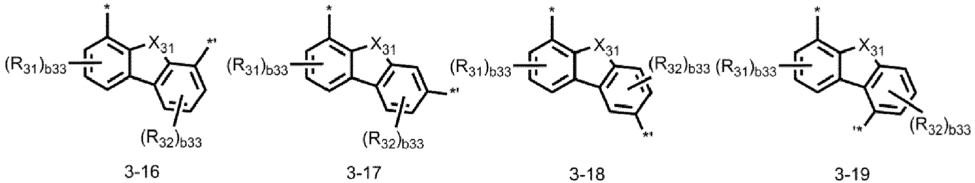 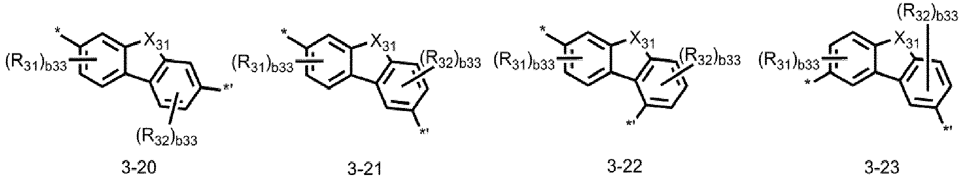 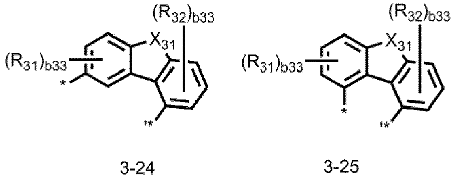 wherein, in Formulae 3-1 to 3-25,
X₃₁ is selected from O, S, and C(R₃₃)(R₃₄),
R₃₁ to R₃₄ are each independently selected from hydrogen, deuterium, -F, -CI, -Br, -I, a cyano group, a nitro group, a methyl group, an ethyl group, an n-propyl group, an iso-propyl group, an n-butyl group, an iso-butyl group, a sec-butyl group, a tert-butyl group, a phenyl group, and a naphthyl group,
b31 is selected from 1, 2, 3, and 4,
b32 is selected from 1, 2, 3, 4, 5, and 6,
b33 is selected from 1, 2, and 3, and
* and *' each indicate a binding site to a neighboring atom.

6. An organic light-emitting device according to any one of claims 1 to 5, wherein A₁₁ is a group represented by one of Formulae 10C-1, 10C-2, and 10C-3: 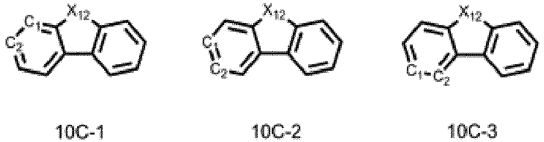 wherein, in Formulae 10C-1, 10C-2, and 10C-3,
X₁₂ is the same as defined in Formula 1, and
C₁ and C₂ are each independently a carbon atom in Formula10-1A.

7. An organic light-emitting device according to any one of claims 1 to 6, wherein Rₓ is selected from groups represented by Formulae 10-21 to 10-26: 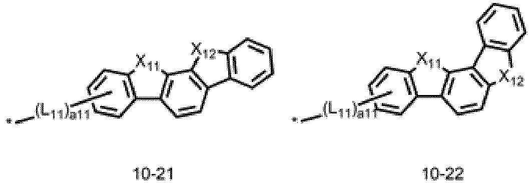 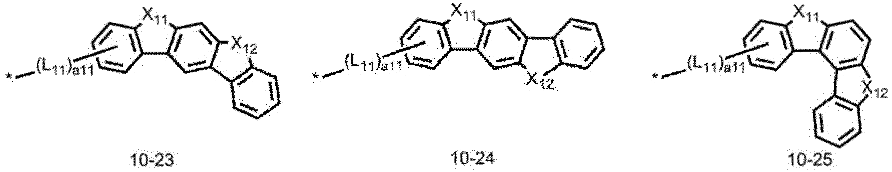 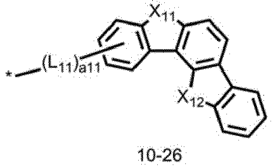 wherein, in Formulae 10-21 to 10-26,
L₁₁, a11, X₁₁, and X₁₂ are the same as defined in Formula 1, and
* indicates a binding site to a neighboring atom.

8. An organic light-emitting device according to any one of claims 1 to 7, wherein R₁₀₈ is selected from:
a phenyl group, a biphenyl group, a terphenyl group, a naphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a carbazolyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group; and
a phenyl group, a biphenyl group, a terphenyl group, a naphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a carbazolyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a carbazolyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group.

9. An organic light-emitting device according to any one of claims 1 to 8, wherein R₁₀₈ is selected from groups represented by Formulae 5-1 to 5-30: 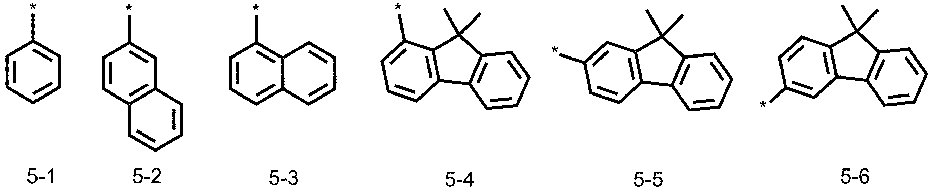 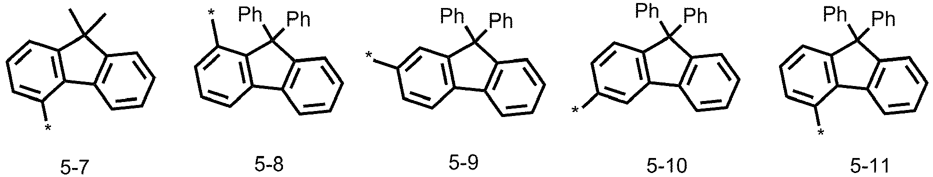 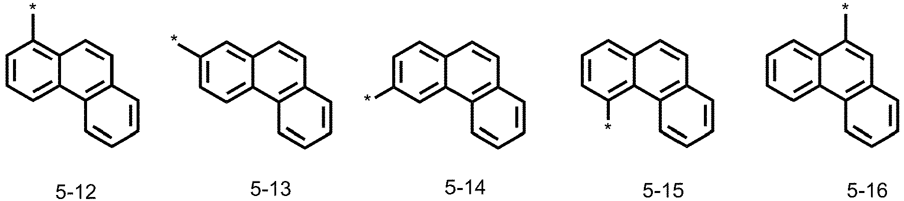 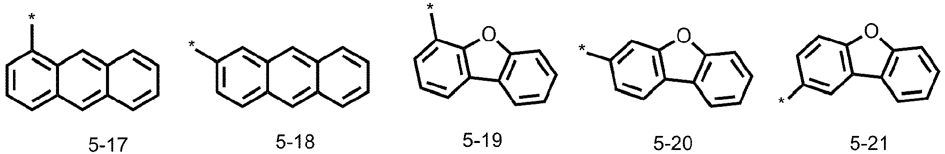 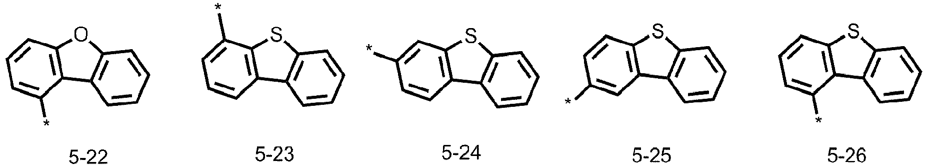 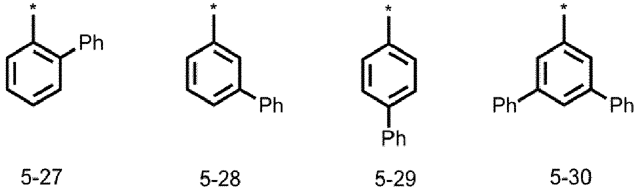 wherein, in Formulae 5-1 to 5-30,
Ph is a phenyl group, and
* indicates a binding site to a neighboring atom.

10. An organic light-emitting device according to any one of claims 1 to 9, wherein
R₂₃ is R_{z}, or
R₂₂ and R₂₄ each are R_{z}, and R₂₂ and R₂₄ are identical to or different from each other.

11. An organic light-emitting device according to any one of claims 1 to 10, wherein R₂₁ to R₂₅ are each independently selected from R_{z}, hydrogen, and a C₁-C₆₀ alkyl group.

12. An organic light-emitting device according to any one of claims 1 to 11, wherein L₂₁ to L₂₃ are each independently selected from: a phenylene group, a naphthylene group, a pyridinylene group, a pyrazinylene group, a pyrimidinylene group, a quinolinylene group, an isoquinolinylene group, and a triazinylene group; and
a phenylene group, a naphthylene group, a pyridinylene group, a pyrazinylene group, a pyrimidinylene group, a quinolinylene group, an isoquinolinylene group, and a triazinylene group, each substituted with at least one selected from deuterium, -F, -CI, -Br, -I, a cyano group, a nitro group, a C₁-C₂₀ alkyl group, a C₁-C₂₀ alkoxy group, a phenyl group, and a naphthyl group.

13. An organic light-emitting device according to any one of claims 1 to 12, wherein L₂₁ to L₂₃ are each independently selected from groups represented by Formulae 6-1 to 6-54: 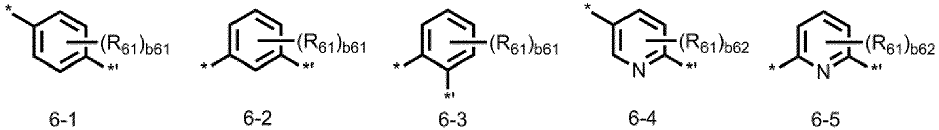 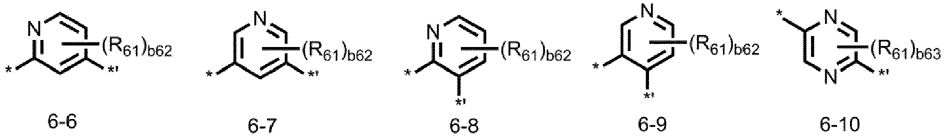 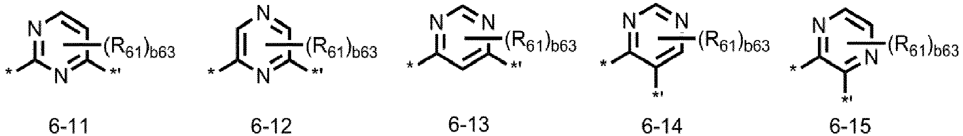 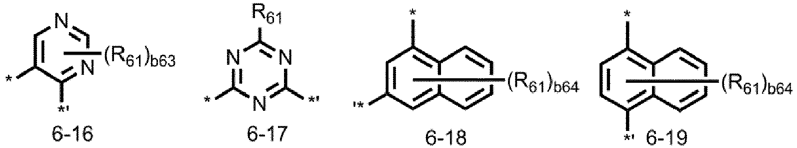 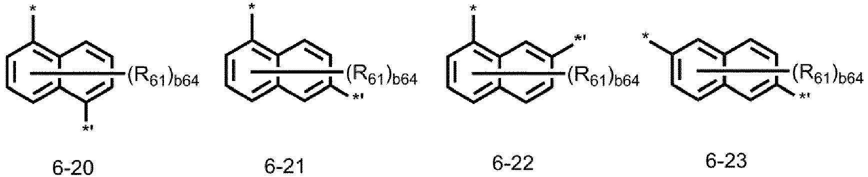 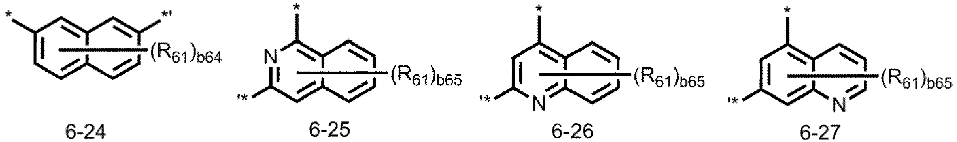 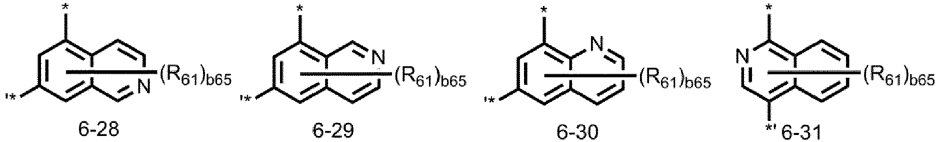 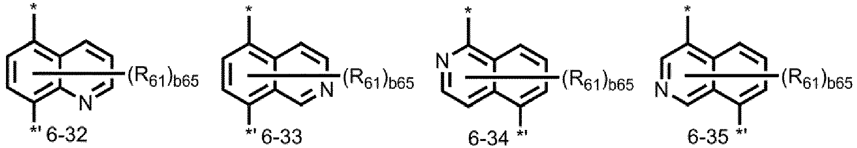 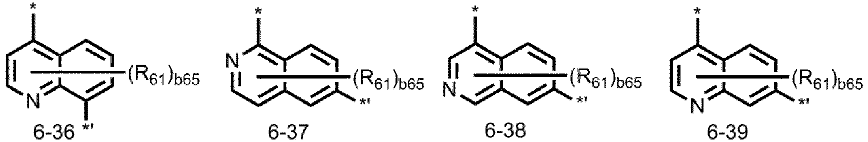 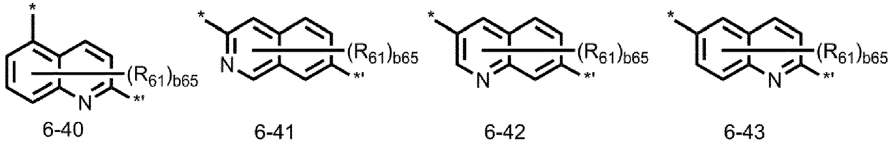 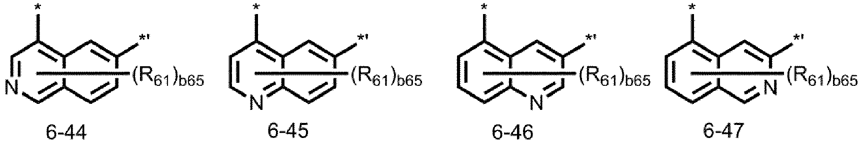 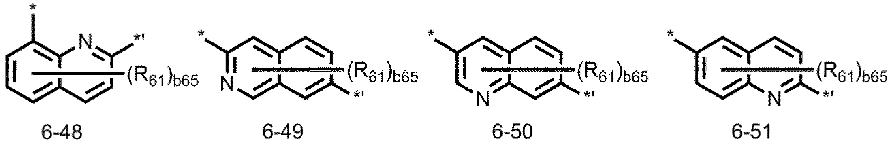 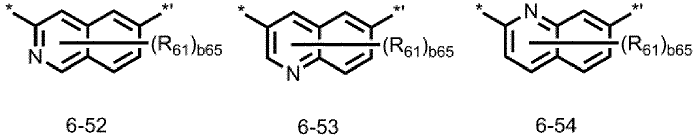 wherein, in Formulae 6-1 to 6-54,
R₆₁ is selected from hydrogen, deuterium, -F, -CI, -Br, -I, a cyano group, a nitro group, a methyl group, an ethyl group, an n-propyl group, an iso-propyl group, an n-butyl group, an iso-butyl group, a sec-butyl group, a tert-butyl group, a methoxy group, an ethoxy group, a phenyl group, and a naphthyl group,
b61 is selected from 1, 2, 3, and 4,
b62 is selected from 1, 2, and 3,
b63 is selected from 1 and 2,
b64 is selected from 1, 2, 3, 4, 5, and 6,
b65 is selected from 1, 2, 3, 4, and 5, and
* and *' each indicate a binding site to a neighboring atom.

14. An organic light-emitting device according to any one of claims 1 to 13, wherein R₂₆, R₂₇, and R₁₁₁ are each independently selected from groups represented by Formulae 8-1 to 8-36: 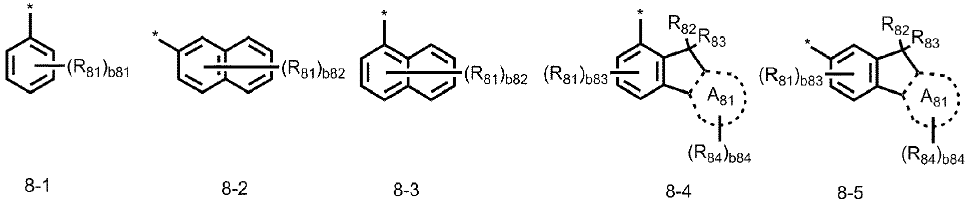 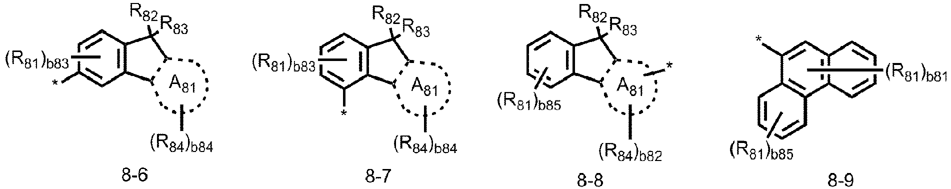 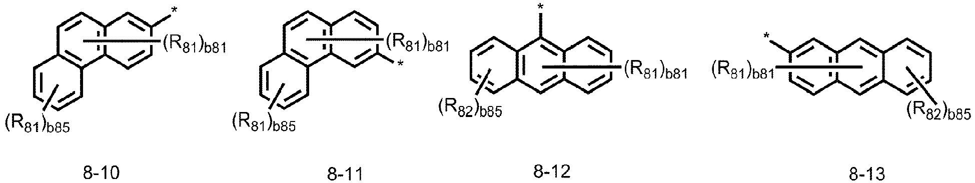 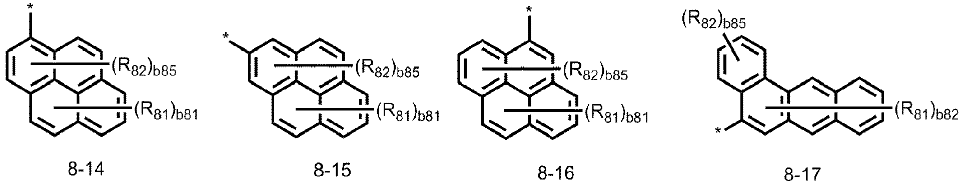 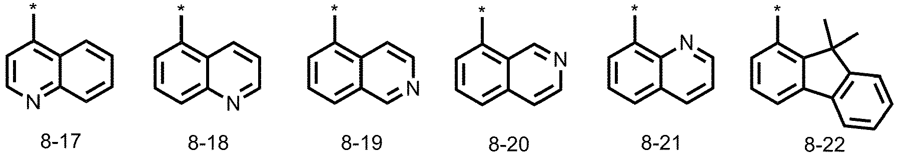 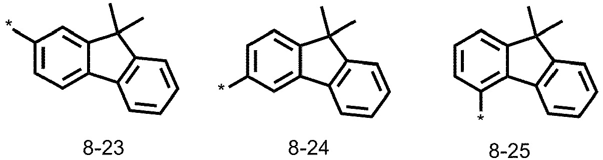 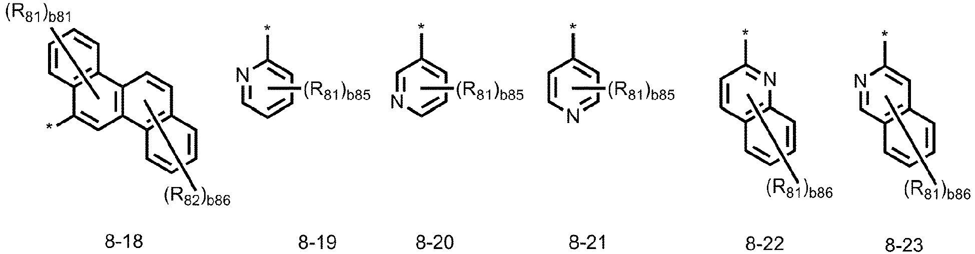 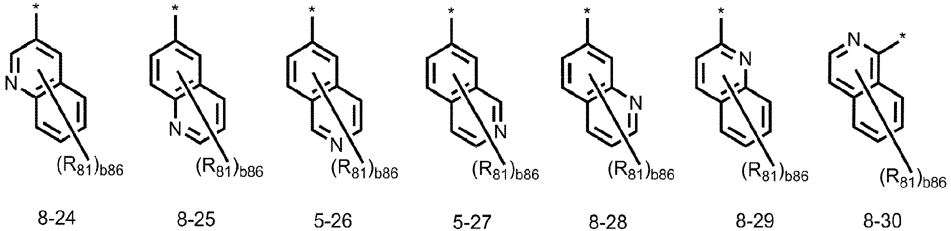 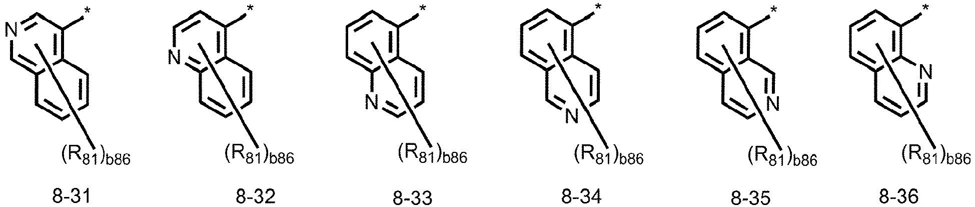 wherein, in Formulae 8-1 to 8-36,
A₈₁ is selected from a benzene group, a naphthalene group, and a phenanthrene group,
R₈₁ to R₈₄ are each independently selected from hydrogen, a methyl group, an ethyl group, an n-propyl group, an iso-propyl group, an n-butyl group, a sec-butyl group, an iso-butyl group, a tert-butyl group, a methoxy group, an ethoxy group, a phenyl group, a phenyl group substituted with a methyl group, a biphenyl group, a terphenyl group, and a naphthyl group,
b81 is selected from 1, 2, 3, 4, and 5,
b82 is selected from 1, 2, 3, 4, 5, 6, and 7,
b83 is selected from 1, 2, and 3,
b84 is selected from 1, 2, 3, 4, 5, 6, 7, and 8,
b85 is selected from 1, 2, 3, and 4,
b86 is selected from 1, 2, 3, 4, 5, and 6, and
* indicates a binding site to a neighboring atom.

15. An organic light-emitting device according to any one of claims 1 to 14, wherein the first compound is represented by Formula 1-1: 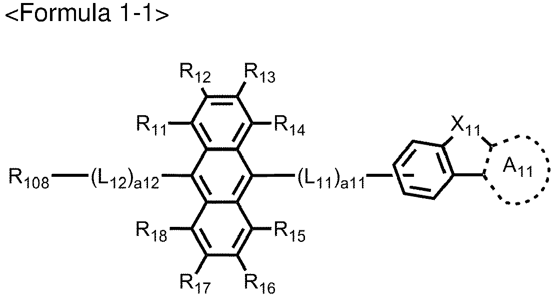 R₁₁ to R₁₄, R₁₅ to R₁₈, L₁₁, L₁₂, a11, a12, A₁₁, X₁₁, and R₁₀₈ in Formula 1-1 is the same as defined in Formula 1.

16. An organic light-emitting device according to any one of claims 1 to 15, wherein the first compound is represented by one of Formulae 1-21 to 1-26: 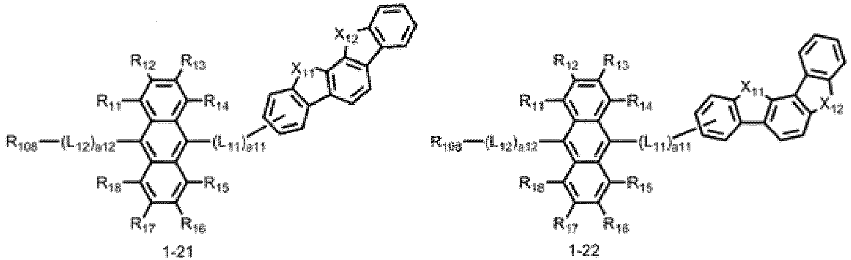 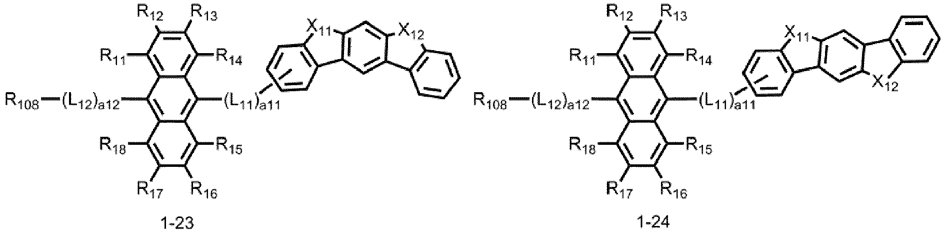 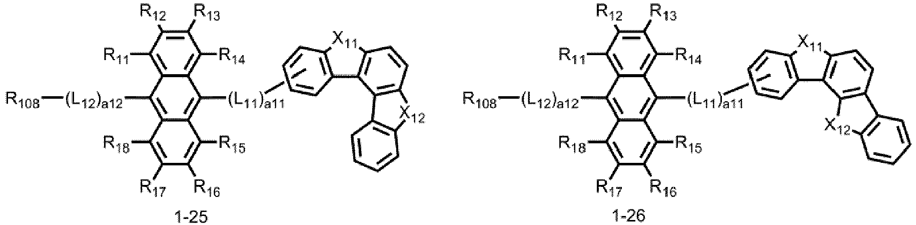 R₁₁ to R₁₄, R₁₅ to R₁₈, L₁₁, L₁₂, a11, a12, X₁₁, X₁₂, and R₁₀₈ in Formulae 1-21 to 1-26 are the same as defined in Formula 1.

17. An organic light-emitting device according to any one of claims 1 to 16, wherein the second compound is represented by one of Formulae 2-1 and 2-2: 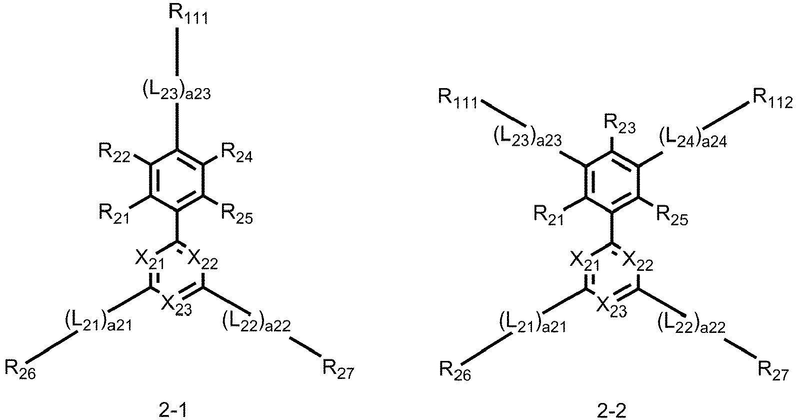 wherein, in Formulae 2-1 and 2-2,
X₂₁ to X₂₃, L₂₁ to L₂₃, a21 to a23, R₂₁, R₂₂, R₂₃, R₂₄ to R₂₇, and R₁₁₁ are the same as defined in Formula 2,
L24 is the same as defined with L₂₃ in Formula 2,
a24 is the same as defined with a23 in Formula 2, and
R112 is the same as defined with R₁₁₁ in Formula 2.

18. An organic light-emitting device according to any one of claims 1 to 17, wherein the second compound is represented by one of Formulae 2-11 to 2-20: 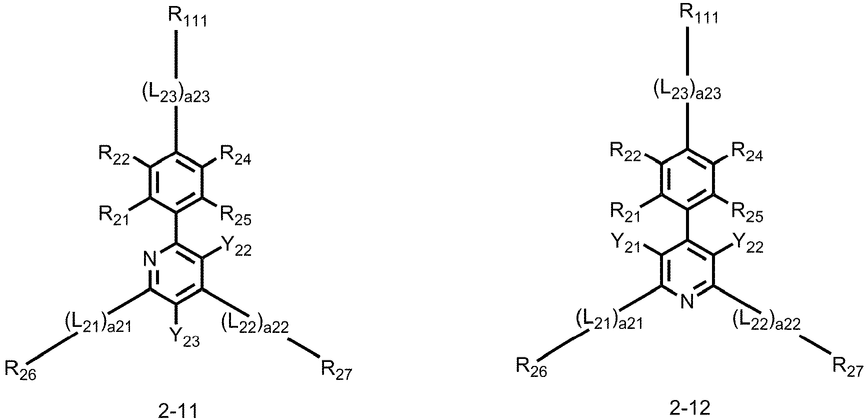 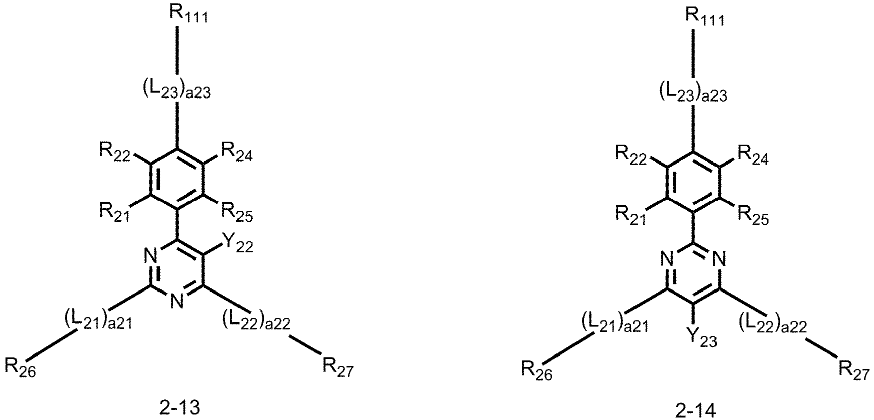 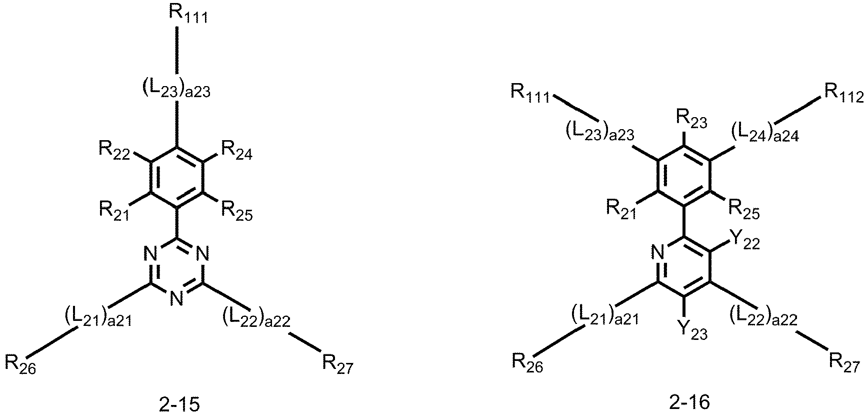 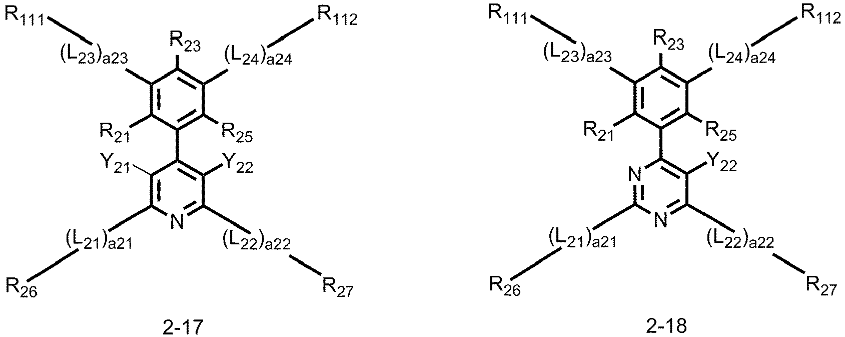 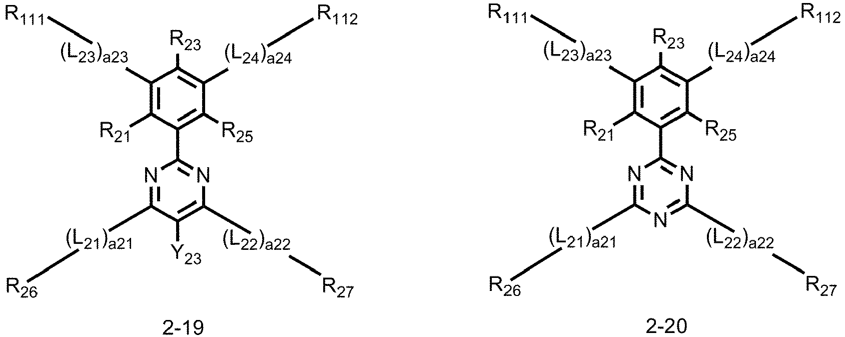 wherein, in Formulae 2-11 to 2-20,
Y21 to Y₂₃, L₂₁ to L₂₃, a21 to a23, R₂₁, R₂₂, R₂₃, R₂₄ to R₂₇, and R₁₁₁ are the same as defined in Formula 2,
L24 is the same as defined with L₂₃ in Formula 2,
a24 is the same as defined with a23 in Formula 2, and
R112 is the same as defined with R₁₁₁ in Formula 2.

19. An organic light-emitting device according to any one of claims 1 to 18, wherein the organic layer comprises an emission layer and an electron transport region,
the electron transport region is disposed between the emission layer and the second electrode,
the emission layer comprises the first compound, and
the electron transport region comprises the second compound.

## Patentansprüche

1. Organische lichtemittierende Vorrichtung, die umfasst:
eine erste Elektrode;
eine zweite Elektrode; und
eine organische Schicht zwischen der ersten Elektrode und der zweiten Elektrode,
wobei die organische Schicht eine erste Verbindung, die durch Formel 1 dargestellt ist, und eine zweite Verbindung, die durch Formel 2 dargestellt ist, umfasst: 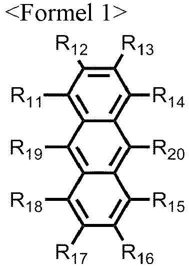 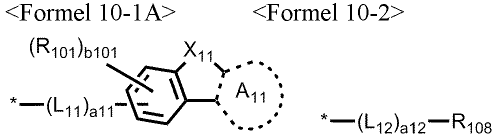 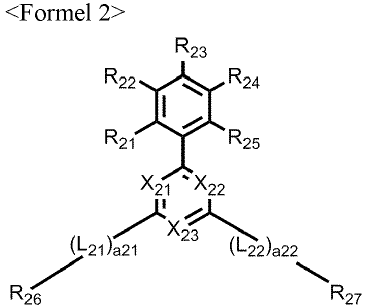
<Formel 11-1> *-(L₂₃)ₐ₂₃-R₁₁₁
wobei in den Formeln 1, 2, 10-1A, 10-2 und 11-1
R₁₁ bis R₂₀ jeweils unabhängig aus Rₓ, R_{y}, Wasserstoff, Deuterium, -F, -Cl, -Br, - I, einer Hydroxylgruppe, einer Cyanogruppe, einer Nitrogruppe, einer Amidinogruppe, einer Hydrazinogruppe, einer Hydrazonogruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkynylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nicht aromatischen kondensierten polycyclischen Gruppe, einer substituierten oder unsubstituierten einwertigen nicht aromatischen kondensierten heteropolycyclischen Gruppe, -Si(Q₁)(Q₂)(Q₃), -N(Q₁)(Q₂), -B(Q₁)(Q₂), -C(=O)(Q₁), -S(=O)₂(Q₁) und - P(=O)(Q₁)(Q₂) ausgewählt sind und mindestens eines von R₁₁ bis R₂₀ Rₓ ist und mindestens eines von R₁₁ bis R₂₀ R_{y} ist,
Rₓ durch die Formel 10-1A dargestellt ist,
R_{y} durch die Formel 10-2 dargestellt ist,
L₁₁ und L₁₂ jeweils unabhängig aus einer substituierten oder unsubstituierten C₆-C₆₀-Arylengruppe, einer substituierten oder unsubstituierten C₁-C₆₀-Heteroarylengruppe, einer substituierten oder unsubstituierten zweiwertigen nicht aromatischen kondensierten polycyclischen Gruppe und einer substituierten oder unsubstituierten zweiwertigen nicht aromatischen kondensierten heteropolycyclischen Gruppe ausgewählt sind,
a11 und a12 jeweils unabhängig aus 0, 1, 2 und 3 ausgewählt sind,
A₁₁ eine Gruppe ist, die durch Formel 10C dargestellt ist, 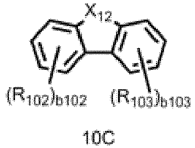
X₁₁ aus einem Sauerstoffatom, einem Schwefelatom und C(R₁₀₄)(R₁₀₅) ausgewählt ist,
X₁₂ aus einem Sauerstoffatom, einem Schwefelatom und C(R₁₀₆)(R₁₀₇) ausgewählt ist,
wobei X₁₁ und X₁₂ beides Sauerstoffatome sind; oder X₁₁ und X₁₂ beides Schwefelatome sind; oder X₁₁ C(R₁₀₄)(R₁₀₅) ist und X₁₂ C(R₁₀₆)(R₁₀₇) ist;
R₁₀₁ bis R₁₀₇ jeweils unabhängig aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, eine Hydrazonogruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkynylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nicht aromatischen kondensierten polycyclischen Gruppe, einer substituierten oder unsubstituierten einwertigen nicht aromatischen kondensierten heteropolycyclischen Gruppe, -Si(Q₁)(Q₂)(Q₃), -N(Q₁)(Q₂), -B(Q₁)(Q₂), -C(=O)(Q₁), -S(=O)₂(Q₁) und - P(=O)(Q₁)(Q₂) ausgewählt sind,
b101 bis b103 jeweils unabhängig aus 1, 2, 3, 4, 5 und 6 ausgewählt sind,
R₁₀₈ aus einer substituierten oder unsubstituierten C₆-C₆₀-Arylgruppe, einer substituierten oder unsubstituierten C₁-C₆₀-Heteroarylgruppe, einer substituierten oder unsubstituierten einwertigen nicht aromatischen kondensierten polycyclischen Gruppe und einer substituierten oder unsubstituierten einwertigen nicht aromatischen kondensierten heteropolycyclischen Gruppe ausgewählt ist,
^{∗} eine Bindungsstelle an ein benachbartes Atom anzeigt,
X₂₁ C(Y₂₁) oder ein Stickstoffatom (N) ist, X₂₂ C(Y₂₂) oder N ist, X₂₃ C(Y₂₃) oder N ist und mindestens eines von X₂₁ bis X₂₃ N ist,
R₂₁ bis R₂₅ jeweils unabhängig aus R_{z}, Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer substituierten oder unsubstituierten C₁-C₆₀-Alkylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nicht aromatischen kondensierten polycyclischen Gruppe, einer substituierten oder unsubstituierten einwertigen nicht aromatischen kondensierten heteropolycyclischen Gruppe, -Si(Q₁)(Q₂)(Q₃), -N(Q₁)(Q₂), -B(Q₁)(Q₂), - C(=O)(Q₁), -S(=O)₂(Q₁) und -P(=O)(Q₁)(Q₂) ausgewählt sind und mindestens eines von R₂₁ bis R₂₅ R_{z} ist,
R_{z} eine Gruppe ist, die durch die Formel 11-1 dargestellt ist,
L₂₁ bis L₂₃ jeweils unabhängig aus einer substituierten oder unsubstituierten C₆-C₆₀-Arylengruppe, einer substituierten oder unsubstituierten C₁-C₆₀-Heteroarylengruppe, einer substituierten oder unsubstituierten zweiwertigen nicht aromatischen kondensierten polycyclischen Gruppe und einer substituierten oder unsubstituierten zweiwertigen nicht aromatischen kondensierten heteropolycyclischen Gruppe ausgewählt sind,
a21 bis a23 jeweils unabhängig aus 0 und 1 ausgewählt sind,
R₂₆, R₂₇ und R₁₁₁ jeweils unabhängig aus einer Phenylgruppe, einer Biphenylgruppe, einer Terphenylgruppe, einer Naphthylgruppe, einer Fluorenylgruppe, einer spiro-Bifluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Tetraphenylgruppe, einer Chrysenylgruppe, einer Perylenylgruppe, einer Pentaphenylgruppe, einer Hexacenylgruppe, einer Pentacenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Indazolylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzoxazolylgruppe, einer Triazolylgruppe, einer Tetrazolylgruppe, einer Oxadiazolylgruppe, einer Triazinylgruppe, einer Dibenzofuranylgruppe und einer Dibenzothiophenylgruppe ausgewählt sind; und
einer Phenylgruppe, einer Biphenylgruppe, einer Terphenylgruppe, einer Naphthylgruppe, einer Fluorenylgruppe, einer spiro-Bifluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Tetraphenylgruppe, einer Chrysenylgruppe, einer Perylenylgruppe, einer Pentaphenylgruppe, einer Hexacenylgruppe, einer Pentacenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Indazolylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzoxazolylgruppe, einer Triazolylgruppe, einer Tetrazolylgruppe, einer Oxadiazolylgruppe, einer Triazinylgruppe, einer Dibenzofuranylgruppe und einer Dibenzothiophenylgruppe, die jeweils mit mindestens einem substituiert sind, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Phenylgruppe, einer Phenylgruppe, substituiert mit einer C₁-C₂₀-Alkylgruppe, einer Biphenylgruppe, einer Terphenylgruppe, einer Naphthylgruppe, einer Fluorenylgruppe, einer spiro-Bifluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Hexacenylgruppe, einer Pentacenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Indazolylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzoxazolylgruppe, einer Triazolylgruppe, einer Tetrazolylgruppe, einer Oxadiazolylgruppe, einer Triazinylgruppe, einer Dibenzofuranylgruppe und einer Dibenzothiophenylgruppe,
Y₂₁ bis Y₂₃ jeweils unabhängig aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer substituierten oder unsubstituierten C₁-C₆₀-Alkylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₆-C₆₀-Arylgruppe,einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nicht aromatischen kondensierten polycyclischen Gruppe, einer substituierten oder unsubstituierten einwertigen nicht aromatischen kondensierten heteropolycyclischen Gruppe, -Si(Q₁)(Q₂)(Q₃), -N(Q₁)(Q₂), -B(Q₁)(Q₂), -C(=O)(Q₁), - S(=O)₂(Q₁) und -P(=O)(Q₁)(Q₂) ausgewählt sind,
mindestens ein Substituent der substituierten C₆-C₆₀-Arylengruppe, der substituierten C₁-C₆₀-Heteroarylengruppe, der substituierten zweiwertigen nicht aromatischen kondensierten polycyclischen Gruppe, der substituierten zweiwertigen nicht aromatischen kondensierten heteropolycyclischen Gruppe, der substituierten C₁-C₆₀-Alkylgruppe, der substituierten C₂-C₆₀-Alkenylgruppe, der substituierten C₂-C₆₀-Alkynylgruppe, der substituierten C₁-C₆₀-Alkoxygruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe,der substituierten C₆-C₆₀-Aryloxygruppe, der substituierten C₆-C₆₀-Arylthiogruppe, der substituierten C₁-C₆₀-Heteroarylgruppe, der substituierten einwertigen nicht aromatischen kondensierten polycyclischen Gruppe und der substituierten einwertigen nicht aromatischen kondensierten heteropolycyclischen Gruppe ausgewählt ist aus:
Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkynylgruppe und einer C₁-C₆₀-Alkoxygruppe;
einer C₁-C₆₀-Alkylgruppe, einer C₂-C₆₀-Alkenylgruppe, einer C₂-C₆₀-Alkynylgruppe und einer C₁-C₆₀-Alkoxygruppe, die jeweils mit mindestens einem substituiert sind, ausgewählt aus Deuterium,-F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht aromatischen kondensierten polycyclischen Gruppe, einer einwertigen nicht aromatischen kondensierten heteropolycyclischen Gruppe, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁) und - P(=O)(Q₁₁)(Q₁₂);
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht aromatischen kondensierten polycyclischen Gruppe und einer einwertigen nicht aromatischen kondensierten heteropolycyclischen Gruppe;
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht aromatischen kondensierten polycyclischen Gruppe und einer einwertigen nicht aromatischen kondensierten heteropolycyclischen Gruppe, die jeweils mit mindestens einem substituiert sind, ausgewählt aus Deuterium, - F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht aromatischen kondensierten polycyclischen Gruppe, einer einwertigen nicht aromatischen kondensierten heteropolycyclischen Gruppe, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁) und - P(=O)(Q₂₁)(Q₂₂); und
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und - P(=O)(Q₃₁)(Q₃₂),
wobei Q₁ bis Q₃, Q₁₁ bis Q₁₃, Q₂₁ bis Q₂₃ und Q₃₁ bis Q₃₃ jeweils unabhängig aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer einwertigen nicht aromatischen kondensierten polycyclischen Gruppe, einer einwertigen nicht aromatischen kondensierten heteropolycyclischen Gruppe, einer Biphenylgruppe und einer Terphenylgruppe ausgewählt sind.

2. Organische lichtemittierende Vorrichtung nach Anspruch 1, wobei R₁₉ und R₂₀ jeweils unabhängig aus Rₓ und R_{y} ausgewählt sind.

3. Organische lichtemittierende Vorrichtung nach Anspruch 1 oder Anspruch 2, wobei R₁₁ bis R₁₈ jeweils unabhängig aus Wasserstoff, Deuterium, -F, -Cl, -Br, -I, einer Cyanogruppe, einer C₁-C₆₀-Alkylgruppe, einer C₆-C₆₀-Arylgruppe,einer C₁-C₆₀-Heteroarylgruppe und -Si(Q₁)(Q₂)(Q₃) ausgewählt sind,
wobei Q₁ bis Q₃ jeweils unabhängig aus einer C₁-C₆₀-Alkylgruppe, einer C₆-C₆₀-Arylgruppe, einer Biphenylgruppe und einer Terphenylgruppe ausgewählt sind.

4. Organische lichtemittierende Vorrichtung nach einem der Ansprüche 1 bis 3, wobei L₁₁ und L₁₂ jeweils unabhängig ausgewählt sind aus:
einer Phenylengruppe, einer Naphthylengruppe, einer Fluorenylengruppe, einer Dibenzofuranylengruppe und einer Dibenzothiophenylengruppe; und
einer Phenylengruppe, einer Naphthylengruppe, einer Fluorenylengruppe, einer Dibenzofuranylengruppe und einer Dibenzothiophenylengruppe, die jeweils mit mindestens einem substituiert sind, ausgewählt aus Deuterium, -F, -Cl, -Br, -I, einer Cyanogruppe, einer Nitrogruppe, einer C₁-C₂₀-Alkylgruppe, einer Phenylgruppe und einer Naphthylgruppe.

5. Organische lichtemittierende Vorrichtung nach einem der Ansprüche 1 bis 4, wobei L₁₁ und L₁₂ jeweils unabhängig aus Gruppen ausgewählt sind, die durch die Formeln 3-1 bis 3-25 dargestellt sind: 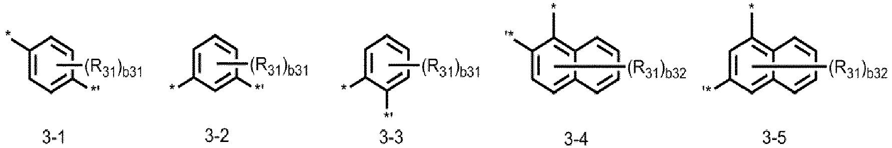 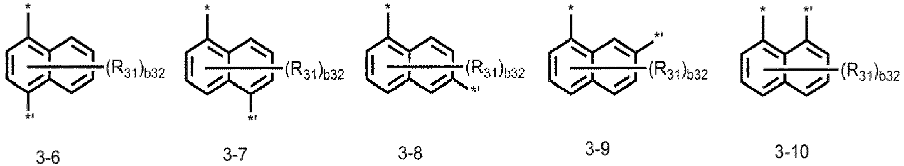 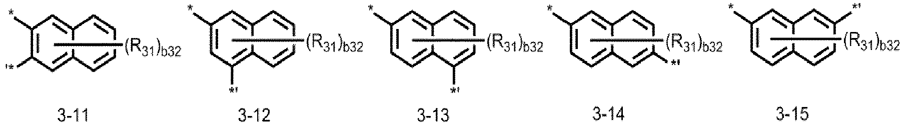 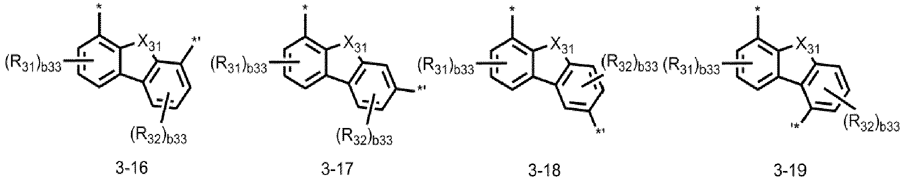 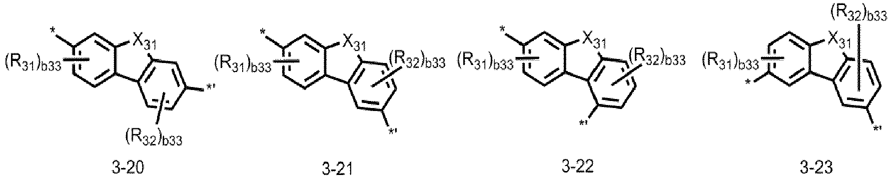 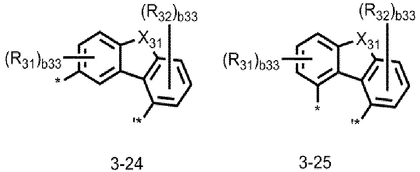 wobei in den Formeln 3-1 bis 3-25
X₃₁ aus O, S und C(R₃₃)(R₃₄) ausgewählt ist,
R₃₁ bis R₃₄ jeweils unabhängig aus Wasserstoff, Deuterium, -F, -Cl, -Br, -I, einer Cyanogruppe, einer Nitrogruppe, einer Methylgruppe, einer Ethylgruppe, einer n-Propylgruppe, einer iso-Propylgruppe, einer n-Butylgruppe, einer iso-Butylgruppe, einer sec-Butylgruppe, einer tert-Butylgruppe, einer Phenylgruppe und einer Naphthylgruppe ausgewählt sind,
b31 aus 1, 2, 3 und 4 ausgewählt ist,
b32 aus 1, 2, 3, 4, 5 und 6 ausgewählt ist,
b33 aus 1, 2 und 3 ausgewählt ist, und
^{∗} und ^{∗}'jeweils eine Bindungsstelle an ein benachbartes Atom anzeigen.

6. Organische lichtemittierende Vorrichtung nach einem der Ansprüche 1 bis 5, wobei A₁₁ eine Gruppe ist, die durch eine der Formeln 10C-1, 10C-2 und 10C-3 dargestellt ist: 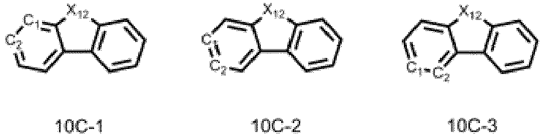 wobei in den Formeln 10C-1, 10C-2 und 10C-3
X₁₂ wie in Formel 1 definiert ist, und
C₁ und C₂ jeweils unabhängig ein Kohlenstoffatom in Formel 10-1A sind.

7. Organische lichtemittierende Vorrichtung nach einem der Ansprüche 1 bis 6, wobei Rₓ aus Gruppen ausgewählt ist, die durch die Formeln 10-21 bis 10-26 dargestellt sind: 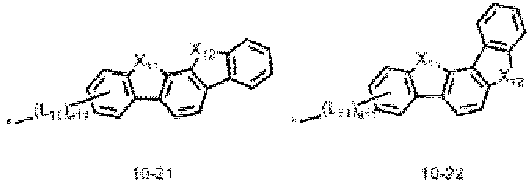 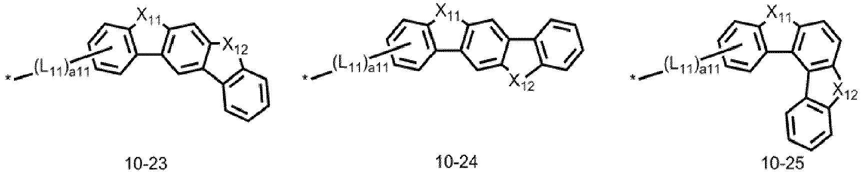 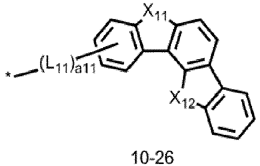 wobei in den Formeln 10-21 bis 10-26
L₁₁, a11, X₁₁ und X₁₂ wie in Formel 1 definiert sind, und
^{∗} eine Bindungsstelle an ein benachbartes Atom anzeigt.

8. Organische lichtemittierende Vorrichtung nach einem der Ansprüche 1 bis 7, wobei R₁₀₈ ausgewählt ist aus:
einer Phenylgruppe, einer Biphenylgruppe, einer Terphenylgruppe, einer Naphthylgruppe, einer Fluorenylgruppe, einer spiro-Bifluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Hexacenylgruppe, einer Pentacenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Indazolylgruppe, einer Chinolinylgruppe, einer Isochinolinylgruppe, einer Carbazolylgruppe, einer Benzochinolinylgruppe, einer Phthalazinylgruppe, einer Naphthyridinylgruppe, einer Chinoxalinylgruppe, einer Chinazolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbozylylgruppe und einer Dibenzocarbazolylgruppe; und
einer Phenylgruppe, einer Biphenylgruppe, einer Terphenylgruppe, einer Naphthylgruppe, einer Fluorenylgruppe, einer spiro-Bifluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Hexacenylgruppe, einer Pentacenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Indazolylgruppe, einer Chinolinylgruppe, einer Isochinolinylgruppe, einer Carbazolylgruppe, einer Benzochinolinylgruppe, einer Phthalazinylgruppe, einer Naphthyridinylgruppe, einer Chinoxalinylgruppe, einer Chinazolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe und einer Dibenzocarbazolylgruppe, die jeweils mit mindestens einem substituiert sind, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Phenylgruppe, einer Biphenylgruppe, einer Terphenylgruppe, einer Naphthylgruppe, einer Fluorenylgruppe, einer spiro-Bifluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Hexacenylgruppe, einer Pentacenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Indazolylgruppe, einer Chinolinylgruppe, einer Isochinolinylgruppe, einer Carbazolylgruppe, einer Benzochinolinylgruppe, einer Phthalazinylgruppe, einer Naphthyridinylgruppe, einer Chinoxalinylgruppe, einer Chinazolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe und einer Dibenzocarbazolylgruppe.

9. Organische lichtemittierende Vorrichtung nach einem der Ansprüche 1 bis 8, wobei R₁₀₈ aus Gruppen ausgewählt ist, die durch die Formeln 5-1 bis 5-30 dargestellt sind: 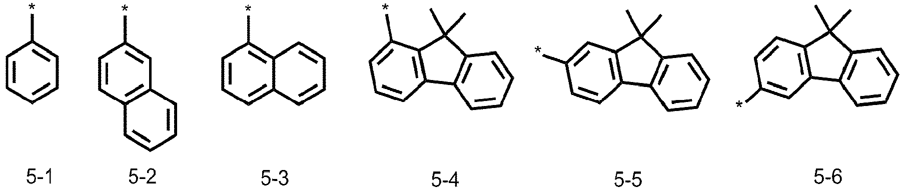 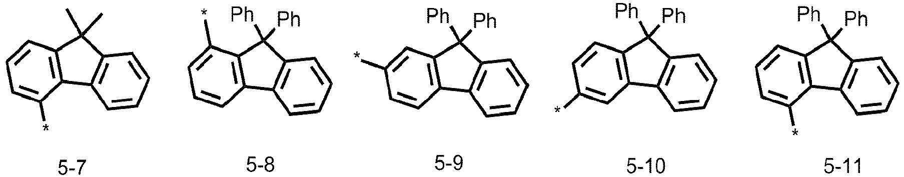 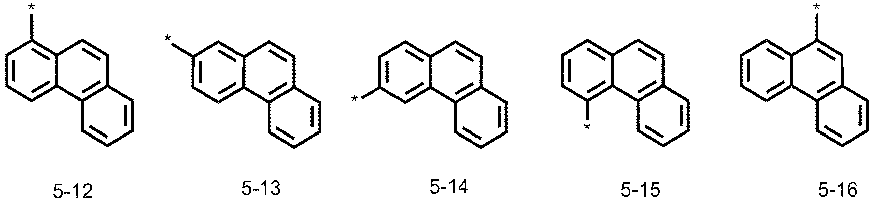 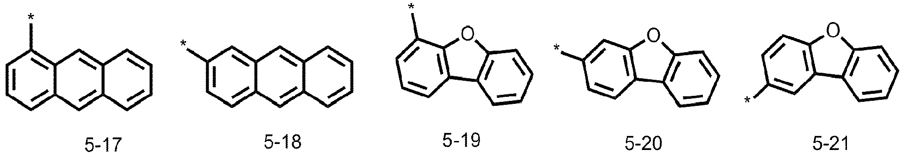 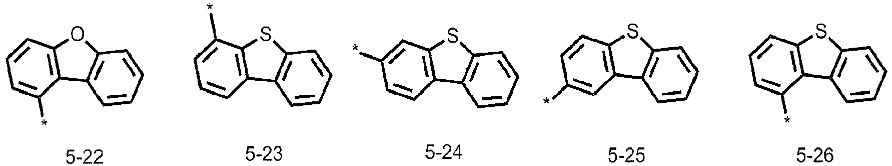 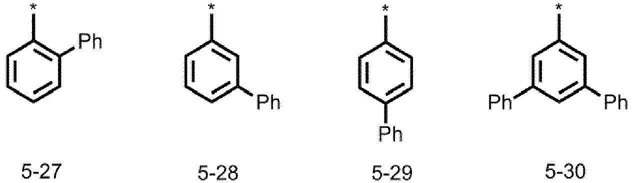 wobei in den Formeln 5-1 bis 5-30
Ph eine Phenylgruppe ist, und
^{∗} eine Bindungsstelle an ein benachbartes Atom anzeigt.

10. Organische lichtemittierende Vorrichtung nach einem der Ansprüche 1 bis 9, wobei
R₂₃ R_{z} ist, oder
R₂₂ und R₂₄ jeweils R_{z} sind und R₂₂ und R₂₄ gleich oder verschieden sind.

11. Organische lichtemittierende Vorrichtung nach einem der Ansprüche 1 bis 10, wobei R₂₁ bis R₂₅ jeweils unabhängig aus R_{z}, Wasserstoff und einer C₁-C₆₀-Alkylgruppe ausgewählt sind.

12. Organische lichtemittierende Vorrichtung nach einem der Ansprüche 1 bis 11, wobei L₂₁ bis L₂₃ jeweils unabhängig ausgewählt sind aus: einer Phenylengruppe, einer Naphthylengruppe, einer Pyridinylengruppe, einer Pyrazinylengruppe, einer Pyrimidinylengruppe, einer Chinolinylengruppe, einer Isochinolinylengruppe und einer Triazinylengruppe; und
einer Phenylengruppe, einer Naphthylengruppe, einer Pyridinylengruppe, einer Pyrazinylengruppe, einer Pyrimidinylengruppe, einer Chinolinylengruppe, einer Isochinolinylengruppe und einer Triazinylengruppe, die jeweils mit mindestens einem substituiert sind, ausgewählt aus Deuterium, -F, -Cl, -Br, -I, einer Cyanogruppe, einer Nitrogruppe, einer C₁-C₂₀-Alkylgruppe, einer C₁-C₂₀-Alkoxygruppe, einer Phenylgruppe und einer Naphthylgruppe.

13. Organische lichtemittierende Vorrichtung nach einem der Ansprüche 1 bis 12, wobei L₂₁ bis L₂₃ jeweils unabhängig aus Gruppen ausgewählt sind, die durch die Formeln 6-1 bis 6-54 dargestellt sind: 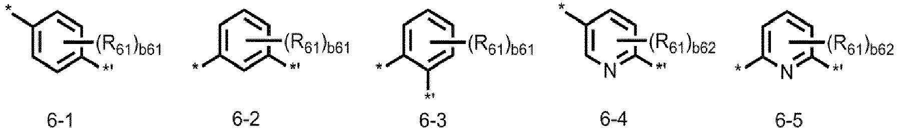 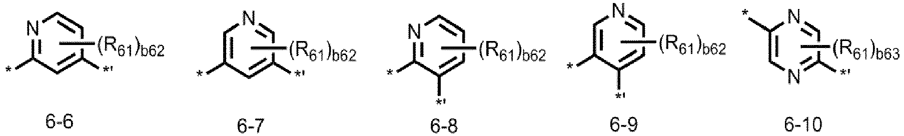 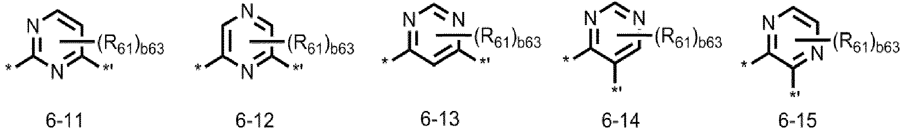 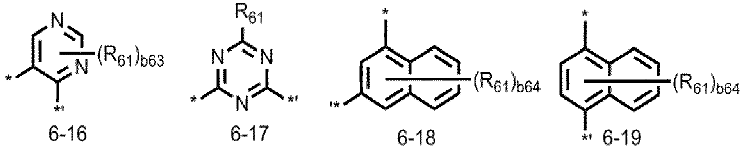 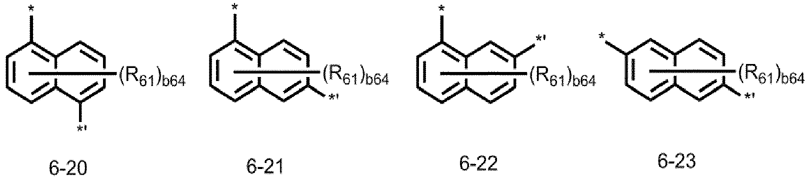 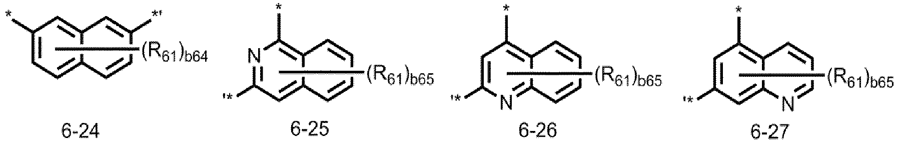 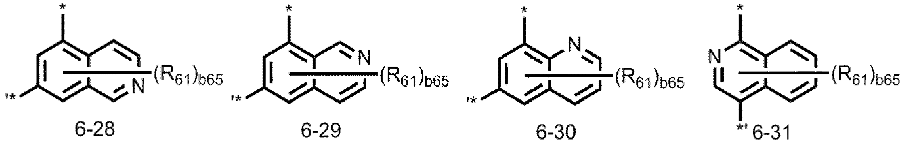 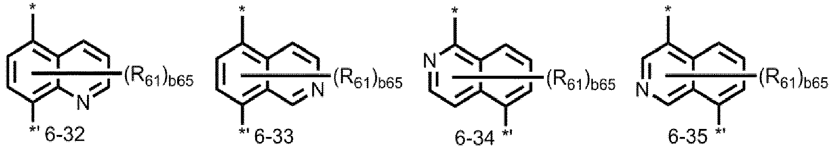 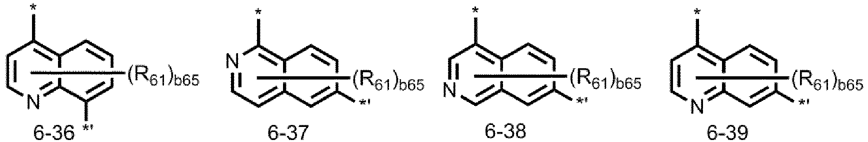 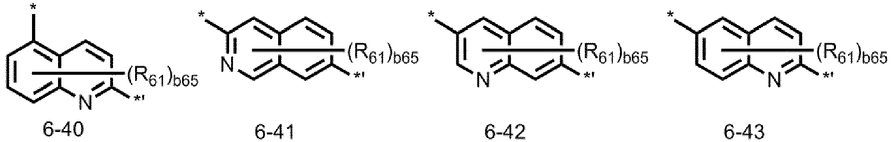 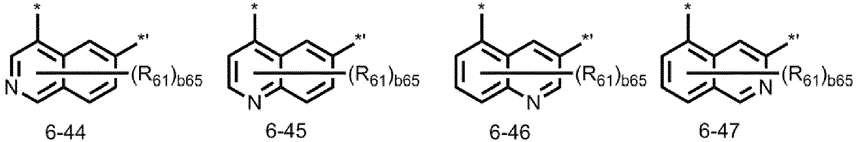 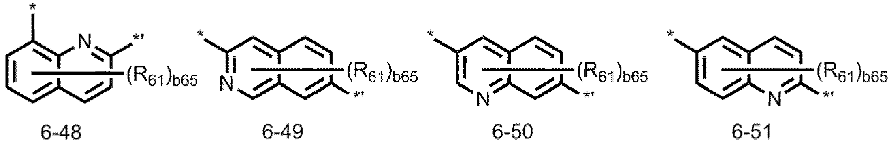 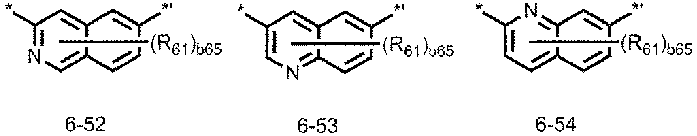 wobei in den Formeln 6-1 bis 6-54
R₆₁ aus Wasserstoff, Deuterium, -F, -Cl, -Br, -I, einer Cyanogruppe, einer Nitrogruppe, einer Methylgruppe, einer Ethylgruppe, einer n-Propylgruppe, einer iso-Propylgruppe, einer n-Butylgruppe, einer iso-Butylgruppe, einer sec-Butylgruppe, einer tert-Butylgruppe, einer Methoxygruppe, einer Ethoxygruppe, einer Phenylgruppe und einer Naphthylgruppe ausgewählt sind,
b61 aus 1, 2, 3 und 4 ausgewählt ist,
b62 aus 1, 2 und 3 ausgewählt ist,
b63 aus 1 und 2 ausgewählt ist,
b64 aus 1, 2, 3, 4, 5 und 6 ausgewählt ist,
b65 aus 1, 2, 3, 4 und 5 ausgewählt ist, und
^{∗} und ^{∗}'jeweils eine Bindungsstelle an ein benachbartes Atom anzeigen.

14. Organische lichtemittierende Vorrichtung nach einem der Ansprüche 1 bis 13, wobei R₂₆, R₂₇ und R₁₁₁ jeweils unabhängig aus Gruppen ausgewählt sind, die durch die Formeln 8-1 bis 8-36 dargestellt sind: 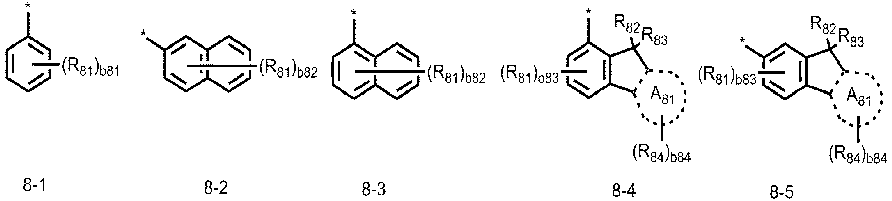 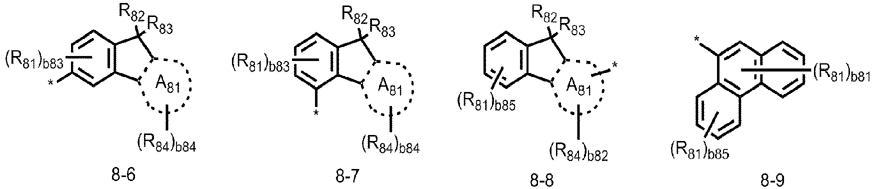 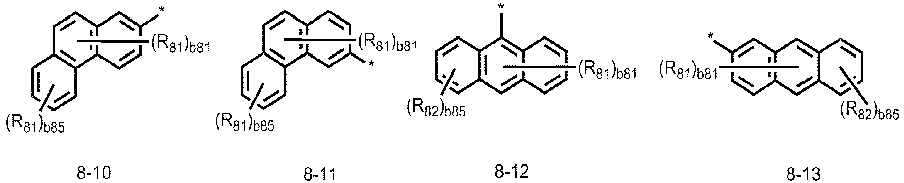 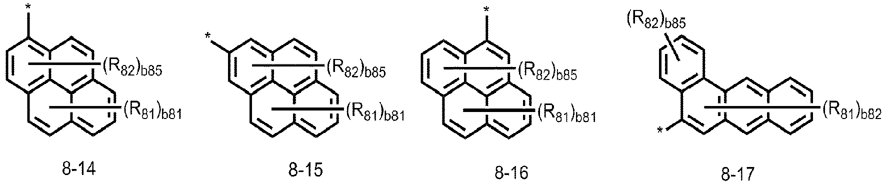 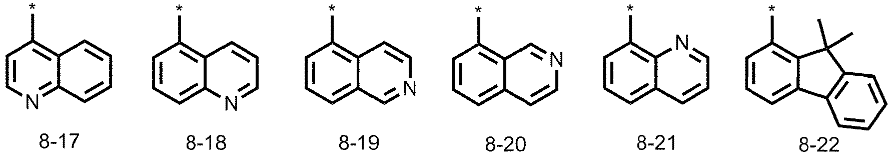 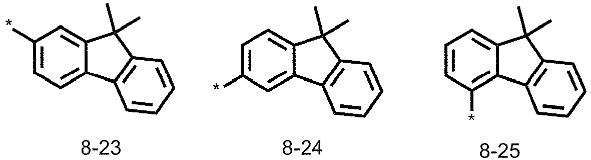 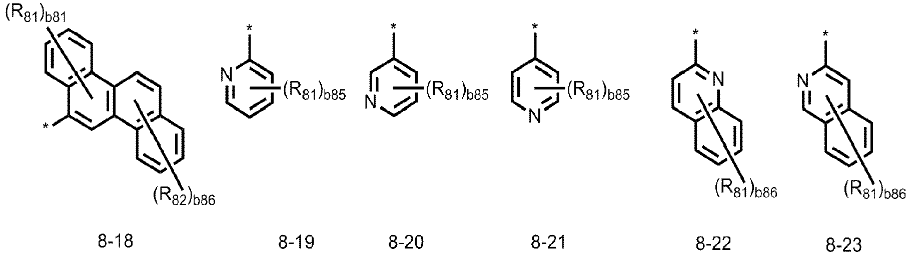 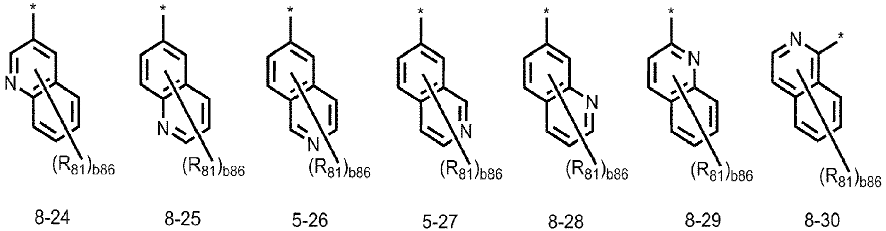 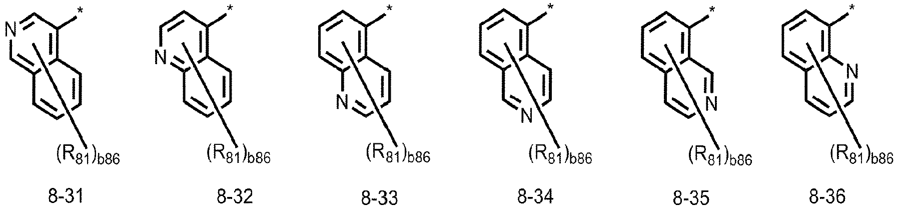 wobei in den Formeln 8-1 bis 8-36
A₈₁ aus einer Benzolgruppe, einer Naphthalengruppe und einer Phenanthrengruppe ausgewählt ist,
R₈₁ bis R₈₄ jeweils unabhängig aus Wasserstoff, einer Methylgruppe, einer Ethylgruppe, einer n-Propylgruppe, einer iso-Propylgruppe, einer n-Butylgruppe, einer sec-Butylgruppe, einer iso-Butylgruppe, einer tert-Butylgruppe, einer Methoxygruppe, einer Ethoxygruppe, einer Phenylgruppe, einer Phenylgruppe, die mit einer Methylgruppe substituiert ist, einer Biphenylgruppe, einer Terphenylgruppe und einer Naphthylgruppe ausgewählt sind,
b81 aus 1, 2, 3, 4 und 5 ausgewählt ist,
b82 aus 1, 2, 3, 4, 5, 6 und 7 ausgewählt ist,
b83 aus 1, 2 und 3 ausgewählt ist,
b84 aus 1, 2, 3, 4, 5, 6, 7 und 8 ausgewählt ist,
b85 aus 1, 2, 3 und 4 ausgewählt ist,
b86 aus 1, 2, 3, 4, 5 und 6 ausgewählt ist, und
^{∗} eine Bindungsstelle an ein benachbartes Atom anzeigt.

15. Organische lichtemittierende Vorrichtung nach einem der Ansprüche 1 bis 14, wobei die erste Verbindung durch Formel 1-1 dargestellt ist: 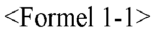 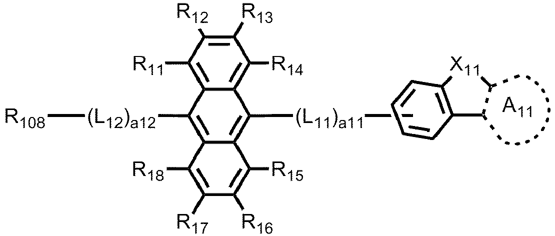 R₁₁ bis R₁₄, R₁₅ bis R₁₈, L₁₁, L₁₂, a11, a12, A₁₁, X₁₁ und R₁₀₈ in Formel 1-1 wie in Formel 1 definiert ist.

16. Organische lichtemittierende Vorrichtung nach einem der Ansprüche 1 bis 15, wobei die erste Verbindung durch eine der Formeln 1-21 bis 1-26 dargestellt ist: 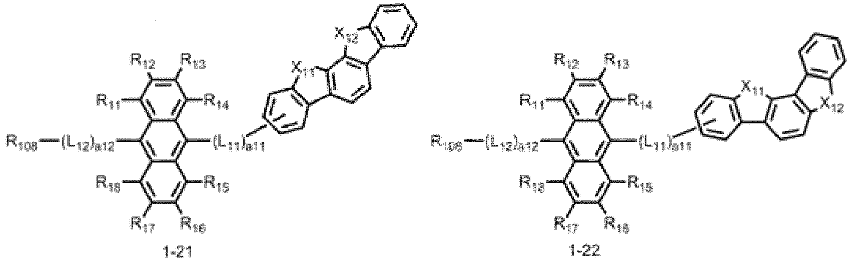 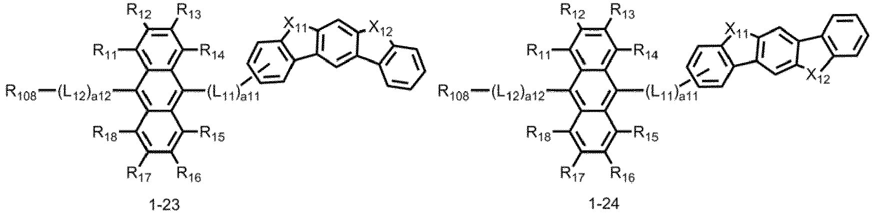 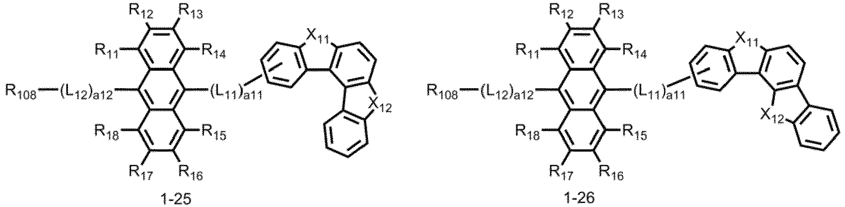 R₁₁ bis R₁₄, R₁₅ bis R₁₈, L₁₁, L₁₂, a11, a12, X₁₁, X₁₂ und R₁₀₈ in den Formeln 1-21 bis 1-26 wie in Formel 1 definiert sind.

17. Organische lichtemittierende Vorrichtung nach einem der Ansprüche 1 bis 16, wobei die zweite Verbindung durch eine der Formeln 2-1 und 2-2 dargestellt ist: 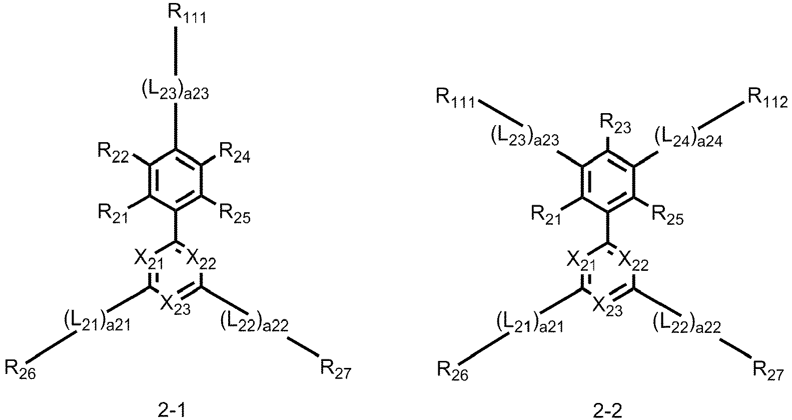 wobei in den Formeln 2-1 und 2-2
X₂₁ bis X₂₃, L₂₁ bis L₂₃, a21 bis a23, R₂₁, R₂₂, R₂₃, R₂₄ bis R₂₇ und R₁₁₁ wie in Formel 2 definiert sind,
L₂₄ wie in Bezug auf L₂₃ in Formel 2 definiert ist,
a24 wie in Bezug auf a23 in Formel 2 definiert ist, und
R₁₁₂ wie in Bezug auf R₁₁₁ in Formel 2 definiert ist.

18. Organische lichtemittierende Vorrichtung nach einem der Ansprüche 1 bis 17, wobei die zweite Verbindung durch eine der Formeln 2-11 bis 2-20 dargestellt ist: 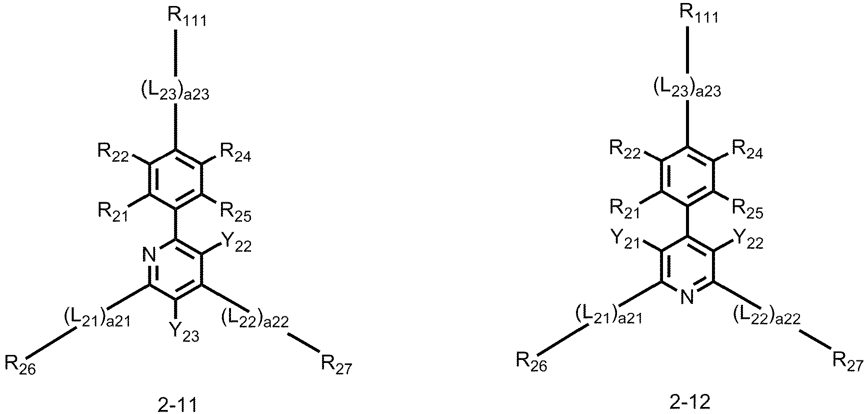 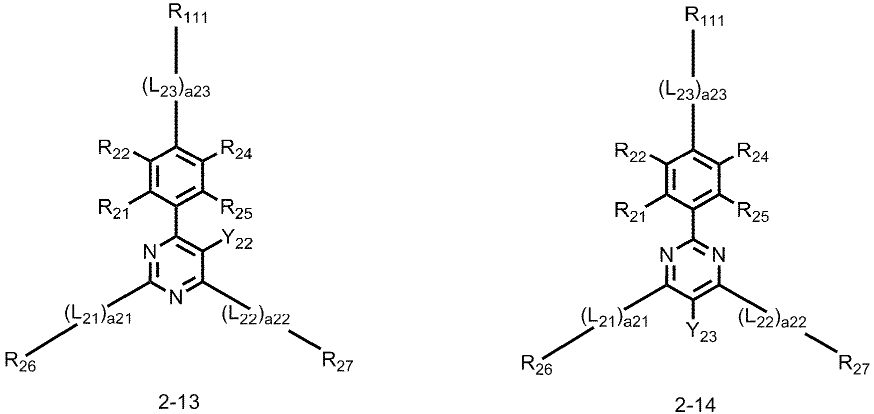 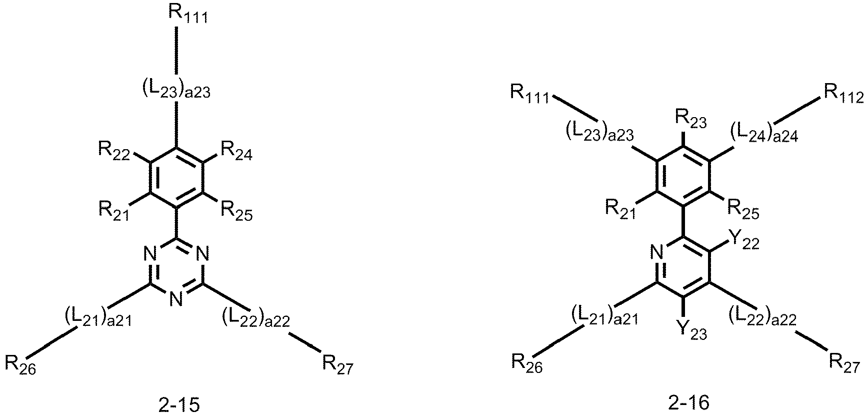 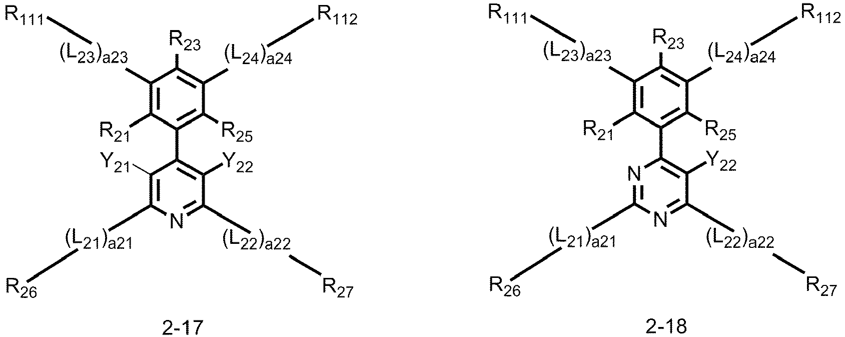 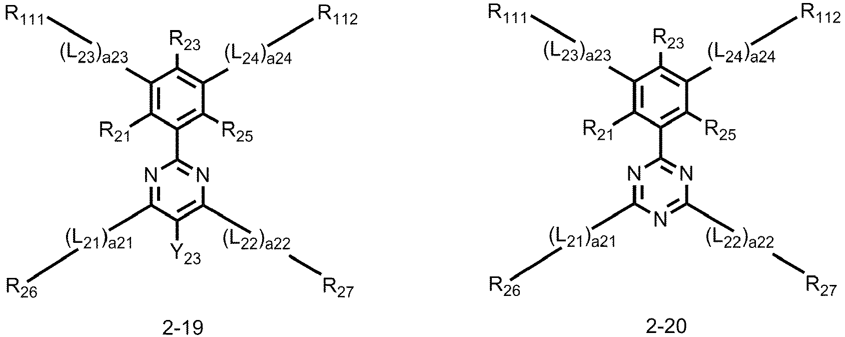 wobei in den Formeln 2-11 bis 2-20
Y₂₁ bis Y₂₃, L₂₁ bis L₂₃, a21 bis a23, R₂₁, R₂₂, R₂₃, R₂₄ bis R₂₇ und R₁₁₁ wie in Formel 2 definiert sind,
L₂₄ wie in Bezug auf L₂₃ in Formel 2 definiert ist,
a24 wie in Bezug auf a23 in Formel 2 definiert ist, und
R₁₁₂ wie in Bezug auf R₁₁₁ in Formel 2 definiert ist.

19. Organische lichtemittierende Vorrichtung nach einem der Ansprüche 1 bis 18, wobei die organische Schicht eine Emissionsschicht und eine Elektronentransportregion umfasst,
die Elektronentransportregion zwischen der Emissionsschicht und der zweiten Elektrode angeordnet ist,
die Emissionsschicht die erste Verbindung umfasst, und
die Elektronentransportregion die zweite Verbindung umfasst.

## Revendications

1. Dispositif électroluminescent organique comprenant :
une première électrode ;
une seconde électrode ; et
une couche organique entre la première électrode et la seconde électrode,
dans lequel la couche organique comprend un premier composé représenté par la Formule 1 et un second composé représenté par la Formule 2 : 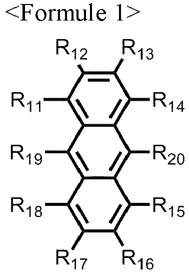 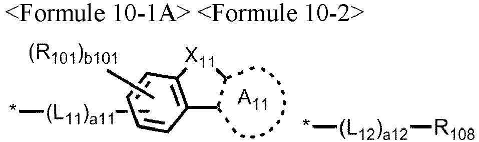 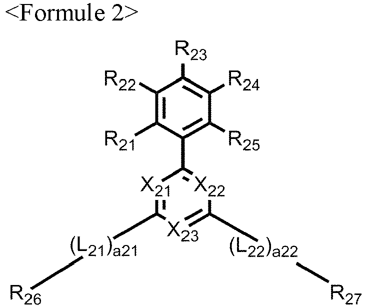
<Formule 11-1> *-(L₂₃)ₐ₂₃-R₁₁₁
dans lequel, dans les Formules 1, 2, 10-1A, 10-2 et 11-1,
R₁₁ à R₂₀ sont chacun indépendamment sélectionnés parmi Rₓ, R_{y}, l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀ substitué ou non-substitué, un groupe alcényle en C₂-C₆₀ substitué ou non-substitué, un groupe alcynyle en C₂-C₆₀ substitué ou non-substitué, un groupe alcoxy en C₁-C₆₀ substitué ou non-substitué, un groupe cycloalkyle en C₃-C₁₀ substitué ou non-substitué, un groupe hétérocycloalkyle en C₁-C₁₀ substitué ou non-substitué, un groupe cycloalcényle en C₃-C₁₀ substitué ou non-substitué, un groupe hétérocycloalcényle en C₁-C₁₀ substitué ou non-substitué, un groupe aryle en C₆-C₆₀ substitué ou non-substitué, un groupe aryloxy en C₆-C₆₀ substitué ou non-substitué, un groupe arylthio en C₆-C₆₀ substitué ou non-substitué, un groupe hétéroaryle en C₁-C₆₀ substitué ou non-substitué, un groupe polycyclique condensé non-aromatique monovalent substitué ou non-substitué, un groupe hétéropolycyclique condensé non-aromatique monovalent substitué ou non-substitué, - Si(Q₁)(Q₂)(Q₃), -N(Q₁)(Q₂), -B(Q₁)(Q₂), -C(=O)(Q₁), -S(=O)₂(Q₁), et -P(=O)(Q₁)(Q₂), et au moins un de R₁₁ à R₂₀ est un Rₓ et au moins un de R₁₁ à R₂₀ est un R_{y},
Rₓ est représenté par la Formule 10-1A,
R_{y} est représenté par la Formule 10-2,
L₁₁ et L₁₂ sont chacun indépendamment sélectionnés parmi un groupe arylène en C₆-C₆₀ substitué ou non-substitué, un groupe hétéroarylène en C₁-C₆₀ substitué ou non-substitué, un groupe polycyclique condensé non-aromatique divalent substitué ou non-substitué, et un groupe hétéropolycyclique condensé non-aromatique divalent substitué ou non-substitué,
a11 et a12 sont chacun indépendamment sélectionnés parmi 0, 1, 2, et 3,
A₁₁ est un groupe représenté par la Formule 10C, 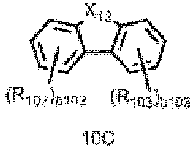
X₁₁ est sélectionné parmi un atome d'oxygène, un atome de soufre, et C(R₁₀₄)(R₁₀₅),
X₁₂ est sélectionné parmi un atome d'oxygène, un atome de soufre, et C(R₁₀₆)(R₁₀₇),
dans lequel X₁₁ et X₁₂ sont tous deux des atomes d'oxygène ; ou X₁₁ et X₁₂ sont tous deux des atomes de soufre ; ou X₁₁ est C(R₁₀₄)(R₁₀₅), et X₁₂ est C(R₁₀₆)(R₁₀₇) ;
R₁₀₁ à R₁₀₇ sont chacun indépendamment sélectionnés parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀ substitué ou non-substitué, un groupe alcényle en C₂-C₆₀ substitué ou non-substitué, un groupe alcynyle en C₂-C₆₀ substitué ou non-substitué, un groupe alcoxy en C₁-C₆₀ substitué ou non-substitué, un groupe cycloalkyle C₃-C₁₀ substitué ou non-substitué, un groupe hétérocycloalkyle en C₁-C₁₀ substitué ou non-substitué, un groupe cycloalcényle en C₃-C₁₀ substitué ou non-substitué, un groupe hététocycloalcényle en C₁-C₁₀ substitué ou non-substitué, un groupe aryle en C₆-C₆₀ substitué ou non-substitué, un groupe aryloxy en C₆-C₆₀ substitué ou non-substitué, i, groupe arylthio en C₆-C₆₀ substitué ou non-substitué, un groupe hétéroaryle en C₁-C₆₀ substitué ou non-substitué, un groupe polycyclique condensé non-aromatique monovalent substitué ou non-substitué, un groupe hétéropolycyclique condensé non-aromatique monovalent substitué ou non-substitué, --Si(Q₁)(Q₂)(Q₃), -N(Q₁)(Q₂), -B(Q₁)(Q₂), -C(=O)(Q₁), -S(=O)₂(Q₁), et -P(=O)(Q₁)(Q₂),
b101 à b103 sont chacun indépendamment sélectionnés parmi 1, 2, 3, 4, 5, et 6,
R₁₀₈ est sélectionné à partir d'un groupe aryle en C₆-C₆₀ substitué ou non-substitué, un groupe hétéroaryle en C₁-C₆₀ substitué ou non-substitué, un groupe polycyclique condensé non-aromatique monovalent substitué ou non-substitué, et un groupe hétéropolycyclique condensé non-aromatique monovalent substitué ou non-substitué,
^{∗} indique un site de liaison à un atome voisin,
X₂₁ est un C(Y₂₁) ou un atome d'azote (N), X₂₂ est C(Y₂₂) ou N, X₂₃ est C(Y₂₃) ou N, et au moins un de X₂₁ à X₂₃ est N,
R₂₁ à R₂₅ sont chacun indépendamment sélectionnés parmi R_{z}, l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀ substitué ou non-substitué, un groupe alcoxy en C₁-C₆₀ substitué ou non-substitué, un groupe cycloalkyle en C₃-C₁₀ substitué ou non-substitué, un groupe aryle en C₆-C₆₀ substitué ou non-substitué, un groupe aryloxy en C₆-C₆₀ substitué ou non-substitué, un groupe arylthio en C₆-C₆₀ substitué ou non-substitué, un groupe hétéroaryle en C₁-C₆₀ substitué ou non-substitué, un groupe polycyclique condensé non-aromatique monovalent substitué ou non-substitué, un groupe hétéropolycyclique condensé non-aromatique monovalent substitué ou non-substitué, -Si(Q₁)(Q₂)(Q₃), -N(Q₁)(Q₂), -B(Q₁)(Q₂), -C(=O)(Q₁), -S(=O)₂(Q₁), et -P(=O)(Q₁)(Q₂), et au moins un R₂₁ à R₂₅ est R_{z},
R_{z} est un groupe représenté par la formule 11-1,
L₂₁ à L₂₃ sont chacun indépendamment sélectionnés parmi un groupe arylène en C₆-C₆₀ substitué ou non-substitué, un groupe hétéroarylène en C₁-C₆₀ substitué ou non-substitué, un groupe polycyclique condensé non-aromatique divalent substitué ou non-substitué, et un groupe hétéropolycyclique condensé non-aromatique divalent substitué ou non-substitué,
a21 à a23 sont chacun indépendamment sélectionnés parmi 0 et 1,
R₂₆, R₂₇, et R₁₁₁ sont chacun indépendamment sélectionnés parmi un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe tétraphényle, un groupe chrysényle, un groupe pérylényle, un groupe pentaphényle, un groupe hexacényle, un groupe pentacényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe indazolyle, un groupe quinolinyle, un groupe isoquinolinyle, un groupe benzoquinolinyle, un groupe phthalazinyle, un groupe naphthyridinyle, un groupe quinoxalinyle, un groupe quinazolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzoxazolyle, un groupe triazolyle, un groupe tétrazolyle, un groupe oxadiazolyle, un groupe triazinyle, un groupe dibenzofuranyle, et un groupe dibenzothiophényle ; et
un groupe phényle, un groupe biphényle, un groupe terphényle, un groupe naphtyle, un groupe fluorényle, un groupe spiro-bifluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe tétraphényle, un groupe chrysényle, un groupe pérylényle, un groupe pentaphényle, un groupe hexacényle, un groupe pentacényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe indazolyle, un groupe quinolinyle, un groupe isoquinolinyle, un groupe benzoquinolinyle, un groupe phthalazinyle, un groupe naphthyridinyle, un groupe quinoxalinyle, un groupe quinazolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzoxazolyle, un groupe triazolyle, un groupe tétrazolyle, un groupe oxadiazolyle, un groupe triazinyle, un groupe dibenzofuranyle, et un groupe dibenzothiophényle, chacun substitués par au moins un élément sélectionné parmi le deutérium, un -F, -Cl, -Br, -I, un groupe hydroxyle, un groupe cyano, un groupe nitro, un groupe amidino, un groupe hydrazino, un groupe hydrazono, un groupe alkyle en C₁-C₂₀, un groupe alcoxy en C₁-C₂₀, un groupe phényle, un groupe phényle substitué par un groupe alkyle en C₁-C₂₀, un groupe biphényle, un groupe terphényle, un groupe naphtyle, un groupe fluorényle, un groupe spiro-bifluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentaphényle, un groupe hexacényle, un groupe pentacényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe indazolyle, un groupe quinolinyle, un groupe isoquinolinyle, un groupe benzoquinolinyle, un groupe phthalazinyle, un groupe naphthyridinyle, un groupe quinoxalinyle, un groupe quinazolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzoxazolyle, un groupe triazolyle, un groupe tétrazolyle, un groupe oxadiazolyle, un groupe triazinyle, un groupe dibenzofuranyle, et un groupe dibenzothiophényle,
Y₂₁ à Y₂₃ sont chacun indépendamment sélectionnés parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀ substitué ou non-substitué, un groupe alcoxy en C₁-C₆₀substitué ou non-substitué, un groupe cycloalkyle en C₃-C₁₀ substitué ou non-substitué, un groupe aryle en C₆-C₆₀ substitué ou non-substitué, un groupe aryloxy en C₆-C₆₀ substitué ou non-substitué, un groupe arylthio en C₆-C₆₀ substitué ou non-substitué, un groupe hétéroaryle en C₁-C₆₀ substitué ou non-substitué, un groupe polycyclique condensé non-aromatique monovalent substitué ou non-substitué, un groupe hétéropolycyclique condensé non-aromatique monovalent substitué ou non-substitué, -Si(Q₁)(Q₂)(Q₃), -N(Q₁)(Q₂), -B(Q₁)(Q₂), -C(=O)(Q₁), -S(=O)₂(Q₁), et -P(=O)(Q₁)(Q₂),
au moins un substituant du groupe arylène en C₆-C₆₀ substitué, du groupe hétéroarylène en C₁-C₆₀ substitué, du groupe polycyclique condensé non-aromatique divalent substitué, du groupe hétéropolycyclique condensé non-aromatique divalent substitué, du groupe alkyle en C₁-C₆₀ substitué, du groupe alcényle en C₂-C₆₀ substitué, du groupe alcynyle en C₂-C₆₀ substitué, du groupe alcoxy en C₁-C₆₀ substitué, du groupe cycloalkyle en C₃-C₁₀ substitué, du groupe hétérocycloalkyle en C₁-C₁₀ substitué, du groupe cycloalcényle en C₃-C₁₀ substitué, du groupe hétérocycloalcényle en C₁-C₁₀ substitué, du groupe aryle en C₆-C₆₀ substitué, du groupe aryloxy en C₆-C₆₀ substitué, du groupe arylthio en C₆-C₆₀ substitué, du groupe hétéroaryle en C₁-C₆₀ substitué, du groupe polycyclique condensé non-aromatique monovalent substitué, et du groupe hétéropolycyclique condensé non-aromatique monovalent substitué est sélectionné parmi :
le deuterium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en C₂-C₆₀, et un groupe alcoxy en C₁-C₆₀ ;
un groupe alkyle en C₁-C₆₀, un groupe alcényle en C₂-C₆₀, un groupe alcynyle en C₂-C₆₀, et un groupe alcoxy en C₁-C₆₀, chacun étant substitué par au moins un élément sélectionné parmi le deuterium, -F, -Cl, -Br, -I, un groupe hydroxyle, un groupe cyano, un groupe nitro, un groupe amidino, un groupe hydrazino, un groupe hydrazono, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non-aromatique monovalent, un groupe hétéropolycyclique condensé non-aromatique monovalent, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), et -P(=O)(Q₁₁)(Q₁₂);
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non-aromatique monovalent, et un groupe hétéropolycyclique condensé non-aromatique monovalent ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non-aromatique monovalent, et un groupe hétéropolycyclique condensé non-aromatique monovalent, chacun étant substitué par au moins un élément sélectionné parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non-aromatique monovalent, un groupe hétéropolycyclique condensé non-aromatique monovalent, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), et -P(=O)(Q₂₁)(Q₂₂) ; et
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), et -P(=O)(Q₃₁)(Q₃₂),
dans lequel Q₁ à Q₃, Q₁₁ à Q₁₃, Q₂₁ à Q₂₃, et Q₃₁ à Q₃₃ sont chacun indépendamment sélectionnés à partir de l'hydrogène, du deuterium, de -F, -Cl, -Br, -I, d'un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe hétéroaryle en C₁-C₆₀, un groupe polycyclique condensé non-aromatique monovalent, un groupe hétéropolycyclique condensé non-aromatique monovalent, un groupe biphényle, et un groupe terphényle.

2. Dispositif électroluminescent organique selon la revendication 1, dans lequel R₁₉ et R₂₀ sont chacun indépendamment sélectionnés parmi Rₓ et R_{y}.

3. Dispositif électroluminescent organique selon la revendication 1 ou la revendication 2, dans lequel R₁₁ à R₁₈ sont chacun indépendamment sélectionnés parmi l'hydrogène, le deutérium, -F, -Cl, -Br, -I, un groupe cyano, un groupe alkyle en C₁-C₆₀, un groupe aryle en C₆-C₆₀, un groupe hétéroaryle en C₁-C₆₀, et -Si(Q₁)(Q₂)(Q₃),
dans lequel Q₁ à Q₃ sont chacun indépendamment sélectionnés parmi un groupe alkyle en C₁-C₆₀, un groupe aryle en C₆-C₆₀, un groupe biphényle, et un groupe terphényle.

4. Dispositif électroluminescent organique selon l'une quelconque des revendications 1 à 3, dans lequel L₁₁ et L₁₂ sont chacun indépendamment sélectionnés parmi :
un groupe phénylène, un groupe naphtylène, un groupe fluorénylène, un groupe dibenzofuranylène, et un groupe dibenzothiophénylène ; et
un groupe phénylène, un groupe naphtylène, un groupe fluorénylène, un groupe dibenzofuranylène, et un groupe dibenzothiophénylène, chacun étant substitué par au moins un élément sélectionné parmi le deuterium, -F, -Cl, -Br, -I, un groupe cyano, un groupe nitro, un groupe alkyle en C₁-C₂₀, un groupe phényle, et un groupe naphtyle.

5. Dispositif électroluminescent organique selon l'une quelconque des revendications 1 à 4, dans lequel L₁₁ et L₁₂ sont chacun indépendamment sélectionnés parmi des groupes représentés par des Formules 3-1 à 3-25 : 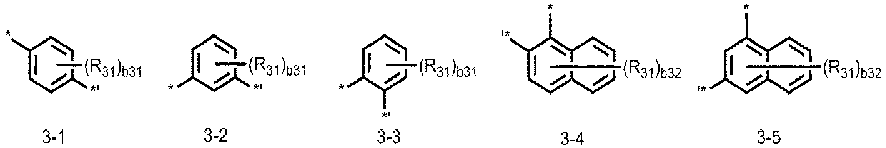 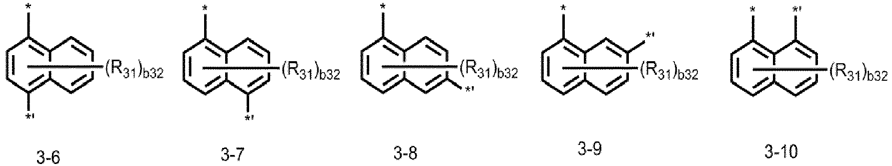 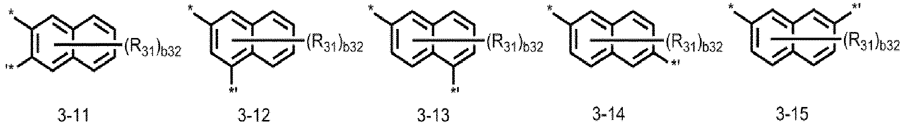 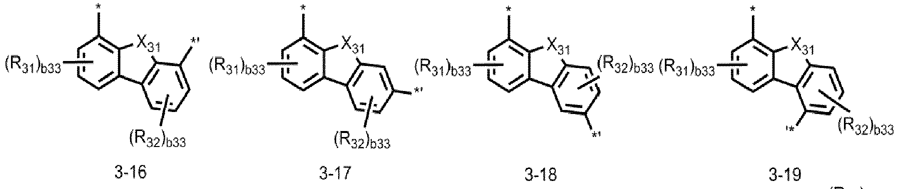 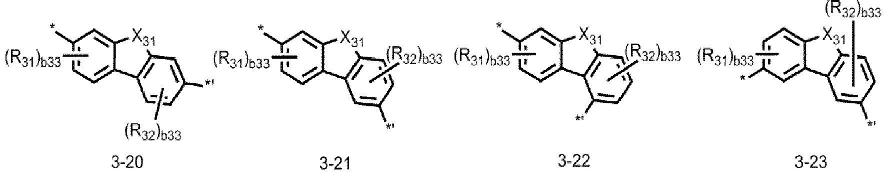 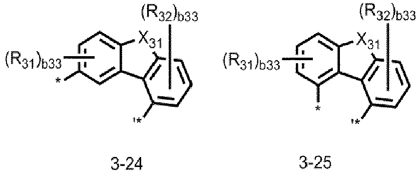 dans lequel, dans les Formules 3-1 à 3-25,
X₃₁ est sélectionné parmi un O, S, et C(R₃₃)(R₃₄),
R₃₁ à R₃₄ sont chacun indépendamment sélectionnés parmi l'hydrogène, le deutérium, -F, -Cl, -Br, -I, un groupe cyano, un groupe nitro, un groupe méthyle, un groupe éthyle, un groupe n-propyle, un groupe isopropyle, un groupe n-butyle, un groupe iso-butyle, un groupe sec-butyle, un groupe tert-butyle, un groupe phényle, et un groupe naphtyle,
b31 est sélectionné parmi 1, 2, 3, et 4,
b32 est sélectionné parmi 1, 2, 3, 4, 5, et 6,
b33 est sélectionné parmi 1, 2, et 3, et
^{∗} et ^{∗}' indiquent chacun un site de liaison à un atome voisin.

6. Dispositif électroluminescent organique selon l'une quelconque des revendications 1 à 5, dans lequel A₁₁ est un groupe représenté par une des Formules 10C-1, 10C-2, et 10C-3 : 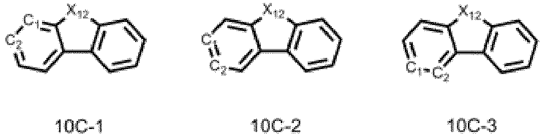 dans lequel, dans les Formules 10C-1, 10C-2, et 10C-3,
X₁₂ est comme défini dans la Formule 1, et
C₁ et C₂ sont chacun indépendamment un atome de carbone de la Formule 10-1A.

7. Dispositif électroluminescent organique selon l'une quelconque des revendications 1 à 6, dans lequel Rₓ est sélectionné à partir de groupes représentés par les Formules 10-21 à 10-26 : 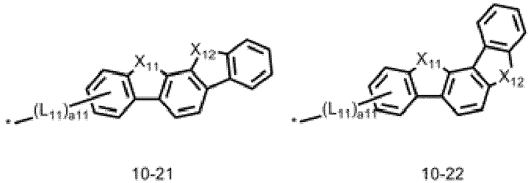 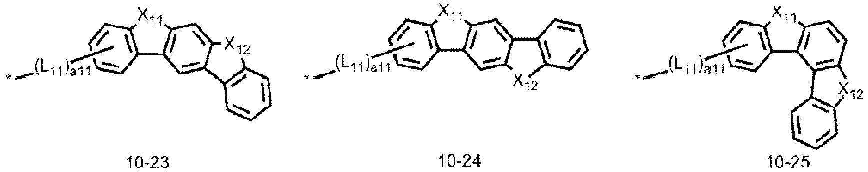 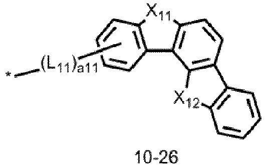 dans lequel, dans les Formules 10-21 à 10-26,
L₁₁, a11, X₁₁, et X₁₂ sont comme défini dans la Formule 1, et
^{∗} indique un site de liaison à un atome voisin.

8. Dispositif électroluminescent organique selon l'une quelconque des revendications 1 à 7, dans lequel R₁₀₈ est sélectionné parmi :
un groupe phényle, un groupe biphényle, un groupe terphényle, un groupe naphtyle, un groupe fluorényle, un groupe spiro-bifluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentaphényle, un groupe hexacényle, un groupe pentacényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe indazolyle, un groupe quinolinyle, un groupe isoquinolinyle, un groupe carbazolyle, un groupe benzoquinolinyle, un groupe phthalazinyle, un groupe naphthyridinyle, un groupe quinoxalinyle, un groupe quinazolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, et un groupe dibenzocarbazolyle ; et
un groupe phényle, un groupe biphényle, un groupe terphényle, un groupe naphtyle, un groupe fluorényle, un groupe spiro-bifluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentaphényle, un groupe hexacényle, un groupe pentacényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe indazolyle, un groupe quinolinyle, un groupe isoquinolinyle, un groupe carbazolyle, un groupe benzoquinolinyle, un groupe phthalazinyle, un groupe naphthyridinyle, un groupe quinoxalinyle, un groupe quinazolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, et un groupe dibenzocarbazolyle, chacun étant substitué par au moins un élément sélectionné parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₂₀, un groupe alcoxy en C₁-C₂₀, un groupe phényle, un groupe biphényle, un groupe terphényle, un groupe naphtyle, un groupe fluorényle, un groupe spiro-bifluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentaphényle, un groupe hexacényle, un groupe pentacényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe indazolyle, un groupe quinolinyle, un groupe isoquinolinyle, un groupe carbazolyle, un groupe benzoquinolinyle, un groupe phthalazinyle, un groupe naphthyridinyle, un groupe quinoxalinyle, un groupe quinazolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, et un groupe dibenzocarbazolyle.

9. Dispositif électroluminescent organique selon l'une quelconque des revendications 1 à 8, dans lequel R₁₀₈ est sélectionné parmi des groupes représentés par les Formules 5-1 à 5-30 : 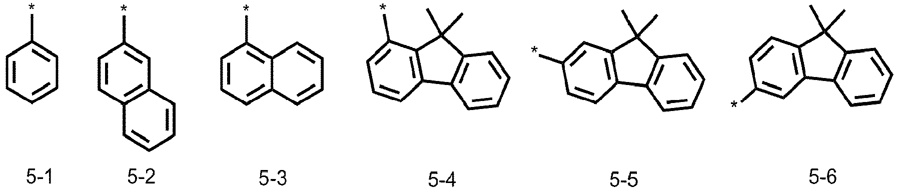 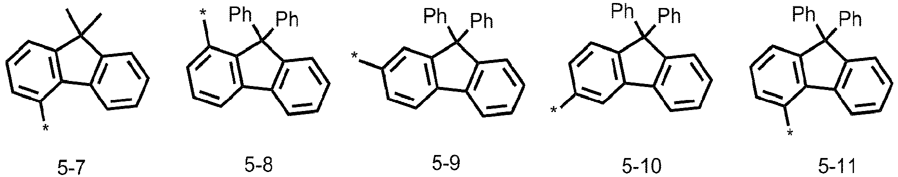 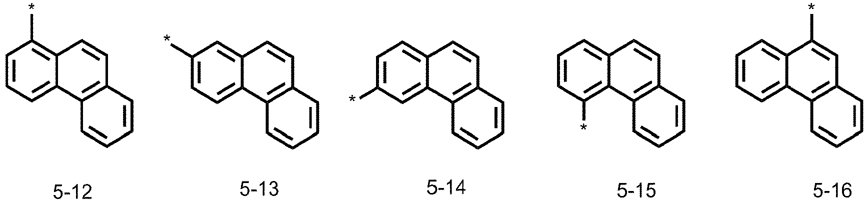 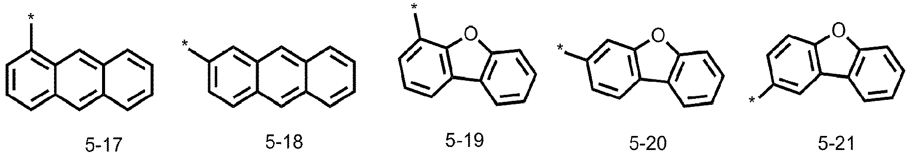 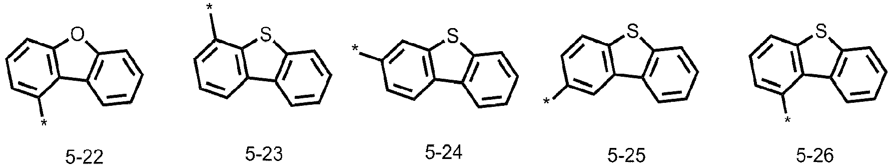 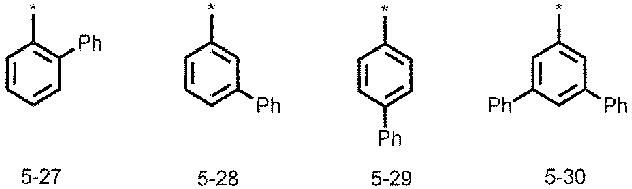 dans lequel, dans les Formules 5-1 à 5-30,
Ph est un groupe phényle, et
^{∗} indique un site de liaison à un atome voisin.

10. Dispositif électroluminescent organique selon l'une quelconque des revendications 1 à 9, dans lequel :
R₂₃ est R_{z}, ou
R₂₂ et R₂₄ sont chacun R_{z}, et R₂₂ et R₂₄ sont identiques ou différents l'un de l'autre.

11. Dispositif électroluminescent organique selon l'une quelconque des revendications 1 à 10, dans lequel R₂₁ à R₂₅ sont chacun indépendamment sélectionnés parmi R_{z}, l'hydrogène et un groupe alkyle en C₁-C₆₀.

12. Dispositif électroluminescent organique selon l'une quelconque des revendications 1 à 11, dans lequel L₂₁ à L₂₃ sont chacun indépendamment sélectionnés parmi : un groupe phénylène, un groupe naphtylène, un groupe pyridinylène, un groupe pyrazinylène, un groupe pyrimidinylène, un groupe quinolinylène, un groupe isoquinolinylène, et un groupe triazinylène ; et
un groupe phénylène, un groupe naphtylène, un groupe pyridinylène, un groupe pyrazinylène, un groupe pyrimidinylène, un groupe quinolinylène, un groupe isoquinolinylène, et un groupe triazinylène, chacun étant substitué par au moins un élément sélectionné parmi le deuterium, -F, -Cl, -Br, -I, un groupe cyano, un groupe nitro, un groupe alkyle en C₁-C₂₀, un groupe alcoxy en C₁-C₂₀, un groupe phényle, et un groupe naphtyle.

13. Dispositif électroluminescent organique selon l'une quelconque des revendications 1 à 12, dans lequel L₂₁ à L₂₃ sont chacun indépendamment sélectionnés parmi des groupes représentés par les Formules 6-1 à 6-54 : 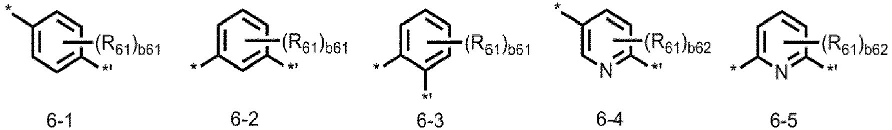 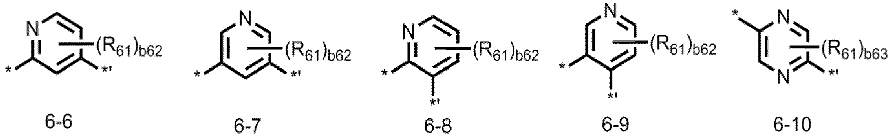 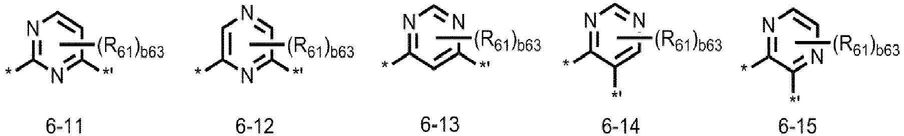 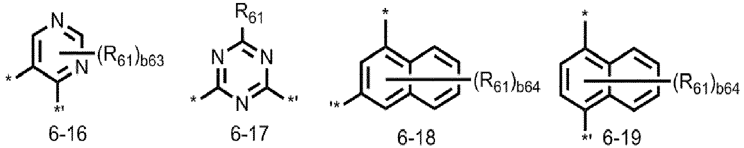 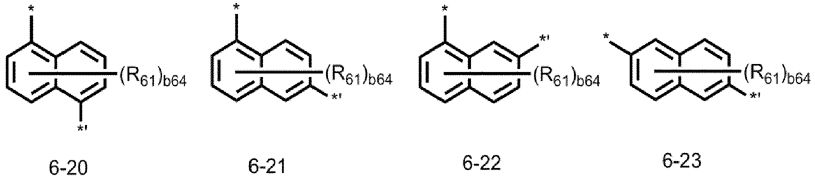 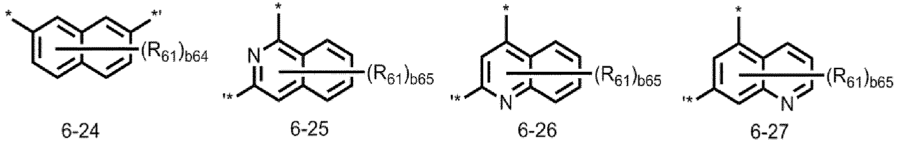 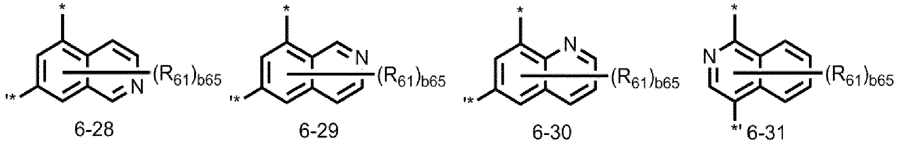 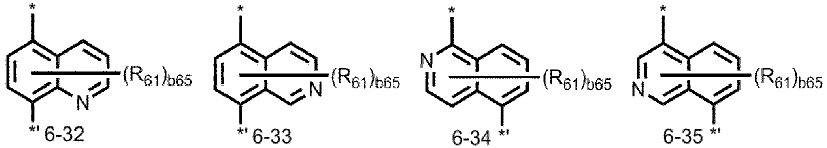 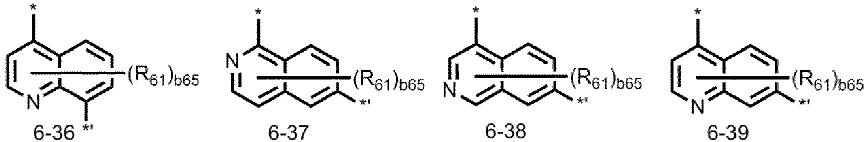 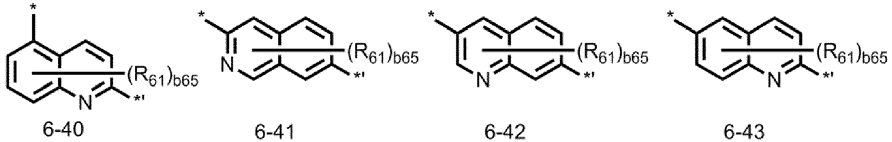 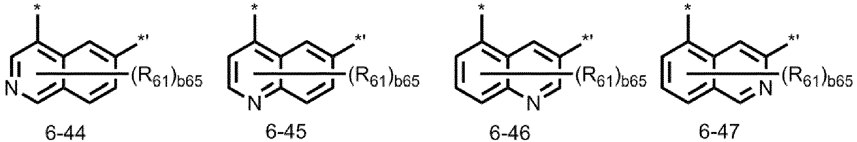 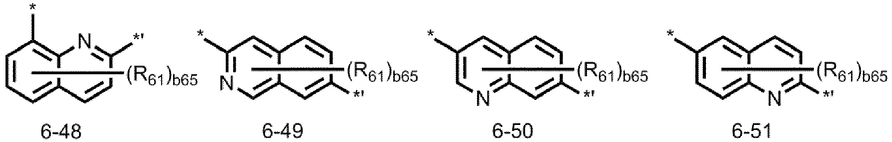 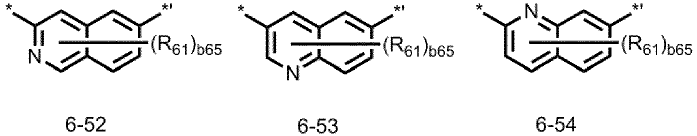 dans lequel, dans les Formules 6-1 à 6-54,
R₆₁ est sélectionné parmi l'hydrogène, le deuterium, -F, -Cl, -Br, -I, un groupe cyano, un groupe nitro, un groupe méthyle, un groupe éthyle, un groupe n-propyle, un groupe isopropyle, un groupe n-butyle, un groupe iso-butyle, un groupe sec-butyle, un groupe tert-butyle, un groupe méthoxy, un groupe éthoxy, un groupe phényle et un groupe napthyle,
b61 est sélectionné parmi 1, 2, 3, et 4,
b62 est sélectionné parmi 1, 2, et 3,
b63 est sélectionné parmi 1 et 2,
b64 est sélectionné parmi 1, 2, 3, 4, 5, et 6,
b65 est sélectionné parmi 1, 2, 3, 4, et 5, et
^{∗} et ^{∗}' indiquent chacun un site de liaison à un atome voisin.

14. Dispositif électroluminescent organique selon l'une quelconque des revendications 1 à 13, dans lequel R₂₆, R₂₇, et R₁₁₁ sont chacun indépendamment sélectionnés dans des groupes représentés par les Formules 8-1 à 8-36 : 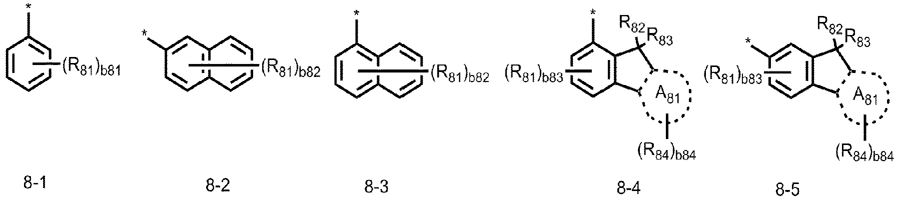 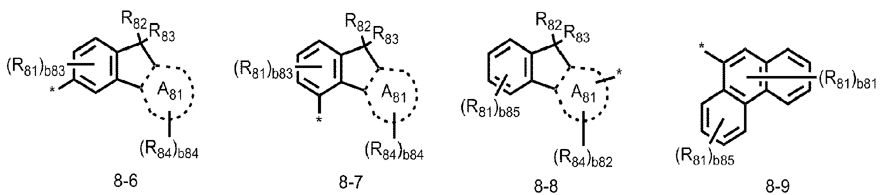 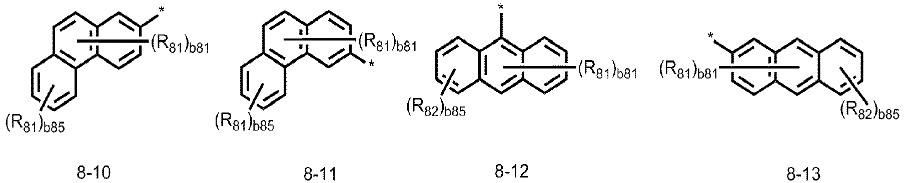 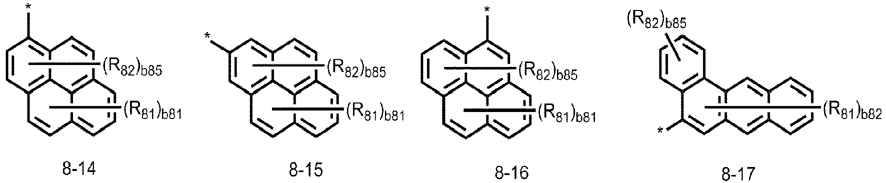 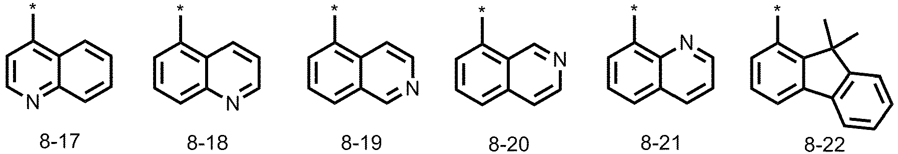 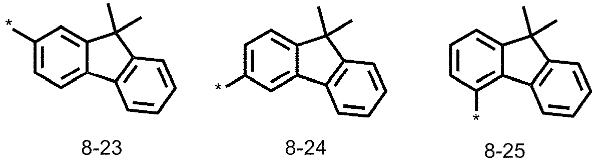 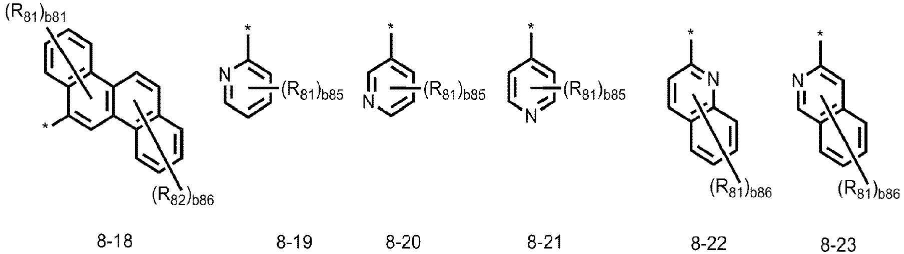 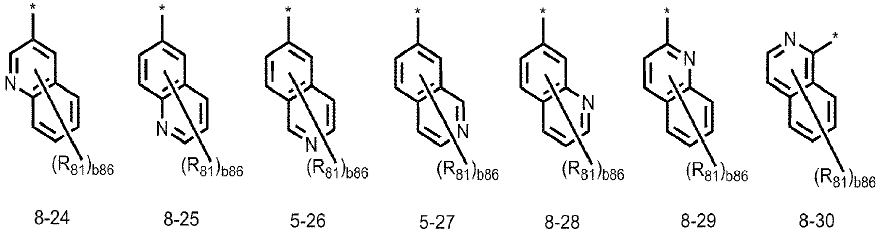 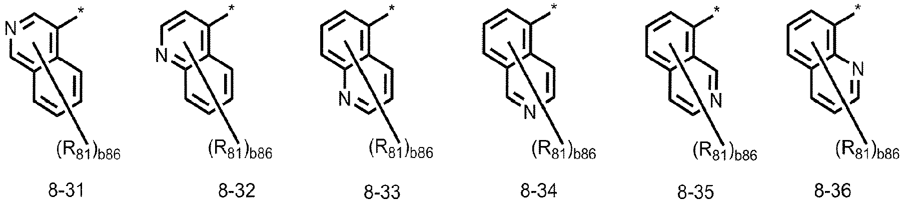 dans lequel, dans les Formules 8-1 à 8-36,
A₈₁ est sélectionné parmi un groupe benzène, un groupe naphtalène, et un groupe phénanthrène,
R₈₁ à R₈₄ sont chacun indépendamment sélectionnés parmi l'hydrogène, un groupe méthyle, un groupe éthyle, un groupe n-propyle, un groupe isopropyle, un groupe n-butyle, un groupe sec-butyle, un groupe iso-butyle, un groupe tert-butyle, un groupe méthoxy, un groupe éthoxy, un groupe phényle, un groupe phényle substitué par un groupe méthyle, un groupe biphényle, un groupe terphényle, et un groupe naphtyle,
b81 est sélectionné parmi 1, 2, 3, 4, et 5,
b82 est sélectionné parmi 1, 2, 3, 4, 5, 6, et 7,
b83 est sélectionné parmi 1, 2, et 3,
b84 est sélectionné parmi 1, 2, 3, 4, 5, 6, 7, et 8,
b85 est sélectionné parmi 1, 2, 3, et 4,
b86 est sélectionné parmi 1, 2, 3, 4, 5, et 6, et
^{∗} indique un site de liaison à un atome voisin.

15. Dispositif électroluminescent organique selon l'une quelconque des revendications 1 à 14, dans lequel le premier composé est représenté par la Formule 1-1 : 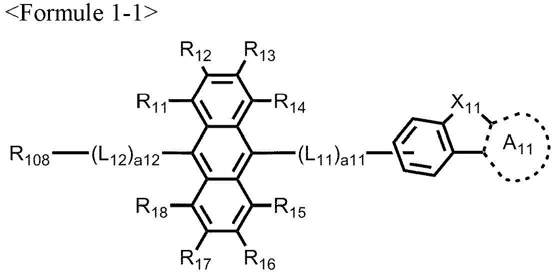 R₁₁ à R₁₄, R₁₅ à R₁₈, L₁₁, L₁₂, a11, a12, A₁₁, X₁₁, et R₁₀₈ dans la Formule 1-1 sont comme définis dans la Formule 1.

16. Dispositif électroluminescent organique selon l'une quelconque des revendications 1 à 15, dans lequel le premier composé est représenté par une des Formules 1-21 à 1-26 : 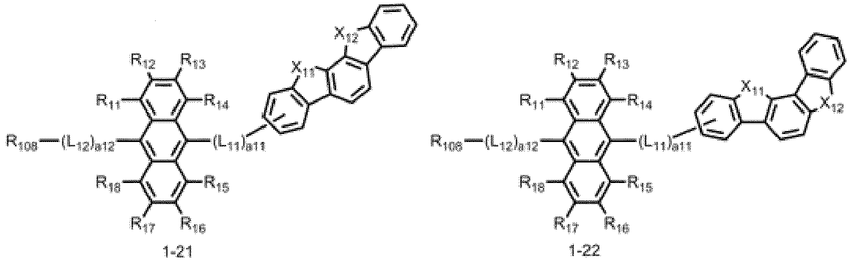 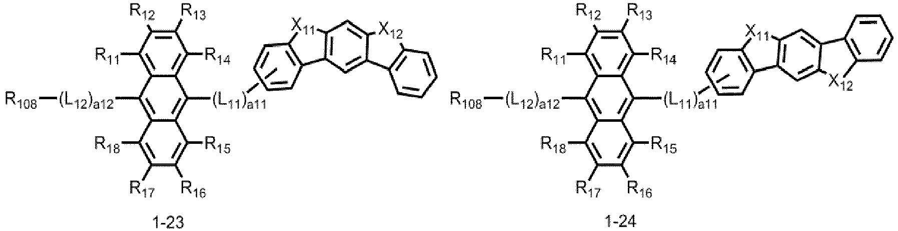 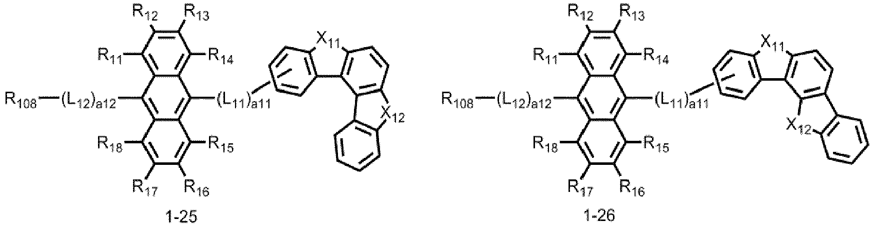 R11 à R₁₄, R₁₅ à R₁₈, L₁₁, L₁₂, a11, a12, X₁₁, X₁₂, et R₁₀₈ dans les Formules 1-21 à 1-26 sont comme définis dans la Formule 1.

17. Dispositif électroluminescent organique selon l'une quelconque des revendications 1 à 16, dans lequel le second composé est représenté par une des Formules 2-1 et 2-2 : 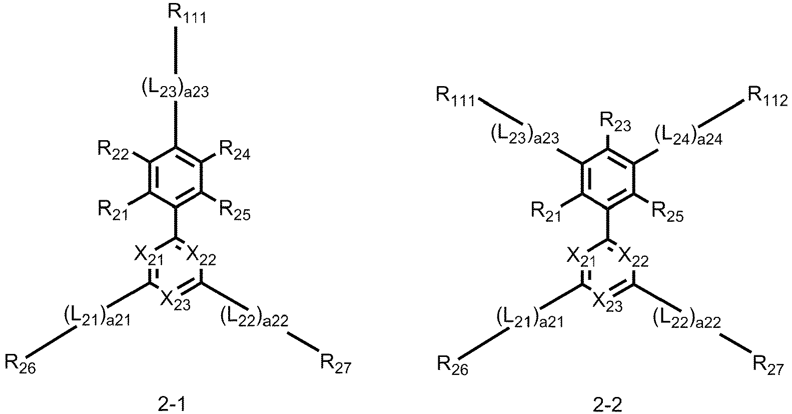 dans lequel, dans les Formules 2-1 et 2-2,
X₂₁ à X₂₃, L₂₁ à L₂₃, a21 à a23, R₂₁, R₂₂, R₂₃, R₂₄ à R₂₇, et R₁₁₁ sont comme définis dans la Formule 2,
L₂₄ est comme défini avec L₂₃ dans la Formule 2,
a24 est comme défini avec a23 dans la Formule 2, et
R₁₁₂ est comme défini avec R₁₁₁ dans la Formule 2.

18. Dispositif électroluminescent organique selon l'une quelconque des revendications 1 à 17, dans lequel le second composé est représenté par une des Formules 2-11 to 2-20 : 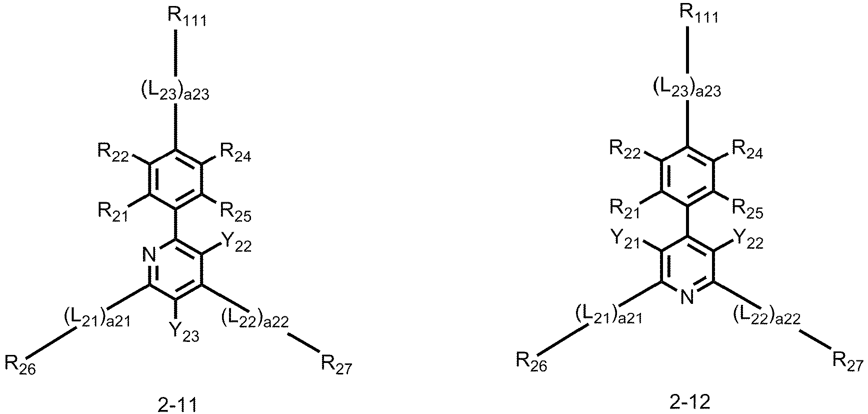 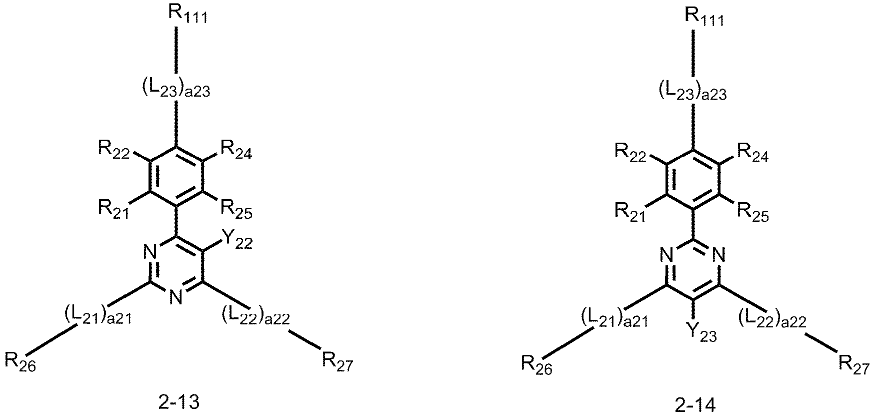 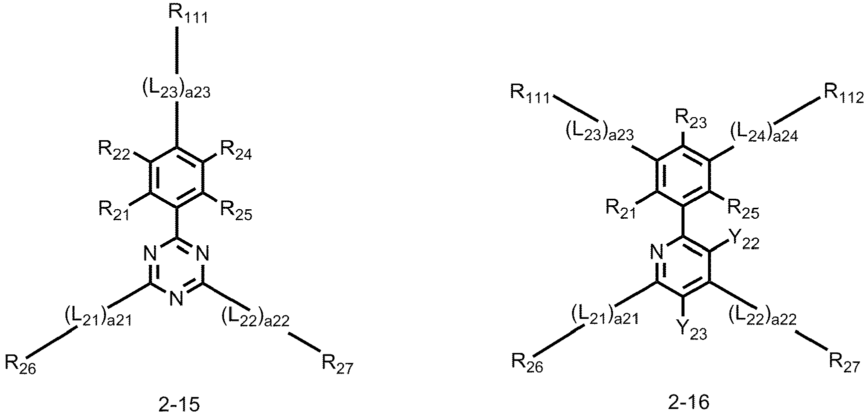 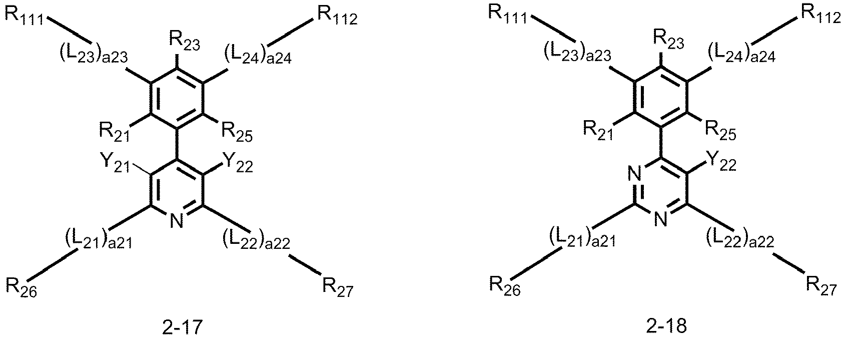 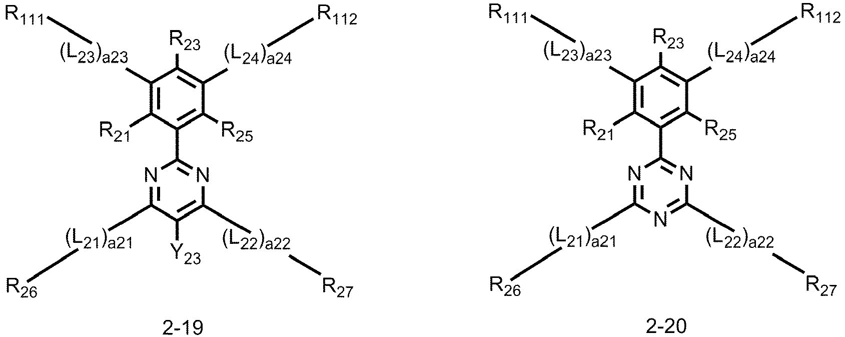 dans lequel, dans les Formules 2-11 to 2-20,
Y₂₁ à Y₂₃, L₂₁ à L₂₃, a21 à a23, R₂₁, R₂₂, R₂₃, R₂₄ à R₂₇, et R₁₁₁ sont comme définis dans la Formule 2,
L₂₄ est comme défini avec L₂₃ dans la Formule 2,
a24 est comme défini avec a23 dans la Formule 2, et
R₁₁₂ est comme défini avec R₁₁₁ dans la Formule 2.

19. Dispositif électroluminescent organique selon l'une quelconque des revendications 1 à 18, dans lequel la couche organique comprend une couche d'émission et une région de transport d'électrons,
la région de transport d'électrons est disposée entre la couche d'émission et la seconde électrode,
la couche d'émission comprend le premier composé, et
la région de transport d'électron comprend le second composé.
